# EUROPÄISCHE PATENTSCHRIFT

(11) **EP 4 055 351 B1**
(45) Veröffentlichungstag und Bekanntmachung des Hinweises auf die Patenterteilung: **03.01.2024**
(21) Anmeldenummer: 20807276.9
(22) Anmeldetag: 06.11.2020
(51) Int. Cl.: G01R 33/26, G01R 33/032, G01D 5/14, G01D 5/26, G01D 5/245, G01D 21/00

(54) **SENSORSYSTEM UND VERFAHREN ZUR MESSUNG DER MAGNETISCHEN FLUSSDICHTE UND ANDERER PARAMETER MITTELS EINER VIELZAHL VON NV-ZENTREN**
SENSOR SYSTEM AND METHOD FOR MEASURING THE MAGNETIC FLUX DENSITY AND OTHER PARAMETERS BY MEANS OF A PLURALITY OF NV CENTRES
SYSTÈME CAPTEUR ET PROCÉDÉ POUR MESURER LA DENSITÉ DE FLUX MAGNÉTIQUE ET D'AUTRES PARAMÈTRES AU MOYEN D'UNE PLURALITÉ DE CENTRES NZ

(30) Priorität: 07.11.2019 DE 102019130114
(43) Veröffentlichungstag der Anmeldung: 14.09.2022
(73) Patentinhaber: Elmos Semiconductor SE, 44227 Dortmund (DE); Quantum Technologies GmbH, 04103 Leipzig (DE)
(72) Erfinder: BURCHARD, Bernd, 45276 Essen (DE); MEIJER, Jan, 44801 Bochum (DE)
(74) Vertreter: dompatent von Kreisler Selting Werner - Partnerschaft von Patent- und Rechtsanwälten mbB
(86) Internationale Anmeldenummer: PCT/DE2020/100953
(87) Internationale Veröffentlichungsnummer: WO 2021/089091

(56) Entgegenhaltungen:
- WO-A1-2016/118791
- WO-A2-2018/226784
- HUIJIE ZHENG ET AL: "Microwave-free vector magnetometry with nitrogen-vacancy centers along a single axis in diamond", ARXIV.ORG, CORNELL UNIVERSITY LIBRARY, 201 OLIN LIBRARY CORNELL UNIVERSITY ITHACA, NY 14853, 8. April 2019 (2019-04-08), XP081643890,
- ROMANA SCHIRHAGL ET AL: "Nitrogen-Vacancy Centers in Diamond: Nanoscale Sensors for Physics and Biology", ANNUAL REVIEW OF PHYSICAL CHEMISTRY., Bd. 65, Nr. 1, April 2014 (2014-04), Seiten 83-105, XP055758070, US ISSN: 0066-426X, DOI: 10.1146/annurev-physchem-040513-103659

## Beschreibung

### Feld der Erfindung

Die Erfindung richtet sich auf ein NV-Zentrum basierendes Sensorsystem und Verfahren zum Betreiben dieses Sensorsystems sowie dessen Anwendungen. Das System unterscheidet sich vom Stand der Technik dadurch, dass keine Mikrowellenfrequenz notwendig ist. Bevorzugt werden mehrere NV-Zentren verwendet. Besonders bevorzugt wird eine Vielzahl von Nanodiamanten mit unterschiedlicher Kristallausrichtung und einer Vielzahl von NV-Zentren verwendet.

### Einleitung und Übersicht

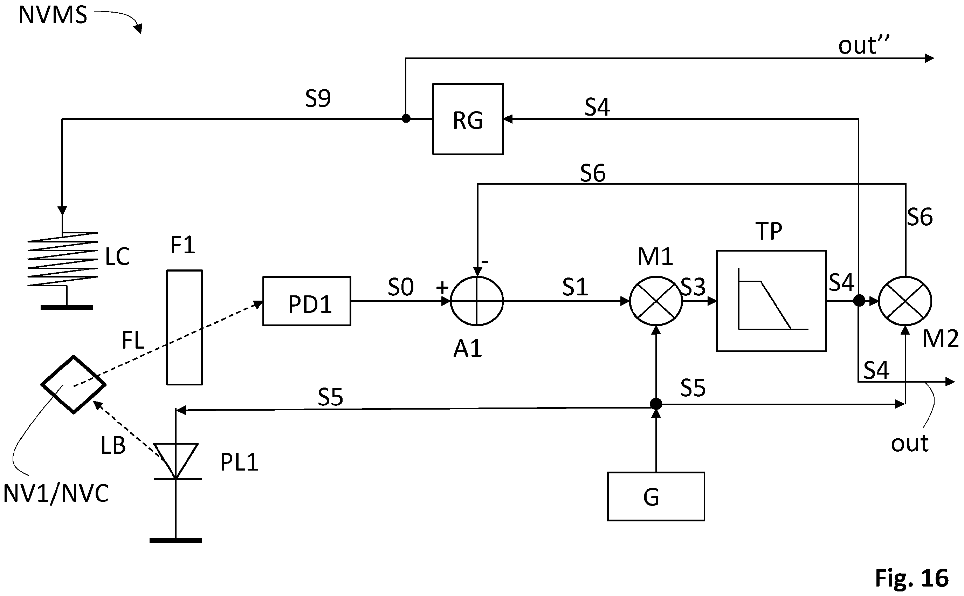

Im Folgenden wird die Erfindung mit Hilfe der beispielhaften Figuren erläutert. Die Erfindung wird durch die unabhängigen Ansprüche 1 und 3 definiert. Die Abbildung 16 zeigt die einzige Variante, die eine Ausführungsform gemäß der Erfindung bildet.

Mit dem Begriff Sensorsystem (NVMS) sind in dieser Beschreibung auch solche Systeme umfasst, die Quanteneigenschaften optischer Zentren bei Raumtemperatur ganz allgemein ausnutzen. Dies betrifft insbesondere Systeme die Modifikationen an Quantenzuständen der paramagnetischen Zentren ausführen und/oder auswerten und/oder erfassen und ausgeben. Bevorzugt handelt es sich um Systeme mit Diamant als Substrat. Hinsichtlich anderer Substrate und Störstellen wird auf die Ausführungen der bereits erwähnten und noch unveröffentlichten PCT/DE 2020/100 827 und DE 10 2020 125 189.0 verwiesen. Bevorzugt handelt es sich bei den Störstellenzentren um Störstellenzentren in Diamant und zwar bevorzugt um NV-Zentren und/oder SiV-Zentren. Andere geeignete paramagnetische Zentren können z.B. ST1-Zentren, GeV-Zentren, TR1-Zentren, L2-Zentren etc. sein.

Die Tabelle ist nur eine beispielhafte Zusammenstellung einiger möglicher paramagnetischer Zentren. Die funktionaläquivalente Nutzung anderer paramagnetischer Zentren in anderen Materialien ist ausdrücklich möglich. Die Wellenlängen der Anregungsstrahlung sind ebenfalls beispielhaft. Andere Wellenlängen sind in der Regel möglich, wenn sie kürzer als die Wellenlänge der anzuregenden ZPL sind.

| Material | beispielhaftes Störstellenzentrum | ZPL | beispielhafte Pumpstrahlungswellenlänge (λₚₘₚ) | Referenz |
|---|---|---|---|---|
| Diamant | NV-Zentrum | | 520nm, 532nm | |
| Diamant | SiV-Zentrum | 738 nm | 685 nm | /1/,/2/,/3/ |
| Diamant | GeV-Zentrum | 602 nm | 532 nm | /3/,/4/ |
| Diamant | SnV-Zentrum | 620 nm | 532 nm | /3/,/5/ |
| Diamant | PbV-Zentrum | 520 nm, | 450 nm | /3/,/6/ |
| | | 552 nm | | /3/,/6/ |
| | | 715 nm | 532 nm | /6/ |

Die Referenzen zu den obigen Störstellenzentren sind:
/1/ C. Wang, C. Kurtsiefer, H. Weinfurter, B. Burchard, "Single photon emission from SiV centres in diamond produced by ion implantation" J. Phys. B: At. Mol.Opt. Phys., 39(37), 2006
/2/ Björn Tegetmeyer, "Luminescence properties of SiV-centers in diamond diodes" Promotionsschrift, Universität Freiburg, 30.01.2018
/3/ Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992
/4/ Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph] 25 May 2020
/5/ Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph]
/6/ Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
Diese Sensor-Systeme sind Teil der hier offengelegten technischen Lehre.

Die in dieser Offenlegung genannten Prinzipien und Merkmale können miteinander kombiniert werden und sind Teil der Beanspruchung, soweit das Ergebnis sinnvoll ist.

Neben dem zum Zeitpunkt der Anmeldung öffentlich zugänglichen Stand der Technik, spielt auch der den Anmeldern bekannte, jedoch patentunschädlich noch unveröffentlichte Stand der Technik eine Rolle.

Dieser zum Zeitpunkt der Anmeldung dieser Offenlegung noch unveröffentlichte Stand der Technik ist insbesondere Gegenstand der Zeitpunkt der Anmeldung der prioritätsbegründenden Anmeldung dieser Offenlegung noch unveröffentlichten Schrift DE 10 2018 127 394 A1 und der zum Zeitpunkt der Anmeldung dieser Offenlegung noch unveröffentlichten deutschen Patentanmeldungen DE 10 2019 120 076.8, DE 10 2019 121 137.9, DE 10 2019 121 028.3, DE 10 2018 127 394.0 und DE 10 2020 119 414.5 und der zum Zeitpunkt der Anmeldung dieser Offenlegung noch unveröffentlichten internationalen Patentanmeldungen PCT/DE 2020/100 648 und PCT/DE 2020/100 827. Dieser unveröffentlichte Stand der Technik der deutschen Patentanmeldungen DE 10 2019 120 076.8, DE 10 2019 121 137.9, DE 10 2019 121 028.3 DE 10 2018 127 394 A1 und DE 10 2020 119 414.5 und der internationalen Patentanmeldung PCT/DE 2020/100 648 ist vollumfänglicher Teil dieser Offenlegung. Insbesondere in der Schrift DE 10 2020 119 414.5 ist umfangreicher Stand der Technik benannt auf den hier verwiesen wird. Dieser zum Zeitpunkt der Anmeldung dieser Schrift unveröffentlichte Stand der der Technik wird mit Hilfe der Figuren 1 bis 4 erläutert.

Wenn in dieser Schrift von Quantenpunkten die Rede ist, so kann es sich insbesondere um ein paramagnetisches Zentrum (NV1) und/oder um einen Cluster solcher paramagnetischer Zentren (NV1) in Form einer Vielzahl (NVC) paramagnetischer Zentren (NV1) und/oder um eine Vielzahl solcher Cluster handeln. Bevorzugt werden als paramagnetische Zentren NV-Zentren in Diamant verwandt. Wenn somit von einem Quantenpunkten die Rede ist, so kann es sich insbesondere um ein NV-Zentrum und/oder um einen Cluster solcher NV-Zentren in Form einer Vielzahl von NV- Zentren und/oder um eine Vielzahl solcher Cluster handeln. Besonders bevorzugt sind dichte Zusammenballungen von paramagnetischen Zentren (NV1), also vorzugsweise von NV-Zentren.

### Figur 1

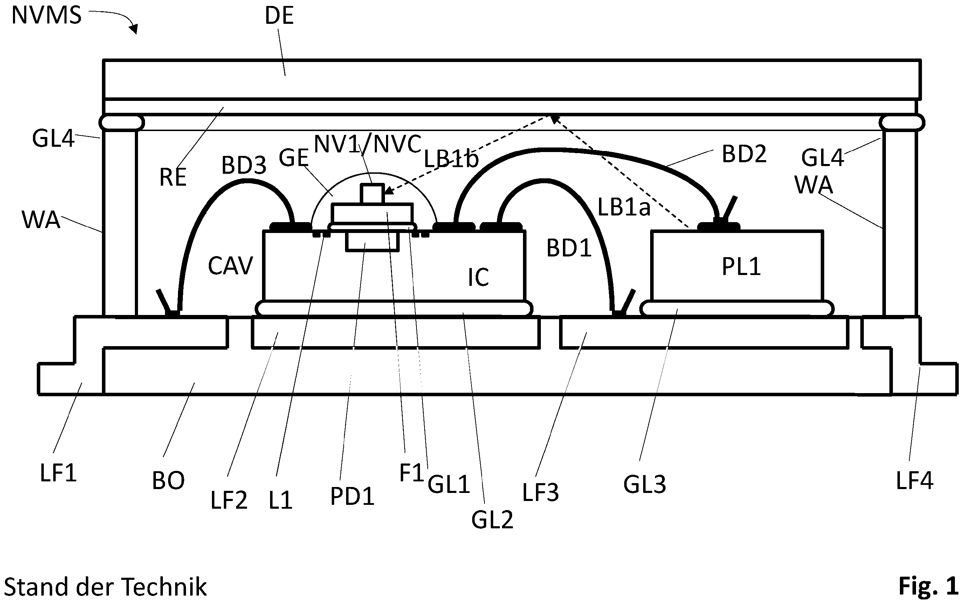

Figur 1 zeigt schematisch vereinfachend ein beispielhaftes Gehäuse entsprechend er DE 10 2020 119 414.5 bzw. der PCT/DE 2020/100 648 für ein beispielhaftes Sensorsystem im Querschnitt. Das Gehäuse umfasst einen Gehäuseboden (BO), Gehäusewände (WA) und einen Gehäusedeckel (DE). Der Gehäusedeckel (DE) ist in dem Beispiel der Figur 1 mit einem beispielhaften vierten Kleber (GL4) auf der Oberkante der Gehäusewand (WA) befestigt. Bevorzugt bilden die Gehäusewand (WA) und der Gehäuseboden (BO) ein sogenanntes Pre-Molded-Open-Cavity-Gehäuse mit einer Kavität (CAV), in das vor dem Verschließen durch das Aufkleben des Gehäusedeckels (DE) die elektronischen, magnetischen und optischen Funktionselemente des Sensorsystems eingebaut werden können. Ein solches Pre-Molded-Open-Cavity-Gehäuse wird bevorzugt durch Spritzguss unter der Verwendung von Duroplasten und Füllmaterialien hergestellt.

In den Boden (BO) des Pre-Molded-Open-Cavity-Gehäuses ist typischerweise ein sogenannter Leadframe eingegossen. Dieser ist strukturiert, so dass sich verschiedene Lead-Frame-Inseln (LF1, LF2, LF3, LF4) bilden, die nach dem Abtrennen des Lead-Frame-Rahmens nach dem Umspritzen durch die Spritzgussmasse des Gehäusebodens (BO) mechanisch gehalten und gegeneinander elektrisch isoliert werden. Dieser Abtrennschritt des Leadframe-Rahmens, der sogenannter Trimm-and-FormSchritt, wird auch benutzt, um die Form der Anschlüsse zu modifizieren. Hier sind das die erste Lead-Frame-Insel (LF1) und die vierte Lead-Frame-Insel (LF4).

An der zweiten Lead-Frame-Insel (LF2), die hier als sogenanntes Die-Paddle dient, ist in dem beispielhaften System eine integrierte Schaltung (IC) mittels eines vorzugsweise elektrisch leitenden zweiten Klebers (GL2) befestigt.

In dem Beispiel der Figur 1 umfasst die integrierte Schaltung (IC) einen lichtempfindlichen ersten Strahlungsempfänger (PD1). Es ist auch denkbar, den lichtempfindlichen ersten Strahlungsempfänger (PD1) separat als diskretes Bauteil in die Kavität (CAV) des Gehäuses einzubauen und beispielsweise über Bonddrähte mit dem integrierten Schaltkreis (IC) zu verbinden.

Eine erste Pumpstrahlungsquelle (PL1) ist mittels eines dritten Klebers (GL3) an der dritten Lead-Frame-Insel (LF3) bevorzugt elektrisch leitfähig befestigt.

Die dritte Lead-Frame-Insel (LF3) ist in dem Beispiel der Figur 1 mittels eines ersten Bonddrahts (BD1) beispielhaft mit der integrierten Schaltung (IC) verbunden. Hierdurch wird in dem Beispiel der Figur 1 eine beispielhafte elektrische Verbindung zwischen der Rückseite der ersten Pumpstrahlungsquelle (PL1) und der integrierten Schaltung (IC) hergestellt.

Ein zweiter Anschluss der ersten Pumpstrahlungsquelle (PL1) ist in dem Beispiel der Figur 1 mittels eines zweiten Bond-Drahtes (BD2) ebenfalls mit dem integrierten Schaltkreis (IC) verbunden. Hierdurch wird die integrierte Schaltung (IC) in die Lage versetzt, die erste Pumpstrahlungsquelle (PL1) mit elektrischer Energie zu versorgen und zu steuern.

In Abhängigkeit von der Ansteuerung durch die integrierte Schaltung (IC) emittiert die erste Pumpstrahlungsquelle (PL1) eine Pumpstrahlung (LB1a). Ein Reflektor (RE) befindet sich an der Unterseite des Gehäusedeckels (DE). Der Reflektor (RE) kann auch Teil des Gehäusedeckels (DE) sein. Beispielsweise kann die Oberfläche der Unterseite des Gehäusedeckels (DE) eine geeignete Oberflächenstruktur aufweisen. Dies kann beispielsweise eine Aufrauhung, eine Politur oder Anschrägung oder ein anderes optisches Funktionselement oder dergleichen sein. Auch kann der Deckel (DE) beispielsweise aus einem besonders gut reflektierenden Material, beispielsweise einer geeigneten Mold-Masse, gefertigt sein. Besonders bevorzugt ist der Gehäusedeckel (DE) aus einem weißen Material gefertigt. Zumindest sollte das Material des Gehäusedeckels (DE) eine solche spektrale Eigenschaft aufweisen, dass er die Strahlung der ersten Pumpstrahlungsquelle (PL1) und/oder die Fluoreszenzstrahlung (FL) des Quantenpunkts, insbesondere des paramagnetischen Zentrums (NV1) oder insbesondere der Vielzahl (NVC) paramagnetischer Zentren (NV1) gut reflektiert. Strahlt die erste Pumpstrahlungsquelle (PL1) beispielsweise grünes Licht aus, so ist ein grüner oder weißer Reflektor (RE) besonders günstig. Die von der ersten Pumpstrahlungsquelle (PL1) emittierte Pumpstrahlung (LB1) wird an diesem Reflektor (RE) reflektiert und als reflektierte Pumpstrahlung (LB1b) auf zumindest ein paramagnetisches Zentrum (NV1) oder eine Vielzahl (NVC) paramagnetischer Zentren (NV1) gelenkt.

Das paramagnetische Zentrum (NV1) oder eine Vielzahl paramagnetischer Zentren (NVC) befinden sich bevorzugt in einem Sensorelement, das hier nicht mit einem gesonderten Bezugszeichen versehen ist, um die Figuren zu vereinfachen. Bevorzugt handelt es sich bei dem paramagnetischen Zentrum (NV1) um ein Störstellenzentrum in einem Kristall, wobei der Kristall das Sensorelement im Sinne dieser Schrift darstellt. Ein Sensorelement kann selbst wieder aus mehreren Sensorelementen, also beispielsweise mehreren Kristallen, bestehen. Es kann sich bei der Vielzahl (NVC) paramagnetischer Zentren (NV1) um ein Störstellenzentrum in einem Kristall oder in mehreren Kristallen handeln, wobei der Kristall bzw. die Kristalle das Sensorelement im Sinne dieser Schrift darstellen. In dem Fall mehrerer Kristalle ist es vorteilhaft, wenn die mehreren Kristalle durch ein Bindemittel zu dem Sensorelement zusammenmontiert sind. Ein solches Bindemittel kann optisch transparenter Kunststoff oder Glas oder dergleichen sein. Das Bindemittel sollte für die Pumpstrahlungswellenlänge der Pumpstrahlung (LB1a, LB1b) und die Fluoreszenzwellenlänge der Fluoreszenzstrahlung (FL) ausreichend transparent sein. Bevorzugt ist der Kristall ein Diamantkristall oder sind die Kristalle Diamantkristalle. Das Störstellenzentrum ist bevorzugt ein NV-Zentrum in einem Diamantkristall. Die Störstellenzentren sind bevorzugt NV-Zentren. Als NV-Zentren werden in dieser Schrift Stickstofffehlstellenzentren in Diamant bezeichnet. Die Verwendung anderer Störstellenzentren wie beispielsweise der von SiV-Zentren ist denkbar. An dieser Stelle sei auf das Standardwerk Alexander M. Zaitsev, "Optical Properties of Diamond", erschienen im Springer Verlag verwiesen, in dem zahlreiche Diamantstörstellenzentren benannt sind. Das NV-Zentrum ist aber besonders gut erforscht und wegen seiner optischen Eigenschaften besonders geeignet. Im Sinne dieser Schrift kann es sich bei dem paramagnetischen Zentrum (NV1) auch um mehrere Störstellenzentren in einem Kristall und/oder um eine Zusammenfügung mehrere Kristalle mit mehreren Störstellenzentren also einer Vielzahl (NVC) paramagnetischer Zentren (NV1) handeln. Besonders bevorzugt sind die Störstellenzentren so entfernungsmäßig dicht oder in einer so großen räumlichen Dichte zueinander angeordnet, dass diese Störstellenzentren miteinander gekoppelt sind. Die Kopplung kann beispielsweise durch stimulierte Emission und durch Absorption und über magnetische Momente der Elektronenkonfiguration der Störstellenzentren erfolgen. Es ergeben sich dann kollektive Effekte. Besonders bevorzugt werden die Störstellenzentren in Form regulärer, besonders bevorzugter periodischer Strukturen angeordnet. Dies kann dadurch erreicht werden, dass die Störstellenzentren oder deren Vorläuferstrukturen im Rahmen des Fertigungsprozesses beispielsweise elektrisch aufgeladen werden, sich dadurch abstoßen und daher zumindest in lokal begrenzten Bereichen in Form eines Übergitters durch elektrostatische Anziehung anordnen. Natürlich kann auch eine Übergitterstruktur durch fokussierte lonenimplantation erreicht werden. (Bernd Burchard et. Al., "NM Scale Resolution Single Ion Implantation Into Diamond for Quantum Dot Production", Diamond 2004 Conference Riva del Garda: Erzeugung eines Übergitters ohne Kopplung zwischen den Gitterpunkten, und B. Burchard, J. Meijer, M. Domhan, C. Wittmann, T. Gaebel, I. Popa, F. Jelezko, and J. Wrachtrup, "Generation of single color centers by focused nitrogen implantation" Appl. Phys. Lett. 87, 261909 (2005); https://doi.org/10.1063/1.2103389)

Beispielsweise kann es sich bei dem paramagnetischen Zentrum (NV1) um eine Vielzahl (NVC) paramagnetischer Zentren (NV1) in Form mehrerer, vorzugsweise miteinander gekoppelter NV-Zentren in einem Diamantkristall und/oder um mehrere Diamanten mit mehreren NV-Zentren, die ebenfalls vorzugsweise miteinander gekoppelt sind, handeln. Die bevorzugte Kopplung bzw. das bevorzugte Zusammenwirken der NV-Zentren erfolgt bevorzugt durch stimulierte Emission und Absorption und/oder über magnetische Kopplung.

Das paramagnetische Zentrum (NV1) bzw. die Vielzahl (NVC) paramagnetischer Zentren (NV1) empfängt zumindest einen Teil der reflektierten Pumpstrahlung (LB1b) und emittiert daraufhin Fluoreszenzstrahlung (FL), die in der Figur 1 zur besseren Übersicht nicht eingezeichnet ist. Fluoreszenzstrahlung (FL), ggf. die Pumpstrahlung (LB1) und die reflektierte Pumpstrahlung (LB1b) treffen typischerweise auf einen ersten optischen Filter (F1). Der erste optische Filter (F1) lässt bevorzugt nur die Fluoreszenzwellenlänge (λ_{fl}) der Fluoreszenzstrahlung (FL) passieren. Der erste optische Filter (F1) ist bevorzugt für die Pumpstrahlungswellenlänge (λₚₘₚ) der Pumpstrahlung (LB1a) und/oder die reflektierte Pumpstrahlung (LB1b) nicht transparent und/oder dämpft diese soweit, dass sie für den beabsichtigten Zweck als im Wesentlichen geblockt angenommen werden kann und in erster, bevorzugt linearer Näherung vernachlässigt werden kann. Die Fluoreszenzstrahlung (FL) des paramagnetischen Zentrums (NV1) bzw. die Vielzahl (NVC) paramagnetischer Zentren (NV1) bestrahlt dann einen ersten Strahlungsempfänger (PD1) der, bevorzugt Teil der integrierten Schaltung (IC) ist. Der erste Strahlungsempfänger (PD1) kann aber auch getrennt von der integrierten Schaltung (IC) aufgebaut werden und wird dann geeignet elektrisch mit der integrierten Schaltung (IC), beispielsweise über weitere Bond-Drähte verbunden.

In dem Beispiel der Figur 1 ist der erste Filter (F1) mittels eines strahlungstransparenten ersten Klebers (GL1) mit der integrierten Schaltung (IC) mechanisch verbunden. Der erste Kleber (GL1) ist dabei für die Fluoreszenzstrahlung (FL) im Wesentlichen transparent. Dies bedeutet, dass der erste Kleber (GL1) die Fluoreszenzstrahlung (FL), wenn überhaupt, nur soweit dämpft, dass es für den bestimmungsgemäßen Zweck der Vorrichtung unerheblich ist. In dem Beispiel der Figur 1 ist der erste optische Filter (F1) im Strahlungspfad zwischen dem paramagnetischen Zentrum (NV1) bzw. der Vielzahl (NVC) paramagnetischer Zentren (NV1) und dem ersten Strahlungsempfänger (PD1) angeordnet. Der erste Kleber (GL1) koppelt in dem Beispiel der Figur 1 das paramagnetische Zentrum (NV1) bzw. die Vielzahl (NVC) paramagnetischer Zentren (NV1) optisch mit dem ersten Strahlungsempfänger (PD1). Diese Kopplung bezieht sich in dem Beispiel der Figur 1 auf die Fluoreszenzstrahlung (FL). Der erste optische Filter (F1) entkoppelt die erste Pumpstrahlungsquelle (PL1) von dem ersten Strahlungsempfänger (PD1) in dem für den bestimmungsgemäß notwendigen Umfang. Aus regelungstechnischen Gründen kann eine optische Grundkopplung wünschenswert sein, die hier zunächst nicht betrachtet wird.

Das Sensorelement mit dem paramagnetischen Zentrum (NV1) bzw. der Vielzahl (NVC) paramagnetischer Zentren (NV1) ist in dem Beispiel der Figur 1 mittels eines Befestigungsmittels (GE) mit dem ersten optischen Filter (F1) mechanisch verbunden.

Das Befestigungsmittel (GE) ist bevorzugt für die Pumpstrahlung (LB1a) bzw. die reflektierte Pumpstrahlung (LB1b) der ersten Pumpstrahlungsquelle (PL1) transparent, damit die Pumpstrahlung (LB1a) der ersten Pumpstrahlungsquelle (PL1) bzw. die reflektierte Pumpstrahlung (LB1b) das paramagnetische Zentrum (NV1) bzw. die Vielzahl (NVC) paramagnetischer Zentren (NV1) im Sensorelement erreichen kann.

Im Folgenden wird später auch die Verwendung einer Kompensationsstrahlungsquelle (PLK) beschrieben, die eine Kompensationsstrahlung (KS) aussendet und in den ersten Strahlungsempfänger (PD1) einstrahlt. Sofern eine Kompensationsstrahlung (KS) für das Einstellen eines optischen Arbeitspunkts des ersten Strahlungsempfängers (PD1) verwendet wird, ist das Befestigungsmittel (GE) bevorzugt für die Kompensationsstrahlungswellenlänge (λₖₛ) der Kompensationsstrahlung (KS) bzw. die ggf. reflektierte Kompensationsstrahlung (KS2) der Kompensationsstrahlungsquelle (PLK) transparent, damit die Kompensationsstrahlung (KS) der Kompensationsstrahlungsquelle (PLK) bzw. die reflektierte Kompensationsstrahlung (KS2) den ersten Strahlungsempfänger (PD1) erreichen kann.

Das Befestigungsmittel (GE) ist bevorzugt für die Fluoreszenzstrahlung (FL, FL1) bzw. eine ggf. je nach Konstruktion auftretende die reflektierte Fluoreszenzstrahlung (FL2) des paramagnetischen Zentrums (NV1) bzw. der Vielzahl (NVC) paramagnetischer Zentren (NV1) transparent, damit die Fluoreszenzstrahlung (FL, FL1) des paramagnetischen Zentrums (NV1) bzw. der Vielzahl (NVC) paramagnetischer Zentren (NV1) bzw. die reflektierte Fluoreszenzstrahlung (FL2) den ersten Strahlungsempfänger (PD1) erreichen kann.

Wie bereits beschrieben, handelt es sich bei dem paramagnetischen Zentrum (NV1) in dem Sensorelement bevorzugt um mindestens ein NV-Zentrum in mindestens einem Diamantkristall, wobei der mindestens eine Diamantkristall das Sensorelement darstellt. Bei der Vielzahl (NVC) paramagnetischer Zentren (NV1) handelt es sich bevorzugt um eine Mehrzahl von NV-Zentren in einem oder mehreren Diamanten, insbesondere Nanodiamanten. Weitere Bonddrähte (BD3) stellen weitere elektrische Verbindungen her. Ein Teil der elektrischen Verbindungen betrifft die Anschlüsse des beispielhaften Gehäuses. In dem Beispiel der Figur 1 werden die Anschlüsse des beispielhaften Gehäuses durch die erste Leadframe-Insel (LF1) und die vierte Leadframe-Insel (LF4) dargestellt. Zur Vereinfachung sind nicht alle notwendigen Bonddrahtverbindungen dargestellt.

### Figur 2

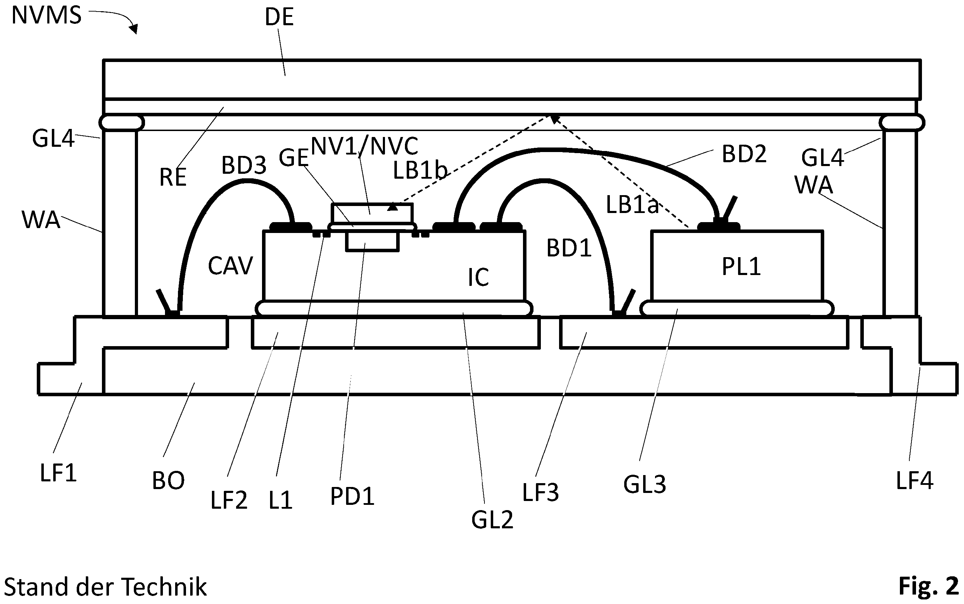

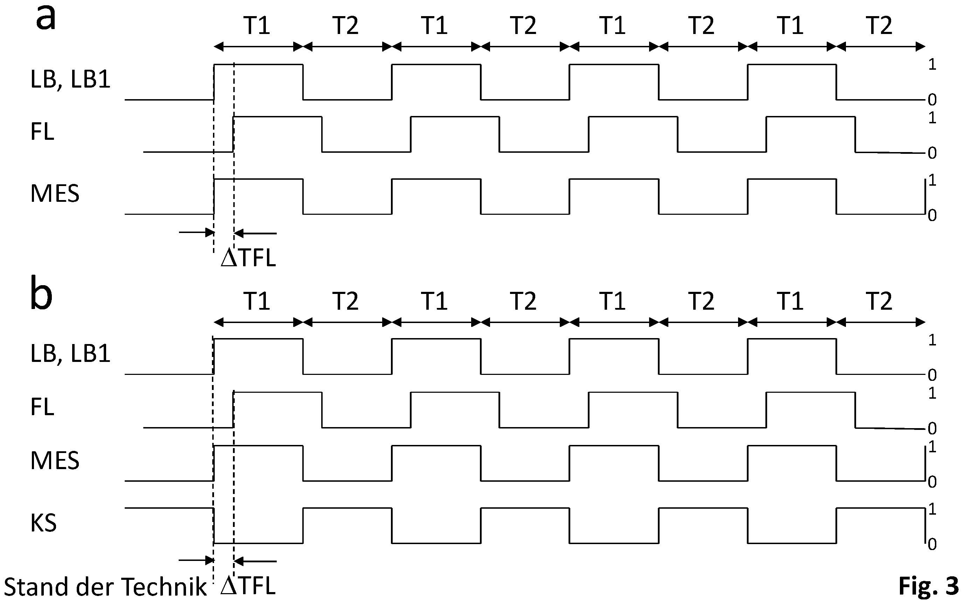

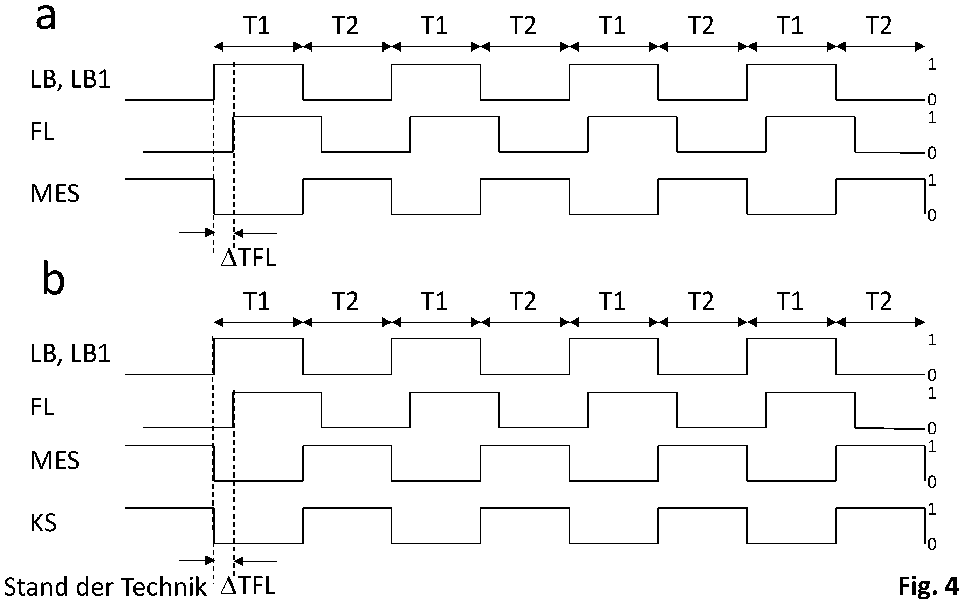

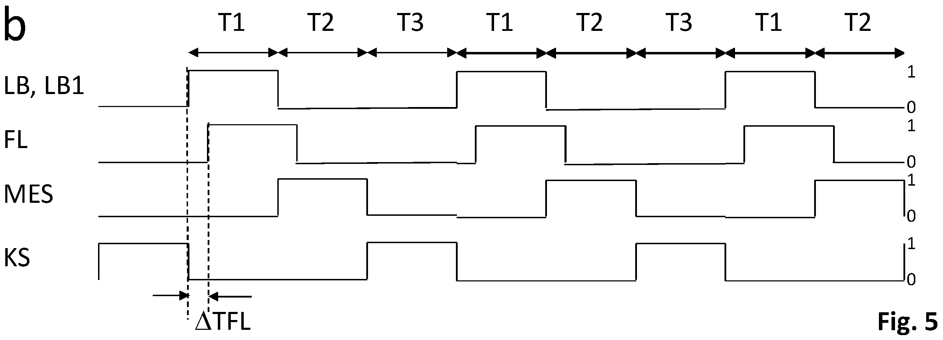

Figur 2 stellt eine Vereinfachung der Figur 1 dar. Im Gegensatz zur Figur 1 fehlen der erste optische Filter (F1) und der erste Kleber (GL1). Stattdessen ist das Sensorelement mit dem paramagnetischen Zentrum (NV1) bzw. der Vielzahl (NVC) paramagnetischer Zentren (NV1) direkt mittels des Befestigungsmittels (GE) direkt mit dem ersten Strahlungsempfänger (PD1) mechanisch und optisch verbunden. Hierfür gibt es zwei Nutzungsszenarien:
a) Die erste Pumpstrahlungsquelle (PL1) ist zu ersten Zeiten (T1) aktiv und sendet in diesen ersten Zeiten (T1) die Pumpstrahlung (LB, LB1) aus. Dies ist durch einen logischen Pegel von 1 in den Figuren 3a, 3b, 4a, 4b, 5b, 6a, 6b, 7b beispielhaft verdeutlicht. Die erste Pumpstrahlungsquelle (PL1) ist zu zweiten Zeiten (T2) nicht aktiv und sendet in diesen zweiten Zeiten (T2) keine Pumpstrahlung (LB, LB1) aus. Die ersten Zeiten (T1) und die zweiten Zeiten (T2) wechseln sich in den Figuren 3a, 3b, 4a, 4b aufeinander folgend ab. Die ersten Zeiten (T1) und die zweiten Zeiten (T2) und die dritten Zeiten (T3) wechseln sich in den Figuren 5b, 6a, 6b und 7b aufeinander folgend ab. Dies ist durch einen logischen Pegel von 0 in den Figuren 3a, 3b, 4a, 4b, 5b, 6a, 6b und 7b beispielhaft verdeutlicht. Bevorzugt wird in diesem Szenario die Fluoreszenzstrahlung (FL, FL1) nur zu zweiten Zeiten (T2) ausgewertet. Dies ist möglich, weil die Fluoreszenzstrahlung (FL, FL1) gegenüber der Pumpstrahlung (LB, LB1) eine Phasenverschiebung um eine Fluoreszenzphasenverschiebungszeit (ΔTFL) aufweist. Bei Verwendung eines NV-Zentrums als paramagnetisches Zentrum (NV1) bzw. einer Vielzahl von NV-Zentren als Vielzahl (NVC) paramagnetischer Zentren (NV1) liegt diese um eine Fluoreszenzphasenverschiebungszeit (ΔTFL) typischerweise in der Größenordnung von 1 ns. Die Auswertung des Empfängerausgangssignals (S0) des ersten Strahlungsempfängers (PD1) ist durch das beispielhafte, nur der Verdeutlichung dienende Messsignal (MES) in den Figuren 3a, 3b, 4a, 4b, 5b, 6a, 6b und 7b verdeutlicht. Hierbei soll ein beispielhafter logischer Pegel des Messsignals (MES) von 1 beispielsweise eine Auswertung des vom ersten Strahlungsempfänger (PD1) empfangenen Signals bedeuten und ein beispielhafter logischer Pegel von 0 beispielsweise keine Auswertung des vom ersten Strahlungsempfänger (PD1) empfangenen Signals bedeuten. In dem Beispiel der Figur 4a und der Figur 4b findet diese Auswertung des vom ersten Strahlungsempfänger (PD1) empfangenen Signals nur zu zweiten Zeiten (T2) statt. Zu diesen zweiten Zeiten (T2) wird nur das Nachleuchten der Fluoreszenzstrahlung (FL, FL1) des paramagnetischen Zentrums (NV1) bzw. der Vielzahl (NVC) paramagnetischer Zentren (NV1) in dem Sensorelement, also beispielsweise des NV-Zentrums in einem oder mehreren Diamanten, erfasst. Bei richtiger Phasenlage wird das Signal der Pumpstrahlung (LB, LB1) nicht erfasst und somit von dem Fluoreszenzsignal der Fluoreszenzstrahlung (FL) getrennt.
b) Für den Fall, dass das Sensorelement eine Vielzahl (NVC) paramagnetischer Zentren (NV1) in einer hohen Dichte paramagnetischer Zentren (NV1) und eine passende, ausreichende Dicke aufweist, kann das Sensorelement selbst als erster optischer Filter (F1) dienen, da seine Absorption der Pumpstrahlung (LB, LB1a, LB1b) selbst ausreicht, um zu verhindern, dass Pumpstrahlung (LB, LB1, LB1b) den ersten Strahlungsempfänger (PD1) erreicht. Handelt es sich beispielsweise um einen Diamanten als Sensorelement mit einer Vielzahl von NV-Zentren als Vielzahl (NVC) paramagnetischer Zentren (NV1), so erscheint dieser Diamant rot. Bei ausreichender Dichte der NV-Zentren und bei einer ausreichenden Dicke des Diamanten lässt dieser für den Anwendungsfall ausreichend wenige oder gar keine grüne Pumpstrahlung (LB, LB1a, LB1b) der Pumpstrahlungsquelle (PL1), beispielsweise einer grünen LED oder eines grünen Lasers, durch.

### Figur 3

### Figur 3a

Figur 3a stellt dar, wann das Empfängerausgangssignal (S0) des ersten Strahlungsempfängers (PD1) in Relation zur Aktivität der ersten Pumpstrahlungsquelle (PL1) ausgewertet wird. Hierbei sollen eine logische 1 des beispielhaften Messsignals (MES) bedeuten, dass das Empfängerausgangssignal (S0) des ersten Strahlungsempfängers (PD1) ausgewertet wird, und eine logische 0 des beispielhaften Messsignals (MES) bedeuten, dass das Empfängerausgangssignal (S0) des ersten Strahlungsempfängers (PD1) nicht ausgewertet wird. Das in der Figur 3a gezeichnete Messsignal (MES) dient nur zur Erläuterung. In der Realisierung des Vorschlags kann ggf. die technische Realisierung abweichen, ohne inhaltlich hinsichtlich des technischen Effekts abzuweichen.

Die erste Pumpstrahlungsquelle (PL1) ist in dem Beispiel der Figur 3a zu ersten Zeiten (T1) aktiv und sendet Pumpstrahlung (LB, LB1) aus. Dies ist durch einen beispielhaften logischen Wert von 1 in der Figur 3a für die Intensität der Pumpstrahlung (LB, LB1) verdeutlicht.

Die erste Pumpstrahlungsquelle (PL1) ist in dem Beispiel der Figur 3a zu zweiten Zeiten (T2) nicht aktiv und sendet im Wesentlichen keine Pumpstrahlung (LB, LB1) aus. Dies ist durch einen beispielhaften logischen Wert von 0 in der Figur 3a für die Intensität der Pumpstrahlung (LB, LB1) verdeutlicht.

Die Pumpstrahlung (LB, LB1a, L1b) bestrahlt zumindest teilweise das paramagnetische Zentrum (NV1) bzw. die Vielzahl (NVC) paramagnetischer Zentren (NV1) des Sensorelements. Daher emittiert das paramagnetische Zentrum (NV1) bzw. die Vielzahl (NVC) paramagnetischer Zentren (NV1) Fluoreszenzstrahlung (FL, FL1). Dies geschieht mit einer zeitlichen Verzögerung. Bei einem NV-Zentrum in Diamant als paramagnetisches Zentrum (NV1) in einem Sensorelement bzw. bei einer Vielzahl von NV-Zentren als Vielzahl (NVC) paramagnetischer Zentren (NV1) in einem Sensorelement liegt diese Verzögerung in der Größenordnung von 1 ns. Daher ist das Signal der Fluoreszenzstrahlung (FL, FL1) zeitlich gegenüber dem Signal der Pumpstrahlung (LB, LB1a, L1b) um eine Fluoreszenzphasenverschiebungszeit (ΔTFL) phasenverschoben.

Das paramagnetische Zentrum (NV1) bzw. die Vielzahl (NVC) paramagnetischer Zentren (NV1) sind in dem Beispiel der Figur 3a somit zeitlich verschoben zu den ersten Zeiten (T1) aktiv und senden Fluoreszenzstrahlung (FL, FL1) aus. Dies ist durch einen beispielhaften, willkürlichen logischen Wert von 1 in der Figur 3a für die Intensität der Fluoreszenzstrahlung (FL, FL1) beispielhaft verdeutlicht.

Das paramagnetische Zentrum (NV1) bzw. die Vielzahl (NVC) paramagnetischer Zentren (NV1) sind in dem Beispiel der Figur 3a somit zeitlich verschoben zu den zweiten Zeiten (T2) nicht aktiv und senden dann keine Fluoreszenzstrahlung (FL, FL1) aus. Dies ist durch einen beispielhaften, willkürlichen logischen Wert von 0 in der Figur 3a für die Intensität der Fluoreszenzstrahlung (FL, FL1) beispielhaft verdeutlicht.

In dem Beispiel der Figur 3a erfolgt die Auswertung des Empfängerausgangssignals (S0) des ersten Strahlungsempfängers (PD1) zu ersten Zeiten (T1). Das der Verdeutlichung dienende Messsignal (MES) hat zu diesen ersten Zeiten (T1) den logischen, willkürlichen Wert 1. Daher kann bei Messsystemen mit diesem Zeitschema der Figur 3a eine Trennung des Signals der Pumpstrahlung (LB, LB1) vom Signal der Fluoreszenzstrahlung (FL, FL1) nur durch einen ersten optischen Filter (F1) oder durch eine Filterwirkung des Sensorelements mit einer Vielzahl (NVC) paramagnetischer Zentren (NV1) erreicht werden.

### Figur 3b

Figur 3b stellt dar, wann das Empfängerausgangssignal (S0) des ersten Strahlungsempfängers (PD1) in Relation zur Aktivität der ersten Pumpstrahlungsquelle (PL1) und zur Aktivität einer Kompensationsstrahlungsquelle (PLK) ausgewertet wird. Hierbei sollen wieder eine logische 1 des beispielhaften Messsignals (MES) bedeuten, dass das Empfängerausgangssignal (S0) des ersten Strahlungsempfängers (PD1) ausgewertet wird. Eine logische 0 des beispielhaften Messsignals (MES) soll bedeuten, dass das Empfängerausgangssignal (S0) des ersten Strahlungsempfängers (PD1) nicht ausgewertet wird. Das in der Figur 3b gezeichnete Messsignal (MES) dient nur zur Erläuterung. In der Realisierung des Vorschlags kann ggf. die technische Realisierung abweichen, ohne inhaltlich hinsichtlich des technischen Effekts abzuweichen.

Die erste Pumpstrahlungsquelle (PL1) ist in dem Beispiel der Figur 3b zu ersten Zeiten (T1) aktiv und sendet Pumpstrahlung (LB, LB1) aus. Dies ist durch einen beispielhaften logischen Wert von 1 in der Figur 3b für die Intensität der Pumpstrahlung (LB, LB1) verdeutlicht.

Die erste Pumpstrahlungsquelle (PL1) ist in dem Beispiel der Figur 3b zu zweiten Zeiten (T2) und zu dritten Zeiten (T3) nicht aktiv und sendet keine Pumpstrahlung (LB, LB1) aus. Dies ist durch einen beispielhaften logischen Wert von 0 in der Figur 3b für die Intensität der Pumpstrahlung (LB, LB1) verdeutlicht.

Die Kompensationsstrahlungsquelle (PLK) ist in dem Beispiel der Figur 3b zu zweiten Zeiten (T2) aktiv und sendet dann Kompensationsstrahlung (KS) aus. Dies ist durch einen beispielhaften logischen Wert von 1 in der Figur 3b für die Intensität der Kompensationsstrahlung (KS) verdeutlicht.

Die Kompensationsstrahlungsquelle (PLK) ist in dem Beispiel der Figur 3b zu ersten Zeiten (T1) nicht aktiv und sendet dann keine Kompensationsstrahlung (KS) aus. Dies ist durch einen beispielhaften logischen Wert von 0 in der Figur 3b für die Intensität der Kompensationsstrahlung (KS) verdeutlicht.

Die Pumpstrahlung (LB, LB1a, LB1b) bestrahlt zumindest teilweise das paramagnetische Zentrum (NV1) bzw. die Vielzahl (NVC) paramagnetischer Zentren (NV1) des Sensorelements. Daher emittieren das paramagnetische Zentrum (NV1) bzw. die Vielzahl (NVC) paramagnetischer Zentren (NV1) Fluoreszenzstrahlung (FL, FL1). Dies geschieht mit einer zeitlichen Verzögerung. Bei einem NV-Zentrum in Diamant als paramagnetisches Zentrum (NV1) in einem Sensorelement bzw. bei einer Vielzahl von NV-Zentren in einem oder mehreren Diamanten als Vielzahl (NVC) paramagnetischer Zentren (NV1) liegt diese Verzögerung in der Größenordnung von 1 ns. Daher ist das Signal der Fluoreszenzstrahlung (FL, FL1) um eine Fluoreszenzphasenverschiebungszeit (ΔTFL) zeitlich gegenüber dem Signal der Pumpstrahlung (LB, LB1a) phasenverschoben.

Das paramagnetische Zentrum (NV1) bzw. die Vielzahl (NVC) paramagnetischer Zentren (NV1) ist in dem Beispiel der Figur 3b somit zeitlich verschoben zu den ersten Zeiten (T1) aktiv und sendet Fluoreszenzstrahlung (FL, FL1) aus. Dies ist durch einen beispielhaften, willkürlichen logischen Wert von 1 in der Figur 3b für die Intensität der Fluoreszenzstrahlung (FL, FL1) beispielhaft verdeutlicht.

Das paramagnetische Zentrum (NV1) bzw. die Vielzahl (NVC) paramagnetischer Zentren (NV1) ist in dem Beispiel der Figur 3b somit zeitlich verschoben zu den zweiten Zeiten (T2) nicht aktiv und sendet dann keine Fluoreszenzstrahlung (FL, FL1) aus. Dies ist durch einen beispielhaften, willkürlichen logischen Wert von 0 in der Figur 3b für die Intensität der Fluoreszenzstrahlung (FL, FL1) beispielhaft verdeutlicht.

Die Kompensationsstrahlung (KS) erzeugt bevorzugt keine Wechselwirkung mit dem paramagnetischen Zentrum (NV1) bzw. der Vielzahl (NVC) paramagnetischer Zentren (NV1).

In dem Beispiel der Figur 3b erfolgt die Auswertung des Empfängerausgangssignals (S0) des ersten Strahlungsempfängers (PD1) wieder zu ersten Zeiten (T1). Das der Verdeutlichung dienende Messsignal (MES) hat zu diesen ersten Zeiten (T1) den logischen, willkürlichen Wert 1. Daher kann bei Messsystemen mit diesem Zeitschema der Figur 3b eine Trennung des Signals der Pumpstrahlung (LB, LB1) vom Signal der Fluoreszenzstrahlung (FL, FL1) nur durch einen ersten optischen Filter (F1) oder durch eine Filterwirkung des Sensorelements mit den paramagnetischen Zentren (NV1) bzw. mit der Vielzahl (NVC) paramagnetischer Zentren (NV1) erreicht werden.

### Figur 4

### Figur 4a

Figur 4a stellt dar, wann das Empfängerausgangssignal (S0) des ersten Strahlungsempfängers (PD1) in Relation zur Aktivität der ersten Pumpstrahlungsquelle (PL1) ausgewertet wird. Hierbei sollen eine logische 1 des beispielhaften Messsignals (MES) bedeuten, dass das Empfängerausgangssignal (S0) des ersten Strahlungsempfängers (PD1) ausgewertet wird, und eine logische 0 des beispielhaften Messsignals (MES) bedeuten, dass das Empfängerausgangssignal (S0) des ersten Strahlungsempfängers (PD1) nicht ausgewertet wird. Das in der Figur 4a gezeichnete Messsignal (MES) dient nur zur Erläuterung. In der Realisierung des Vorschlags kann ggf. die technische Realisierung abweichen, ohne inhaltlich hinsichtlich des technischen Effekts abzuweichen.

Die erste Pumpstrahlungsquelle (PL1) ist in dem Beispiel der Figur 4a zu ersten Zeiten (T1) aktiv und sendet Pumpstrahlung (LB, LB1) aus. Dies ist durch einen beispielhaften logischen Wert von 1 in der Figur 4a für die Intensität der Pumpstrahlung (LB, LB1) verdeutlicht.

Die erste Pumpstrahlungsquelle (PL1) ist in dem Beispiel der Figur 4a zu zweiten Zeiten (T2) nicht aktiv und sendet keine Pumpstrahlung (LB, LB1) aus. Dies ist durch einen beispielhaften logischen Wert von 0 in der Figur 4a für die Intensität der Pumpstrahlung (LB, LB1) verdeutlicht.

Die Pumpstrahlung (LB, LB1) bestrahlt zumindest teilweise das paramagnetische Zentrum (NV1) des Sensorelements bzw. die Vielzahl (NVC) paramagnetischer Zentren (NV1) des Sensorelements. Daher emittieren das paramagnetische Zentrum (NV1) bzw. die Vielzahl (NVC) paramagnetischer Zentren (NV1) Fluoreszenzstrahlung (FL, FL1). Dies geschieht mit einer zeitlichen Verzögerung. Bei einem NV-Zentrum in Diamant als paramagnetisches Zentrum (NV1) in einem Sensorelement bzw. einer Vielzahl von NV-Zentren in einem oder mehreren Diamanten als Vielzahl (NVC) paramagnetischer Zentren (NV1) liegt diese Verzögerung in der Größenordnung von 1 ns. Daher ist das Signal der Fluoreszenzstrahlung (FL, FL1) um eine Fluoreszenzphasenverschiebungszeit (ΔTFL) zeitlich gegenüber dem Signal der Pumpstrahlung (LB, LB1) phasenverschoben.

Das paramagnetische Zentrum (NV1) bzw. die Vielzahl (NVC) paramagnetischer Zentren (NV1) sind in dem Beispiel der Figur 4a somit zeitlich verschoben zu den ersten Zeiten (T1) aktiv und senden Fluoreszenzstrahlung (FL, FL1) zeitlich verschoben zu den ersten Zeiten (T1) aus. Dies ist durch einen beispielhaften, willkürlichen, logischen Wert von 1 in der Figur 4a für die Intensität der Fluoreszenzstrahlung (FL, FL1) beispielhaft verdeutlicht.

Das paramagnetische Zentrum (NV1) bzw. die Vielzahl (NVC) paramagnetischer Zentren (NV1) sind in dem Beispiel der Figur 4a somit zeitlich verschoben zu den zweiten Zeiten (T2) nicht aktiv und senden dann zeitlich verschoben zu den zweiten Zeiten (T2) keine Fluoreszenzstrahlung (FL, FL1) aus. Dies ist durch einen beispielhaften, willkürlichen logischen Wert von 0 in der Figur 4a für die Intensität der Fluoreszenzstrahlung (FL, FL1) beispielhaft verdeutlicht.

In dem Beispiel der Figur 4a erfolgt die Auswertung des Empfängerausgangssignals (S0) des ersten Strahlungsempfängers (PD1) im Gegensatz zur Figur 3a nun jedoch zu zweiten Zeiten (T2). Das der Verdeutlichung dienende Messsignal (MES) hat zu diesen zweiten Zeiten (T2) den logischen, willkürlichen Wert 1. Daher kann bei Messsystemen mit diesem Zeitschema der Figur 4a eine Trennung des Signals der Pumpstrahlung (LB, LB1) vom Signal der Fluoreszenzstrahlung (FL, FL1) im Gegensatz zur Figur 3a auch ohne einen ersten optischen Filter (F1) und ohne eine Filterwirkung des Sensorelements mit den paramagnetischen Zentren (NV1) bzw. mit Clustern paramagnetischer Zentren (NV1) mit jeweils Vielzahl (NVC) paramagnetischer Zentren (NV1) erreicht werden. Allerdings wird nur der Teil der Fluoreszenzstrahlung (FL, FL1) erfasst, der zeitlich in die zweiten Zeiten (T2) fällt. Dies kann eine verschlechterte Empfindlichkeit zur Folge haben.

### Figur 4b

Figur 4b stellt dar, wann das Empfängerausgangssignal (S0) des ersten Strahlungsempfängers (PD1) in Relation zur Aktivität der ersten Pumpstrahlungsquelle (PL1) und zur Aktivität einer Kompensationsstrahlungsquelle (PLK) ausgewertet wird. Hierbei sollen wieder eine logische 1 des beispielhaften Messsignals (MES) bedeuten, dass das Empfängerausgangssignal (S0) des ersten Strahlungsempfängers (PD1) ausgewertet wird, und eine logische 0 des beispielhaften Messsignals (MES) bedeuten, dass das Empfängerausgangssignal (S0) des ersten Strahlungsempfängers (PD1) nicht ausgewertet wird. Das in der Figur 4b gezeichnete Messsignal (MES) dient wieder nur zur Erläuterung. In der Realisierung des Vorschlags kann ggf. die technische Realisierung abweichen, ohne inhaltlich hinsichtlich des technischen Effekts abzuweichen.

Die erste Pumpstrahlungsquelle (PL1) ist in dem Beispiel der Figur 4b zu ersten Zeiten (T1) aktiv und sendet Pumpstrahlung (LB, LB1) aus. Dies ist durch einen beispielhaften logischen Wert von 1 in der Figur 4b für die Intensität der Pumpstrahlung (LB, LB1) verdeutlicht.

Die erste Pumpstrahlungsquelle (PL1) ist in dem Beispiel der Figur 4b zu zweiten Zeiten (T2) nicht aktiv und sendet keine Pumpstrahlung (LB, LB1) aus. Dies ist durch einen beispielhaften logischen Wert von 0 in der Figur 4b für die Intensität der Pumpstrahlung (LB, LB1) verdeutlicht.

Die Kompensationsstrahlungsquelle (PLK) ist in dem Beispiel der Figur 4b zu zweiten Zeiten (T2) aktiv und sendet dann Kompensationsstrahlung (KS) aus. Dies ist durch einen beispielhaften logischen Wert von 1 in der Figur 4b für die Intensität der Kompensationsstrahlung (KS) verdeutlicht.

Die Kompensationsstrahlungsquelle (PLK) ist in dem Beispiel der Figur 4b zu ersten Zeiten (T1) nicht aktiv und sendet dann keine Kompensationsstrahlung (KS) aus. Dies ist durch einen beispielhaften logischen Wert von 0 in der Figur 4b für die Intensität der Kompensationsstrahlung (KS) verdeutlicht.

Die Pumpstrahlung (LB, LB1) bestrahlt zumindest teilweise das paramagnetische Zentrum (NV1) des Sensorelements bzw. die Vielzahl (NVC) der paramagnetischen Zentren (NV1) des Sensorelements. Daher emittiert das paramagnetische Zentrum (NV1) bzw. die Vielzahl (NVC) paramagnetischer Zentren (NV1) Fluoreszenzstrahlung (FL, FL1). Dies geschieht mit einer zeitlichen Verzögerung. Bei einem NV-Zentrum in Diamant als paramagnetisches Zentrum (NV1) in einem Sensorelement bzw. bei einer Vielzahl von NV-Zentren in einem oder mehreren Diamanten als Vielzahl (NVC) paramagnetischer Zentren (NV1) liegt diese Verzögerung in der Größenordnung von 1 ns. Daher ist das Signal der Fluoreszenzstrahlung (FL) um eine Fluoreszenzphasenverschiebungszeit (ΔTFL) zeitlich gegenüber dem Signal der Pumpstrahlung (LB, LB1) phasenverschoben.

Das paramagnetische Zentrum (NV1) bzw. die Vielzahl (NVC) paramagnetischer Zentren (NV1) sind in dem Beispiel der Figur 4b somit zeitlich verschoben zu den ersten Zeiten (T1) aktiv und senden Fluoreszenzstrahlung (FL, FL1) aus. Dies ist durch einen beispielhaften, willkürlichen logischen Wert von 1 in der Figur 4b für die Intensität der Fluoreszenzstrahlung (FL, FL1) beispielhaft verdeutlicht.

Das paramagnetische Zentrum (NV1) bzw. die Vielzahl (NVC) paramagnetischer Zentren (NV1) sind in dem Beispiel der Figur 4b somit zeitlich verschoben zu den zweiten Zeiten (T2) nicht aktiv und senden dann keine Fluoreszenzstrahlung (FL, FL1) aus. Dies ist durch einen beispielhaften, willkürlichen logischen Wert von 0 in der Figur 4b für die Intensität der Fluoreszenzstrahlung (FL, FL1) beispielhaft verdeutlicht.

Die Kompensationsstrahlung (KS) erzeugt bevorzugt keine Wechselwirkung mit dem paramagnetischen Zentrum (NV1) bzw. der Vielzahl (NVC) paramagnetischer Zentren (NV1).

In dem Beispiel der Figur 4b erfolgt die Auswertung des Empfängerausgangssignals (S0) des ersten Strahlungsempfängers (PD1) nun im Gegensatz zu dem Zeitschema der Figur 3b zu zweiten Zeiten (T2). Das der Verdeutlichung dienende Messsignal (MES) hat zu diesen zweiten Zeiten (T2) im Gegensatz zur dem Zeitschema der Figur 3b den logischen, willkürlichen Wert 1. Daher kann bei Messsystemen mit diesem Zeitschema der Figur 4b eine Trennung des Signals der Pumpstrahlung (LB, LB1) vom Signal der Fluoreszenzstrahlung (FL, FL1) auch ohne einen ersten optischen Filter (F1) und ohne eine Filterwirkung des Sensorelements mit den paramagnetischen Zentren (NV1) bzw. den Clustern mit jeweils einer Vielzahl (NVC) paramagnetischer Zentren (NV1) erreicht werden.

Aus der WO 2016 / 118 791 A1 ist ein NV-Zentren basierendes Magnetometer bekannt, das mittels Spin-Manipulationen ein magnetisches Feld vermessen kann. Der Nachteil der Vorrichtung der WO 2016 / 118 791 A1 ist a) dass sie der Steuerung durch Mikrowellen bedarf, was die Biokompatibilität einschränkt und die entsprechenden Schaltkreise verteuert, und b) einer hoch genauen Ausrichtung des Kristalls bei der Fertigung bedarf. In der WO 2016/ 118 791 A1 wird dies u.a. durch ein System aus Helmholzspulen gelöst, die ein Bias-Feld geeignet ausrichten.

Aus Huijie Zheng et al. "Microwave-free vector magnetometry with nitrogen-vacancy centers along a single axis in diamond" ist eine Vermessung von Magnetfeldern ohne Mikrowellenansteuerung mit Hilfe der besagten Helmholzspulen bekannt.

Aus der Schrift WO 2018 / 2267 784 A2 ist die Vermessung von Magnetfeldern mit Bias-Magneten bekannt, die einen magnetischen Arbeitspunkt einstellen.

### Weiterentwicklung des unveröffentlichten Stands der Technik

### Figur 5

### Figur 5b

Figur 5b stellt dar, wann das Empfängerausgangssignal (S0) des ersten Strahlungsempfängers (PD1) in Relation zur Aktivität der ersten Pumpstrahlungsquelle (PL1) und zur Aktivität einer Kompensationsstrahlungsquelle (PLK) ausgewertet wird. Hierbei sollen wieder eine logische 1 des beispielhaften Messsignals (MES) bedeuten, dass das Empfängerausgangssignal (S0) des ersten Strahlungsempfängers (PD1) ausgewertet wird, und eine logische 0 des beispielhaften Messsignals (MES) bedeuten, dass das Empfängerausgangssignal (S0) des ersten Strahlungsempfängers (PD1) nicht ausgewertet wird. Das in der Figur 5b gezeichnete Messsignal (MES) dient wieder nur zur Erläuterung. In der Realisierung des Vorschlags kann ggf. die technische Realisierung abweichen, ohne inhaltlich hinsichtlich des technischen Effekts abzuweichen.

Die erste Pumpstrahlungsquelle (PL1) ist in dem Beispiel der Figur 5b zu ersten Zeiten (T1) aktiv und sendet Pumpstrahlung (LB, LB1) aus. Dies ist durch einen beispielhaften logischen Wert von 1 in der Figur 5b für die Intensität der Pumpstrahlung (LB, LB1) verdeutlicht.

Die erste Pumpstrahlungsquelle (PL1) ist in dem Beispiel der Figur 5b zu zweiten Zeiten (T2) und zu dritten Zeiten (T3) nicht aktiv und sendet keine Pumpstrahlung (LB, LB1) aus. Dies ist durch einen beispielhaften logischen Wert von 0 in der Figur 5b für die Intensität der Pumpstrahlung (LB, LB1) verdeutlicht.

Die Kompensationsstrahlungsquelle (PLK) ist in dem Beispiel der Figur 5b zu dritten Zeiten (T3) aktiv und sendet dann Kompensationsstrahlung (KS) aus. Dies ist durch einen beispielhaften logischen Wert von 1 in der Figur 5b für die Intensität der Kompensationsstrahlung (KS) verdeutlicht.

Die Kompensationsstrahlungsquelle (PLK) ist in dem Beispiel der Figur 5b zu ersten Zeiten (T1) und zweiten Zeiten (T2) nicht aktiv und sendet dann keine Kompensationsstrahlung (KS) aus. Dies ist durch einen beispielhaften logischen Wert von 0 in der Figur 5b für die Intensität der Kompensationsstrahlung (KS) verdeutlicht.

Die Pumpstrahlung (LB, LB1) bestrahlt zumindest teilweise das paramagnetische Zentrum (NV1) des Sensorelements bzw. die Vielzahl (NVC) paramagnetischer Zentren (NV1) des Sensorelements. Daher emittiert das paramagnetische Zentrum (NV1) bzw. die Vielzahl (NVC) paramagnetischer Zentren (NV1) Fluoreszenzstrahlung (FL, FL1). Dies geschieht mit einer zeitlichen Verzögerung. Bei einem NV-Zentrum in Diamant als paramagnetisches Zentrum (NV1) in einem Sensorelement bzw. einer Vielzahl von NV-Zentren in einem oder mehreren Diamanten als Vielzahl (NVC) paramagnetischer Zentren (NV1) liegt diese Verzögerung in der Größenordnung von 1 ns. Daher ist das Signal der Fluoreszenzstrahlung (FL, FL1) um eine Fluoreszenzphasenverschiebungszeit (ΔTFL) zeitlich gegenüber dem Signal der Pumpstrahlung (LB, LB1) phasenverschoben.

Das paramagnetische Zentrum (NV1) bzw. die Vielzahl (NVC) paramagnetischer Zentren (NV1) sind in dem Beispiel der Figur 5b somit zeitlich verschoben zu den ersten Zeiten (T1) aktiv und senden Fluoreszenzstrahlung (FL, FL1) aus. Dies ist durch einen beispielhaften, willkürlichen logischen Wert von 1 in der Figur 5b für die Intensität der Fluoreszenzstrahlung (FL, FL1) beispielhaft verdeutlicht.

Das paramagnetische Zentrum (NV1) bzw. die Vielzahl (NVC) paramagnetischer Zentren (NV1) sind in dem Beispiel der Figur 5b somit zeitlich verschoben zu den zweiten Zeiten (T2) und den dritten Zeiten (T3) nicht aktiv und senden dann keine Fluoreszenzstrahlung (FL, FL1) aus. Dies ist durch einen beispielhaften, willkürlichen logischen Wert von 0 in der Figur 5b für die Intensität der Fluoreszenzstrahlung (FL, FL1) beispielhaft verdeutlicht.

Die Kompensationsstrahlung (KS) erzeugt bevorzugt keine Wechselwirkung mit dem paramagnetischen Zentrum (NV1) bzw. mit der Vielzahl (NVC) paramagnetischer Zentren (NV1).

In dem Beispiel der Figur 5b erfolgt die Auswertung des Empfängerausgangssignals (S0) des ersten Strahlungsempfängers (PD1) nun im Gegensatz zur dem Zeitschema der Figur 3b zu zweiten Zeiten (T2). Das der Verdeutlichung dienende Messsignal (MES) hat zu diesen zweiten Zeiten (T2) im Gegensatz zur dem Zeitschema der Figur 3b den logischen, willkürlichen Wert 1.

Die Kompensation durch die Kompensationsstrahlung (KS) erfolgt nun aber zu dritten Zeiten (T3), die von den zweiten Zeiten (T2) und ersten Zeiten (T1) verschieden sind.

Daher kann bei Messsystemen mit diesem Zeitschema der Figur 5b eine Trennung des Signals der Pumpstrahlung (LB, LB1) vom Signal der Fluoreszenzstrahlung (FL, FL1) auch ohne einen ersten optischen Filter (F1) und ohne eine Filterwirkung des Sensorelements mit den paramagnetischen Zentren (NV1) bzw. mit der Vielzahl (NVC) paramagnetischer Zentren (NV1) erreicht werden. Insbesondere vermeidet dieses Zeitschema eine Störung des ersten Strahlungsempfängers (PD1) durch die Kompensationsstrahlung (KS) während der Auswertung der Fluoreszenzstrahlung (FL, FL1)

### Figur 6

### Figur 6a

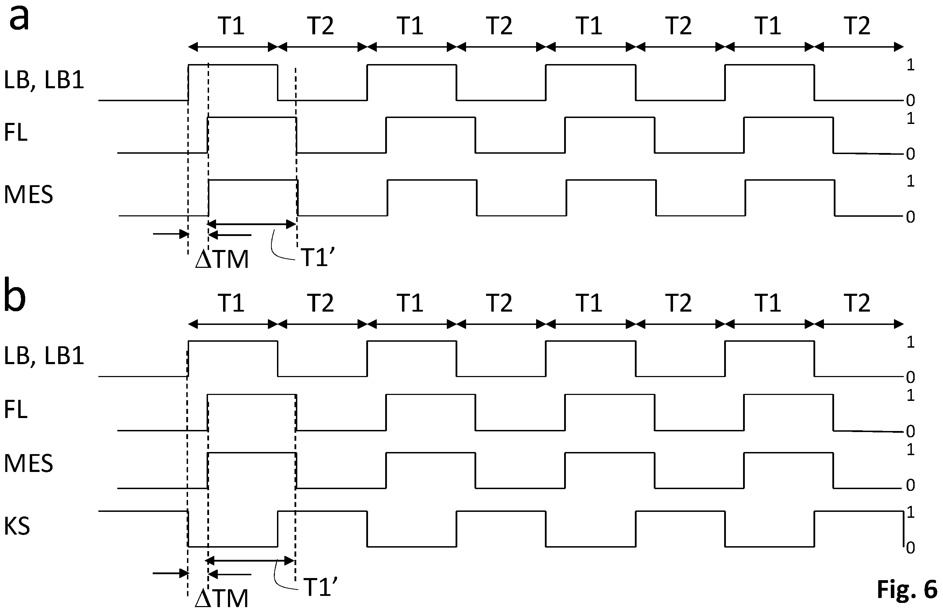

Das Zeitschema der Figur 6a entspricht dem Zeitschema der Figur 3a mit dem Unterschied, dass das Messsignal (MES) dem Signal der Pumpstrahlung (LB, LB1) verschoben um eine Messphasenverschiebungszeit (ΔTM) entspricht. Die Figur 6a ist somit eine Mischung der Figur 3a und der Figur 4a.

### Figur 6b

Das Zeitschema der Figur 6b entspricht dem Zeitschema der Figur 3b mit dem Unterschied, dass das Messsignal (MES) dem Signal der Pumpstrahlung (LB, LB1) verschoben um eine Messphasenverschiebungszeit (ΔTM) entspricht. Die Figur 6b ist somit eine Mischung der Figur 3b und der Figur 4b.

### Figur 7

### Figur 7b

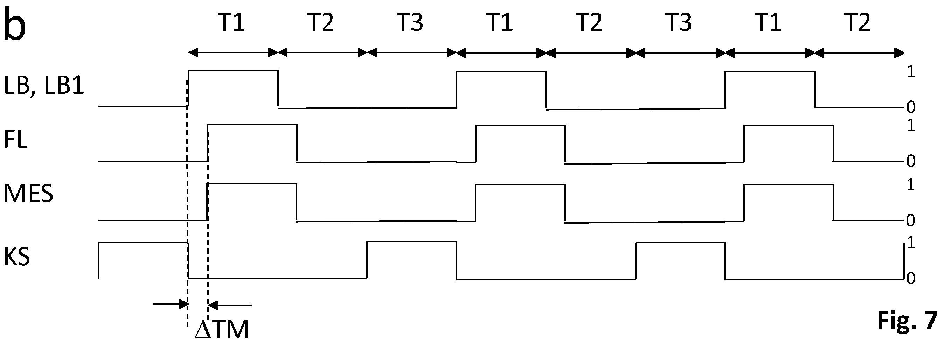

Das Zeitschema der Figur 7b entspricht dem Zeitschema der Figur 5b mit dem Unterschied, dass das Messsignal (MES) dem Signal der Pumpstrahlung (LB, LB1) verschoben um eine Messphasenverschiebungszeit (ΔTM) entspricht.

### Figur 8

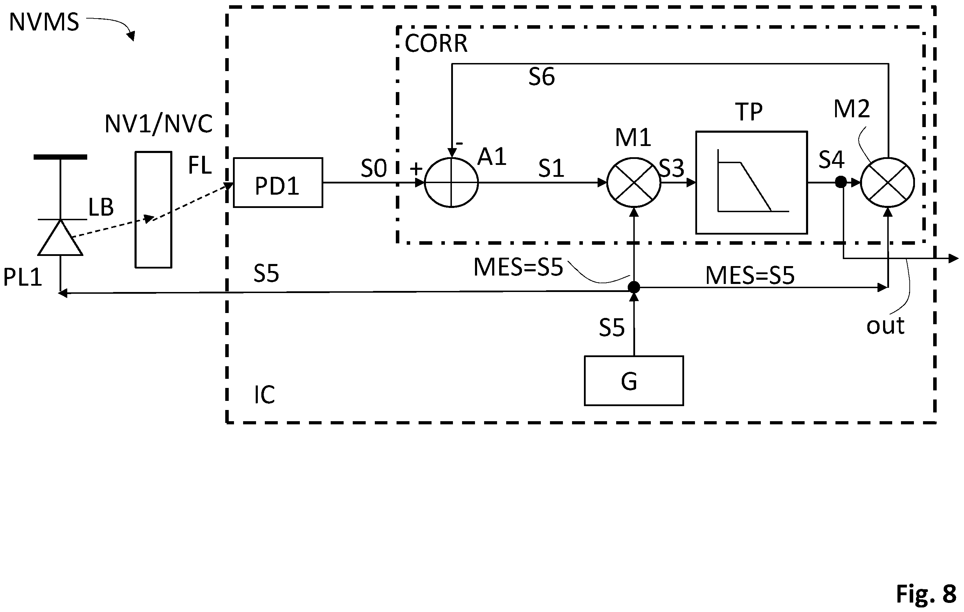

Die Figur 8 stellt schematisch vereinfacht ein besonders einfaches Auswertungssystem für die Fluoreszenzstrahlung (FL) des paramagnetischen Zentrums (NV1) des Sensorelements bzw. der Vielzahl (NVC) paramagnetischer Zentren (NV1) des Sensorsystems dar. Bevorzugt handelt es sich um mehrere paramagnetische Zentren (NV1) und mehrere Sensorelemente. In einer besonders bevorzugten Variante handelt es sich bei dem Sensorelement um einen Diamanten und bei dem paramagnetischen Zentrum (NV1) um ein NV-Zentrum. In einer weiteren beispielhaften Variante umfasst das Sensorelement einen oder mehrere Diamanten und eine Vielzahl (NVC) paramagnetischer Zentren (NV1), wobei auch hier NV-Zentren als paramagnetische Zentren (NV1) bevorzugt sind. In einer weiteren beispielhaften Variante handelt es sich bei dem Sensorelement um eine Vielzahl von Diamanten, die bevorzugt zu einem Sensorelement verbunden sind, und bei dem paramagnetischen Zentrum (NV1) um eine Vielzahl (NVC) paramagnetischer Zentren (NV1), wobei auch hier NV-Zentren als paramagnetische Zentren (NV1) bevorzugt sind.

In einer typischen Variante umfasst das System eine erste Pumpstrahlungsquelle (PL1), das mindestens eine paramagnetische Zentrum (NV1) in mindestens einem Sensorelement und/oder eine Vielzahl (NVC) paramagnetischer Zentren (NV1) in mindestens einem Sensorelement und eine Auswerteschaltung, hier in Form des integrierten Schaltkreises (IC). Die erste Pumpstrahlungsquelle (PL1) wird mit dem Sendesignal (S5) eines Signalgenerators (G) moduliert und mit Energie versorgt. Im Falle der Verwendung von NV-Zentren in Diamant als paramagnetische Zentren (NV1) handelt es sich bei der ersten Pumpstrahlungsquelle (PL1) bevorzugt um eine grüne Lichtquelle, die das paramagnetische Zentrum, beispielsweise ein NV-Zentrum, (NV1) mittels ihrer Pumpstrahlung (LB) zur Abgabe von typischerweise roter Fluoreszenzstrahlung (FL) veranlassen kann. Insbesondere sind in diesem Falle grüne Laserdioden und LEDs gut als Pumpstrahlungsquellen (PL1) geeignet.

Im Falle von NV-Zentren in Diamant oder in Diamanten ist eine Laser-Diode der Fa. Osram vom Typ PLT5 520B beispielsweise als erste Pumpstrahlungsquelle (PL1) mit 520 nm Pumpstrahlungswellenlänge (λₚₘₚ) geeignet. Die Pumpstrahlung (LB) der ersten Pumpstrahlungsquelle (PL1) sollte bei der Verwendung von NV-Zentren als paramagnetischen Zentren (NV1) eine Pumpstrahlungswellenlänge (λₚₘₚ) in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Pumpstrahlung (LB) dieser Funktion wird hier als "grüne" Pumpstrahlung (LB) bezeichnet. Bevorzugt ist bei der Verwendung von NV-Zentren eindeutig eine Wellenlänge von 532 nm als Pumpstrahlungswellenlänge (λₚₘₚ) der Pumpstrahlung (LB). 520 nm wurden auch erfolgreich verwendet. Die erste Pumpstrahlungsquelle (PL1) ist aus Kostengründen bevorzugt eine lichtemittierende Diode oder ein Laser, die im Folgenden auch gemeinschaftlich vereinfachend als LED bezeichnet werden. Es ist denkbar, andere Leuchtmittel, z.B. organische lichtemittierende Dioden (OLEDs) oder elektrolumineszierende Vorrichtungen, als Pumpstrahlungsquellen (PL1) einzusetzen. Der Einsatz von LEDs als Pumpstrahlungsquellen (PL1) ist derzeit aber eindeutig vorteilhafter.

Die erste Pumpstrahlungsquelle (PL1) emittiert in Abhängigkeit von dem Sendesignal (S5) eine Pumpstrahlung (LB). Im Falle von NV-Zentren als paramagnetische Zentren (NV1) ist diese Pumpstrahlung (LB) bevorzugt grünes Licht.

Diese Pumpstrahlung (LB) veranlasst das paramagnetische Zentrum (NV1) bzw. die Vielzahl (NVC) paramagnetischer Zentren (NV1) zur Abgange von Fluoreszenzstrahlung (FL), die von der auf das paramagnetische Zentrum (NV1) bzw. die Vielzahl (NVC) paramagnetischer Zentren (NV1) eingestrahlten Pumpstrahlung (LB) und typischerweise von der magnetischen Flussdichte (B) am Ort des jeweiligen paramagnetischen Zentrums (NV1) und ggf. weiteren physikalischen Parametern abhängt.

Weitere physikalische Parameter neben der magnetischen Flussdichte (B), die ggf. mittels der Intensität I_{fl}) der Fluoreszenzstrahlung (FL) des paramagnetischen Zentrums (NV1) bzw. der Vielzahl (NVC) paramagnetischer Zentren (NV1) auf diese Weise gemessen werden könnten, wären beispielsweise elektrische Flussdichte D, Beschleunigung a, Gravitationsfeldstärke g, Druck P, Temperatur 9, Rotationsgeschwindigkeit ω, Schwingfrequenz mechanischer Teile (Balken), Position, Intensität ionisierender Strahlung etc.

Durch die Erfassung eines Werts, welcher der Intensität der Fluoreszenzstrahlung (FL) und/oder eines Werts der Fluoreszenzphasenverschiebungszeit (ΔTFL) entspricht, kann somit ein Wert als Messwert für einen Wert einer oder mehrere dieser physikalischen Größen ermittelt werden.

Ist bei der Verwendung mehrerer paramagnetischen Zentren (NV1) in Form einer Vielzahl (NVC) paramagnetischer Zentren (NV1) die Dichte dieser mehreren paramagnetischen Zentren (NV1) in dem Sensorelement sehr hoch, so können zwei oder mehr paramagnetische Zentren (NV1) der Vielzahl (NVC) paramagnetischer Zentren (NV1) miteinander koppeln. Es hat sich gezeigt, dass es hierdurch zu Koppeleffekten kommen kann. Wird gleichzeitig die Intensität der Pumpstrahlung (LB) am Ort der paramagnetischen Zentren (NV1) der Vielzahl (NVC) paramagnetischer Zentren (NV1), sehr hoch, so kommt es zu einer Verstärkung der Wechselwirkung mit einer magnetischen Flussdichte (B) am Ort des paramagnetischen Zentrums (NV1) bzw. der Vielzahl paramagnetischer Zentren (NV1). Dies ist insbesondere im Falle der Verwendung von NV-Zentren in Diamant als paramagnetische Zentren (NV1) besonders vorteilhaft. Vorzugweise handelt es sich im Falle der Verwendung von NV-Zentren in Diamant als paramagnetische Zentren (NV1) bei dem Sensorelement um einen Diamanten mit hoher NV-Dichte und zwar vorzugsweise um einen mittels High-Pressure-High-Temperature künstlich erzeugten Diamanten mit vorzugsweise einem Gehalt von NV-Zentren als paramagnetische Zentren (NV1) in einem Konzentrationsbereich von 0,1 ppm bis 500 ppm und zwar bevorzugt von mehr als 50 ppm, besser mehr als 100 ppm, besser mehr als 200 ppm. Insofern hängt die Fluoreszenzstrahlung (FL) nicht unbedingt linear von der Intensität der einfallenden Pumpstrahlung (LB) ab. Für kleine Amplituden kann die Abhängigkeit aber linerarisiert werden.

In dem Beispiel der Figur 8 wird das Sensorelement mit den paramagnetischen Zentren (NV1) so dick und die Gesamtanzahl der paramagnetischen Zentren (NV1) im Strahlengang der Pumpstrahlung (LB) als Vielzahl (NVC) paramagnetischer Zentren (NV1) so hoch gewählt, dass durch die Absorption der Pumpstrahlung (LB) durch die paramagnetischen Zentren (NV1) der Vielzahl (NVC) paramagnetischer Zentren (NV1) des Sensorelements praktisch keine Pumpstrahlung (LB) mehr den im Strahlengang nachfolgenden ersten Strahlungsempfänger (PD1) erreicht. Damit wirkt in diesem Beispiel das Sensorelement mit den paramagnetischen Zentren (NV1) im Strahlengang der Pumpstrahlung (LB) wie ein erstes optisches Filter (F1), dass das Signal der Pumpstrahlung (LB) von dem Signal der Fluoreszenzstrahlung (FL) trennt. Somit ist in diesem Beispiel unter der Voraussetzung einer ausreichenden Menge an paramagnetischen Zentren (NV1) im Strahlengang der Pumpstrahlung (LB) kein erstes optisches Filter (F1) mehr notwendig. Es kann somit das Zeitschema der Figur 3a angewendet werden.

Der erste Strahlungsempfänger (PD1) empfängt überlagernd das Signal der Fluoreszenzstrahlung (FL) der paramagnetischen Zentren (NV1) bzw. der Vielzahl (NVC) paramagnetischer Zentren (NV1) des Sensorelements sowie das Signal der nicht weggefilterten Anteile der Pumpstrahlung (LB) - sofern die Anordnung in dieser Hinsicht nicht perfekt sein sollte - und erzeugt aus dem Gesamtsignal das Empfängerausgangssignal (S0) in Abhängigkeit von dem Signal der Intensität der Fluoreszenzstrahlung (FL) der paramagnetischen Zentren (NV1) bzw. der Vielzahl (NVC) der paramagnetischen Zentren (NV1) des Sensorelements sowie des Signals der Intensität der nicht weggefilterten Anteile der Pumpstrahlung (LB).

Bevorzugt ist die Filterwirkung des Sensorelements mit den paramagnetischen Zentren (NV1) bzw. der Vielzahl (NVC) paramagnetischer Zentren (NV1) hinsichtlich der Filterung der Pumpstrahlung (LB) derart ausgelegt, dass die Intensität der nicht weggefilterten Anteile der Pumpstrahlung (LB) vernachlässigt werden kann und hier näherungsweise zu Null angenommen werden kann.

Bevorzugt ist die Filterwirkung des Sensorelements mit den paramagnetischen Zentren (NV1) bzw. der Vielzahl (NVC) paramagnetischer Zentren (NV1) hinsichtlich der Filterung der Fluoreszenzstrahlung (FL) derart ausgelegt, dass die Intensität der weggefilterten Anteile der Fluoreszenzstrahlung (FL) vernachlässigt werden kann und hier näherungsweise zu Null angenommen werden kann, die Fluoreszenzstrahlung (FL) durch das Sensorelement also im Wesentlichen für die Funktion des Systems nicht in relevanter Weise gefiltert wird.

Der erste Strahlungsempfänger (PD1) kann noch weitere Verstärker und/oder Filter und/oder andere Signalaufbereitungen umfassen, die zur Vereinfachung hier nicht weiter diskutiert werden.

Ein Korrelator (CORR) korreliert das reduzierte Empfängerausgangssignal (S1) mit dem Messsignal (MES). Ein Subtrahierer (A1) subtrahiert von dem Empfängerausgangssignal (S0) in dem Bespiel der Figur 8 ein Rückkoppelsignal (S6) und bildet so das reduzierte Empfängerausgangssignal (S1).

Das Ausgangssignal des Korrelators (CORR) ist ein Filterausgangssignal (S4), das angibt, wieviel des Messsignals (MES), das hier gleich dem Sendesignal (S5) ist, in dem Empfängerausgangssignal (S0) enthalten ist. In dem Beispiel der Figur 8 wird es als Ausgangssignal (out) des Sensorsystems verwendet.

In dem Beispiel der Figur 8 führt ein Synchrondemodulator aus einem ersten Multiplizierer (M1) und einem Filter (TP) die eigentliche Korrelation des Korrelators (CORR) beispielhaft aus. Es kann aber auch ein anderer Verarbeitungsblock, wie beispielsweise ein lineares Optimalfilter, als Korrelator (CORR) verwendet werden, das auf das Sendesignal (S5) optimiert ist. In dem Beispiel der Figur 8 soll der Filter (TP) ein Tiefpassfilter sein. Der Ausgang des Filters (TP), wird bevorzugt mit einer getakteten Halteschaltung (Englisch: Sample & Hold-Schaltung) versehen, die den Ausgangswert des Filters zum Ende einer Wiederholungsperiode des Sendesignals (S5) erfasst und einfriert und als Filterausgangssignal (S4) an die nachfolgenden Stufen im Signalpfad weitergibt.

Der erste Multiplizierer (M1) multipliziert in dem Beispiel der Figur 8 das reduzierte Empfängerausgangssignal (S1) mit dem Messsignal (MES), das hier gleich dem Sendesignal (S5) ist, und erzeugt so das Filtereingangssignal (S3). Der Filter (TP), der in dem Beispiel der Figur 8 ein Tiefpassfilter sein soll, filtert das Filtereingangssignal (S3) zum Filterausgangsignal (S4). Der Filter sollte bevorzugt im Wesentlichen eine integrierende Eigenschaft haben. Dabei steht wirkmäßig die integrierende Wirkung des Filters (TP) im Vordergrund, der hierdurch im Zusammenwirken mit der nicht gezeichneten und bevorzugt verwendeten Sample & Hold-Ausgangsschaltung des Filters (TP) ein zeitliches Integral während der zeitlichen Dauer einer Sendesignalperiode des Sendesignals (S5) über das Produkt aus Messsignal (MES), hier gleich dem Sendesignal (S5), einerseits und dem reduzierten Empfängerausgangssignal (S1) andererseits, bildet. Dies entspricht einem Skalar-Produkt in der sogenannten L2-Form aus dem reduzierten Empfängerausgangssignal (S1) und dem Messsignal (MES). Damit wird durch den ersten Multiplizierer (M1) und den vorzugsweise integrierenden Filter (TP) mathematisch ein Skalar-Produkt und damit ein Hilbert-Raum oder zumindest ein Banach-Raum definiert. Die Vektoren innerhalb dieses Banach-Raumes sind die Signale. Da nur eine endliche Menge an Messsignalen verwendet werden kann, handelt es sich in der Regel um einen Banach-Raum. Der zweite Multiplizierer (M2) rekonstruiert durch die Multiplikation des Filterausgangssignals (S4) mit dem Messsignal (MES), das hier gleich dem Sendesignal (S5) ist, den verstärkten Anteil des Messsignals (MES) im Empfängerausgangssignal (S0) als Rückkoppelsignal (S6). Ist die Verstärkung des Filters (TP) sehr groß, so enthält dann das reduzierte Empfängerausgangssignal (S1) fast keinen Anteil des Messsignals (MES) mehr. Das reduzierte Empfängerausgangssignal (S1) ist dann typischerweise im Idealfall in etwa ein Gleichsignal. Natürlich zeigt das System noch Regelfehler und Systemrauschen, die hier zunächst nicht betrachtet und vernachlässigt werden.

Statt der Skalar-Produktbildung durch den ersten Multiplizierer (M1) und das integrierende Filter (TP) können auch andere Skalar-Produkte anderer Skalar-Produktbildungsvorrichtungen verwendet werden. Sie müssen nur einen Banach-Raum für Signale ermöglichen.

Der Wert des Filterausgangssignals (S4) und damit des Ausgangssignals (out) stellt somit einen Messwert für die Intensität der aktuellen Fluoreszenzstrahlung (FL) dar.

Da die Fluoreszenzstrahlung (FL)
- von der Intensität der Pumpstrahlung (LB) und/oder
- der magnetischen Flussdichte (B) am Ort des mindestens einen paramagnetischen Zentrums (NV1) bzw. der Vielzahl (NVC) paramagnetischer Zentren (NV1) und/oder
- dem Abstand von der ersten Pumpstrahlungsquelle (PL1) zu dem mindestens einen paramagnetischen Zentrum (NV1) bzw. zu der Vielzahl (NVC) paramagnetischer Zentren (NV1) und/oder
- dem Abstand vom dem mindestens einen paramagnetischen Zentrum (NV1) bzw. von der Vielzahl (NVC) paramagnetischer Zentren (NV1) zu dem ersten Strahlungsempfänger (PD1) und/oder
- dem Transmissionsgrad der optischen Strecke zwischen ersten Pumpstrahlungsquelle (PL1) und dem mindestens einen paramagnetischen Zentrum (NV1) bzw. der Vielzahl (NVC) paramagnetischer Zentren (NV1) für die Pumpstrahlung (LB) und/oder
- dem Transmissionsgrad der optischen Strecke zwischen dem mindestens einen paramagnetischen Zentrum (NV1) bzw. einer Vielzahl (NVC) paramagnetischer Zentren (NV1) und dem ersten Strahlungsempfänger (PD1) für die Fluoreszenzstrahlung (FL) und/oder
- in bestimmten Fällen auch von der Kristallausrichtung des Sensorelements, beispielsweise des Diamantkristalls im Falle von NV-Zentren als paramagnetische Zentren (NV1), relativ zur Richtung der magnetischen Flussdichte (B) und/oder
- ggf. von einem oder mehreren anderen physikalischen Parametern wie beispielsweise die elektrische Flussdichte D, die Beschleunigung a, die Gravitationsfeldstärke g, die Rotationsgeschwindigkeit Ω, Schwingungsfrequenzen ω, die Modulation elektromagnetischer Strahlung, die Intensität ionisierender Strahlung, die Temperatur ϑ handeln kann,
abhängt, ist es möglich das Filterausgangssignal (S4) als Sensorausgangssignal (out), das den Messwert beispielsweise über seinen Betrag signalisiert, für einen dieser Werte zu verwenden, wenn die anderen Werte konstant gehalten werden können.

Das sich ergebende Zeitschema entspricht dem der Figur 3a.

### Figur 9

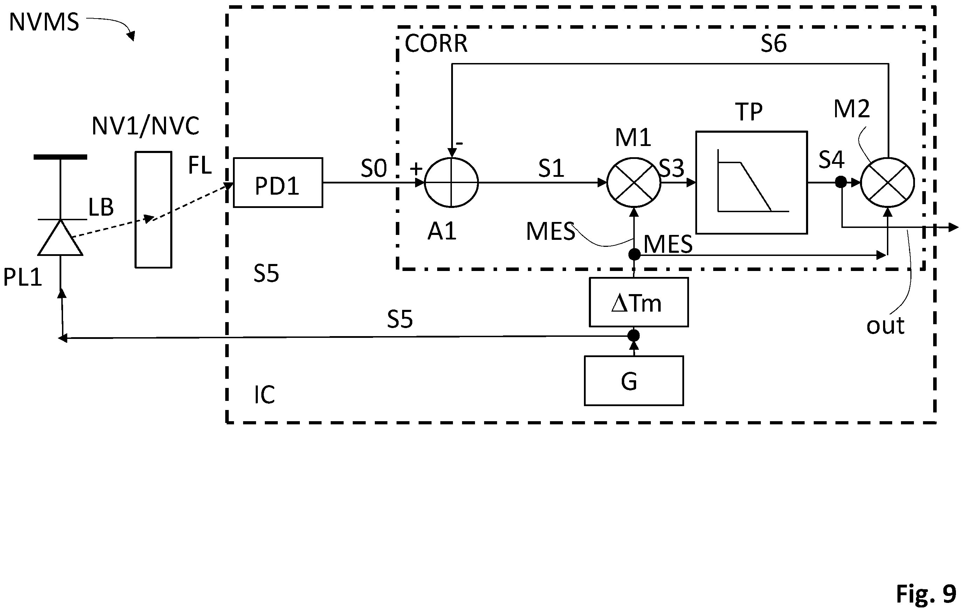

Die Figur 9 entspricht der Figur 8 wobei nun eine Messphasenverschiebungseinheit (ΔTm) das Sendesignal (S5) um eine Messphasenverschiebungszeit (ΔTM) zum Messsignal (MES) verzögert. Das sich ergebende Zeitschema entspricht dem der Figur 6a.

### Figur 10

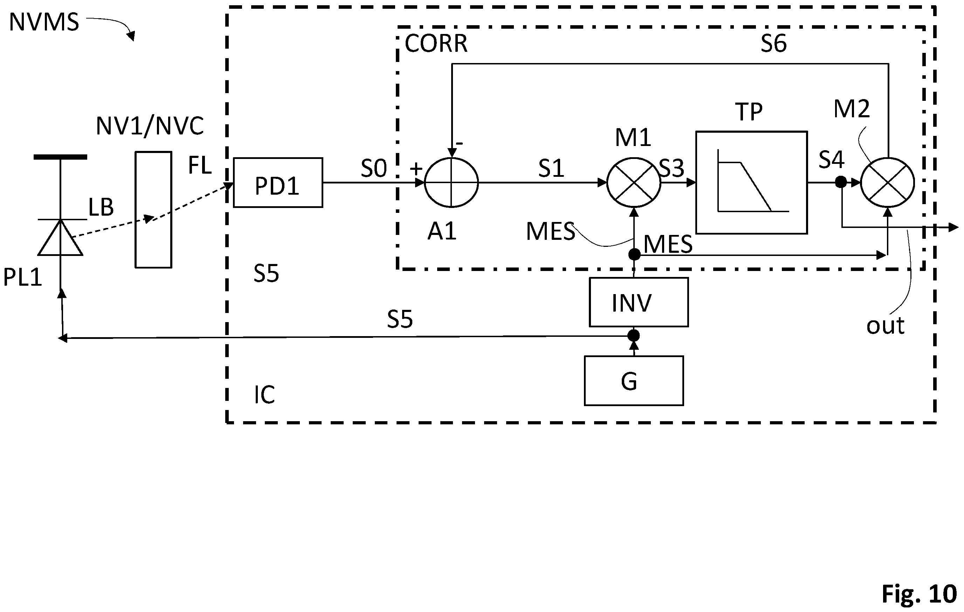

Die Figur 10 entspricht der Figur 8 wobei nun eine Invertierungseinheit (INV) das Sendesignal (S5) zum Messsignal (MES) invertiert. Das sich ergebende Zeitschema entspricht dem der Figur 4a.

### Figur 11

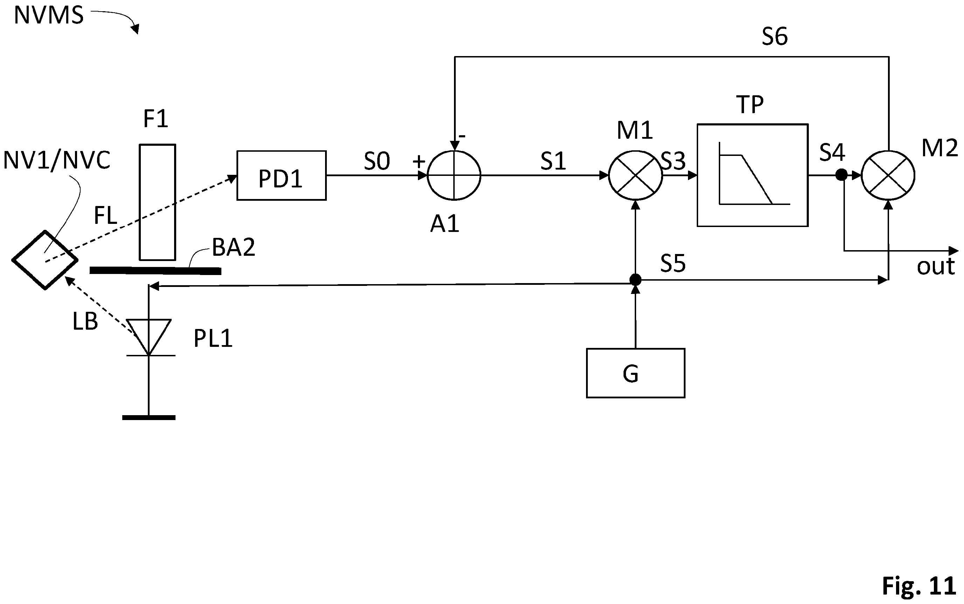

Figur 11 entspricht der Figur 8 mit dem Unterschied, dass das Sensorelement mit den paramagnetischen Zentren (NV1) bzw. der Vielzahl (NVC) paramagnetischer Zentren (NV1) nun nicht mehr die Funktion des ersten optischen Filters (F1) mitumfasst. Daher ist hier ein erster optischer Filter (F1) in den optischen Pfad der Fluoreszenzstrahlung (FL) miteingefügt, der verhindert, dass Pumpstrahlung (LB) der ersten Pumpstrahlungsquelle (PL1) auf den ersten Strahlungsempfänger (PD1) fällt. Der erste optische Filter (F1) ist bevorzugt im Wesentlichen transparent für Strahlung mit der Fluoreszenzwellenlänge (λ_{FL}) der Fluoreszenzstrahlung (FL) und im Wesentlichen nicht transparent für Strahlung mit der Pumpstrahlungswellenlänge (λₚₘₚ) der Pumpstrahlung (LB) der ersten Pumpstrahlungsquelle (PL1). Sofern eine Kompensationsstrahlung (KS) benutzt wird (wird später diskutiert) ist der erste optische Filter (F1) bevorzugt im Wesentlichen transparent für Strahlung der Kompensationsstrahlungswellenlänge (λₖₛ) der Kompensationsstrahlung (KS) der Kompensationsstrahlungsquelle (PLK), sofern die Kompensationsstrahlung (KS) den ersten optischen Filter (F1) auf dem Weg zum ersten Strahlungsempfänger (PD1) durchqueren muss.

Das Vorliegen einer Eigenschaft "im Wesentlichen" ist im Sinne dieser Schrift der Fall, wenn die noch bestehenden Abweichungen von der betreffenden Eigenschaft für den beabsichtigten Zweck und/oder die tatsächliche Verwendung nicht relevant sind und/oder vernachlässigt werden können.

Eine beispielhafte zweite Blende (BA2) verhindert im Beispiel der Figur 11 ebenfalls, dass Pumpstrahlung (LB) der ersten Pumpstrahlungsquelle (PL1) auf direktem Weg den ersten Strahlungsempfänger (PD1) erreicht.

Kombinationen der Figur 11 sind insbesondere mit den Systemen der Figuren 8 bis 10 möglich.

### Figur 12

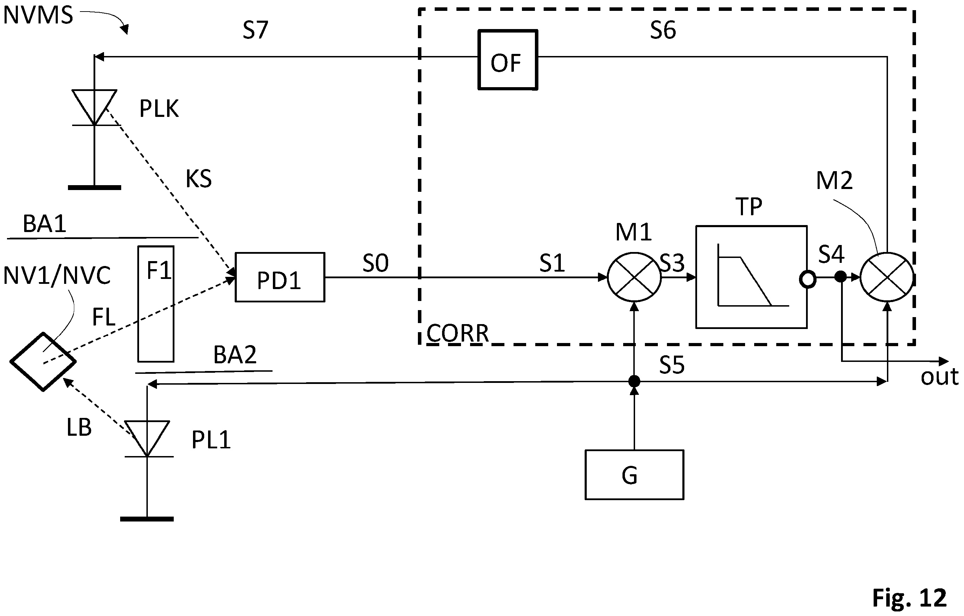

Die Figur 12 entspricht weitestgehend der Figur 11 mit dem Unterschied, dass kein erster Subtrahierer (A1) vorgesehen ist, der das Rückkoppelsignal (S6) von dem Empfängerausgangssignal (S0) abzieht und so das reduzierte Empfängerausgangssignal (S1) bildet. In dem Fall der Figur 12 ist es vielmehr so, dass eine Kompensationsstrahlungsquelle (PLK) eine Kompensationsstrahlung (KS) in den ersten Strahlungsempfänger (PD1) einstrahlt. In dem ersten Strahlungsempfänger (PD1) überlagern sich somit die Fluoreszenzstrahlung (FL) und die Kompensationsstrahlung (KS) und die parasitären, doch durch den ersten optischen Filter (F1) transmittierten Anteile der Pumpstrahlung (LB) in der Regel im Wesentlichen summierend. Typischer Weise können die doch durch den ersten optischen Filter (F1) transmittierten Anteile der Pumpstrahlung (LB) für die Betrachtung des Systemverhaltens vernachlässigt werden.

Da eine negative Intensität der Kompensationsstrahlung (KS) einer nicht möglichen negativen Energie entsprechen würde, wird durch eine Offset-Vorrichtung (OF) ein Gleichanteil auf das Rückkoppelsignal (S6) aufaddiert und so ein offsetbehaftetes Rückkoppelsignal (S7) erzeugt.

Der Gleichanteil wird durch die spätere Multiplikation des reduzierten Empfängerausgangssignals (S1) im ersten Multiplizierer (M1) mit dem Messsignal (MES), das hier gleich dem Sendesignal (S5) ist, in das Frequenzspektrum des Messsignals (MES) transformiert. Bei geeigneter Gestaltung des Filters (TP), beispielsweise als Tiefpassfilter, filtert dieser diesen von 0 Hz verschiedenen Signalanteil aus dem Filtereingangssignal (S3), das das Ausgangssignal des ersten Multiplizierers (M1) ist, heraus oder dämpft ihn bevorzugt so weit, dass er bei der hier vorgenommenen Betrachtung vernachlässigt werden kann.

Bevorzugt wird die Verstärkung des Filters (TP) sehr hoch und negativ gewählt.

Durch das negative Vorzeichen der Verstärkung des Filters (TP), das in der Figur 12 durch einen kleinen Kreis am Ausgang des Filters (TP) angedeutet ist, wird wieder der Signalinhalt des Rückkoppelsignals (S6) von dem Signalinhalt der Fluoreszenzstrahlung (FL) abgezogen. Somit ist das Empfängerausgangssignal (S0) in dieser Konfiguration gleich dem reduzierten Empfängerausgangssignal (S1). Der Vorteil liegt darin, dass der erste Strahlungsempfänger (PD1) immer im gleichen optischen Arbeitspunkt betrieben werden kann.

Eine optionale erste Barriere (BA1) verhindert in dem Fall, dass die Kompensationsstrahlungsquelle (PLK) das mindestens eine Sensorelement mit dem mindestens einen paramagnetischen Zentrum (NV1) bzw. der Vielzahl (NVC) paramagnetischer Zentren (NV1) direkt bestrahlen kann. Zwischen der ersten Barriere (BA1) und der zweiten Barriere (BA2) kann sich beispielsweise ein Fenster in einer Gesamtbarriere aus erster Barriere (BA1) und zweiter Barriere (BA2) befinden, dass in dem Beispiel der Figur 12 in Form des ersten optischen Filters (F1) vorliegt. Die bevorzugten Eigenschaften des ersten optischen Filters (F1) wurden bereits mehrfach diskutiert.

Die erste Übertragungsstrecke für die Pumpstrahlung (LB) von der ersten Pumpstrahlungsquelle (PL1) zum mindestens einen Sensorelement mit mindestens einen paramagnetischen Zentrum (NV1) bzw. mit einer Vielzahl (NVC) paramagnetischer Zentren (NV1) ist bevorzugt bekannt und in ihren Eigenschaften konstant.

Die zweite Übertragungsstrecke für die Fluoreszenzstrahlung (FL) von dem mindestens einen Sensorelement mit mindestens einem paramagnetischen Zentrum (NV1) bzw. mit der Vielzahl (NVC) paramagnetischer Zentren (NV1) ist bevorzugt bekannt und in ihren Eigenschaften konstant
Die dritte Übertragungsstrecke für die Kompensationsstrahlung (KS) von der Kompensationsstrahlungsquelle (PLK) zum ersten Strahlungsempfänger (PD1) ist bevorzugt bekannt und in ihren Eigenschaften konstant.

### Figur 13

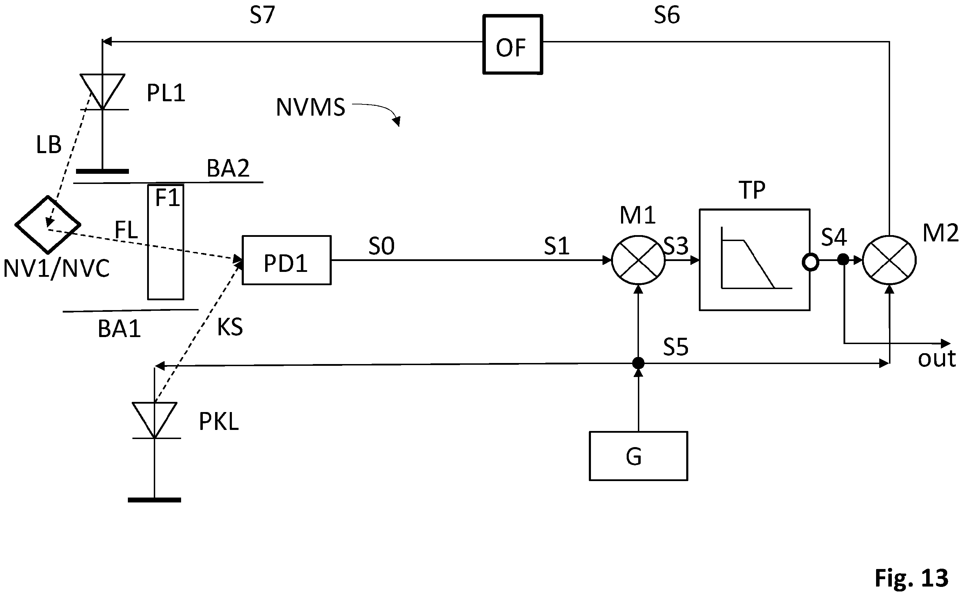

Die Figur 13 entspricht der Figur 12 mit dem Unterschied, dass die Kompensationsstrahlungsquelle (PLK) nicht geregelt wird und stattdessen nun die erste Pumpstrahlungsquelle (PL1) geregelt wird.

### Figur 14

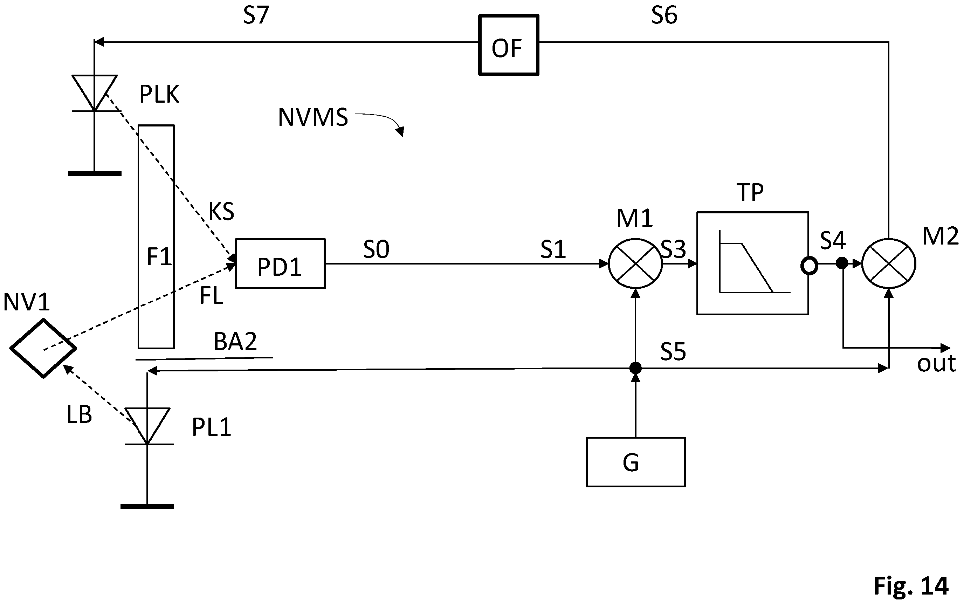

Die Figur 14 entspricht der Figur 12 mit dem Unterschied, dass der erste optische Filter (F1) auch von der Kompensationsstrahlung (KS) passiert wird. Damit die Regelung funktioniert, muss der erste optische Filter (F1) für die Kompensationsstrahlungswellenlänge (λₖₛ) der Kompensationsstrahlung (KS) transparent sein.

Im Falle des mindestens einen Diamanten als Sensorelement und des mindestens einen NV-Zentrums in diesem mindestens einen Diamanten als paramagnetisches Zentrum (NV1) bzw. einer Vielzahl von NV-Zentren als Vielzahl (NVC) paramagnetischer Zentren (NV1) ist die Kompensationsstrahlungswellenlänge (λₖₛ) der Kompensationsstrahlung (KS) bevorzugt länger als die Fluoreszenzwellenlänge (λ_{fl}) der Fluoreszenzstrahlung (FL) und bevorzugt länger als die Pumpstrahlungswellenlänge (λₚₘₚ) der Pumpstrahlung (LB).

Im Falle des mindestens einen Diamanten als Sensorelement und des mindestens einen NV-Zentrums in diesem mindestens einen Diamanten als paramagnetisches Zentrum (NV1) bzw. einer Vielzahl von NV-Zentren als Vielzahl (NVC) paramagnetischer Zentren (NV1) ist die Fluoreszenzwellenlänge (λ_{fl}) der Fluoreszenzstrahlung (FL) bevorzugt kürzer als die Kompensationsstrahlungswellenlänge (λₖₛ) der Kompensationsstrahlung (KS) und bevorzugt länger als die Pumpstrahlungswellenlänge (λₚₘₚ) der Pumpstrahlung (LB).

Bevorzugt ist die Kompensationsstrahlung eine infrarote elektromagnetische Strahlung. Ganz besonders bevorzugt ist die Kompensationsstrahlungsquelle (PLK) eine Infrarotdiode oder eine infrarote Laserdiode.

### Figur 15

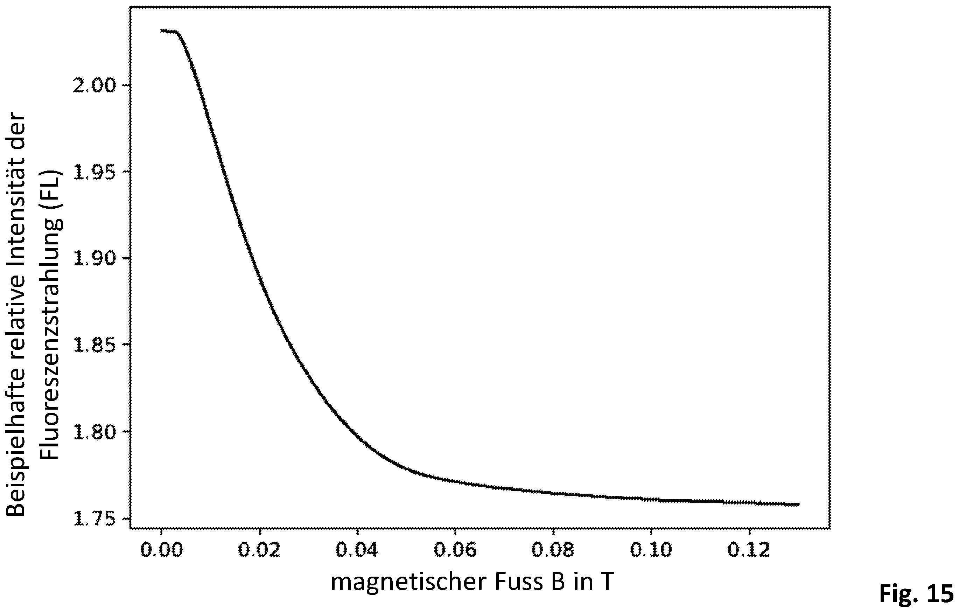

Figur 15 zeigt eine beispielhafte Abhängigkeit der Intensität der Fluoreszenzstrahlung (FL) einer Vielzahl (NVC) von NV-Zentren in Diamant, die als Vielzahl (NVC) an paramagnetische Zentren (NV1) in einer Vielzahl von Sensorelementen verwendet wurden, in Abhängigkeit von einer magnetischen Flussdichte (B) in Tesla (Einheitszeichen T). Die vertikale Achse zeigt die gemessene Intensität der Fluoreszenzstrahlung (FL) einer solchen Zusammenstellung mehrerer NV-Zentren in einer Vielzahl kleiner Nano-Diamanten und ist willkürlich auf einen willkürlichen Intensitätswert normiert.

Der horizontale Verlauf im Bereich kleiner 10 mT ist auf Begrenzungen des verwendeten Messaufbaus zurückzuführen.

Wichtig ist, dass der Verlauf dieser Kurve durch die Verwendung unterschiedlich orientierter Nano-Diamanten als einer Vielzahl unterschiedlich orientierter Sensorelemente nicht richtungsabhängig ist. Daher müssen die hier beschriebenen Sensoren für eine Verwendung nicht ausgerichtet werden. Dies ist für eine Serienfertigung und eine CMOS-Kompatibilität von ausschlaggebender Bedeutung, weil erst dadurch der in anderen Techniken notwendige Ausrichtungsschritt entfällt.

Im Wesentlichen kann die Kurve in weiten Bereichen durch eine fallende Exponentialkurve mit einem Offset angenähert werden.

Der Abfall der Intensität der Fluoreszenzstrahlung (FL) mit steigender Stärke der Flussdichte (B) hängt nach derzeitiger Erkenntnis mit einer Kopplung mehrerer NV-Zentren zusammen.

Diese Kopplung der paramagnetischen Zentren (NV1), insbesondere der NV-Zentren, führt auch bei Dekalibrierung zu einer Empfindlichkeit der Intensität der Fluoreszenzstrahlung (FL) der paramagnetischen Zentren (NV1) gegenüber einer Änderung der magnetischen Flussdichte (B). Es ist daher wichtig, dass mindestens zwei, besser mindestens 4, besser mindestens 8, besser mindestens 20, besser mindestens 40, besser mindestens 100, besser mindestens 200, besser mindestens 400, besser mindestens 1000 paramagnetische Zentren (NV1) - hier NV-Zentren in Diamant- miteinander gekoppelt sind, um diesen Effekt zu erreichen. Entsprechend ist es sinnvoll, wenn Maßnahmen zur Kopplung von mindestens zwei, besser mindestens 4, besser mindestens 8, besser mindestens 20, besser mindestens 40, besser mindestens 100, besser mindestens 200, besser mindestens 400, besser mindestens 1000 paramagnetischer Zentren (NV1) vorgenommen werden.

Diese Kopplung kann auch über optische und/oder elektronische Funktionselemente der integrierten Schaltung (IC) und/oder über optische Funktionselemente des Gehäuses erfolgen.

### Figur 16

Eine weitere Variante des vorgeschlagenen Sensorsystems, die die einzige Variante gemäß der Erfindung bildet, betrifft ein Sensorsystem und/oder quantentechnologischen System, im Folgenden auch nur vereinfacht als Sensorsystem bezeichnet, bei dem das Sensorsystem ein Sensorelement und/oder quantentechnologisches Vorrichtungselement umfasst und bei dem das Sensorsystem ein paramagnetisches Zentrum (NV1) oder eine Vielzahl (NVC) paramagnetischer Zentren (NV1) im Material dieses Sensorelements und/oder quantentechnologischen Vorrichtungselements umfasst. Das Sensorsystem der Figur 16 entspricht im Wesentlichen dem Sensorsystem der Figur 8. Im Gegensatz zum Sensorsystem der Figur 8 weist das Sensorsystem der Figur 16 eine Stabilisierung der Flussdichte (B) am Ort des paramagnetischen Zentrums (NV1) mittels des Magnetfeldes einer Kompensationsspule (LC) auf. Das Sensorsystem umfasst wieder eine erste Pumpstrahlungsquelle (PL1) für Pumpstrahlung (LB), insbesondere bevorzugt in Form einer LED oder eines Lasers, und einen ersten Strahlungsempfänger (PD1). Die Pumpstrahlung (LB) weist eine Pumpstrahlungswellenlänge (λₚₘₚ) auf. Die Pumpstrahlung (LB) veranlasst das paramagnetisches Zentrum (NV1) bzw. die Vielzahl (NVC) paramagnetischer Zentren (NV1) zur Abgabe von Fluoreszenzstrahlung (FL) mit einer Fluoreszenzwellenlänge (λ_{fl}). Der erste Strahlungsempfänger (PD1) ist bevorzugt für die Fluoreszenzwellenlänge (λ_{fl}) empfindlich. Die erste Pumpstrahlungsquelle (PL1) für Pumpstrahlung (LB) emittiert die Pumpstrahlung (LB). Das Sensorsystem ist insbesondere mittels optischer Funktionselemente so gestaltet, dass die Pumpstrahlung (LB) auf das paramagnetische Zentrum (NV1) bzw. die Vielzahl (NVC) paramagnetischer Zentren (NV1) fällt. Des Weiteren ist bevorzugt das Sensorsystem insbesondere mittels optischer Funktionselemente so gestaltet, dass die Fluoreszenzstrahlung (FL) den ersten Strahlungsempfänger (PD1) bestrahlt. Das Besondere an der hier vorgestellten Variante ist nun, dass das Sensorsystem Mittel, insbesondere einen Regler (RG) und/oder insbesondere eine Kompensationsspule (LC) und/oder einen ggf. zusätzlichen oder ersetzenden Permanentmagneten, umfasst, um die Änderung der Intensität der Fluoreszenzstrahlung (FL) bei einer Änderung des Werts der magnetischen Flussdichte (B) oder einer Änderung des Werts eines anderen der oben erwähnten physikalischen Parameter am Ort des paramagnetischen Zentrums (NV1) oder am Ort der Vielzahl (NVC) paramagnetischer Zentren (NV1) bezogen auf die jeweilige Anwendung zu maximieren. D.h. durch Subtraktion oder Addition eines quasistatischen Anteils des magnetischen Flusses (B), durch Subtraktion und/oder Addition eines durch den Regler (RG) gespeisten Spulenstromes wird die magnetische Gesamtflussdichte (B) am Ort des paramagnetischen Zentrums (NV1) bzw. am Ort der Vielzahl (NVC) paramagnetischer Zentren (NV1) in Richtung eines Arbeitspunktes in der Kurve der Figur 15 verlagert, der einen optimierten Abstand zum Punkt der maximalen Empfindlichkeit hat. Dabei wird ausgenutzt, dass die paramagnetischen Zentren (NV1) einer Vielzahl (NVC) paramagnetischer Zentren (NV1) (im Falle der Figur 15 sind dies NV-Zentren in Diamant) bei ausreichend hoher lokaler Dichte an paramagnetischen Zentren (NV1) am Ort der Vielzahl (NVC) paramagnetischer Zentren (NV1) koppeln und somit kollektive Effekte von Gruppen paramagnetischer Zentren (NV1) erzeugen. Diese führen zu der Modulation der Empfindlichkeit.

Wird diese Arbeitspunkteinstellung der magnetischen Flussdichte (B) mittels einer Kompensationsspule (LC) vorgenommen, so ist es sinnvoll, diese mit einem elektrischen Strom zu bestromen, der aus dem Messwert der magnetischen Flussdichte (B), also dem Filterausgangssignal (S4) des Filters (TP), abgeleitet wird. Das entsprechende Arbeitspunktregelsignal (S9) leitet der besagte Regler (RG) bevorzugt aus dem Filterausgangssignal (S4) ab. Bevorzugt hat der Regler (RG) eine Tiefpasscharakteristik oder besser eine integrierende Charakteristik. Bevorzugt handelt es sich also um einen PI-Regler oder einen im Wesentlichen funktionsäquivalenten Regler. Die Regelung durch den Regler (RG) erfolgt bevorzugt dann mit einer ersten Zeitkonstante τ₁, während die Kompensationsregelung mittels des Filters (TP) mit einer zweiten Zeitkonstante τ₂ erfolgt. D.h. ein erstes Ausgangssignal (out) gibt die kurzfristigen Änderungen eines magnetischen Flussdichtewechselfeldes des Werts der magnetischen Flussdichte (B) wieder während ein zweites Ausgangssignal (out") die langfristigen Änderungen bzw. den aktuellen quasistatischen Arbeitspunkt des Sensorsystems wiedergibt. Damit dies möglich ist, ist bevorzugt die erste Zeitkonstante τ₁ des Reglers (RG) größer als die zweite Zeitkonstante τ₂ des Filters (TP). Es gilt somit bevorzugt: (τ₁>τ₂).

### Figur 17

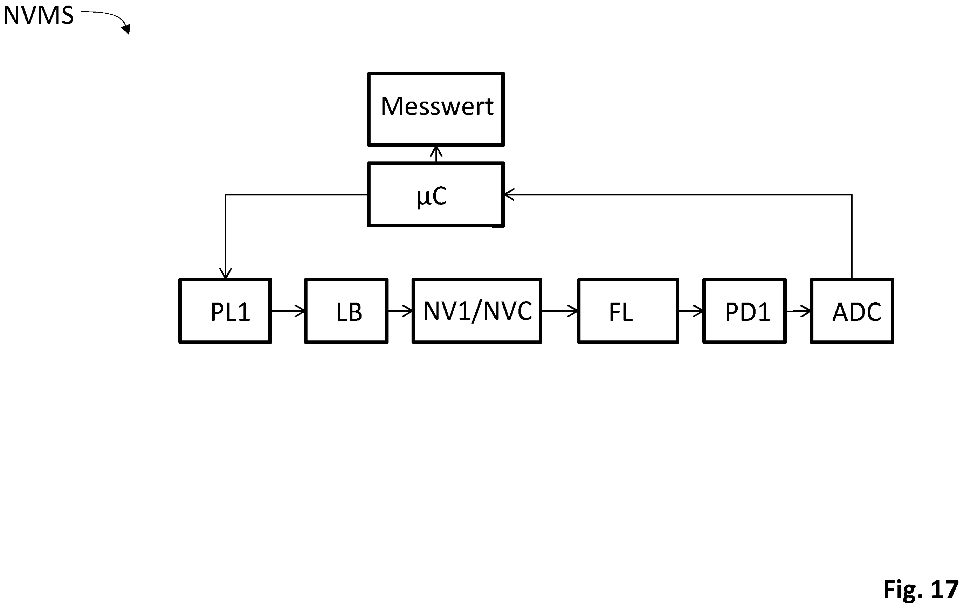

Figur 17 zeigt den Aufbau eines beispielhaften Sensorsystems (NVMS) auf Basis eines Mikrorechners (µC). In dem Beispiel der Figur 17 steuert der Mikrorechner (µC) die erste Pumpstrahlungsquelle (PL1). Diese erzeugt die Pumpstrahlung (LB). Die Pumpstrahlung (LB) wirkt auf die paramagnetischen Zentren (NV1) bzw. die Vielzahl (NVC) paramagnetischer Zentren (NV1) ein. Bevorzugt handelt es sich bei den paramagnetischen Zentren (NV1) um mindestens ein, bevorzugt mehrere NV-Zentren, also eine Vielzahl (NVC) paramagnetischer Zentren (NV1), in mindestens einem oder mehreren Sensorelementen, bevorzugt einem oder mehreren Diamanten.

Die paramagnetischen Zentren (NV1) erzeugen in Abhängigkeit von der magnetischen Flussdichte (B) am Ort der jeweiligen paramagnetischen Zentren (NV1) bzw. am Ort der Vielzahl (NVC) paramagnetischer Zentren (NV1) und in Abhängigkeit von der Intensität der Pumpstrahlung (LB) am Ort der jeweiligen paramagnetischen Zentren (NV1) bzw. am Ort der Vielzahl (NVC) paramagnetischer Zentren (NV1) eine Fluoreszenzstrahlung (FL), die auf den ersten Strahlungsempfänger (PD1) einwirkt. Dessen Signal wird in dem Beispiel der Figur 17 durch einen Analog-zu-Digital-Wandler (ADC) erfasst und dem Mikrorechner (µC) zugeführt. Der Mikrorechner (µC) steuert dann bevorzugt in Abhängigkeit von dem Signal des Analog-zu-Digital-Wandlers (ADC) die erste Pumpstrahlungsquelle (PL1). Das Signal der ersten Pumpstrahlungsquelle (PL1) kann auch statisch und/oder quasistatisch sein. Bevorzugt emuliert der Mikrorechner (µC) ein System entsprechend der Figuren 8 bis 14 und 16.

Aus dem Wert, den der Analog-zu-Digital-Wandler (ADC) an den Mikrorechner (µC) liefert, bestimmt der Mikrorechner (µC) einen Messwert. Der Mikrorechner (µC) gibt diesen Messwert dann bevorzugt über ein erstes Ausgangssignal (out) aus. Das erste Ausgangssignal (out) ist im Falle der Verwendung eines Mikrorechners (µC) bevorzugt eine Signalisierung über einen in Figur 17 nicht extra dargestellten Datenbus (DB) an den der Mikrorechner (µC) angeschlossen ist.

Dieser Messwert kann u.a. von folgenden Parametern abhängen:
- von der Intensität der Pumpstrahlung (LB), die das paramagnetische Zentrum (NV1) erreicht, und damit von den Übertragungseigenschaften der Übertragungsstrecke von der ersten Pumpstrahlungsquelle (PL1) zum paramagnetischen Zentrum (NV1) und
- der magnetischen Flussdichte (B) am Ort des mindestens einen paramagnetischen Zentrums (NV1) und
- den Übertragungseigenschaftender Übertragungsstrecke von dem mindestens einen paramagnetischen Zentrum (NV1) zum ersten Strahlungsempfänger (PD1) und
- in bestimmten Fällen auch von der Kristallausrichtung des Sensorelements, beispielsweise des Diamantkristalls im Falle von NV-Zentren als paramagnetische Zentren (NV1), relativ zur Richtung der magnetischen Flussdichte (B) und
- ggf. von einem oder mehreren anderen physikalischen Parametern, wie beispielsweise die elektrische Flussdichte D, die Beschleunigung a, die Gravitationsfeldstärke g, die Rotationsgeschwindigkeit Ω, Schwingungsfrequenzen ω, die Modulation elektromagnetischer Strahlung, die Intensität ionisierender Strahlung, die Temperatur ϑ.

D.h. der Messwert kann Reflektivitäten, Transmissionsgrade, Abstände, magnetische Flussdichten, und andere physikalische Parameter wiederspiegeln, die diese Übertragungsstrecken und das paramagnetische Zentrum (NV1) bzw. die Vielzahl (NVC) paramagnetischer Zentren (NV1) beeinflussen. Bevorzugt wird das jeweilige Sensorsystem (NVMS) so gestaltet, dass bis auf den zu erfassenden Parameter alle anderen Einflussgrößen im Wesentlichen konstant gehalten werden.

### Figur 18

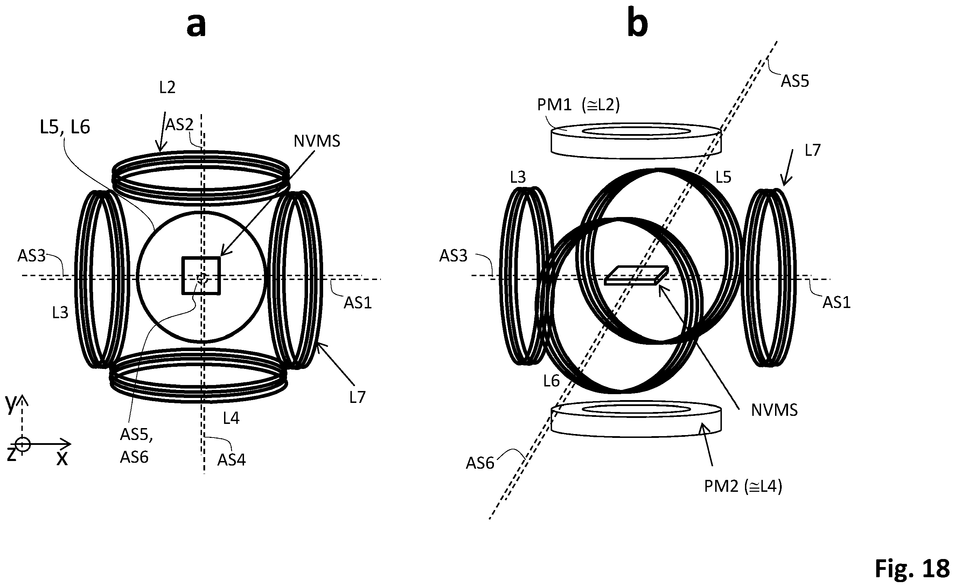

Figur 18 zeigt die Kombination eines der zuvor beschriebenen oder aus diesen abgeleiteten Sensorsystemen (NVMS), die mindestens ein paramagnetisches Zentrum (NV1) umfassen, mit zwei oder drei beispielhaften Helmholz-Spulenpaaren. Das paramagnetische Zentrum (NV1) ist bevorzugt wieder mindestens ein NV-Zentrum in mindestens einem Diamanten. Sofern es sich um eine Vielzahl (NVC) paramagnetischer Zentren (NV1) handelt, umfasst das Sensorsystemen (NVMS) bevorzugt wieder einen oder mehrere Sensorelemente, die bevorzugt wieder die Vielzahl (NVC) der paramagnetischen Zentren (NV1) umfassen. Bevorzugt handelt es sich um eine Ansammlung von Nano-Diamanten unterschiedlicher Ausrichtung mit NV-Zentren als paramagnetischen Zentren (NV1).

Bevorzugt bildet ein System entsprechend der Figur 17 die Basis der Ansteuerung der HelmholzSpulenpaare.

Wenn hier von Spulen die Rede ist, sind damit magnetfelderzeugende Bauelemente gemeint. Es kann sich beispielsweise um Induktivitäten handeln, die typischerweise als Kupferwicklungen oder Wicklungen elektrisch leitender Drähte auf einem Wickelkörper oder der Gleichen ausgeführt sind. Die im Folgenden erwähnten Spulen (L2 bis L7) können beispielsweise auch Permanentmagnete (PM1, PM2) sein oder Induktivitäten und /oder Permanentmagneten umfassen. Details der magnetischen Kreise wie magnetische Kerne etc. sind weggelassen, um die Darstellung einfach zu halten. In diesem Zusammenhang sei auf das Buch Küpfmüller, Kohn, "Theoretische Elektrotechnik und Elektronik" Springer 1993 Kapitel 3 mit besonderem Schwerpunkt auf Kapitel 3 Abschnitt I 25 verwiesen. Die Offenbarung umfasst aber die typischen Elemente magnetischer Kreise wie Luftspalte, ferromagnetische Joche, Ferritkerne, Permanentmagnete, etc. Es ist aber auch denkbar, die Vorrichtung, wie dargestellt, als reines Luft-System ohne magnetische Joche zu nutzen.

In dem Beispiel der Figur 18a bilden eine siebte Spule (L7) und eine dritte Spule (L3) das erste Helmholz-Spulenpaar. Die siebte Spule (L7) und die dritte Spule (L3) sind bevorzugt in Serie geschaltet, damit sie vom gleichen Strom durchflossen werden. Die erste Achse (AS1) der ersten Helmholz-Spule, der siebten Spule (L7), und die dritte Achse (AS3) der dritten Helmholz-Spule, der dritten Spule (L3), sind bevorzugt gleich ausgerichtet und vorzugsweise gleich. In dem Beispiel der Figur 18 sind sie nur zur Verdeutlichung jedoch leicht versetzt eingezeichnet.

In dem Beispiel der Figur 18a bilden eine zweite Spule (L2) und eine vierte Spule (L4) das zweite Helmholz-Spulenpaar. Die zweite Spule (L2) und die vierte Spule (L4) sind bevorzugt in Serie geschaltet, damit sie vom gleichen Strom durchflossen werden. Die zweite Achse (AS2) der zweiten Helmholz-Spule (L2) und die vierte Achse (AS4) der vierten Helmholz-Spule (L4) sind bevorzugt gleich ausgerichtet und vorzugsweise gleich. In dem Beispiel der Figur 18 sind sie nur zur Verdeutlichung jedoch leicht versetzt eingezeichnet.

Die erste Achse (AS1) und dritte (AS3) Achse sind bevorzugt senkrecht zur zweiten Achse (AS2) und vierten Achse (AS4). In dem Beispiel der Figur 18 sind sie nur zur Verdeutlichung jedoch leicht versetzt eingezeichnet.

In dem Beispiel der Figur 18a bilden eine fünfte Spule (L5) und eine sechste Spule (L6) das dritte Helmholz-Spulenpaar. Die fünfte Spule (L5) und die sechste Spule (L6) sind bevorzugt in Serie geschaltet, damit sie vom gleichen Strom durchflossen werden. Die fünfte Achse (AS5) der fünften Helmholz-Spule (L5) und die sechste Achse (AS6) der sechsten Helmholz-Spule (L6) sind bevorzugt gleich ausgerichtet und vorzugsweise gleich. In dem Beispiel der Figur 18 sind sie nur zur Verdeutlichung jedoch leicht versetzt eingezeichnet.

Die erste Achse (AS1) und dritte Achse (AS3) sind bevorzugt senkrecht zur fünften Achse (AS5) und sechsten Achse (AS6).

Die zweite Achse (AS2) und vierte Achse (AS4) sind bevorzugt senkrecht zur fünften Achse (AS5) und sechsten Achse (AS6).

Die fünfte Achse (AS5) und sechste Achse (AS6) stehen also bevorzugt senkrecht auf der durch die erste Achse (AS1) und dritte Achse (AS3) einerseits und die zweite Achse (AS2) und vierte Achse (AS4) andererseits aufgespannten Ebene.

Die Vorrichtung kann statt drei Spulenpaaren ([L3, L7], [L4, L2], [L5, L6]) auch nur zwei Spulenpaare oder nur ein Spulenpaar aufweisen. Natürlich können ggf. weitere Spulenpaare vorgesehen werden. Die Achsen dieser hier nicht eingezeichneten weiteren Spulenpaare sind bevorzugt um einen von 90° abweichenden Winkel gegenüber der Achse eines oder mehrerer Spulenpaare verkippt.

Statt der Spulenpaare können auch einzelne Spulen eingesetzt werden, wobei sich das paramagnetische Zentrum (NV1) und/oder die Vielzahl (NVC) paramagnetischer Zentren (NV1) und/oder der Quantenpunkt (NV1) bevorzugt am Punkt der Achse der Spule in der Spulenebene oder zumindest in der Nähe dieses Punktes befindet. Ein, zwei oder drei der Spulenpaare können somit durch jeweils eine Spule ersetzt werden.

Der Mikrorechner (µC) der Figur 17 kann nun durch Änderung der Bestromung der hier im Beispiel der Figur 18 beispielhaft drei Helmholzspulenpaare ein externes Magnetfeld kompensieren, das aus einer beliebigen Richtung auf das Sensorsystem (NVMS) bzw. das paramagnetische Zentrum (NV1) einwirkt. Im Prinzip haben also die beispielhaft drei Helmholzspulenpaare der Figur 18 die Funktion der Kompensationsspule (LC) der Figur 16, wobei dem Mikrorechner (µC) die Funktion des Reglers (RG) der Figur 16 in diesem Beispiel zukommen würde.

Ein beispielhaftes Verfahren zur Regelung des magnetischen Flusses (B) des Kompensationsmagnetfelds, das durch die Spulenpaare (L2 bis L7) erzeugt wird, kann wie folgt aussehen:
Der Mikrorechner (µC) passt in einem ersten Schritt den ersten Spulenstrom des ersten Helmholzspulenpaares (L7, L3) so an, dass die Fluoreszenzstrahlung (FL) des paramagnetischen Zentrums (NV1) des Sensorsystems (NVMS) in ein erstes Maximum kommt.

In einem zweiten Schritt passt der Mikrorechner (µC) den zweiten Spulenstrom des zweiten Helmholzspulenpaares (L2, L4) so an, dass die Fluoreszenzstrahlung (FL) des paramagnetischen Zentrums (NV1) des Sensorsystems (NVMS) in ein zweites Maximum kommt.

In einem dritten Schritt passt der Mikrorechner (µC) den dritten Spulenstrom des dritten Helmholzspulenpaares (L5, L6) so an, dass die Fluoreszenzstrahlung (FL) des paramagnetischen Zentrums (NV1) des Sensorsystems (NVMS) in ein drittes Maximum kommt.

Wie oben bereits erwähnt, können statt der Spulenpaare für dieses Verfahren ggf. auch nur einzelne Spulen verwendet werden.

Im Wesentlichen ist nach der Ausregelung durch das Kompensationsspulensystem dann bevorzugt die magnetische Flussdichte (B) am Ort des paramagnetischen Zentrums (NV1) zu Null kompensiert oder zumindest auf ein betragsmäßiges Minimum ausgeregelt.

Der Wert des ersten Spulenstroms des ersten Helmholzspulenpaares (L7, L3) repräsentiert dann einen ersten Wert B1 der magnetischen Flussdichte (B) in eine erste Richtung, hier der x-Richtung.

Der Wert des zweiten Spulenstroms des zweiten Helmholzspulenpaares (L2, L4) repräsentiert dann einen zweiten Wert B2 der magnetischen Flussdichte (B) in eine zweite Richtung, hier der y-Richtung.

Der Wert des dritten Spulenstroms des dritten Helmholzspulenpaares (L5, L6) repräsentiert dann einen dritten Wert B3 der magnetischen Flussdichte (B) in eine dritte Richtung, hier der z-Richtung.

Das 3-Tupel aus dem ersten Wert B1 der magnetischen Flussdichte (B) und dem zweiten Wert B2 der magnetischen Flussdichte (B) und dem dritten Wert B3 der magnetischen Flussdichte (B) repräsentiert dann einen Vektor, der den Vektor der magnetischen Flussdichte (B) repräsentiert.

Neben dem ersten Wert B1, zweiten Wert B2 und dritten Wert B3 der magnetischen Flussdichte (B) kann das Messsystem auch diesen Vektor in seiner Gesamtheit oder in Teilen als Messwert weitergeben.

In Figur 18b ist das dritte Helmholzspulenpaar (L5, L6) durch das Paar zweier Permanentmagneten (PM1, PM2) ersetzt. Diese sind bevorzugt so gestaltet, dass sie ein homogenes Bias-Feld im Bereich des paramagnetischen Zentrums (NV1) bzw. im Bereich der Vielzahl (NVC) paramagnetischer Zentren innerhalb des Sensorsystems (NVMS) erzeugen. Hierdurch kann ein optimaler Arbeitspunkt der magnetischen Flussdichte (B) mit einer maximalen Empfindlichkeit bestimmt werden.

### Figur 19

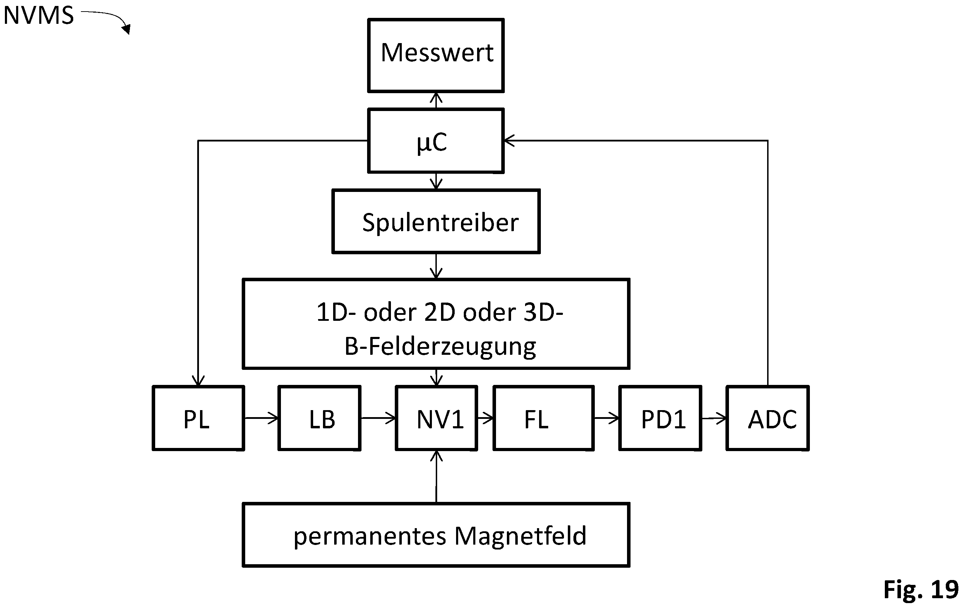

Figur 19 gibt das System der Figur 17 erweitert um eine Ansteuerung der Helmholzspulenpaare ([L3, L7], [L4, L2], [L5, L6]) der Figur 18 wieder. Der Mikrorechner (µC) steuert Spulentreiber an, die bevorzugt mit dem Mikrorechner (µC) Teil des Sensorsystems (NVMS) sind. Diese erzeugen den jeweiligen Spulenstrom der Helmholzspulenpaare ([L3, L7], [L4, L2], [L5, L6]). Die Helmholzspulenpaare bilden die 1D-2D-oder 3D-B-Felderzeugung. Das Sensorsystem kann auch zur eindimensionalen Vermessung von nur einer Magnetfeldkomponente mittels nur eines Helmholzspulenpaares, also mittels einer 1D-B-Feld-Erzeugung, oder der zweidimensionalen Vermessung von nur zwei Magnetfeldkomponenten mittels nur zweier nicht paralleler und bevorzugt senkrecht aufeinander stehender Helmholzspulenpaare, also mittels einer 2D-B-Feld-Erzeugung, oder der dreidimensionalen Vermessung von drei Magnetfeldkomponenten mittels dreier nicht paralleler und bevorzugt senkrecht aufeinander stehender Helmholzspulenpaare, also mittels einer 3D-B-Feld-Erzeugung, verwendet werden. Das Messverfahren vereinfacht sich im Falle der 1D-B-Feld-Erzeugung bzw. der 2D-B-Feld-Erzeugung entsprechend durch Weglassen der Optimierung des Spulenstromes der fehlenden Helmholzspulenpaare.

Die durch die Helmholzspulenpaare ([L3, L7], [L4, L2], [L5, L6]). und die Permanentmagneten (PM1, PM2) erzeugte magnetische Flussdichte (B) wirkt dann auf das paramagnetische Zentrum (NV1) bzw. die Vielzahl (NVC) paramagnetischer Zentren (NV1) des Sensorsystems (NVMS) ein. Diese Einwirkung erfasst beispielsweise der Mikrorechner (µC) über die Messtrecke und ändert die Ansteuerung der Helmholzspulenpaare ([L3, L7], [L4, L2], [L5, L6]) entsprechend. Das System kann selbstverständlich auch analog entsprechend einem oder mehreren der zuvor vorgestellten Systeme oder entsprechend einem System aus dem Stand der Technik aufgebaut werden.

Das hier diskutierte System kann ggf. unter möglichen Einbußen der Leistungsfähigkeit vereinfacht werden. Beispielsweise können in bestimmten Fällen statt Helmholzspulenpaaren einzelne Spulen vorgesehen werden. Letzteres hätte Feldinhomogenitäten zur Folge, die ggf. Auswirkungen haben können.

### Figur 20

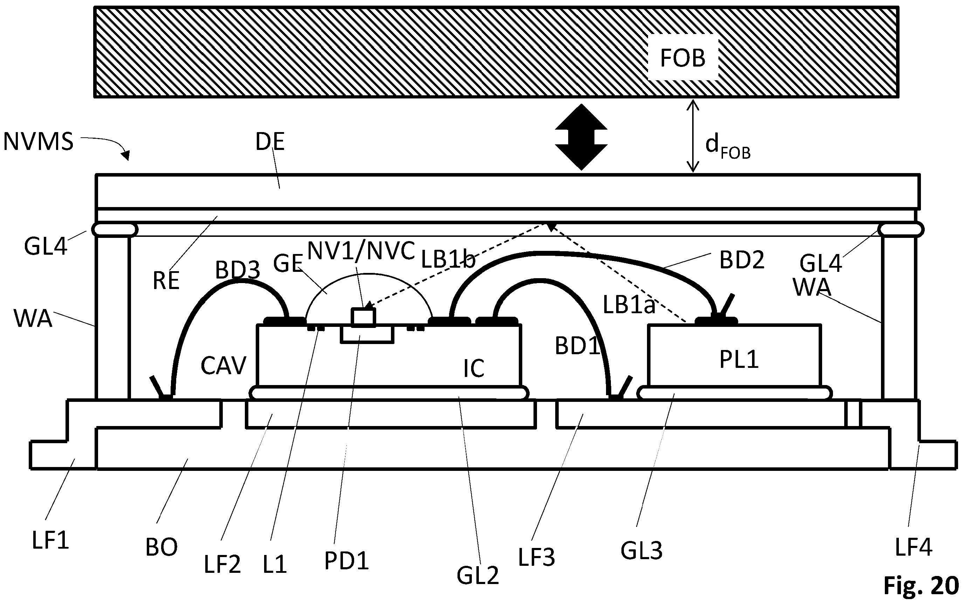

Figur 20 zeigt die Erfassung eines ferromagnetischen Objekts (FOB) durch das Sensorsystem (NVMS) der Figur 1. Bevorzugt sind möglichst alle Komponenten des Sensorsystems (NVMS) nicht ferromagnetisch. Auch sollten die Ströme innerhalb des Sensorsystems möglichst gering sein, um das Messergebnis nicht zu verfälschen.

Wird das ferromagnetische Objekt (FOB) an das Sensorsystem (NVMS) angenähert, so ändert sich in der Regel die magnetische Flussdichte (B) am Ort des paramagnetischen Zentrums (NV1) bzw. der Vielzahl (NVC) der paramagnetischen Zentren (NV1) des Sensorsystems (NVMS). Dadurch ändert sich die Intensität der Fluoreszenzstrahlung (FL) bzw. die Fluoreszenzphasenverschiebungszeit (ΔTFL) des paramagnetischen Zentrums (NV1) bzw. der Vielzahl (NVC) paramagnetischer Zentren (NV1) und damit der betreffende, durch das Sensorsystem (NVMS) erfasste Messwert. Das Sensorsystem (NVMS) kann daher zur Messung des Abstands (d_{FOB}) zu einem magnetisierten Objekt, hier dem ferromagnetischen Objekt (FOB), genutzt werden. Auch kann eine Änderung der Form des ferromagnetischen Objekts (FOB) erfasst werden. Des Weiteren kann eine Änderung der Magnetisierung des ferromagnetischen Objekts und/oder des von dem ferromagnetischen Objekt (FOB) erzeugten magnetischen Flusses (B) erfasst werden. Dies kann beispielsweise durch Überschreiten des Curie-Punkts durch Temperatursteigerung erfolgen. In ähnlicher Weise können auch die Materialeigenschaften dia- und/oder paramagnetischer Stoffe, die die Stelle des ferromagnetischen Objekts (FOB) einnehmen, erfasst werden, wenn eine eine magnetische Flussdichte erzeugende Vorrichtung, also beispielsweise ein Permanentmagnet und/oder eine stromdurchflossene Spule einen magnetischen Fluss (B) erzeugt mit dem dia- und/oder paramagnetischer Stoffe, die die Stelle des ferromagnetischen Objekts (FOB) einnehmen, wechselwirken. Die magnetische Flussdichte (B) der die magnetische Flussdichte (B) erzeugenden Vorrichtung sollte dabei den Ort des paramagnetischen Zentrums (NV1) bzw. den Ort der Vielzahl (NVC) paramagnetischer Zentren (NV1) durchfluten.

### Figur 21

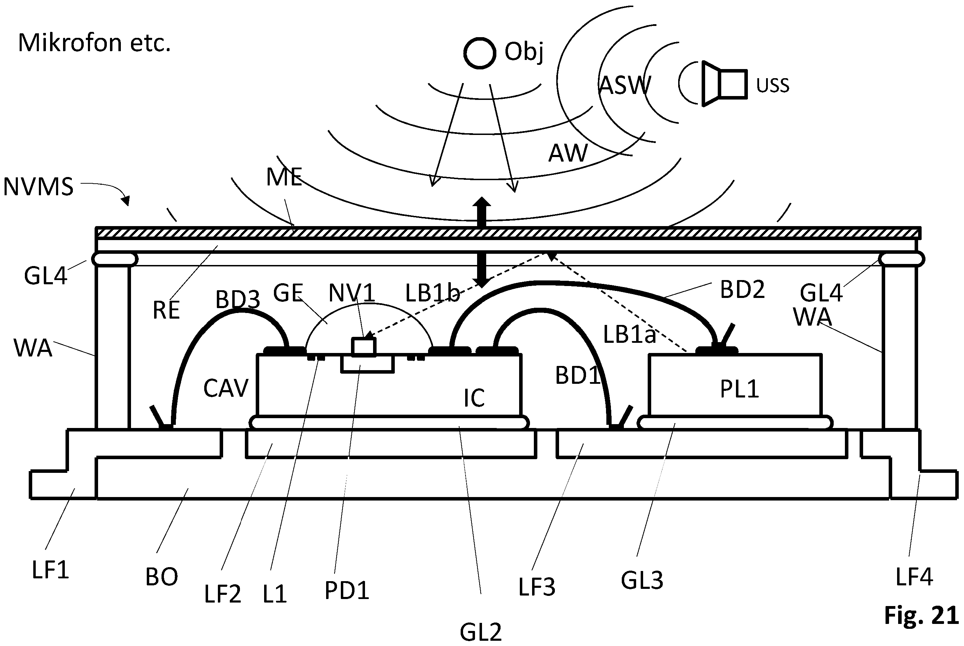

In Figur 21 ist der Deckel des Sensorsystems (NVMS) der Figur 1 als mechanisch schwingungsfähige, ferromagnetische Membrane (ME) ausgeführt. Ein Objekt (Obj) sendet Schallwellen als akustische Wellen (AW) aus. Hierbei kann es sich beispielsweise um eine oder mehrere, von einem Objekt (Obj) reflektierte Ultraschallwellen handeln. Wobei eine reflektierte Ultraschallwelle typischerweise eine durch das Objekt (Obj) reflektierte akustische Sendewelle (ASW) ist, die wiederum von einem Ultraschallsender oder einem Ultraschallsendesystem (USS) stammt.

Diese Schallwellen versetzen die ferromagnetische Membrane (ME) in dem Beispiel der Figur 21 in mechanische Schwingungen. Diese mechanischen Schwingungen modifizieren die magnetische Flussdichte (B) am Ort des paramagnetischen Zentrums (NV1) in Form eines Schwingungsanteils des Werts der magnetischen Flussdichte (B) am Ort des paramagnetischen Zentrums (NV1) bzw. am Ort der Vielzahl (NVC) paramagnetischer Zentren (NV1). Diese Schwingungen des Werts der magnetischen Flussdichte (B) führen zu einer Schwingung des Werts der Intensität der Fluoreszenzstrahlung (FL) und/oder einer Schwingung des Werts der Fluoreszenzphasenverschiebungszeit (ΔTFL). Diese Schwingungen werden daher durch das Sensorsystem (NVMS) daher erfasst. Das Sensorsystem (NVMS) der Figur 21 arbeitet somit wie ein Mikrofon. Im einfachsten Fall spiegelt dann der zeitliche Verlauf eines ersten Ausgangssignals (out) des Sensorsystems (NVMS) der Figur 21 den zeitlichen Verlauf des Werts des Schalldrucks der akustischen Welle (AW), ggf. mit einem Phasenversatz, wieder. Die Membrane (ME) ist bevorzugt elastisch gefertigt. Die durch das Sensorsystem (NVMS) ermittelten Messwerte entsprechen typischerweise der Position bzw. der Auslenkung der Membrane (ME) zum Messzeitpunkt.

Der Wirkungspfad ist als so, dass die akustische Schwingung der akustischen Welle (AW) in einem ersten Schritt in eine mechanische Schwingung der Membrane (ME) umgesetzt wird und in einem zweiten Schritt in eine Schwingung der magnetischen Flussdichte (B) durch die Magnetisierung der Membrane (ME) umgesetzt wird und dann in einem dritten Schritt durch das paramagnetische Zentrum (NV1) oder die Vielzahl (NVC) paramagnetischer Zentren (NV1) in eine Schwingung der Intensität der Fluoreszenzstrahlung (FL) und/oder eine Schwingung der Fluoreszenzphasenverschiebungszeit (ΔTFL) umgesetzt wird und dann in einem vierten Schritt durch den ersten Strahlungsempfänger (PD1) in eine Schwingung des Werts des Empfängerausgangssignals (S0) umgesetzt wird. In einem optionalen fünften Schritt können dann die zuvor beschriebenen Weiterverarbeitungen erfolgen, die insbesondere in dem besagten Messwert der Figuren 16 und 19 oder in einem Wert eines ersten Ausgangssignals (out) resultieren können.

### Figur 22

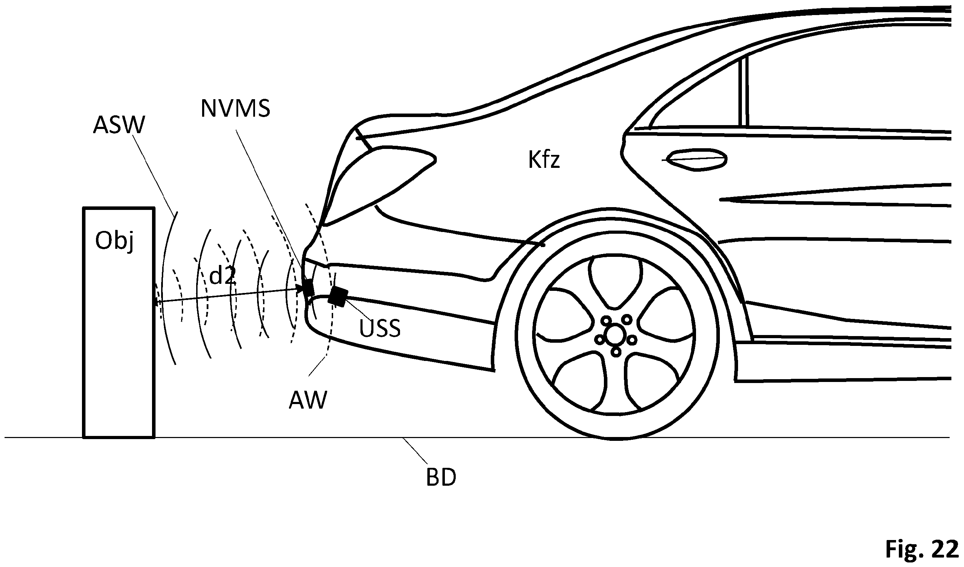

In Figur 22 wird eine Nutzungssituation für ein Mikrofon entsprechend der Figur 21 dargestellt. Ein Ultraschallsender (USS), der beispielhaft in der Stoßstange eines Fahrzeugs (Kfz) angebracht ist, sendet ein Ultraschallsignal, welches eine akustische Sendewelle (ASW) ist, aus. Dieses trifft nach einer Laufzeit über die Distanz d2 auf das Objekt (Obj) und wird dort reflektiert. Das Sensorsystem (NVMS), z.B. eines entsprechend der Figur 21, erfasst das reflektierte Schallsignal in Form einer akustischen Welle (AW), hier das Ultraschallsignal, mit Hilfe seines paramagnetischen Zentrums (NV1) bzw. mit Hilfe einer Vielzahl (NVC) paramagnetischer Zentren (NV1) und wandelt die zu verschiedenen Zeitpunkten ermittelten Messwerte der Position der Membrane (ME) bzw. der einfachen oder mehrfachen zeitlichen Ableitungen und/oder Integrationen der Messwerte dieser Position in einen ggf. sonst wie gefilterten Datenstrom um, der bevorzugt dem jeweiligen Schalldruck im Wesentlichen entspricht oder sonst wie extrahierten Messwerten entspricht. Beispielsweise kann der Abstand d2 extrahiert und geschätzt und ausgegeben werden.

Dieser Datenstrom wird dann bevorzugt durch den Mikrorechner (µC) oder eine entsprechende Vorrichtung komprimiert und an ein übergeordnetes Rechnersystem übertragen, wo er bevorzugt dekomprimiert wird und mit Messdatenströmen und Messwerten anderer Sensoren, beispielsweise anderen Ultraschallsensoren und/oder LIDAR-Sensoren und/oder Radar-Sensoren und/oder Halios-Sensoren und/oder elektrostatischen Sensoren mittels Sensor-Fusion zu neuen Messwerten kombiniert und/oder umgerechnet wird.

Bevorzugt führt das übergeordnete Rechnersystem ein Programm der künstlichen Intelligenz aus. Ganz besonders bevorzugt führt das übergeordnete Rechnersystem eine Emulation eines neuronalen Netzwerkmodells aus. In diesem Zusammenhang wird auf die noch unveröffentlichte internationale Schutzrechtsanmeldung PCT/EP2020/056727 verwiesen, deren Offenbarungsgehalt vollumfänglicher Teil der hier vorgelegten Offenlegung ist.

Es wird somit ein übergeordnetes Rechnersystem vorgeschlagen, dass ein neuronales Netzwerkmodell ausführt, bei dem das neuronale Netzwerkmodell Netzwerkknoten umfasst, die in Netzwerkebenen organisiert sind, und wobei jeder Netzwerkknoten des neuronalen Netzes Eingangs- und Ausgangsparameter aufweist und wobei zumindest ein, bevorzugt mehrere Eingangsparamater von Netzwerkknoten entweder ein Eingangsparameter des neuronalen Netzwerkmodells sind oder ein Ausgangsparameter eines anderen Netzwerkknotens des neuronalen Netzwerkmodells sind und wobei zumindest ein, bevorzugt mehrere Ausgangsparameter eines Netzwerkknotens ein Ausgangsparameter des neuronalen Netzwerkmodells oder ein Eingangsparameter eines anderen neuronalen Netzwerkknotens sind und wobei ein Netzwerknoten, bei dem ein Ausgangsparameter ein Ausgangsparameter des neuronalen Netzwerkmodells ist, keinen Eingangsparameter aufweist, der ein Eingangsparameter des neuronalen Netzwerkmodells ist, und wobei ein Netzwerknoten, bei dem ein Eingangsparameter ein Eingangsparameter des neuronalen Netzwerkmodells ist, keinen Ausgangsparameter aufweist, der ein Ausgangsparameter des neuronalen Netzwerkmodells ist, und wobei kein Netzwerkknoten des neuronalen Netzes, bei dem ein Ausgangsparameter ein Ausgangsparameter des neuronalen Netzwerkmodells ist, einen Eingangsparameter aufweist, der ein Ausgangsparameter eines Netzwerkknotens ist, bei dem ein Eingangsparameter ein Eingangsparameter des neuronalen Netzwerkmodells ist. Die Eingangsparameter eines Netzwerkknotens des neuronalen Netzwerkmodells werden innerhalb eines Netzwerkknotens mittels einer Verknüpfungsfunktion für den betreffenden neuronalen Netzwerkknoten mit den Ausgangsparametern dieses neuronalen Netzwerkknotens verknüpft. Bevorzugt ist diese Verknüpfungsfunktion stark nichtlinear. Die Eigenschaften der Verknüpfungsfunktion hängen dabei von Verknüpfungsfunktionsparametern ab, die bevorzugt spezifisch für den jeweiligen Netzwerkknoten sind. Die Verknüpfungsfunktion kann von Netzwerkknoten zu Netzwerknoten unterschiedlich sein. Die Verknüpfungsfunktionsparameter werden in einem Trainingsprozess ermittelt und antrainiert. Die Beschreibung hier beschreibt ein zumindest dreischichtiges neuronales Netz mit mindestens drei Netzebenen.

Es wird nun vorgeschlagen, dass zumindest ein, bevorzugt mehrere Eingangsparameter des neuronalen Netzwerkmodells, das die übergeordnete Rechnereinheit ausführt, von einem Parameter des paramagnetischen Zentrums (NV1) oder der Vielzahl (NVC) paramagnetischer Zentren (NV1) abhängt. Ein solcher Parameter kann beispielsweise der Wert der Intensität der Fluoreszenzstrahlung (FL) und/oder der Wert der Fluoreszenzphasenverschiebungszeit (ΔTFL) sein.

Die Verwendung von solchen Methoden und Verfahren der künstlichen Intelligenz ist von besonderer Bedeutung für das autonome Fahren und/oder den Betrieb komplexer Systeme und/oder den Betrieb von Vorrichtungen in ggf. komplexen Umgebungen.

Bevorzugt ermittelt eines der hier vorgestellten Systeme beispielsweise einen Abstand (d2) zwischen dem Fahrzeug (Kfz) und einem Objekt (Obj) in Bewegungsrichtung des Fahrzeugs (Kfz). Bevorzugt wird diese Information zur Veränderung der Bewegungsrichtung und/oder der Geschwindigkeit und/oder Beschleunigung oder sonstiger Fahrzeugparameter durch den Fahrer oder ein vollautomatisches System genutzt. Es hängt dann somit ein Betriebsparameter des Fahrzeugs (Kfz) von der Fluoreszenzstrahlung (FL) eines Quantenpunkts (NV1) bzw. eines paramagnetischen Zentrums (NV1) bzw. einer Vielzahl (NVC) paramagnetischer Zentren (NV1) bzw. eines oder mehrerer NV-Zentren in dem Sensorsystem (NVMS) ab. Hier wäre ein beispielhafter Betriebsparameter die Geschwindigkeit und/oder die Beschleunigung und/oder die Rotation bzw. die Richtung des Fahrzeugs.

### Figur 23

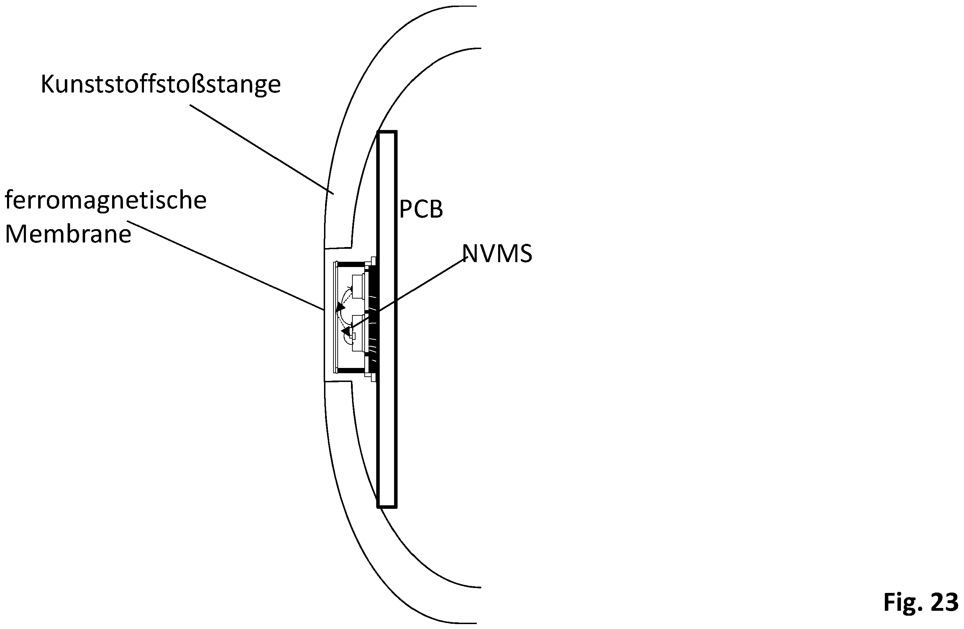

Figur 23 zeigt ein Sensorsystem der Figur 21 in einer vereinfachten Einbausituation in der Stoßstange eines beispielhaften Fahrzeugs (Kfz) - hier eines Kraftfahrzeugs, beispielsweise des Fahrzeugs (Kfz) der Figur 22. Bei einem Fahrzeug (Kfz) kann es sich auch um eine andere mobile Vorrichtung und/oder einen Roboter oder einen Flugkörper oder ein Geschoss oder ein Wasserfahrzeug oder einen Schwimm- oder Tauchkörper handeln.

Das Sensorsystem ist bevorzugt auf einer Platine, einer gedruckten Schaltung (PCB), montiert, beispielsweise aufgelötet. In dem Beispiel der Figur 23 verfügt das Gehäuse des Sensorsystems (NVMS) bevorzugt über einen nichtmagnetischen Deckel, wie beispielsweise in der Figur 18 dargestellt.

Die ferromagnetische Membrane (ME) befindet sich nun außen auf der Stoßstange. Dies hat den Vorteil, dass die Stoßstange durchlackiert werden kann, ohne dass das Schalleintrittsfenster offengehalten werden muss, was ästhetisch von großem Vorteil ist. Bevorzugt ist die Stoßstange aus nicht magnetischem Material gefertigt, um das Sensorsystem (NVMS) nicht zu stören.

### Figur 24

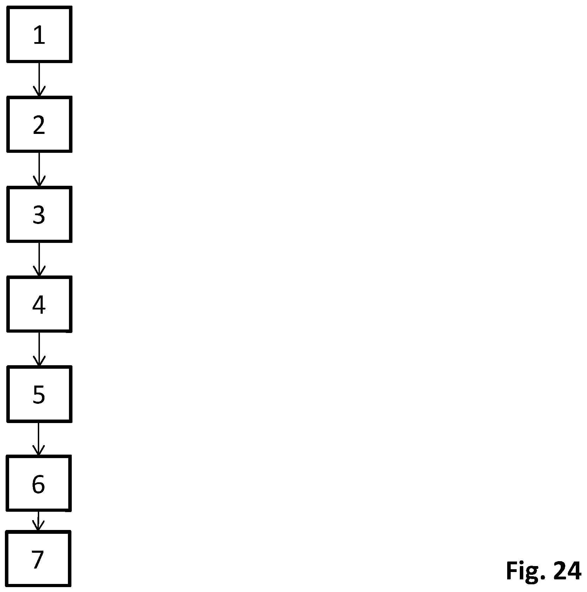

Figur 24 zeigt einen typischen Ablauf eines Verfahrens zum Betrieb eines Ultraschallmesssystems mit einem Sensorsystem (NVMS) mit mindestens einem Sensorelement mit mindestens einem paramagnetischen Zentrum (NV1) oder einer Vielzahl (NVC) paramagnetischer Zentren (NV1).

In einem ersten Schritt (1) sendet ein Ultraschallsender (USS) eine Ultraschallwelle als akustische Sendewelle (ASW) aus. In einem zweiten Schritt (2) reflektieren ein oder mehrere Objekte (Obj) die akustische Sendewelle (ASW) als reflektierte Ultraschallwelle in Form einer reflektierten akustischen Welle (AW). Die reflektierte Ultraschallwelle, also die reflektierte akustische Welle (AW), versetzt eine Membrane (ME) mit einer ferromagnetischen Teilvorrichtung in einem dritten Schritt (3) in Schwingungen. Diese schwingende Membrane (ME) mit der ferromagnetischen Teilvorrichtung verursacht in einem vierten Schritt (4) eine Modulation der magnetischen Flussdichte (B) am Ort des paramagnetischen Zentrums (NV1) bzw. der Vielzahl (NVC) paramagnetischer Zentren (NV1) des Sensorsystems (NVMS). In einem fünften Schritt (5) verändert die Modulation der magnetischen Flussdichte (B) am Ort des paramagnetischen Zentrums (NV1) bzw. der Vielzahl (NVC) paramagnetischer Zentren (NV1) des Sensorsystems (NVMS) die Fluoreszenzstrahlung (FL) des mindestens einen paramagnetischen Zentrums (NV1) bzw. der Vielzahl (NVC) paramagnetischer Zentren (NV1). In einem sechsten Schritt (6) erfasst ein erster Strahlungsempfänger (PD1) des Sensorsystems (NVMS) diese Modulation der Fluoreszenzstrahlung (FL), insbesondere die Modulation der Intensität der Fluoreszenzstrahlung (FL) und/oder die Modulation der Fluoreszenzphasenverschiebungszeit (ΔTFL), als Empfängerausgangssignal (S0). In einem siebten Schritt (7) erzeugt eine Auswerteschaltung daraus einen oder mehrere Messwerte, bevorzugt eine zeitliche Abfolge von Messwerten, die dann bevorzugt ganz oder teilweise oder nach Kompression, beispielsweise an ein übergeordnetes Rechnersystem übertragen und ggf. dekomprimiert werden und in dem übergeordneten Rechnersystem oder in dem Sensorsystem (NVMS) selbst für andere Zwecke verwendet werden.

Das Verfahren kann auch für normalen Schall und Infraschall angewendet werden.

### Figur 25

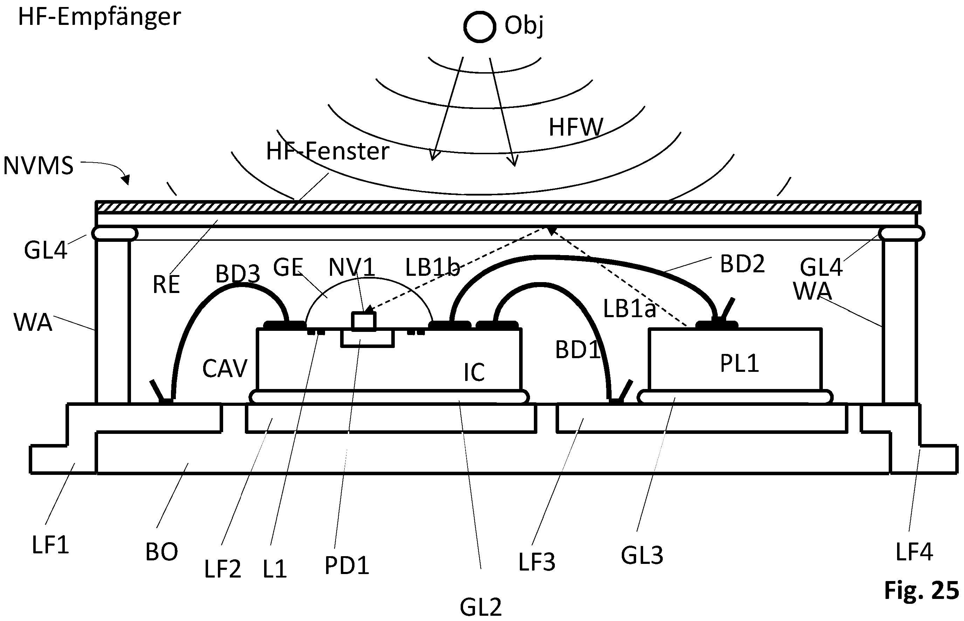

Figur 25 zeigt ein Sensorsystem entsprechend Figur 1 als HF-Empfänger für elektromagnetische Hochfrequenzstrahlung. Eine Verwendung als Empfänger in Radar-Systemen insbesondere in den besagten Fahrzeugen und in ortsfesten Vorrichtungen ist denkbar. Auch ist eine Verwendung für Breitbandempfänger denkbar.

Ein Objekt (Obj) sendet elektromagnetische Wellen (HFW) aus. Dabei kann das Objekt (Obj) auf das Objekt (Obj) eingestrahlte elektromagnetische Wellen (HFW) reflektieren oder selbst als Sender aussenden. Diese elektromagnetischen Wellen (HFW) wechselwirken mit dem paramagnetischen Zentrum (NV1) bzw. der Vielzahl (NVC) paramagnetischer Zentren (NV1) des Sensorsystems (NVMS). Hierdurch wird die Fluoreszenzstrahlung (FL) moduliert. Bei dieser Modulation der Fluoreszenzstrahlung kann es sich um eine Modulation der Intensität der Fluoreszenzstrahlung (FL) und/oder der Modulation der Fluoreszenzphasenverschiebungszeit (ΔTFL) handeln.

Da die Fluoreszenzstrahlung (FL) eine Zeitkonstante τ_{FL} aufweist mit der die Fluoreszenzstrahlung (FL) Änderungen der magnetischen Flussdichte (B) folgen kann, ist der Empfang der elektromagnetischen Wellen (HFW) auf Periodendauern oberhalb dieser Zeitkonstante τ_{FL} begrenzt. Für die Maximalfrequenz (f_{HFmax}) des nicht gedämpften Empfangs der elektromagnetischen Wellen (HFW) gilt daher 2πf_{HFmax}=1/τ_{FL}.

Um nun höhere Frequenzen empfangen zu können, kann beispielsweise durch eine erste Spule (L1) und/oder einen Resonator oder dergleichen in unmittelbarer Nähe des paramagnetischen Zentrums (NV1) bzw. der Vielzahl (NVC) paramagnetischer Zentren (NV1) ein magnetisches und/oder elektromagnetisches Wechselfeld sehr hoher Frequenz f_{LC} erzeugt werden. Dieses überlagert sich dann mit dem magnetischen Wechselfeld der einfallenden elektromagnetischen Welle (HFW). Hierbei entstehen zwei Wellenanteile.

Der erste Wellenanteil weist dabei eine Summenfrequenz f_{S} auf, die der Summe aus der Frequenz f_{HF} der einfallenden elektromagnetischen Welle (HFW) und der Frequenz f_{LC} des durch die erste Spule (L1) und/oder einen Resonator oder dergleichen erzeugten magnetischen Wechselfeldes entspricht. Diesem ersten Wellenanteil können das paramagnetische Zentrum (NV1) bzw. die Vielzahl (NVC) paramagnetischer Zentren (NV1) nicht folgen, da für diese Summenfrequenz f_{S} gilt: 2πf_{S}>1/τ_{FL}. Dieser erste Wellenanteil wird, wenn er energetisch nicht einem Übergang des paramagnetischen Zentrums (NV1) entspricht, ignoriert. Insofern weist das paramagnetische Zentrum (NV1) typischerweise ein Tiefpassverhalten auf.

Der zweite Wellenanteil weist dabei eine Differenzfrequenz f_{D} auf, die der Differenz aus der Frequenz f_{HF} der einfallenden elektromagnetischen Welle (HFW) und der Frequenz f_{LC} des durch die erste Spule (L1) und/oder einen Resonator oder dergleichen erzeugten magnetischen Wechselfeldes entspricht. Bei geeigneter Wahl der Frequenz f_{LC} des durch die erste Spule (L1) und/oder einen Resonator oder dergleichen erzeugten magnetischen Wechselfeldes können das paramagnetische Zentrum (NV1) bzw. die Vielzahl (NVC) der paramagnetischen Zentren (NV1) diesem zweiten Wellenanteil folgen, wenn für diese Differenzfrequenz f_{D} gilt: 2πf_{D}<1/τ_{FL}. Dieser zweite Wellenanteil wird durch das paramagnetische Zentrum (NV1) bzw. die Vielzahl (NVC) paramagnetischer Zentren (NV1) in eine mit der Differenzfrequenz f_{D} modulierte Modulation der Fluoreszenzstrahlung (FL) umgesetzt, die von dem ersten Strahlungsempfänger (PD1) empfangen werden kann und durch die integrierte Schaltung (IC) in ein erstes Ausgangssignal (out) umgesetzt werden kann. Bei der Modulation der Fluoreszenzstrahlung (FL) kann es sich wieder um eine Modulation der Intensität der Fluoreszenzstrahlung (FL) und/oder der Modulation der Fluoreszenzphasenverschiebungszeit (ΔTFL) handeln.

### Figur 26

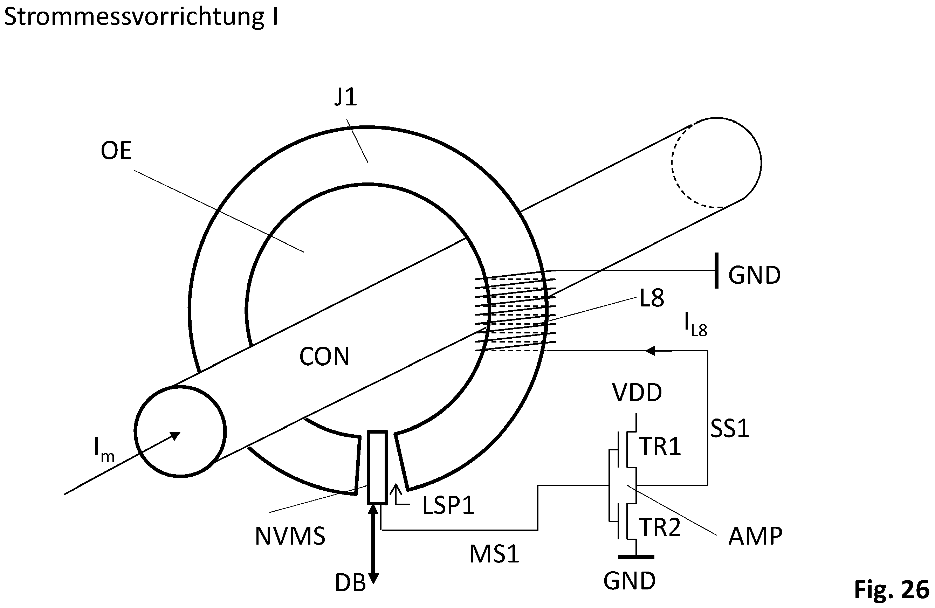

Figur 26 zeigt eine Messvorrichtung für den elektrischen Strom (Iₘ) durch einen Leiter (CON). Ein torusförmiges oder ringförmiges Joch (J1) erfasst die durch den elektrischen Strom (Iₘ) durch den Leiter (CON) erzeugte magnetische Flussdichte (B). Das Joch (J1) weist einen ersten Luftspalt (LSP1) auf, in dem das Sensorsystem (NVMS) mit dem paramagnetischen Zentrum (NV1) oder zumindest das paramagnetische Zentrum (NV1) platziert ist.

Es handelt sich um einen geschlossenen magnetischen Kreis mit einem ersten Luftspalt (LSP1).

Das Sensorsystem (NVMS) erzeugt in Abhängigkeit von dem Messwert der magnetischen Flussdichte (B), also z.B. in Abhängigkeit von dem ersten Ausgangssignal (out) ein erstes Messwertsignal (MS1). Ein beispielhafter Verstärker (AMP) als Regler (RG) verstärkt dieses erste Messwertsignal (MS1) zu einem ersten Steuersignal auf einer Steuersignalleitung (SS1). Der Verstärker (AMP) kann Teil des Sensorsystems (NVMS) sein. Der beispielhafte Verstärker (AMP) ist in dem Beispiel der Figur 26 eine Push-Pull-Stufe mit einem ersten Transistor (TR1) und einem zweiten Transistor (TR2), die zwischen eine Betriebsspannungsleitung (VDD) auf Betriebsspannungspotenzial und einer Bezugspotenzialleitung (GND) auf Bezugspotenzial geschaltet sind. In der Realität werden sicherlich kompliziertere Verstärker verwendet.

Durch die Steuersignalleitung (SS1) fließt dann in eine achte Spule (L8) ein achter Spulenstrom (I_{L8}). Die Steuersignalleitung (SS1) entspricht somit typischerweise in ihrer Funktion dem Arbeitspunktregelsignal (S9) der Figur 16. Die achte Spule (L8), die der Kompensationsspule (LC) der Figur 16 funktional entspricht, erzeugt dann in dem ersten Joch (J1) eine zusätzliche Erregung in Form einer magnetischen Feldstärke H, die der magnetischen Erregung durch den zu erfassenden elektrischen Strom (Iₘ), der den Leiter (CON) durchströmt, entgegenwirkt. Hierdurch wird der magnetische Fluss (B) am Ort des paramagnetischen Zentrums (NV1) bzw. am Ort der Vielzahl (NVC) paramagnetischer Zentren (NV1) des Sensorsystems (NVMS) bei richtiger Wahl der Übertragungsfunktionen des Regelsystems auf nahezu Null, bis auf Regelfehler und Rauschen, zurückgeregelt.

Das Sensorsystem kann beispielsweise über einen Mikrorechner (µC) und einen Analog-zu-Digital-Wandler (ADC) verfügen und beispielsweise über einen Datenbus (DB) den Wert des ersten Messwertsignals (MS1) oder eines Regelwerts an ein übergeordnetes Rechnersystem als Messwert für den Wert und/oder den Betrag des elektrischen Stromes (Iₘ) durch den Leiter (CON) weitergeben. Beispielsweise kann das Sensorsystem (NVMS) in Gänze oder teilweise eine Struktur wie in den Figuren 16, 17 und/oder 19 aufweisen. Im Prinzip handelt es sich um ein ein-dimensionales System mit nur einer Spule entsprechend Figur 18. Die Vorrichtung der Figur 26 ist besonders geeignet, den Zuleitungsstrom in elektro-mobilen Batterien und Motoren oder anderer Vorrichtungen in Elektroautos und anderen Fahrzeugen und Vorrichtungen der Energietechnik wie Generatoren, Transformatoren und Motoren, zu erfassen. Auch ist die Vorrichtung der Figur 26 besonders für die Verwendung zur Erfassung der Ströme in Überlandleitungen und in den Zuleitungen zu elektrochemischen Vorrichtungen wie Elektrolysezellen und dergleichen geeignet.

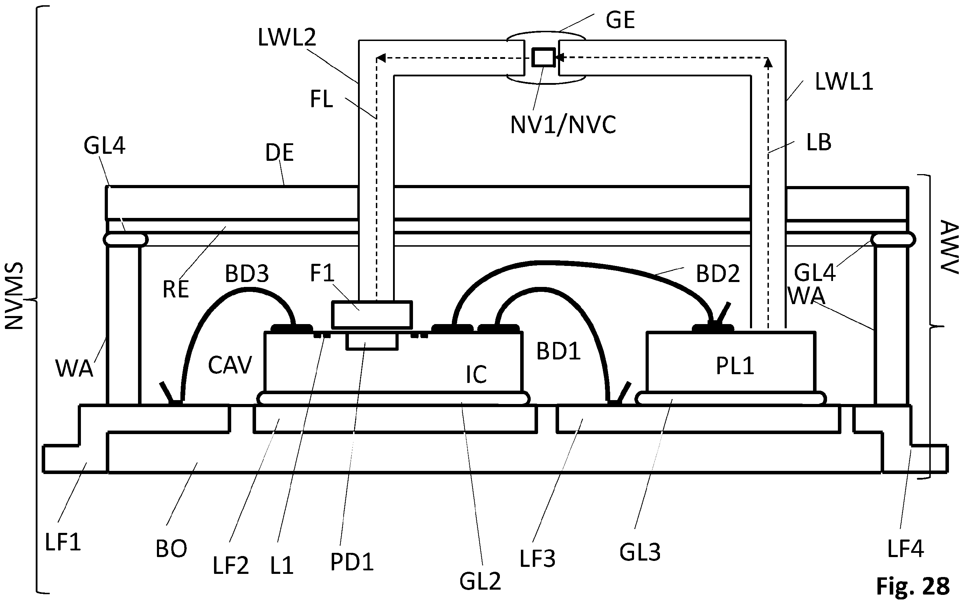

In Kombination mit optischen Wellenleitern, wie in der folgenden Figur 28 dargestellt, kann das torusförmige (torodiale) Joch (J1) mit dem Sensorelement und dem einen oder mehreren paramagnetischen Zentren (NV1) bzw. der Vielzahl (NVC) paramagnetischer Zentren (NV1) beispielsweise um eine stromführende Leitung auf hohem elektrischen Potenzial angebracht werden, während die Auswertevorrichtung (AWV) im Niederspannungsbereich angeordnet wird. Das Sensorelement im ersten Luftspalt (LSP1) des Jochs (J1), das das eine oder die mehreren paramagnetischen Zentren (NV1) bzw. die Vielzahl (NVC) paramagnetischer Zentren (NV1) umfasst, wird dabei mittels eines oder mehrerer Lichtwellenleiter (LWL1, LWL2) mit der Auswertevorrichtung (AWV) gekoppelt. Hierdurch kann eine sehr gute galvanische Trennung erreicht werden. Bevorzugt werden die Lichtwellenleiter (LWL1, LWL2 - siehe Figur 28) in diesem Anwendungsfall mit Isolatoren ummantelt, die bevorzugt umlaufende Rippen zur Verlängerung des Kriechweges und zum Feuchtigkeitsschutz aufweisen. Die bevorzugte Montage-Situation dieser Isolatoren ist dann so, dass die Lichtwellenleiter (LWL1, LWL2) dann möglichst senkrecht montiert werden.

### Figur 27

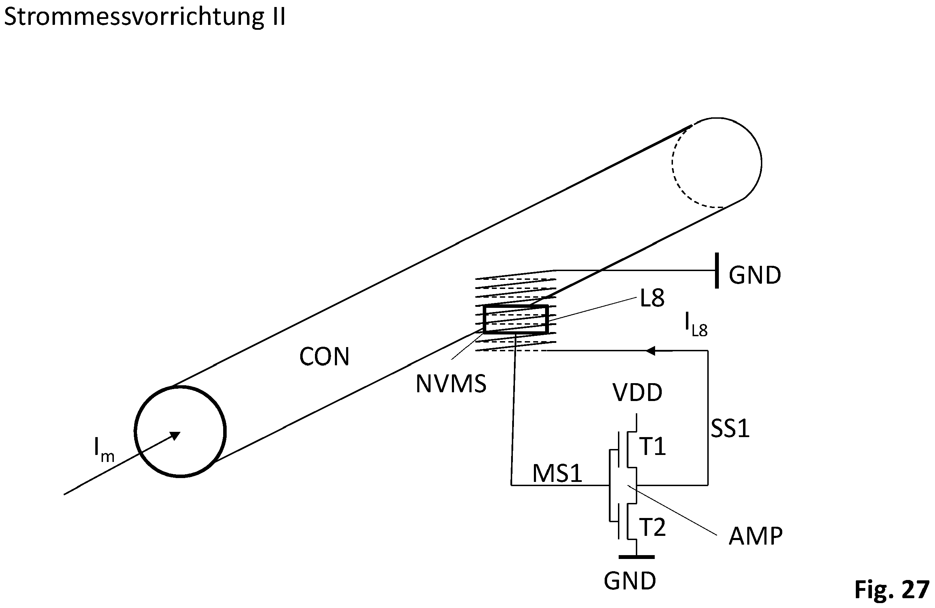

Die Figur 27 entspricht der Figur 26 mit dem Unterschied, dass kein ring- oder torusförmiges Joch (J1) mehr vorgesehen ist, da die Feldlinien der magnetischen Flussdichte (B) nicht senkrecht auf dem Sensorsystem (NVMS) stehen müssen, da die Kurve der Figur 15 im Gegensatz zu Empfindlichkeitskurven für Hall- und AMR-Sensoren nicht richtungsabhängig ist, was ein wesentlicher Vorteil dieser Vorrichtung ist.

Daher kann das Joch (J1) bei Sensorsystemen (NVMS) mit einem paramagnetischen Zentrum (NV1) weggelassen werden. Allerdings hat das Joch (J1) der Figur 26 den Vorteil, dass es die Empfindlichkeit des Sensorsystems (NVMS) signifikant erhöht.

### Figur 28

Das paramagnetische Zentrum (NV1) bzw. die Vielzahl (NVC) paramagnetischer Zentren (NV1) können von dem restlichen Sensorsystem (NVMS) getrennt werden, wenn optische Funktionselemente die Pumpstrahlung (LB) zu dem Sensorelement mit dem paramagnetischen Zentrum (NV1) bzw. der Vielzahl (NVC) paramagnetischer Zentren (NV1), also beispielsweise mindestens einem NV-Zentrum in mindestens einem Diamanten oder eine Vielzahl von NV-Zentren in einem oder mehreren Diamanten, die bevorzugt unterschiedlich ausgerichtet sind, transportieren. Bevorzugt transportieren umgekehrt, diese oder andere optische Funktionselemente die Fluoreszenzstrahlung (FL) des paramagnetischen Zentrums (NV1) bzw. der Vielzahl (NVC) paramagnetischer Zentren (NV1) zu dem ersten Strahlungsempfänger (PD1). Bevorzugt weisen diese Übertragungswege keine zu große Dämpfung auf.

In dem Beispiel der Figur 28 transportiert ein erster Lichtwellenleiter (LW1) die Pumpstrahlung (LB) zu dem Sensorelement mit dem paramagnetischen Zentrum (NV1) bzw. der Vielzahl (NVC) paramagnetischer Zentren (NV1), also beispielsweise zu mindestens einem NV-Zentrum in mindestens einem Diamanten oder einer Vielzahl von NV-Zentren in einem oder mehreren Diamanten, die bevorzugt unterschiedlich ausgerichtet sind. Ein zweiter Lichtwellenleiter (LWL2) transportiert die Fluoreszenzstrahlung (FL) des paramagnetischen Zentrums (NV1) bzw. der Vielzahl (NVC) paramagnetischer Zentren (NV1) zu dem ersten Strahlungsempfänger (PD1). In dem Beispiel der Figur 28 ist das Sensorelement mit dem paramagnetischen Zentrum (NV1) bzw. mit der Vielzahl (NVC) paramagnetischer Zentren (NV1), also beispielsweise mit einem Diamanten mit einem NV-Zentrum oder einer Vielzahl von NV-Zentren in einem oder mehreren Diamanten mit bevorzugt unterschiedlicher Ausrichtung, mit einem Befestigungsmittel (GE) an den ersten Lichtwellenleiter (LWL1) und den zweiten Lichtwellenleiter (LWL2) mechanisch und optisch gekoppelt. Bevorzugt ist das Befestigungsmittel (GE) für Strahlung mit der Fluoreszenzwellenlänge (λ_{fl}) der Fluoreszenzstrahlung (FL) transparent und für Strahlung mit der Pumpstrahlungswellenlänge (λₚₘₚ) der Pumpstrahlung (LB) transparent. Bevorzugt ist der erste Lichtwellenleiter (LWL1) für Strahlung mit der Pumpstrahlungswellenlänge (λₚₘₚ) der Pumpstrahlung (LB) transparent. Bevorzugt ist der zweite Lichtwellenleiter (LWL2) für Strahlung mit der Fluoreszenzwellenlänge (λ_{fl}) der Fluoreszenzstrahlung (FL) transparent.

Der Vorteil dieses Aufbaus des Sensorsystems (NVMS) ist, dass die Lichtwellenleiter (LWL1, LWL2) in der Regel elektrisch nicht oder schlecht leitend sind und daher im Wesentlichen kein magnetisches Feld erzeugen oder das magnetische Feld im Wesentlichen nicht stören.

Ein weiterer Vorteil dieses Aufbaus des Sensorsystems (NVMS) ist, dass die Lichtwellenleiter (LWL1, LWL2) in der Regel thermisch nicht oder schlecht leitend sind und daher im Wesentlichen keine störende Wärmeenergie an den Messort eintragen oder von dort abziehen. Hierdurch ist eine thermische Entkopplung von Magnetfeldmessung und Auswertelektronik möglich.

Da die Lichtwellenleiter (LWL1, LWL2) aus chemisch weitestgehend inertem Material, beispielsweise Glas, hergestellt werden können, kann das Sensorelement mit dem paramagnetischen Zentrum (NV1) bzw. mit der Vielzahl (NVC) paramagnetischer Zentren (NV1) dann in Umgebungen mit harten Betriebsbedingungen eingebracht werden. Dies betrifft u.a. hohe und tiefe Temperaturen, radioaktive Strahlungsfelder, Strahlungsfelder mit Röntgen- oder Gammastrahlung, Bereiche hoher elektrischer Feldstärken, korrosive Umgebungen mit sehr hohem und/oder niedrigem ph-Wert, Salzlösungen, abrasive Umgebungen, etc..

Beispielsweise kann das Sensorelement mit dem paramagnetischen Zentrum (NV1) bzw. mit der Vielzahl (NVC) paramagnetischer Zentren (NV1) in unmittelbare Nähe eines supraleitenden Magneten und/oder einer supraleitenden Leitung in einen Tieftemperaturbereich gebracht werden um die erzeugte magnetische Flussdichte (B) zu erfassen.

Beispielsweise kann das Sensorelement mit dem paramagnetischen Zentrum (NV1) bzw. mit der Vielzahl (NVC) paramagnetischer Zentren (NV1) in einem Hochtemperaturbereich, beispielsweise in Induktionsöfen und /oder in Induktionskochplatten zur Vermessung der dortigen magnetischen Flussdichten (B) und/oder Stromstärken betrieben werden.

Auch ist die Verwendung zur Vermessung der Kolbenposition in ferromagnetischer Kolben von Verbrennungsmaschinen denkbar.

Auch ist der Einsatz in Raketentriebwerken und Turbinen denkbar.

Insbesondere ist der Einsatz in Hyperschalltriebwerken oder Fusionsreaktoren oder Plasmakammern zur Vermessung der magnetischen Eigenschaften des Plasmas und/oder magnetfelderzeugender Elemente und/oder die Erfassung der magnetischen Flussdichte (B) innerhalb dieser Systeme denkbar. Es wird somit ein Fusions- oder Plasmareaktor, bzw. ein Hyperschalltriebwerk vorgeschlagen, mit einer Plasmakammer und einer magnetfelderzeugenden Vorrichtung, die eine magnetische Flussdichte (B) innerhalb der Plasmakammer erzeugt, bei dem eine Sensorelement mit einem paramagnetischen Zentrum (NV1) bzw. einer Vielzahl (NVC) paramagnetischer Zentren (NV1) innerhalb der Plasmakammer innerhalb des magnetischen Feldes der magnetfelderzeugenden Vorrichtung angeordnet ist und bei dem das Sensorelement mit einer optischen Vorrichtung mit einer Auswertvorrichtung (AWV) gekoppelt ist und wobei die Auswertvorrichtung (AWV) eine erste Pumpstrahlungsquelle (PL1) umfasst, die eine Pumpstrahlung (LB) erzeugen kann und wobei die Pumpstrahlung (LB) das paramagnetische Zentrum (NV1) bzw. die Vielzahl (NVC) paramagnetischer Zentren (NV1) des Sensorelements innerhalb der Plasmakammer zur Abgabe einer Fluoreszenzstrahlung (FL) anregen kann, die von zumindest einem physikalischen Parameter, insbesondere der magnetischen Flussdichte (B), innerhalb der Plasmakammer abhängt und wobei die Auswertevorrichtung insbesondere mittels eines ersten Strahlungsempfängers (PD1) die Fluoreszenzstrahlung (FL) des paramagnetischen Zentrums (NV1) bzw. der Vielzahl (NVC) paramagnetischer Zentren (NV1) erfasst und wobei die Auswertvorrichtung (AWV) in Abhängigkeit von der erfassten Fluoreszenzstrahlung (FL) einen oder mehrere Messwerte erzeugt. Bevorzugt hängen ein oder mehrere Betriebsparameter des Hyperschalltriebwerks oder des Fusionsreaktors oder der Plasmakammer von einem oder mehreren dieser Messwerte ab.

Des Weiteren ist es denkbar ein oder mehrere Sensorelemente (NV1) mit einem oder mehreren paramagnetischen Zentren (NV1) bzw. einer Vielzahl (NVC) paramagnetischer Zentren (NV1), also beispielsweise ein oder mehrere Nanodiamanten mit einem oder mehreren NV-Zentren in einem oder mehreren Diamanten, in Glas als Befestigungsmittel (GE) einzuschmelzen.

Die Erfindung umfasst also auch einen Glaskörper, in den mindestens ein Sensorelement mit mindestens einem paramagnetischen Zentrum (NV1) bzw. einer Vielzahl (NVC) paramagnetischer Zentren (NV1) eingegossen ist.

Statt Glas kommen sicherlich auch andere äquivalente Materialien als Befestigungsmittel (GE) in Frage. Insbesondere ist ein Verguss mit transparenten Kunststoffen denkbar.

Des Weiteren ist es denkbar, ein oder mehrere Sensorelemente mit einem oder mehreren paramagnetischen Zentren (NV1) bzw. einer Vielzahl (NVC) paramagnetischer Zentren (NV1) als Sensoren zur Stromdichtemessung in elektrochemischen Zellen, Akkumulatoren oder Batterien zu platzieren. Es wird somit eine elektrochemische Zelle, insbesondere ein Akkumulator oder eine Batterie oder eine Elektrolysevorrichtung, vorgeschlagen mit einer Zellenkammer und einer magnetfelderzeugenden Vorrichtung, die eine magnetische Flussdichte (B) innerhalb der Zellenkammer erzeugt, bei dem ein Sensorelement mit einem paramagnetischen Zentrum (NV1) bzw. einer Vielzahl (NVC) paramagnetischer Zentren (NV1) innerhalb der Zellenkammer innerhalb des magnetischen Feldes der magnetfelderzeugenden Vorrichtung angeordnet ist und bei dem das Sensorelement mit einer optischen Vorrichtung mit einer Auswertvorrichtung (AWV) gekoppelt ist und wobei die Auswertvorrichtung (AWV) eine Pumpstrahlungsquelle (PL1) umfasst, die eine Pumpstrahlung (LB) erzeugen kann und wobei die Pumpstrahlung (LB) das paramagnetische Zentrum (NV1) bzw. die Vielzahl (NVC) paramagnetischer Zentren (NV1) des Sensorelements innerhalb der Zellenkammer zur Abgabe einer Fluoreszenzstrahlung (FL) anregen kann, die von zumindest einem physikalischen Parameter, insbesondere der magnetischen Flussdichte (B) innerhalb der Zellenkammer abhängt, und wobei die Auswertevorrichtung (AWV) insbesondere mittels eines ersten Strahlungsempfängers (PD1) die Fluoreszenzstrahlung des paramagnetischen Zentrums (NV1) bzw. der Vielzahl (NVC) paramagnetischer Zentren (NV1) erfasst und wobei die Auswertvorrichtung (AWV) in Abhängigkeit von der erfassten Fluoreszenzstrahlung (FL) einen oder mehrere Messwerte erzeugt. Bevorzugt hängen ein oder mehrere Betriebsparameter der elektrochemischen Zelle, insbesondere des Akkumulators oder der Batterie oder der Elektrolysevorrichtung, oder der Zellenkammer von einem oder mehreren dieser Messwerte ab. Die Zellenkammer ist typischerweise mit einem Elektrolyten oder einer Schmelze ganz oder teilweise gefüllt. Bei der magnetfelderzeugenden Vorrichtung kann es sich auch um den Elektrolyten oder eine andere Flüssigkeit innerhalb der Zellenkammer handeln, die durch einen elektrischen Strom durchflossen werden und so ein magnetisches Feld aufbauen.

### Figur 29

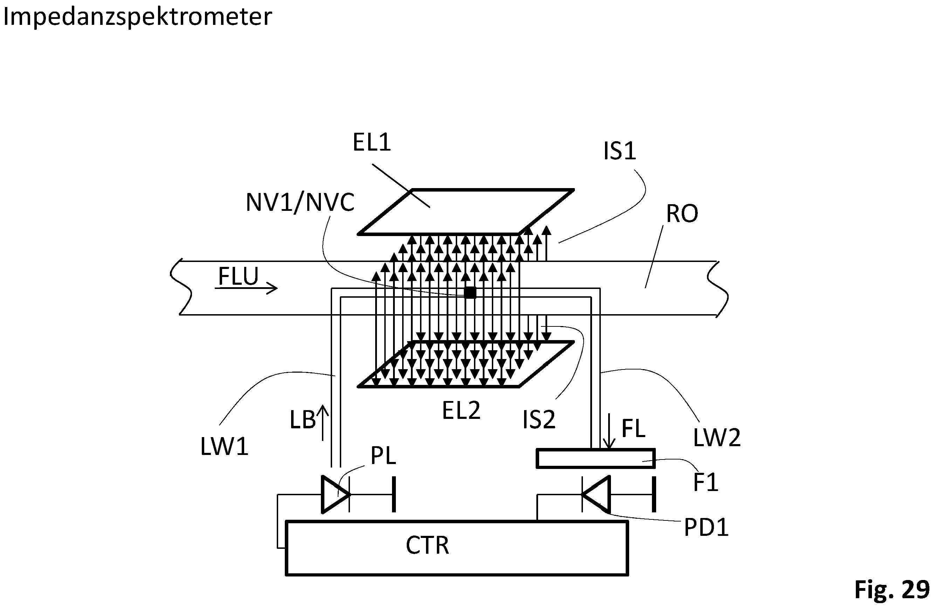

Figur 29 zeigt eine Platzierung eines oder mehrerer Sensorelemente mit einem oder mehreren paramagnetischen Zentren (NV1) bzw. mit einer Vielzahl (NVC) paramagnetischer Zentren (NV1), also beispielsweise von mehreren bevorzugt unterschiedlich ausgerichteten Nanodiamanten mit mehreren NV-Zentren, in einer fluidischen Leitung (RO). In der fluidischen Leitung (RO) befindet sich ein Fluid (FLU), das typischerweise in einer Flussrichtung in Bewegung ist. Zwischen einer ersten Elektrode (EL1) und einer zweiten Elektrode (EL2) ist eine elektrische Gleich- oder Wechselspannung aufgebaut.

Die erste Elektrode (EL1) ist durch eine erste elektrische Isolation (IS1) von dem Fluid (FLU) in der fluidischen Leitung (RO) getrennt.

Die zweite Elektrode (EL2) ist durch eine zweite elektrische Isolation (IS2) von dem Fluid (FLU) in der fluidischen Leitung (RO) getrennt.

Das elektrische Feld führt in dem Fluid (FLU) zu Verschiebungsströmen, die mittels der modulierten Fluoreszenzstrahlung (FL) der paramagnetischen Zentren (NV1) bzw. der Vielzahl (NVC) paramagnetischer Zentren (NV1) gemessen werden können. Die entsprechenden Messvorrichtungen wurden zuvor bereits beschrieben.

Ein Problem sind die dabei auftretenden Doppelschichten und Raumladungszonen.

### Figur 30

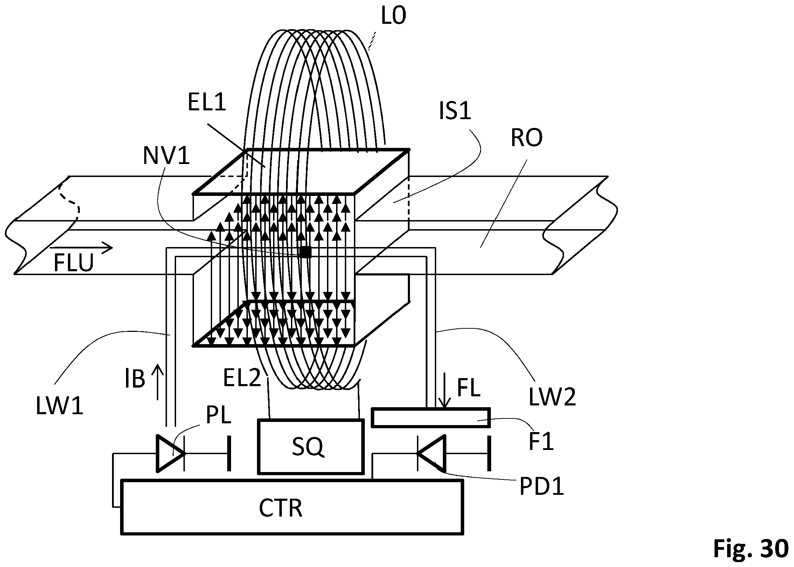

Figur 30 zeigt eine elektrochemische Zelle, wie die in Figur 29, mit dem Unterschied, dass die erste Elektrode (E1) und die zweite Elektrode (E2) in elektrischem Kontakt mit dem Fluid (FLU) sind. Bei dem Fluid (FLU) kann es sich um eine Flüssigkeit und/oder ein Gas oder ein Plasma handeln. Es können auch Mischungen vorliegen. Diese Situation ist die typische Situation in Plasmakammern, Batterien, Akkumulatoren und Elektrolysezellen. Somit ermöglichen die Sensorelemente mit den paramagnetischen Zentren (NV1) erstmals eine Vermessung der elektrischen Stromdichten innerhalb solcher elektrochemischer Zellen, ohne die Felder durch die Zuleitungen zu beeinflussen. Außerdem ist eine galvanische Trennung möglich.

Eine Stromquelle (SQ) erzeugt in dem Beispiel der Figur 30 mittels einer Spule (L0) eine magnetische Flussdichte (B). Diese Konstellation Quantenpunkt (NV1) zu Spule (L0) lässt sich beispielsweise in Fusionsreaktoren, Plasmareaktoren und Hyperschalltriebwerken finden.

Kombinationen mit mehreren Spulen, mehreren Elektroden und mehreren Quantenpunkten sind ebenfalls möglich.

### Figur 31

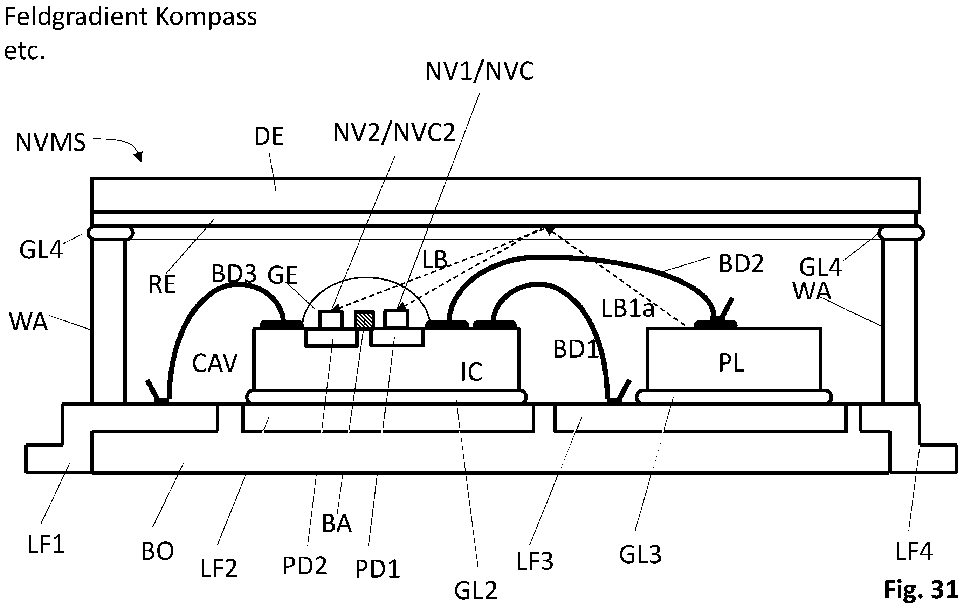

Figur 31 zeigt die Vorrichtung der Figur 1 ergänzt um einen zweiten Strahlungsempfänger (PD2) und ein zweites Sensorelement mit mindestens einem weiteren zweiten paramagnetischen Zentrum (NV2) bzw. mit einer zweiten Vielzahl (NVC2) zweiter paramagnetischer Zentren (NV2). Bevorzugt handelt es sich bei dem ersten Sensorelement mit dem ersten paramagnetischen Zentrum (NV1) bzw. der Vielzahl (NVC) paramagnetischer Zentren (NV1) um einen oder mehrere erste Diamantkristalle mit einem oder mehreren ersten NV-Zentren. Bevorzugt koppeln diese ersten NV-Zentren untereinander. Bevorzugt handelt es sich bei dem zweiten Sensorelement mit dem zweiten paramagnetischen Zentrum (NV2) bzw. der zweiten Vielzahl (NVC2) zweiter paramagnetischer Zentren (NV2) um einen oder mehrere zweite Diamantkristalle mit einem oder mehreren zweiten NV-Zentren. Bevorzugt koppeln diese zweiten NV-Zentren untereinander. Das erste Sensorelement mit dem ersten paramagnetischen Zentrum (NV1) bzw. der Vielzahl (NVC) paramagnetischer Zentren (NV1) ist beabstandet von dem zweiten Sensorelement mit dem zweiten paramagnetischen Zentrum (NV2) bzw. der zweiten Vielzahl (NVC2) zweiter paramagnetischer Zentren (NV2) . Bevorzugt wird die erste optische Übertragungsstrecke der Pumpstrahlung (LB) von der Pumpstrahlungsquelle (PL1) zum ersten Sensorelement mit dem ersten paramagnetischen Zentrum (NV1) bzw. der Vielzahl (NVC) paramagnetischer Zentren (NV1) so ausgelegt, dass sie in etwa die gleichen optischen Übertragungseigenschaften aufweist, wie die zweite optische Übertragungsstrecke von der Pumpstrahlungsquelle (PL1) zum zweiten Sensorelement mit dem zweiten paramagnetischen Zentrum (NV2) bzw. der zweiten Vielzahl (NVC2) zweiter paramagnetischer Zentren (NV2).

Die Pumpstrahlungsquelle (PL1) bestrahlt daher das erste Sensorelement mit dem ersten paramagnetischen Zentrum (NV1) bzw. der Vielzahl (NVC) paramagnetischer Zentren (NV1) mit Pumpstrahlung (LB) und veranlasst somit das erste paramagnetische Zentrum (NV1) bzw. die Vielzahl (NVC) paramagnetischer Zentren (NV1) zur Abgabe einer ersten Fluoreszenzstrahlung (FL1). Der erste Strahlungsempfänger (PD1) empfängt diese erste Fluoreszenzstrahlung (FL1). Eine Barriere (BA) verhindert, dass das zweite paramagnetische Zentrum (NV2) bzw. die zweite Vielzahl (NVC2) zweiter paramagnetischer Zentren (NV2) die von diesem emittierte, zweite Fluoreszenzstrahlung (FL22) in den ersten Strahlungsempfänger (PD1) direkt einstrahlen kann.

Die Pumpstrahlungsquelle (PL1) bestrahlt daher das zweite Sensorelement mit dem zweiten paramagnetischen Zentrum (NV2) bzw. der zweiten Vielzahl (NVC2) zweiter paramagnetischer Zentren (NV2) mit Pumpstrahlung (LB) und veranlasst somit das zweite paramagnetische Zentrum (NV2) bzw. die zweite Vielzahl (NVC2) zweiter paramagnetischer Zentren (NV2) zur Abgabe von zweiter Fluoreszenzstrahlung (FL22). Der zweite Strahlungsempfänger (PD2) empfängt diese zweite Fluoreszenzstrahlung (FL22). Eine Barriere (BA) verhindert, dass das erste paramagnetische Zentrum (NV1) bzw. die Vielzahl (NVC) paramagnetischer Zentren (NV1) die von diesem emittierte, erste Fluoreszenzstrahlung (FL1) in den zweiten Strahlungsempfänger (PD2) direkt einstrahlen kann.

Durch die bekannte Beabstandung des ersten Sensorelements mit dem ersten paramagnetischen Zentrum (NV1) bzw. mit der Vielzahl (NVC) paramagnetischer Zentren (NV1) gegenüber dem zweiten Sensorelement mit dem zweiten paramagnetischen Zentrum (NV2) bzw. mit der zweiten Vielzahl (NVC2) zweiter paramagnetischer Zentren (NV2) kann beispielsweise ein Mikrorechner (µC), der ein Teil der integrierten Schaltung (IC) sein kann, einen Gradienten der magnetischen Flussdichte (B) ermitteln, in dem er die zwei Messwerte der magnetischen Flussdichte (B) mit Hilfe des ersten Sensorelements mit dem ersten paramagnetischen Zentrum (NV1) bzw. mit der Vielzahl (NVC) paramagnetischer Zentren (NV1) und mit Hilfe des zweiten Sensorelements mit dem zweiten paramagnetischen Zentrum (NV2) bzw. mit der zweiten Vielzahl (NVC2) zweiter paramagnetischer Zentren (NV2) ermittelt. Der Mikrorechner (µC) berechnet die Differenz der beiden Messwerte und dividiert diese Werte durch den bekannten Abstand des ersten Sensorelements mit dem ersten paramagnetischen Zentrum (NV1) bzw. der Vielzahl (NVC) paramagnetischer Zentren (NV1) zum zweiten Sensorelement mit dem zweiten paramagnetischen Zentrum (NV2) bzw. der zweiten Vielzahl (NVC2) zweiter paramagnetischer Zentren (NV2) und erhält so näherungsweise die Ableitung der magnetischen Flussdichte (B) längs der Linie zwischen dem ersten Sensorelement und dem zweiten Sensorelement. Der Mikrorechner (µC) kann dann beispielsweise über eine Datenleitung oder einen Datenbus (DB) diesen Messwert an ein übergeordnetes System, insbesondere ein übergeordnetes Rechnersystem, weitergeben.

### Figur 32

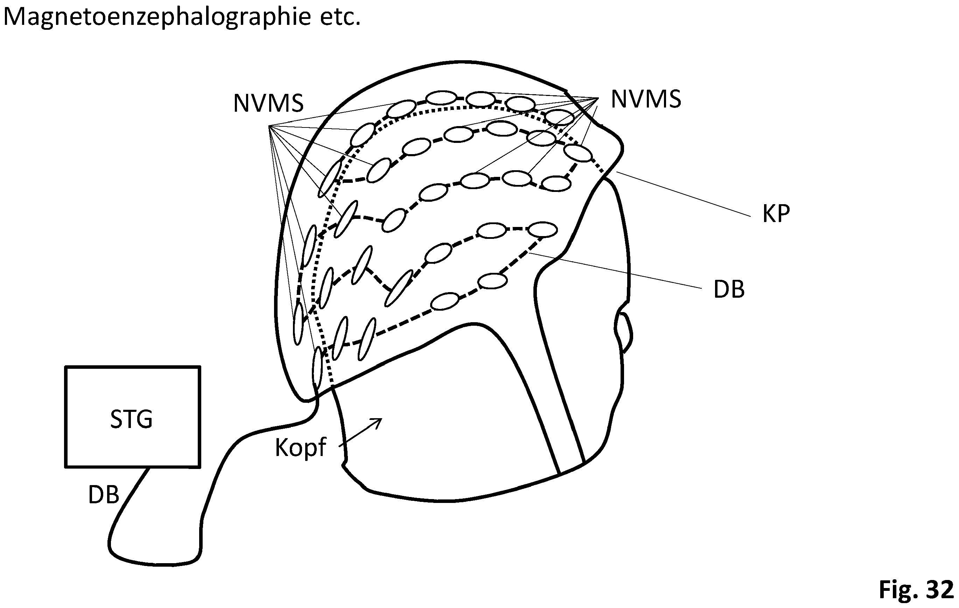

Figur 32 zeigt dein Einsatz mehrerer Sensorsysteme (NVMS), die jeweils mindestens ein Sensorelement mit mindestens einem paramagnetischen Zentrum (NV1) bzw. einer Vielzahl (NVC) paramagnetischer Zentren (NV1) umfassen, als magnetoenzephalographisches Erfassungssystem.

Die Sensorsysteme (NVMS) sind auf einer Kappe (KP), die bevorzugt, aber nicht notwendigerweise, starr ist, bevorzugt gleichmäßig verteilt. Die Sensorsysteme (NVMS) sind bevorzugt an einen Datenbus (DB), der bevorzugt den Sensorsystemen (NVMS) gemeinsam ist, angeschlossen.

Im Falle einer starren Kappe (KP) (z.B. eines Helmes) sind die relativen Positionen der Systeme zueinander bekannt. Daher können dann aus den gemessenen Magnetfeldern der Hirnströme in Form von Werten der magnetischen Flussdichte (B) ortsaufgelöste Informationen über diese Ströme ermittelt werden. Dies ist natürlich auch für andere Körperteile, möglich. Beispielsweise ist es denkbar, die Sensoren mittels einer Matte gleichmäßig über eine Liegefläche zu verteilen, so dass eine Ganzkörpermessung möglich wird.

Ein Steuergerät (STG) ist mit dem Datenbus (DB) verbunden. Das Steuergerät veranlasst über den Datenbus (DB) ein oder mehrere Sensorsysteme (NVMS) zu einem bestimmten Zeitpunkt die magnetische Flussdichte (B) am Ort des oder der paramagnetischen Zentren (NV1) bzw. am Ort der Vielzahl (NVC) paramagnetischer Zentren (NV1) zu erfassen. Das Steuergerät (STG) empfängt von den Sensorsystemen (NVMS) Messwerte für die Flussdichte (B) am Ort des oder der paramagnetischen Zentren (NV1) bzw. am Ort der Vielzahl (NVC) paramagnetischer Zentren (NV1). Das Steuergerät (STG) verarbeitet diese Messwerte.

### Figur 33

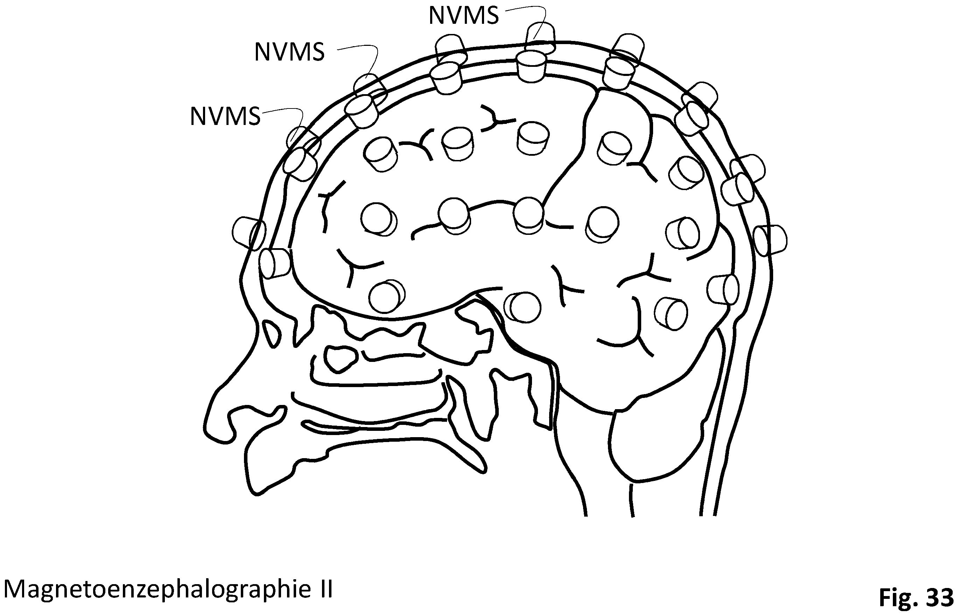

Figur 33 stellt noch einmal die Positionierung der Sensorsysteme (NVMS) mit den paramagnetischen Zentren (NV1) gegenüber dem Gehirn zur weiteren Verdeutlichung der Idee der Figur 32 dar.

### Figur 34

Werden die Gehirnströme, wie in den Figuren 32 und 33 dargestellt, mit Hilfe von mehreren Sensorsystemen (NVMS) erfasst. So können sie zum einen analysiert werden, aber zum anderen auch zum Erkennen von Willensäußerungen des Trägers der Kappe (KP) der Figur 32 genutzt werden. Im Prinzip ist es nicht wichtig, ob eine Willensäußerung des Trägers oder eine zeitlich-räumliche Struktur der Hirnströme zu medizinischen Zwecken erkannt werden soll.

Eine solche Vorrichtung umfasst bevorzugt ein Sensorsystem oder besonders bevorzugt eine Mehrzahl von Sensorsystemen (NVMS).

Dabei umfasst jedes dieser Sensorsysteme (NVMS) ein oder mehrere paramagnetische Zentren (NV1) oder eine Vielzahl (NVC) paramagnetischer Zentren (NV1). Bevorzugt weist jedes der Sensorsysteme (NVMS) eine Pumpstrahlungsquelle (PL1) auf, die mit einer Pumpstrahlung (LB) das eine oder die mehreren paramagnetischen Zentren (NV1) oder die Vielzahl (NVC) paramagnetischer Zentren (NV1) bestrahlt, und so zur Emission von Fluoreszenzstrahlung (FL) veranlasst. Diese Emission der Pumpstrahlung (LB) erfolgt in Abhängigkeit von einem Sendesignal (S5). Ein erster Strahlungsempfänger (PD1) wandelt einen Signalanteil des Signals der Fluoreszenzstrahlung (FL) in ein Empfängerausgangssignal (S0) um. Eine Auswerteschaltung erzeugt bevorzugt das Sendesignal (S5). Die Auswerteschaltung korreliert bevorzugt das Empfängerausgangssignal (S0) mit dem Sendesignal (S5) oder mit einem Vorgängersignal des Sendesignals (S5) aus dem das Sendesignal (S5) ggf. erzeugt wurde, oder mit einem aus dem Sendesignal (S5) ab geleiteten Signal und erzeugt so einen Wert, der beispielsweise den Wert der Intensität der Fluoreszenzstrahlung (FL) oder den Wert der Fluoreszenzphasenverschiebungszeit (ΔTFL) widerspiegelt. Dieser Wert kann über ein erstes Ausgangssignal (out) des Sensorsystems (NVMS) ausgegeben werden. Es ist aber sinnvoll, wenn der Wert in digitalisierter Form beispielsweise mit Hilfe eines Mikrorechners (µC), der Teil des Sensorsystems (NVMS) sein kann, über einen Datenbus (DB) weitergegeben wird.

Die Vorrichtung umfasst daher bevorzugt auch einen oder mehrere Datenbusse (DB), die die von den Sensorsystemen (NVMS) erfassten Daten an eine Schnittstelle einer Ansteuerungs- und Aufbereitungseinheit (IF) der Vorrichtung weiterleiten.

Die Vorrichtung umfasst bevorzugt eine Haltevorrichtung, die die Sensorsysteme (NVMS) an dem zu vermessenden biologischen Objekt mechanisch im Wesentlichen ausreichend stabil fixiert. Im Falle eines zu vermessenden menschlichen Gehirns, ist diese Haltevorrichtung bevorzugt eine Kappe (KP). Sollen Tiere vermessen werden, sind andere Haltevorrichtungen denkbar und sinnvoll, die funktionsäquivalent an die Kopfform des jeweiligen Tieres angepasst werden können.

Für die besagte Mustererkennung werden mit Hilfe einer Kappe (KP) oder einer entsprechenden funktionsäquivalenten Vorrichtung mit mehreren Sensorsystemen (NVMS), die jeweils mindestens ein Sensorelement (NVMS) mit jeweils mindestens einem oder mehreren paramagnetischen Zentren (NV1) oder einer Vielzahl (NVC) paramagnetischer Zentren (NV1) aufweisen, Messwerte der magnetischen Flussdichte (B) oder der besagten anderen physikalischen Parameter am jeweiligen Ort des paramagnetischen Zentrums (NV1) bzw. der Vielzahl (NVC) paramagnetischer Zentren (NV1) des jeweiligen Sensorsystems (NVMS) aufgenommen.

Bevorzugt erfolgt dies zeitdiskret zu synchronisierten Messzeitpunkten. Hierzu sendet die Ansteuerungs- und Aufbereitungseinheit (IF) der Vorrichtung beispielsweise mittels eines sogenannten Broad-Cast-Befehls einen Start- oder Synchronisationsbefehl an alle Sensorsysteme (NVMS) der Kappe (KP) über den bevorzugt gemeinsamen Datenbus (DB). Die Sensorsysteme (NVMS) weisen hierzu bevorzugt den besagten eigenen Mikrorechner (µC) auf, der an den Datenbus (DB) angeschlossen ist und die anderen Vorrichtungen des diesem Mikrorechner (µC) zugehörigen Sensorsystems (NVMS), sofern notwendig, steuert und ggf. überwacht. Nachdem diese Mikrorechner (µC) der zugehörigen Sensorsysteme (NVMS) über den besagten Datenbus (DB) den Synchronisations- oder Startbefehls empfangen haben, messen alle Sensorsystem (NVMS) bevorzugt zu gleichen Zeitpunkten die jeweilig magnetische Flussdichte (B) bzw. den betreffenden physikalischen Parameter am Ort ihrer jeweiligen paramagnetischen Zentren (NV1) bzw. am Ort der Vielzahl (NVC) paramagnetischer Zentren (NV1) ihrer betreffenden Sensorelemente.

Die Mikrorechner (µC) der Sensorsysteme (NVMS) übertragen sodann ihren jeweiligen ermittelten Messwert der magnetischen Flussdichte (B) bzw. der betreffenden erfassten physikalischen

Parameter über den bevorzugt gemeinsamen Datenbus (DB) an die Ansteuerungs- und Aufbereitungseinheit (IF). Wir beschreiben nun die Erfassung der magnetischen Flussdichte (B) als Beispiel für die Erfassung eines physikalischen Parameters. Weitere physikalische Parameter neben der magnetischen Flussdichte (B), die ggf. mittels der Intensität (I_{fl}) der Fluoreszenzstrahlung (FL) des paramagnetischen Zentrums (NV1) bzw. der Vielzahl (NVC) paramagnetischer Zentren und/oder eines Werts der Fluoreszenzphasenverschiebungszeit (ΔTFL) der Fluoreszenzstrahlung (FL) des paramagnetischen Zentrums (NV1)bzw. der Vielzahl (NVC) paramagnetischer Zentren auf die in dieser Offenlegung beschriebenen Weise gemessen werden könnten, wären beispielsweise elektrische Flussdichte D, Beschleunigung a, Gravitationsfeldstärke g, Druck P, Temperatur 9, Rotationsgeschwindigkeit ω, Schwingfrequenz mechanischer Teile (Balken), Position, Intensität ionisierender Strahlung, etc. Durch die Erfassung eines Werts, der der Intensität (I_{fl}) der Fluoreszenzstrahlung (FL) und/oder eines Werts der Fluoreszenzphasenverschiebungszeit (ΔTFL) entspricht, kann somit ein Wert als Messwert für einen Wert einer oder mehrere dieser physikalischen Größen ermittelt werden. Im Folgenden wird beispielhaft für diese physikalischen Parameter die Erfassung der magnetischen Flussdichte (B) beschrieben, ohne dass die folgende Beschreibung dadurch auf diesen physikalischen Parameter begrenzt wird. Auf die technische Lehre der zum Zeitpunkt der Anmeldung noch unveröffentlichten PCT DE 2020 100 648 wird ausdrücklich verwiesen. Bei n Sensorsystemen (NVMS) und beispielsweise einem erfassten physikalischen Parameter wird somit von den Sensorsystemen (NVMS) der Kappe (KP) ein n-dimensionaler Messwertvektor der Werte der magnetischen Flussdichten (B) zum jeweiligen Messzeitpunkt übertragen. Durch die Vorgabe einer zeitlichen Folge von Messzeitpunkten durch die Ansteuerungs- und Aufbereitungseinheit (IF) übertragen somit die Sensorsysteme (NVMS) der Kappe (KP) eine zeitliche Abfolge von Messwertvektoren der Werte der magnetischen Flussdichten (B) oder anderer physikalischer Parameter, die mit Hilfe der paramagnetischen Zentren (NV1) der Sensorsysteme (NVMS) erfasst wurden, zu den Messzeitpunkten dieser zeitlichen Folge von Messzeitpunkten an die Ansteuerungs- und Aufbereitungseinheit (IF). Die Ansteuerungs- und Aufbereitungseinheit (IF) führt typischerweise eine Aufbereitung dieser zeitlichen Abfolge von Messwertvektoren durch. Dies kann Integrationen, Differentiation und andere komplexere Filterungen umfassen, wie sie aus der Signaltheorie und Nachrichtentechnik sowie der künstlichen Intelligenz bekannt sind. Diese Operationen der Ansteuerungs- und Aufbereitungseinheit (IF) können die Dimensionalität der dann an die Mustererkennung übertragenen Daten erhöhen. Die Ansteuerungs- und Aufbereitungseinheit (IF) erzeugt auf diese Weise aus der zeitlichen Abfolge von Messwertvektoren einen neuen Datenstrom aufbereiteter, vektorieller, aktueller Daten. Diese Vektoren werden in der Fachliteratur der Mustererkennung auch als Merkmalsvektoren bezeichnet. Es werden also aus mehreren Messdaten, die mit Hilfe eines oder mehrerer paramagnetischer Zentren (NV1) der Sensorsysteme (NVMS) gewonnen wurden, Merkmalsvektoren erzeugt. Die Ansteuerungs- und Aufbereitungseinheit (IF) überträgt diesen neuen Datenstrom aufbereiteter, vektorieller, aktueller Daten in der Form eines Stromes von Merkmalsvektoren mittels eines vektoriellen Ausgangsdatenstroms (VDS) der Ansteuerungs- und Aufbereitungseinheit (IF) an einen Mustererkenner (NN). Der Mustererkenner (NN) kann Teil des Steuerrechners (CTR) sein.

Der Mustererkenner (NN), der beispielsweise ein neuronales Netzwerkmodell (neuronales Netz) auf einem Rechnersystem des Mustererkenners (NN) zur Erkennung von Mustern (Englisch: Pattern) in den empfangenen Merkmalsvektoren ausführen kann, ordnet bevorzugt die von der Ansteuerungs- und Aufbereitungseinheit (IF) an den Mustererkenner (NN) übertragenen, derartig aufbereiteten vektoriellen aktuellen Daten, also die Merkmalsvektoren, voraufgezeichneten oder vorgegebenen vektoriellen Prototypendatensätzen von Prototypen aus einer Prototypendatenbank des Mustererkenners (NN) zu. Die Prototypen sind bevorzugt Merkmalsvektoren, die beispielsweise mit Hilfe von Klassifikationsprogrammen aus zuvor erfassten Merkmalsvektordatensätzen bekannter manuell bewerteter Situationen durch Klassifikation gewonnen werden. Hierzu sei auf das Buch Francisco Herrera, Francisco Charte, Antonio J. Rivera, Maria J. del Jesus, "Multilabel Classification: Problem Analysis, Metrics and Techniques", Springer, 22. April 2018, ISBN-13 : 978-3319822693 verwiesen. Diese Prototypendatenbank umfasst bevorzugt die aufbereiteten, vektoriellen, zuvor aufgezeichneten Daten der prototypischen Situationen, deren vorerfasste Merkmalsvektoren in der Prototypendatenbank die Prototypen darstellen. Jedem Prototypen, also jedem prototypischen Merkmalsvektor, ist in der Prototypendatenbank ein für diesen Prototypen spezifisches Symbol zugeordnet. Die Ansteuerungs- und Aufbereitungseinheit (IF) übermittelt die aktuellen Merkmalsvektoren als aufbereitete, vektorielle und aktuelle Daten. Die aufbereiteten, vektoriellen und aktuellen Daten liegen als Merkmalsvektoren vor. Die Prototypen liegen in Form von prototypischen Merkmalsvektoren als zuvor aufgezeichnete prototypische, vektorielle Daten vor. Wird ein Prototyp, also ein prototypischer Merkmalsvektor, durch den Mustererkenner (NN) in diesen aufbereiteten, vektoriellen und aktuellen Daten mittels des Vergleichs dieser aufbereiteten, vektoriellen, aktuellen Daten mit diesen prototypischen, vektoriellen, zuvor aufgezeichneten Daten erkannt, so wird ein Symbol für diesen erkannten Prototypen, also den erkannten prototypischen vektoriellen und zuvor aufgezeichneten Datenvektor, durch den Mustererkenner (NN) an einen Steuerrechner (CTR) übergeben. Diese Übergabe an den Steuerrechner (CTR) erfolgt beispielsweise mittels eines Ausgangsdatenstrom (MDS) der durch den Mustererkenner (NN) erkannten Prototypen. Mit den Symbolen für die erkannten Prototypen können auch Parameter, wie beispielsweise die Wahrscheinlichkeit für das Vorliegen eines solchen Prototypen übergeben werden.

Der Mustererkenner (NN) führt mit einem Rechnersystem des Mustererkenners (NN) bevorzugt ein Programm der Mustererkennung aus. Hierbei kann es sich um ein neuronales Netzt oder einen HMM-Erkenner oder ein Petri-Netz handeln.

Der Steuerrechner (CTR) steuert bevorzugt mittels einer Leitung und/oder eines Datenbusses (IFL) zur Steuerung der Ansteuerungs- und Aufbereitungseinheit (IF) die Ansteuerungs- und Aufbereitungseinheit (IF) und erhält ggf. über diesen Weg Statusdaten und andere Daten von der Ansteuerungs- und Aufbereitungseinheit (IF).

Der Steuerrechner (CTR) steuert bevorzugt mittels einer Leitung und/oder eines Datenbusses (NNL) zur Steuerung des Mustererkenners (NN) den Mustererkenner (NN) und erhält ggf. über diesen Weg Statusdaten und andere Daten von dem Mustererkenner (NN).

In Abhängigkeit von dem, den erkannten Prototypen repräsentierenden, Symbol, kann der Steuerrechner (CTR) nun beispielsweise Ausgaben, beispielsweise über Lautsprecher (LS), Anzeigen und Bildschirme (DSP) vornehmen oder Aktoren (AKT), wie Motoren, Heizer, Schaltmagnete, etc., oder beispielsweise Vorrichtung, wie beispielsweise Fahrzeuge, Roboter, Flugkörper, Schwimm- und Tauchkörper, Waffensysteme, Computer-Schnittstellen, etc., steuern. Der Steuerrechner (CTR) kann natürlich über zur Vereinfachung nicht eingezeichnete Eingabegeräte, wie Tastaturen, etc., zusätzlich gesteuert werden. Auch kann der Steuerrechner (CTR) wieder weitere Datenschnittstellen, die drahtgebunden und/oder drahtlos sein können aufweisen. Insbesondere kann der Steuerrechner (CTR) an das Internet oder einen anderen Datenverbund oder einen anderen Rechner ggf. auch über eine quantenkryptografisch verschlüsselte Datenübertragungsstrecke angebunden sein. Das bedeutet, dass die beispielhaften Ausgabeeinheiten wie Lautsprecher (LS), Bildschirme (DSP) und Aktoren (AKT) oder gesteuerten Vorrichtungen sich ganz oder teilweise örtlich entfernt von dem Träger der Kappe (KP) befinden können.

Beispielsweise ist es denkbar, auf diese Weise Roboter und/oder andere Vorrichtungen in unmittelbarer Nähe des Trägers der Kappe (KP) oder aber auch entfernt von diesem zu steuern.

Es ist denkbar, dass mehrere Personen auf diese Weise Steuerbefehle für eine Vorrichtung erzeugen. Bevor die Steuerbefehle an die Vorrichtung weitergegeben werden, kann eine weitere übergeordnete Recheneinheit diese Steuerbefehle erfassen und bewerten. Eine Möglichkeit der Bewertung ist beispielsweise eine Mittelwertbildung oder die Blockierung von weiteren Steuerbefehlen für die Zeit der Ausführung des zuerst erfassten Steuerbefehls. Nach der Bewertung gibt die übergeordnete Recheneinheit den von ihr nach welchem Verfahren auch immer ausgewählten Steuerbefehl an die zu steuernde Vorrichtung weiter, die diesen Befehl dann ausführt.

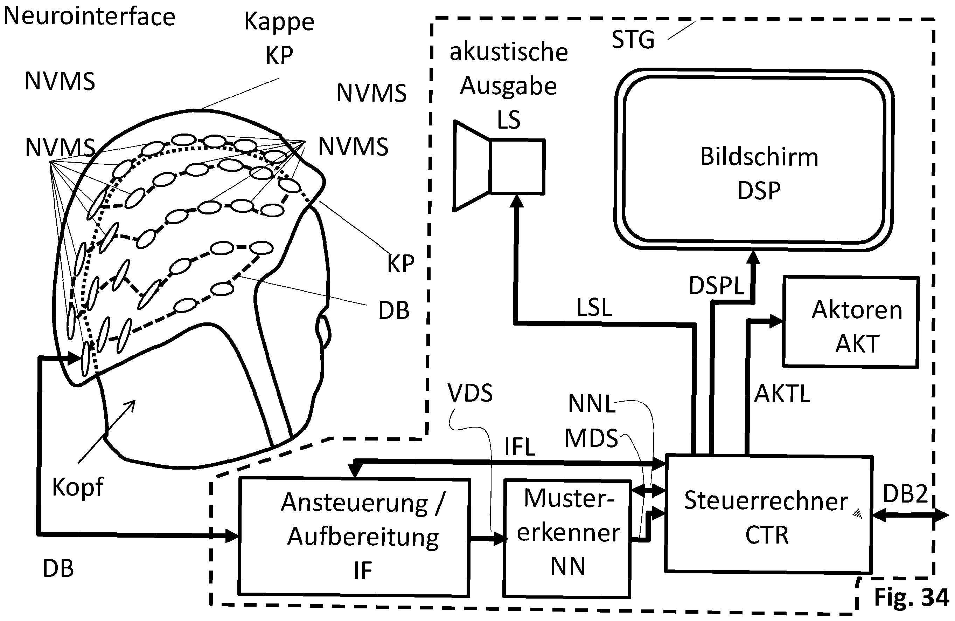

Das System der Figur 34 stellt also im weitesten Sinne ein Neurointerface zur Steuerung von Rechnersystemen und Vorrichtungen und deren Ausgaben dar, wobei das Rechnersystem in einen Rechnersystemverbund mit Rechnern eingebunden sein kann, die wiederum über Ein- und Ausgabegeräte und Aktoren und Sensoren verfügen.

Statt der Steuerung von Rechnersystemen kann ein System gleicher Topologie verwendet werden, um die Reaktion des Gehirns des Trägers der Kappe (KP) auf typischerweise vorgegebene Stimuli, die beispielsweise durch einen Lautsprecher (LS) oder einen Bildschirm (DSP) oder einen anderen Aktor (AKT) auf den Träger der Kappe (KP) einwirken, zu erfassen, und auf ggf. einem zweiten Bildschirm in aufbereiteter Form darzustellen, an andere Rechner eines Rechnerverbundes zu übertragen oder mittels eines Mustererkenners (NN) zu klassifizieren. Somit ist dieses System auch für medizinische Untersuchungen geeignet. Im Prinzip handelt es sich um einen Magnetoenzephalographen, wobei statt der im Stand der Technik üblichen SQUID-Sensoren hier Sensorsysteme (NVMS) mit jeweils einem oder mehreren Sensorelementen mit jeweils einem oder mehreren paramagnetischen Zentren (NV1) eingesetzt werden. Bevorzugt handelt es sich bei den Sensorelementen und den paramagnetischen Zentren um einen oder mehrere Diamanten mit einem oder mehreren NV-Zentren. Sofern die Sensorelemente jeweils mehrere paramagnetische Zentren (NV1) aufweisen, sind diese paramagnetischen Zentren (NV1) bevorzugt innerhalb eines Sensorelements miteinander gekoppelt. Eine Kopplung der paramagnetischen Zentren (NV1) über Sensorelemente hinweg ist denkbar.

### Figur 35

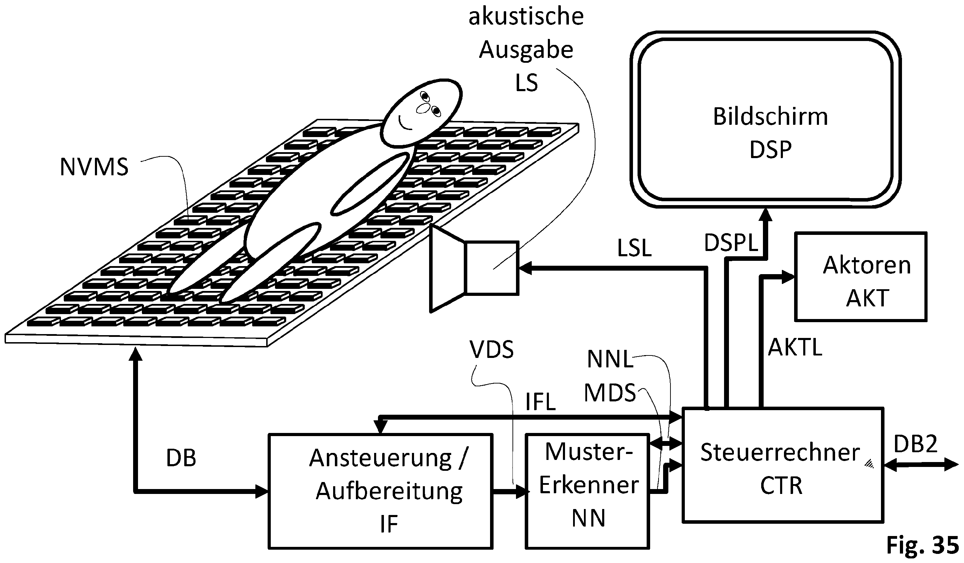

In Figur 35 sind die vorgeschlagenen Sensorsysteme (NVMS) statt auf einer Kappe (KP) beispielhaft flächenhaft angeordnet. Die Sensorsysteme (NVMS) können beispielsweise innerhalb einer ausrollbaren Matte, einer Trage oder einem Bett oder eine Liege oder einem Stuhl etc. angeordnet sein. Das Beispiel der Figur 35 soll nur darstellen, dass auch andere Körperteile von Menschen oder Tieren, der ganze menschliche Körper, ganze Tierkörper und/oder andere Objekte mit der Methodik der Figur 34 und Anordnungen entsprechend der Figur 34 untersucht und/oder klassifiziert werden können.

Die Aktoren (AKT) können ggf. so gestaltet werden, dass sie auf das Tier, bzw. den Menschen, oder auf andere Vorrichtungen zurückwirken können.

Beispielsweise ist es denkbar, biologische Ströme im Körper eines Tieres zu erkennen, auszuwerten, ggf. in Beziehung zu den Resultaten anderer Sensoren und weiteren Daten zu setzen und in Abhängigkeit hiervon mittels der Aktoren (AKT) auf das Tier einzuwirken, um ein geeignetes Verhalten hervorzurufen. Beispielsweise können so Tiere unter Zuhilfenahme von GPS-Daten und mobiler Datenkommunikation (z.B. mittels Mobiltelefonen) zur Zurücklegung einer bestimmten Wegstrecke und/oder zum Verweilen an einem bestimmten Ort veranlasst werden, was die Zustellung von Gegenständen von einem Ort A zu einem Ort B ermöglicht. Ein ähnliches Einwirken aufgrund von Gehirnzuständen ist mit Menschen möglich, um diese beispielsweise auf Gefahren aufmerksam zu machen oder vollautomatisch Medikamente zu verabreichen. Somit ist es denkbar, eine vollautomatische Medikamentengabe in Abhängigkeit von diesen magnetisch erfassten biologischen Strömen vorzunehmen, um beispielsweise Anfällen vorzubeugen.

### Figur 36

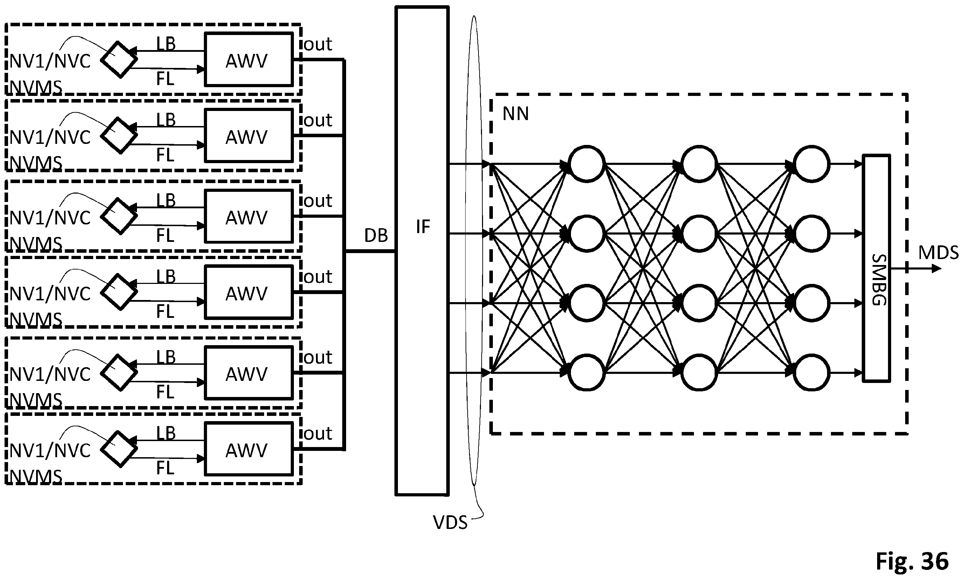

Figur 36 zeigt abstrahiert eine vereinfachte Vorrichtung zur Erkennung von Mustern mit Hilfe paramagnetischer Zentren (NV1) bzw. mit Hilfe von Clustern paramagnetischer Zentren (NV1), wobei hier unter Cluster eine Vielzahl (NVC) paramagnetischer Zentren (NV1) verstanden wird. In dem Beispiel der Figur 36 sind beispielhaft sechs Sensorsysteme (NVMS) mit jeweils einem oder mehreren paramagnetischen Zentren (NV1) bzw. einer Vielzahl (NVC) paramagnetischer Zentren (NV1) mit ihrem ersten Ausgangssignal (out) über einen Datenbus (DB) mit einer Ansteuerungs- und Aufbereitungseinheit (IF) gekoppelt. Bevorzugt umfassen die Sensorsysteme (NVMS) zu diesem Zweck einen Mikrorechner (µC), der mit einer Schnittstelle an dem Datenbus (DB) angeschlossen ist. Das erste Ausgangssignal (out) ist in dem Fall bevorzugt ein digitales Signal. Jedes Sensorsystem (NVMS) umfasst in dem Beispiel der Figur 36 eine Auswertevorrichtung (AWV). Die Auswertevorrichtung (AWV) erzeugt Pumpstrahlung (LB), mit der sie das eine oder die mehreren paramagnetischen Zentren (NV1) bestrahlt oder die Vielzahl (NVC) paramagnetischer Zentren (NV1) bestrahlt. Das eine oder die mehreren paramagnetischen Zentren (NV1) oder die Vielzahl (NVC) paramagnetischer Zentren (NV1) emittieren Fluoreszenzstrahlung (FL), die die Auswertevorrichtung (AWV) erfasst und auswertet. Dabei erzeugt die Auswertevorrichtung (AWV) in Abhängigkeit von der Fluoreszenzstrahlung (FL) ein erstes Ausgangssignal (out) mit einem Wert. Der Wert wird über den Datenbus (DB) von dem jeweiligen Sensorsystem (NVMS) an die Ansteuerungs- und Aufbereitungseinheit (IF) gesendet. Diese erzeugt aus den empfangenen mehreren Messwerten einen vektoriellen Ausgangsdatenstrom (VDS) der Ansteuerungs- und Aufbereitungseinheit (IF). In dem Beispiel der Figur 36 ist dieser Vektordatenstrom nur vierdimensional. In der Regel dürfte der Datenstrom eine andere Dimensionalität, typischerweise eine höhere Dimensionalität haben. In dem Beispiel der Figur 36 führt der Mustererkenner (NN) ein neuronales Netzwerkmodell mit drei Schichten von neuronalen Netzwerknoten aus. In der Realität werden die Anzahl der Schichten und die Anzahl der Knoten in den Schichten abweichen. Bevorzugt führt ein Rechnersystem innerhalb des Mustererkenners (NN) als übergeordnete Rechnersystem ein Programm der künstlichen Intelligenz aus. Ganz besonders bevorzugt führt das übergeordnete Rechnersystem des Mustererkenners (NN) eine Emulation eines neuronalen Netzwerkmodells aus. In diesem Zusammenhang wird wieder auf die noch unveröffentlichte, internationale Schutzrechtsanmeldung PCT/EP2020/056727 verwiesen, deren Offenbarungsgehalt vollumfänglicher Teil der hier vorgelegten Offenlegung ist.

Es wird somit ein übergeordnetes Rechnersystem vorgeschlagen, dass ein neuronales Netzwerkmodell ausführt. Dabei umfasst das neuronale Netzwerkmodell Netzwerkknoten, die in Netzwerkebenen organisiert sind. Jeder Netzwerkknoten des neuronalen Netzes weist Eingangs- und Ausgangsparameter auf. Zumindest ein, bevorzugt mehrere Eingangsparameter von Netzwerkknoten sind entweder ein Eingangsparameter des neuronalen Netzwerkmodells oder ein Ausgangsparameter eines anderen Netzwerkknotens des neuronalen Netzwerkmodells. Zumindest ein, bevorzugt mehrere Ausgangsparameter eines Netzwerkknotens sind ein Ausgangsparameter des neuronalen Netzwerkmodells oder ein Eingangsparameter eines anderen neuronalen Netzwerkknotens. Ein Netzwerknoten, bei dem ein Ausgangsparameter ein Ausgangsparameter des neuronalen Netzwerkmodells ist, weist keinen Eingangsparameter auf, der ein Eingangsparameter des neuronalen Netzwerkmodells ist. Ein Netzwerknoten, bei dem ein Eingangsparameter ein Eingangsparameter des neuronalen Netzwerkmodells ist, weist keinen Ausgangsparameter auf, der ein Ausgangsparameter des neuronalen Netzwerkmodells ist. Kein Netzwerkknoten des neuronalen Netzes, bei dem ein Ausgangsparameter ein Ausgangsparameter des neuronalen Netzwerkmodells ist, weist einen Eingangsparameter auf, der ein Ausgangsparameter eines anderen Netzwerkknotens ist, bei dem ein Eingangsparameter dieses anderen Netzwerkknotens ein Eingangsparameter des neuronalen Netzwerkmodells ist. Die Eingangsparameter eines Netzwerkknotens des neuronalen Netzwerkmodells werden innerhalb eines Netzwerkknotens mittels einer Verknüpfungsfunktion für den betreffenden neuronalen Netzwerkknoten mit den Ausgangsparametern dieses neuronalen Netzwerkknotens verknüpft. Bevorzugt ist diese Verknüpfungsfunktion stark nichtlinear. Die Eigenschaften der Verknüpfungsfunktion hängen dabei von Verknüpfungsfunktionsparametern ab, die bevorzugt spezifisch für den jeweiligen Netzwerkknoten sind. Die Verknüpfungsfunktion kann von Netzwerkknoten zu Netzwerknoten unterschiedlich sein. Die Verknüpfungsfunktionsparameter werden in einem Trainingsprozess ermittelt und antrainiert. Die Beschreibung hier beschreibt ein zumindest dreischichtiges neuronales Netz mit mindestens drei Netzebenen, wie es in der Figur 36 als neuronales Netzwerkmodell innerhalb des Mustererkenners (NN) symbolisch dargestellt ist.

Es wird nun vorgeschlagen, dass zumindest ein, bevorzugt mehrere Eingangsparameter des neuronalen Netzwerkmodells, dass die übergeordnete Rechnereinheit des Mustererkenners (NN) ausführt, von einem Parameter der paramagnetischen Zentren (NV1) oder der Vielzahl (NVC) paramagnetischer Zentren (NV1) in den jeweiligen Sensorsystemen (NVMS) abhängen. Ein solcher Parameter kann beispielsweise der Wert der Intensität der Fluoreszenzstrahlung (FL) und/oder der Wert der Fluoreszenzphasenverschiebungszeit (ΔTFL) sein.

Die Verwendung von solchen Methoden und Verfahren der künstlichen Intelligenz ist von besonderer Bedeutung für das autonome Fahren und/oder den betrieb komplexer Systeme und/oder dem Betrieb von Vorrichtungen in ggf. komplexen Umgebungen oder wie in den Figuren 32 bis 35 für die Realisierung eines Neuro-Interfaces. Ein Symbolgenerator (SMBG), der Teil des von dem Rechnersystem des Mustererkenners (NN) ausgeführten Programms sein kann, erzeugt in Abhängigkeit von den Ausgangsparametern des neuronalen Netzwerkmodells eine Folge von Symbolen in Form eines Ausgangsdatenstroms (MDS) der durch den Mustererkenner (NN) erkannten Prototypen. Hier überträgt der Mustererkenner (NN) vorzugsweise nur die Symbole als Repräsentanten der erkannten prototypischen Merkmalsvektoren der Prototypendatenbank.

Damit das neuronale Netz des Mustererkenners (NN) in die Lage versetzt werden kann, diese prototypischen Merkmalsvektoren der Prototypendatenbank zu erkennen wird das neuronale Netzwerkmodell in einem Trainingsbetrieb mit diesen prototypischen Merkmalsvektoren als Eingangsvektoren des neuronalen Netzes stimuliert. Die Ausgangsparameter des neuronalen Netzwerkmodells werden mit Vorgabewerten verglichen und die Verknüpfungsparameter der Verknüpfungsfunktion der neuronalen Netzwerkknoten werden entsprechend dem Lern-Algorithmus so lange modifiziert, bis die Bewertung der Fehler bei der Erkennung der Trainingsdatensätze ein vorgegebenes Maß unterschreitet. Das so trainierte neuronale Netz kann dann für die Erkennung der Muster eingesetzt werden. In ähnlicher Weise können Methoden des "machine learnings" und des "deep-learnings" eingesetzt werden. Hier sei beispielhaft auf das Fachbuch von Charu C. Aggarwal, "Neural Networks and Deep Learning: A Textbook" Springer; 1st ed. 2018 Auflage (13. September 2018) hingewiesen. Die dort beschriebenen Methoden sind vollumfänglicher Teil der hier vorgelegten Offenlegung.

### Figur 37

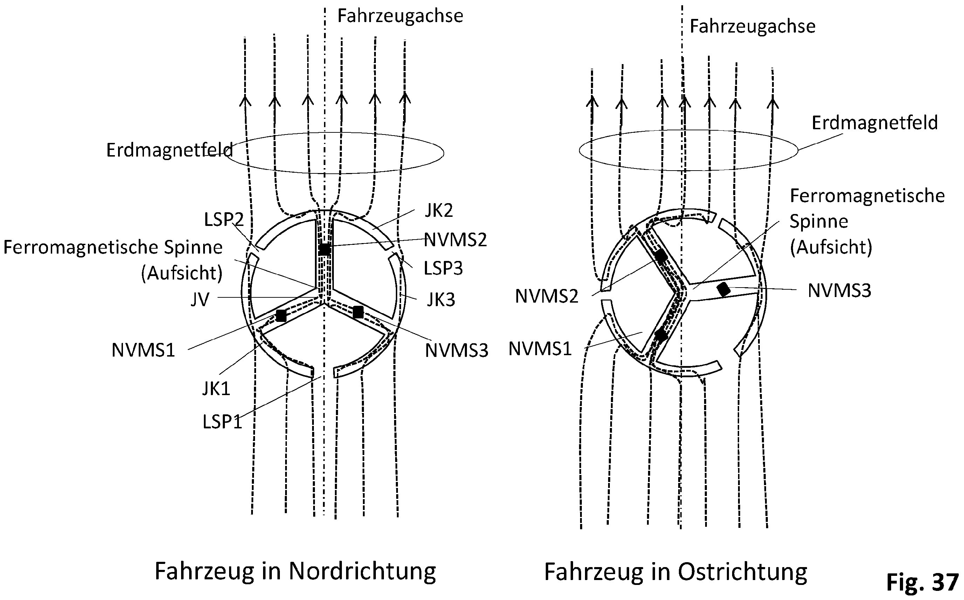

Figur 37 zeigt eine einfache Vorrichtung zur Erfassung der Ausrichtung des Erdmagnetfeldes mit Hilfe dreier Sensorsystem (NVMS1, NVMS2, NVMS3) mit paramagnetischen Zentren (NV1) bzw. einer jeweiligen Vielzahl (NVC) paramagnetischer Zentren (NV1).

Figur 37 zeigt ein als Kern der Vorrichtung bevorzugt ferromagnetisches, rotationssymmetrisches Joch (JK1, JK2, JK3, JV) mit einer bevorzugt ungradzahligen Rotationssymmetrie. In Figur 37 ist beispielhaft eine dreizählige Rotationssymmetrie dargestellt.

Das beispielhafte Joch (JK1, JK2, JK3, JV) umfasst ein ringförmiges Teiljoch (JK1, JK2, JK3). Dieses ringförmige Teiljoch (JK1, JK2, JK3) ist in dem Beispiel der Figur 37 durch beispielhaft drei Luftspalte (LSP1, LSP2, LSP3) in ein erstes Jochsegment (JK1) und in ein zweites Jochsegment (JK2) und in ein drittes Jochsegment (JK3) unterteilt.

Der erste Luftspalt (LSP1) befindet sich dabei zwischen dem ersten Jochsegment (JK1) und dem dritten Jochsegment (JK3). Der zweite Luftspalt (LSP2) befindet sich dabei zwischen dem zweiten Jochsegment (JK2) und dem ersten Jochsegment (JK1). Der dritte Luftspalt (LSP3) befindet sich dabei zwischen dem dritten Jochsegment (JK3) und dem zweiten Jochsegment (JK2). In dem Beispiel der Figur 37 rufen die drei Luftspalte (LSP1, LSP2, LSP3) eine dreizählige Rotationssymmetrie des ringförmigen Teiljochs (JK1, JK2, JK3) hervor.

Ein Verbindungsjoch (JV) weist eine gleiche Rotationssymmetrie um die gleiche Rotationsachse wie das Teiljoch (JK1, JK2, JK3) auf. In dem Beispiel der Figur 37 weist das Y-förmige Verbindungsjoch (JV) eine dreizählige Rotationssymmetrie um die gleiche Rotationsachse wie die dreizählig rotationssymmetrischen Teiljoche (JK1, JK2, JK3) auf. Das Verbindungsjoch (JV) besteht in dem Beispiel der Figur 37 aus beispielhaft drei Stegen, die eine magnetische Verbindung zwischen den beispielhaft drei Teiljochen (JK1, JK2, JK3) untereinander herstellen, wobei diese magnetische Verbindung bevorzugt über den Ort der Symmetrieachse der Rotationssymmetrie verläuft.

Jedem der beispielhaft drei Teiljoche (JK1, JK2, JK3) ist dabei ein Steg zugeordnet. Dieser stellt den magnetischen Kontakt bevorzugt in einem Symmetriepunkt desjeweiligen Teiljochs (JK1, JK2, JK3) her, damit die magnetische Strecke innerhalb des Teiljochs in beide Richtungen vom Kontaktpunkt weg gleich ist. Bevorzugt werden nun in jeden der drei Stege bevorzugt drei Sensorsysteme (NVMS1, NVMS2, NVMS3) mit Sensorelementen mit paramagnetischen Zentren (NV1) so eingefügt, dass der magnetische Fluss (B) innerhalb der jeweiligen Stege die jeweiligen paramagnetischen Zentren (NV1), bzw. die jeweiligen Cluster paramagnetischer Zentren (NV1) in Form einer Vielzahl (NVC) paramagnetischer Zentren (NV1) der entsprechenden Sensorsysteme (NVMS1, NVMS2, NVMS3), jeweils durchflutet. Dies kann beispielsweise durch jeweils einen Luftspalt in jedem der drei Stege sichergestellt werden, in den jeweils eines der drei Sensorsysteme (NVMS1, NVMS2, NVMS3) und/oder das paramagnetische Zentrum (NV1) oder die Vielzahl (NVC) paramagnetischer Zentren (NV1) des jeweiligen Sensorsystems (NVMS1, NVMS2, NVMS3) eingefügt ist.

Hierdurch sind die jeweiligen Sensorsysteme (NVMS1, NVMS2, NVMS3) in der Lage, den magnetischen Fluss (B) innerhalb des jeweiligen Steges der drei Stege zu erfassen. Die beispielhaft drei Sensorsysteme (NVMS1, NVMS2, NVMS3) ermitteln zu jedem Messzeitpunkt dann drei Messwerte der jeweiligen magnetischen Flussdichte (B).

Je nach Ausrichtung dieser Anordnung zu einem externen Magnetfeld mit einer externen magnetischen Flussdichte (B), beispielsweise dem Erdmagnetfeld, wird die sich so ergebende ferromagnetische Spinne, die durch das ferromagnetische, rotationssymmetrische Joch (JK1, JK2, JK3, JV) gebildet wird, unterschiedlich durch das Magnetfeld in Form der externen magnetischen Flussdichte (B) durchflutet. Hierdurch unterscheiden sich die drei Werte der beispielhaft dreidimensionalen vektoriellen Messsignale der drei Sensorsysteme (NVMS1, NVMS2, NVMS3) je nach Ausrichtung der Vorrichtung im Magnetfeld. Ein solches vektorielles Messsignal kann beispielsweise zur Steuerung von Fahrzeugen, Robotern, Flugkörpern, Schiffskörpern, etc., und zur Navigation eingesetzt werden.

### Figur 38

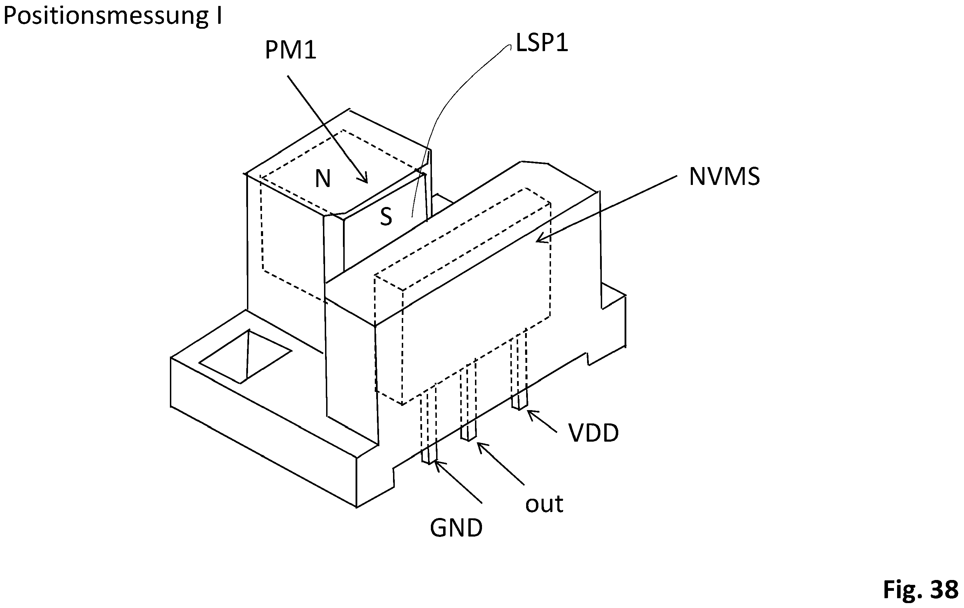

Figur 38 zeigt einen beispielhaften Schlitzsensor. Derbeispielhafte Schlitzsensor weist einen magnetischen Kreis auf, der über einen ersten Luftspalt (LSP1) verfügt. In den magnetischen Kreis sind beispielhaft ein Sensorsystem (NVMS) und ein erster Permanentmagnet (PM1) zur Erregung des magnetischen Kreises eingefügt. Das Sensorsystem (NVMS) verfügt über mindestens ein Sensorelement mit mindestens einem paramagnetischen Zentrum (NV1) bzw. einer Vielzahl (NVC) paramagnetischer Zentren (NV1). Die paramagnetischen Zentren (NV1) sind bevorzugt NV-Zentren in einem oder mehreren Diamanten.

Der von dem ersten Permanentmagneten (PM1) erzeugte magnetische Fluss (B) durchflutet auch das Sensorsystem (NVMS) und damit das paramagnetische Zentrum (NV1) bzw. die Vielzahl (NVC) paramagnetischer Zentren (NV1).

Wird nun ein Material eines Gegenstands oder ein Vorrichtungsteil einer Anwendungsvorrichtung in den ersten Luftspalt (LSP1) eingeführt, so ändert sich der magnetische Fluss (B) am Ort des paramagnetischen Zentrums (NV1) bzw. am Ort der Vielzahl (NVC) paramagnetischer Zentren (NV1) des Sensorelements des Sensorsystems (NVMS), was durch das Sensorsystem (NVMS) in Folge der sich ändernden Fluoreszenzstrahlung (FL) des paramagnetischen Zentrums (NV1) bzw. der Vielzahl (NVC) paramagnetischer Zentren (NV1) detektiert wird und an übergeordnete Rechnersysteme, beispielsweise über einen Datenbus (DB) oder ein anderes erstes Ausgangssignal (out), gemeldet werden kann. Bevorzugt besitzt ein Sensorsystem (NVMS) daher nur drei Anschlüsse: Einen Anschluss an eine Betriebsspannungsleitung (VDD) auf Betriebsspannungspotential, einen Anschluss an eine Bezugspotenzialleitung (GND) auf Bezugspotenzial und ein erstes Ausgangssignal (out), das ein analoges oder digitales Signal sein kann, oder ein uni- oder bidirektionaler Datenbusanschluss sein kann.

### Figur 39

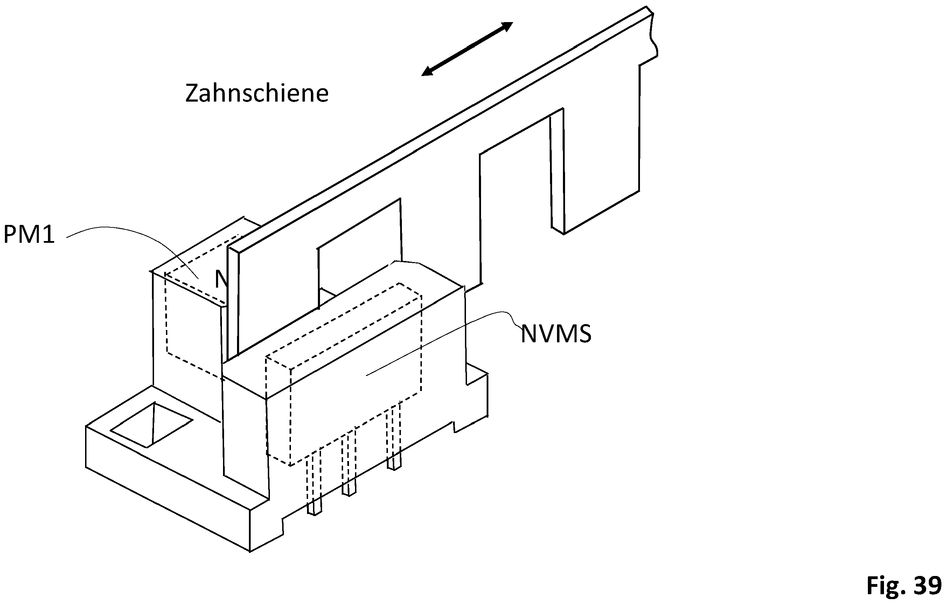

Figur 39 zeigt den Schlitzsensor der Figur 38 mit einer Zahnschiene aus bevorzugt ferromagnetischem Material als in den ersten Luftspalt (LSP1) eingeführten Vorrichtungsteil. Wird die Zahnschiene vor oder zurückbewegt, so ändert sich mehr oder weniger periodisch mit dem Ein- und Austreten der Zähne der Zahnschiene aus dem ersten Luftspalt (LSP1) der magnetische Fluss (B) am Ort des paramagnetischen Zentrums (NV1) bzw. am Ort der Vielzahl (NVC) paramagnetischer Zentren (NV1) des Sensorsystems (NVMS) des Schlitzsensors, was durch das zugehörige Sensorsystem (NVMS) infolge der sich ändernden Fluoreszenzstrahlung (FL) erfasst wird, und ggf. an ein übergeordnetes Rechnersystem übermittelt wird. Auf diese Weise kann eine Position, z.B. durch zählen der Zähne, ermittelt werden.

### Figur 40

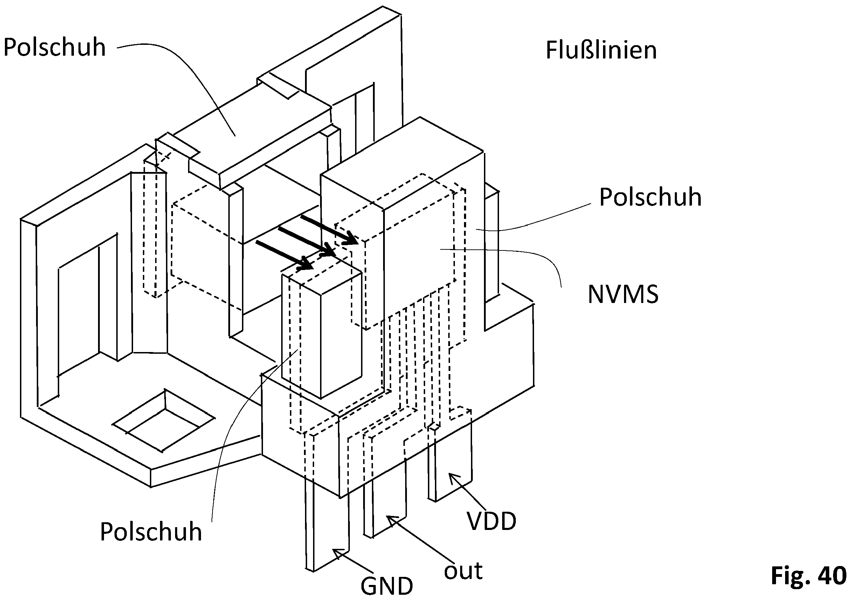

Figur 40 zeigt weitere Details des Schlitzsensors der Figuren 38 und 39 und seines magnetischen Kreises mit einer Zahnschiene aus ferromagnetischem Material.

### Figur 41

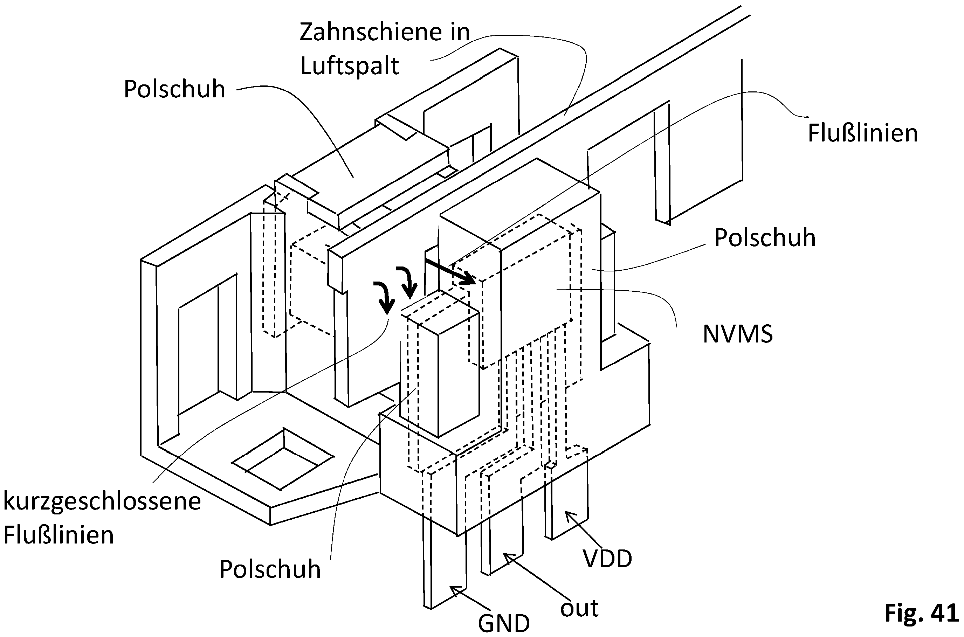

Figur 41 zeigt wieder den Schlitzsensor mit einer Zahnschiene aus ferromagnetischem Material.

### Figur 42

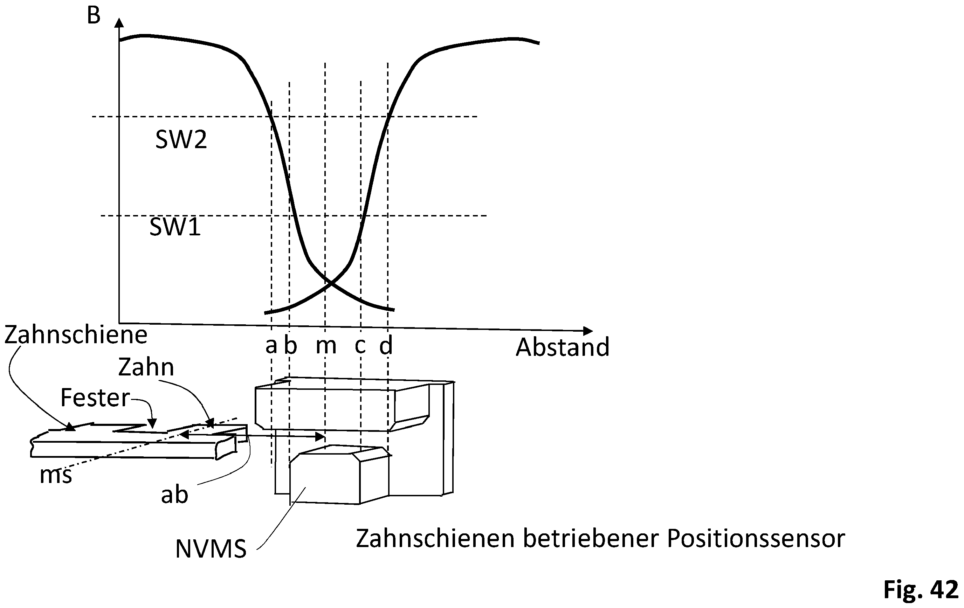

Figur 42 zeigt vereinfacht die Abhängigkeit der magnetischen Flussdichte (B) im Luftspalt am Ort des paramagnetischen Zentrums (NV1) bzw. am Ort der Vielzahl (NVC) paramagnetischer Zentren (NV1) des Sensorelements des Sensorsystems (NVMS) in Abhängigkeit vom Abstand (ab) der Symmetrieachse (ms) des Zahns einer Zahnschiene aus ferromagnetischem Material vom Symmetriepunkt (m) eines beispielhaft ansonsten symmetrisch konstruierten Schlitzsensors. Der Schlitzsensor soll in diesem Beispiel als beispielhaftes Schaltelement dienen, das eine Positionsdetektion in Abhängigkeit von der Position einer Zahnschiene relativ zu dem Schlitzsensor durch Schaltsignale ermöglicht. Hierzu wird bevorzugt das Ausgangssignal des Sensorsystems (NVMS) vor der Ausgabe mit Hilfe einer nichtlinearen Funktion verstärkt oder modifiziert, sodass eine mehr oder weniger digitale Schaltfunktion daraus resultiert, und das erste Ausgangssignal (out) im

Wesentlichen nur noch einen ersten Zustand und einen zweiten Zustand aufweist, wobei der Zweite Zustand des ersten Ausgangssignals (out) wiederum vom zuvor genannten ersten Zustand des ersten Ausgangssignals (out) verschieden ist. Beispielsweise kann dem ersten Zustand ein erster Spannungspegel am ersten Ausgangssignal (out) gegenüber einer Bezugspotenzialleitung (GND) auf Bezugspotenzial zugewiesen sein, während dem zweiten Zustand des ersten Ausgangssignals (out) ein zweiter Spannungspegel des ersten Ausgangssignals (out) gegenüber der Bezugspotenzialleitung (GND) auf Bezugspotenzial zugewiesen sein, der vom ersten Potenzial verschieden ist.

Wir nehmen nun an, dass die Zahnschiene beispielsweise von links nach rechts durch den Schlitzsensor bewegt wird. Außerdem nehmen wir an, dass mehr als ein Ausgangssignal durch die nichtlineare Schaltfunktion erzeugt wird.

Befindet sich die Symmetrieachse (ms) des Zahns der Zahnschiene am Punkt a, so wird ein vorzugsweise einstellbarer zweiter Schwellwert (SW2) unterschritten und das Sensorsystem (NVMS) gibt ein beispielhaftes erstes Schaltsignal, beispielsweise auf einem ersten Ausgangssignal (out), aus.

Befindet sich die Symmetrieachse (ms) des Zahns der Zahnschiene am Punkt b, so wird ein vorzugsweise einstellbarer erster Schwellwert (SW1) unterschritten und das Sensorsystem (NVMS) gibt ein beispielhaftes zweites Schaltsignal beispielsweise auf einem zweiten Ausgangssignal (out") aus.

Befindet sich die Symmetrieachse (ms) des Zahns der Zahnschiene am Punkt c, so wird der vorzugsweise einstellbare erste Schwellwert (SW1) überschritten und das Sensorsystem (NVMS) gibt ein beispielhaftes drittes Schaltsignal beispielsweise auf einem dritten Ausgangssignal aus.

Befindet sich die Symmetrieachse (ms) des Zahns der Zahnschiene am Punkt d, so wird der vorzugsweise einstellbare zweite Schwellwert (SW2) überschritten und das Sensorsystem (NVMS) gibt ein beispielhaftes viertes Schaltsignal beispielsweise auf einem vierten Ausgangssignal aus.

Zur Unterscheidung der Bewegungsrichtung ermittelt dabei das Sensorsystem (NVMS) bevorzugt die zeitliche Ableitung der magnetischen Flussdichte (B) und ermittelt aus magnetischer Flussdichte (B) und zeitlicher Veränderungsgeschwindigkeit der magnetischen Flussdichte dB/dt die Bewegungsrichtung und die Position der Zahnschiene und gibt diese bevorzugt über einen Datenbus (DB) aus, über den auch die Ausgangssignale, beispielsweise im Zeitmultiplex, signalisiert werden.

### Figur 43

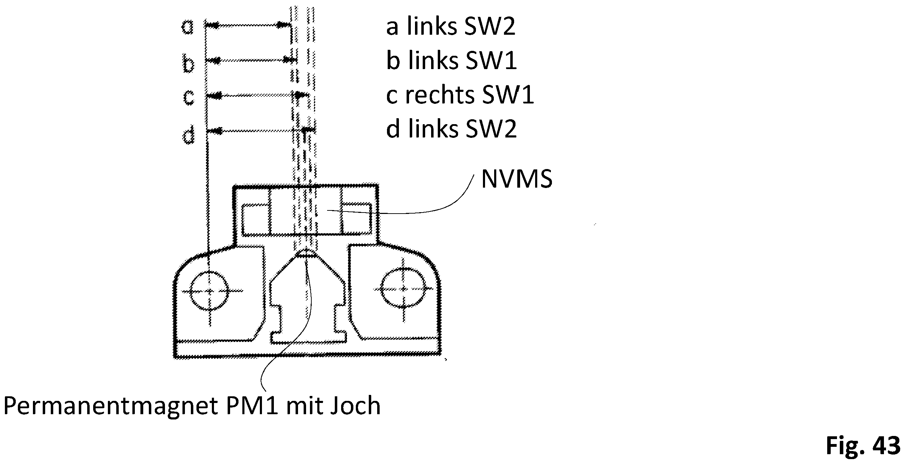

Figur 43 zeigt eine Aufsicht auf einen beispielhaften Schlitzsensor mit einem Sensorsystem (NVMS) mit einem Sensorelement mit einem paramagnetischen Zentrum (NV1) bzw. einer Vielzahl (NVC) paramagnetischer Zentren (NV1). Durch die spitz zulaufende Form des ersten Permanentmagneten (PM1) (ggf. mit einem Joch) wird die Auflösung des Sensors erhöht.

### Figur 44

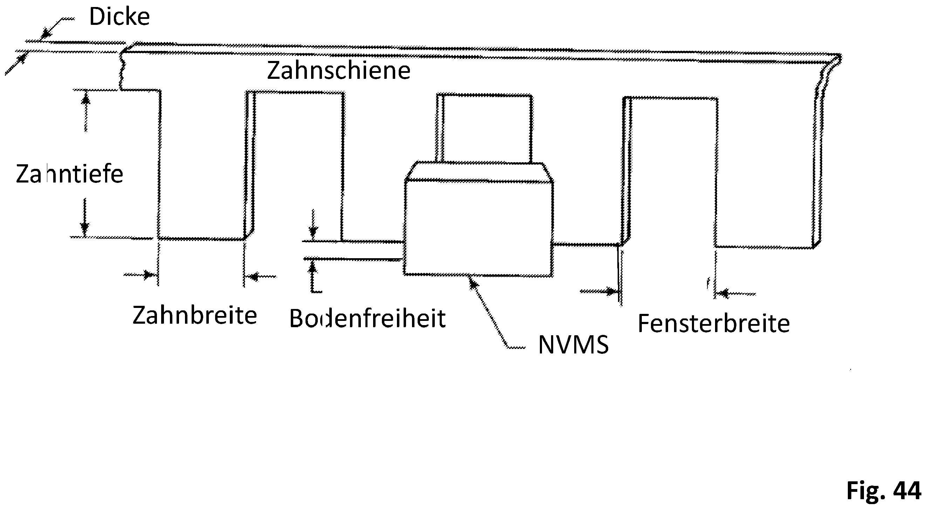

Figur 44 zeigt die Positionierung der Zahnschiene aus ferromagnetischem Material innerhalb eines Schlitzsensors mit einem Sensorsystem (NVMS) mit einem Sensorelement mit einem paramagnetischen Zentrum (NV1) bzw. einer Vielzahl (NVC) paramagnetischer Zentren (NV1).

### Figur 45

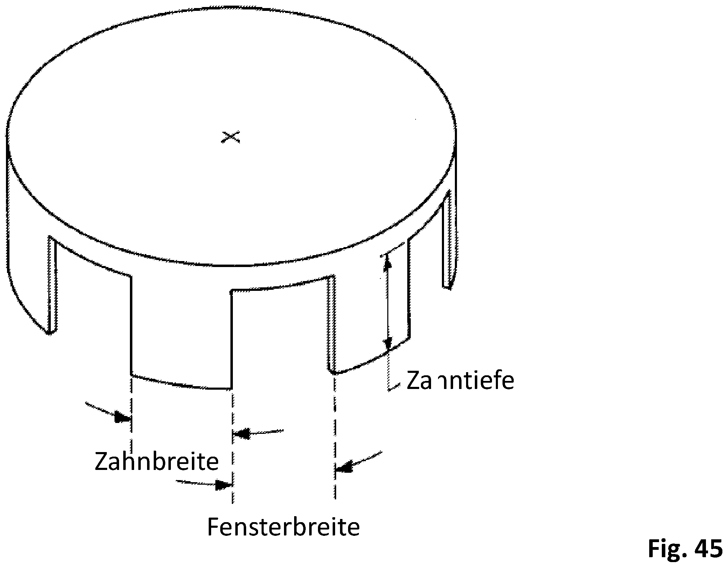

Figur 45 zeigt eine rotationssymmetrische Zahnschiene aus ferromagnetischem Material für die Verwendung in einem Schlitzsensor mit einem Sensorsystem (NVMS) mit einem Sensorelement mit einem paramagnetischen Zentrum (NV1) bzw. einer Vielzahl (NVC) paramagnetischer Zentren (NV1). Bei dieser Zahnschiene sind die Zähne senkrecht zur Scheibenebene angeordnet. Mit Hilfe dieser Zahnschiene können Drehwinkel der rotationssymmetrischen Zahnschiene relativ zu einem Sensorsystem (NVMS) mit einem Sensorelement mit einem paramagnetischen Zentrum (NV1) bzw. einer Vielzahl (NVC) paramagnetischer Zentren (NV1) unter Zuhilfenahme eines solchen Sensorsystem (NVMS) mit einem Sensorelement mit einem paramagnetischen Zentrum (NV1) bzw. einer Vielzahl (NVC) paramagnetischer Zentren (NV1) bestimmt werden.

### Figur 46

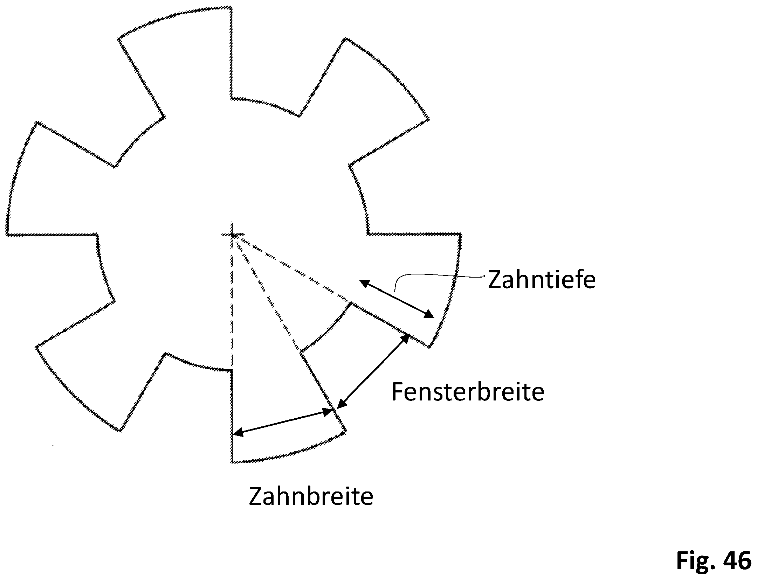

Figur 46 zeigt eine rotationssymmetrische Zahnschiene aus ferromagnetischem Material für die Verwendung in einem Schlitzsensor mit einem Sensorsystem (NVMS) mit einem Sensorelement mit einem paramagnetischen Zentrum (NV1) bzw. einer Vielzahl (NVC) paramagnetischer Zentren (NV1). Bei dieser Zahnschiene sind die Zähne in der Scheibenebene angeordnet. Mit Hilfe dieser Zahnschiene können Drehwinkel der rotationssymmetrischen Zahnschiene relativ zu einem Sensorsystem (NVMS) mit einem Sensorelement mit einem paramagnetischen Zentrum (NV1) bzw. einer Vielzahl (NVC) paramagnetischer Zentren (NV1) unter Zuhilfenahme eines solchen Sensorsystem (NVMS) mit einem Sensorelement mit einem paramagnetischen Zentrum (NV1) bzw. einer Vielzahl (NVC) paramagnetischer Zentren (NV1) bestimmt werden.

### Figur 47

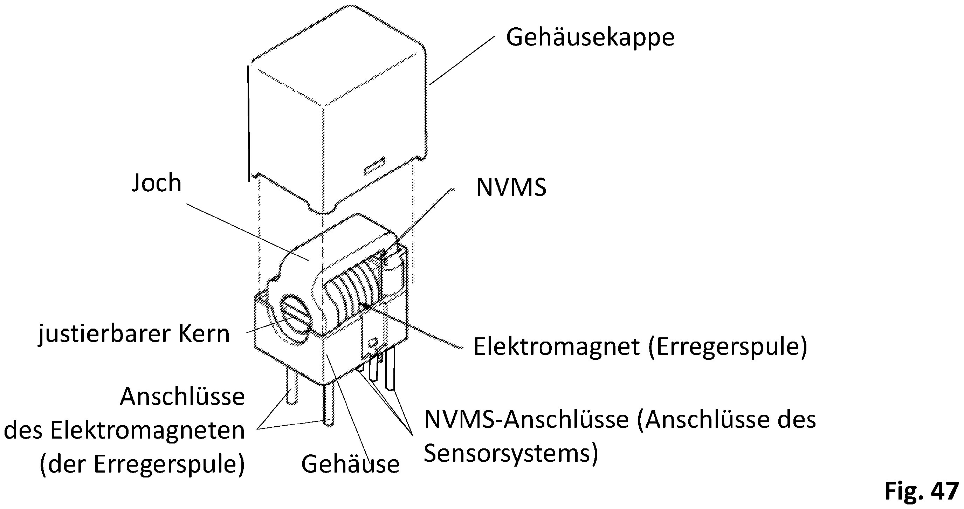

Figur 47 zeigt eine beispielhafte Strommessvorrichtung für sehr kleine Ströme.

Ein Elektromagnet wird über die zugehörigen Anschlüsse mit dem zu erfassenden Strom bestromt und erzeugt eine magnetische Erregung H die einen magnetischen Kreis erregt. Der magnetische Kreis umfasst in dem Beispiel den beispielhaft justierbaren Kern des Elektromagneten, ein Joch und einen Luftspalt. Das Joch dient zum Schließen des magnetischen Kreises. In den Luftspalt ist ein Sensorsystem (NVMS) mit einem Sensorelement mit einem paramagnetischen Zentrum (NV1) bzw. einer Vielzahl (NVC) paramagnetischer Zentren (NV1) eingefügt, das ein Ausgangssignal liefert, dessen Wert der magnetischen Flussdichte (B) am Ort des paramagnetischen Zentrums (NV1) bzw. am Ort der Vielzahl (NVC) paramagnetischer Zentren (NV1) des Sensorelements des Sensorsystems (NVMS) entspricht. Statt des Sensorsystems (NVMS) kann auch nur das Sensorelement mit dem paramagnetischen Zentrum (NV1) bzw. der Vielzahl (NVC) paramagnetischer Zentren (NV1) in den Luftspalt eingefügt sein, wobei dann das paramagnetische Zentrum (NV1) bzw. die Vielzahl (NVC) paramagnetischer Zentren (NV1) optisch, beispielsweise über optische Funktionsmittel, wie beispielsweise Lichtwellenleiter, Spiegel, Linsen, und dergleichen, mit einer Auswertevorrichtung (AWV) an anderer Stelle gekoppelt wird. Eine solche Trennung hat die Vorteile der besseren galvanischen Trennung und ggf. besseren thermischen Trennung. Wir gehen hier jedoch beispielhaft davon aus, dass das Sensorsystem (NVMS) komplett im Luftspalt untergebracht ist. Die Anschlüsse (NVMS-Anschlüsse) des Sensorsystems (NVMS) Versorgen das Sensorsystem (NVMS) mit elektrischer Energie und ermöglichen die Kommunikation eines nicht gezeichneten übergeordneten Rechnersystems mit dem Sensorsystem (NVMS) mit dem Sensorelement mit dem paramagnetischen Zentrum (NV1) bzw. der Vielzahl (NVC) paramagnetischer Zentren (NV1). Hierüber kann das Sensorsystem (NVMS) erfasste Werte der magnetischen Flussdichte (B) und/oder daraus abgeleitete Werte, wie beispielsweise einen daraus berechneten Wert des elektrischen Stromes durch die Windungen des Elektromagneten ausgeben. Da die Induktivität des Elektromagneten aufgrund dessen bekannter Konstruktion bekannt ist, kann das Sensorsystem (NVMS) und/oder das übergeordnete Rechnersystem den Wert des elektrischen Stromes durch den Elektromagneten auf Basis des erfassten Werts der magnetischen Flussdichte (B) bestimmen. Um Störungen auszuschließen, wird das Gehäuse bevorzugt mit einer Gehäusekappe verschlossen. Bevorzugt sind dieses Gehäuse und die Gehäusekappe zur Magnetfeldabschirmung aus einem weichmagnetischen Material, z.B. µ-Metall, gefertigt. Ein als Schraube ausgeführter, magnetischer, justierbarer Kern ermöglicht in der Fertigung die Kalibration des erregenden Elektromagneten.

### Figur 48

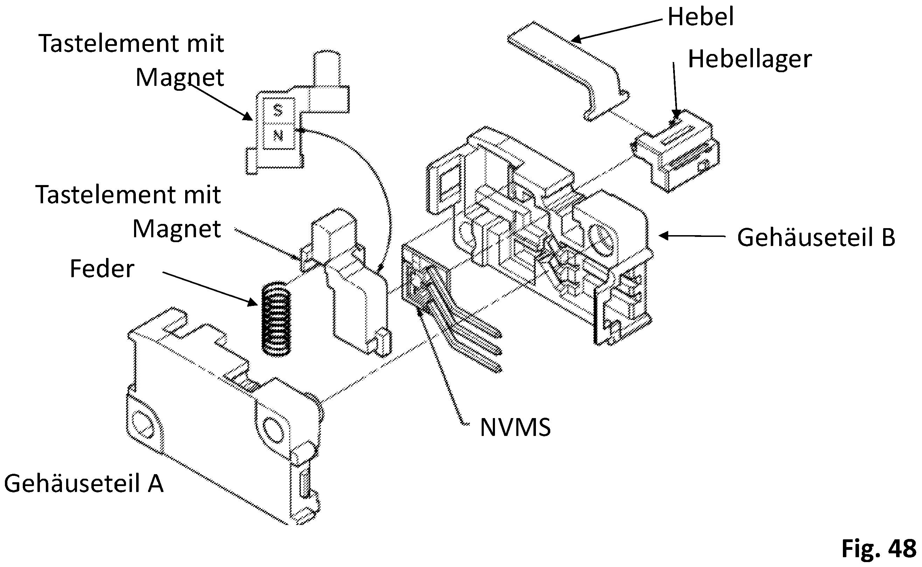

Figur 48 zeigt die Verwendung des Sensorsystems (NVMS) in einem Mikroschalter. Ein Tastelement ist beispielhaft drehbar um eine Rotationsachse in dem Gehäuseteil A des Mikroschalters und in dem Gehäuseteil B gelagert. Der Gehäuseteil A und der Gehäuseteil B bilden zusammen das Gehäuse zur Aufnahme der Mechanik. Eine Feder stellt das Tastelement wieder in seine Ursprungs- bzw.

Ruheposition nach Betätigung zurück. Ein Hebel mit einem Hebellager überträgt die mechanische Tastbewegung auf das Tatelement, das dadurch bei Betätigung eine Rotationsbewegung um einen kleinen Winkel um die Rotationsachse ausführt. In dem Tastelement ist ein Permanentmagnet eingearbeitet. Das Magnetfeld des Permanentmagneten des Tastelements wird durch das Sensorsystem (NVMS) erfasst. Bevorzugt verfügt das Sensorsystem (NVMS) wieder über drei Anschlüsse: Einen ersten Anschluss für die positive Versorgungsspannung, einen zweiten Anschluss für die negative Versorgungsspannung und einen Anschluss für ein erstes Ausgangssignal (out) oder alternativ dazu über einen uni- oder bidirektionalen Datenbus (DB) zur Ausgabe der Messwerte, bzw. eines daraus abgeleiteten Schaltsignals.

### Figur 49

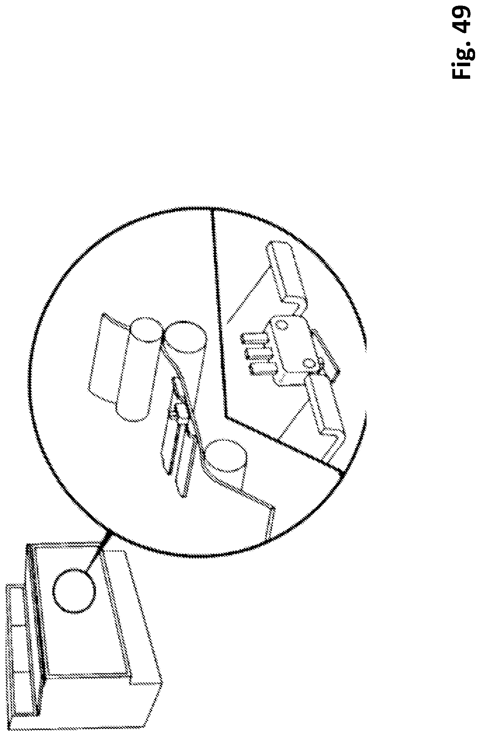

Figur 49 zeigt eine beispielhafte Nutzungssituation eines Mikroschalters entsprechend Figur 48. Eine Maschine, beispielsweise ein Kopierer, eine Druckmaschine, ein Verpackungsautomat, oder dergleichen, überwacht mittels des Mikroschalters der Figur 48 die Anwesenheit einer beispielhaften Folie, eines Blechs, einer Papierbahn, eines textilen Stoffes, oder dergleichen, in der Maschine an einer vorgegebenen Position. Der Schalter wird bei Fehlen dieses Materials betätigt und ein Fehlerprozess, beispielsweise eine Abschaltung oder Signalisierung, eingeleitet.

### Figur 50

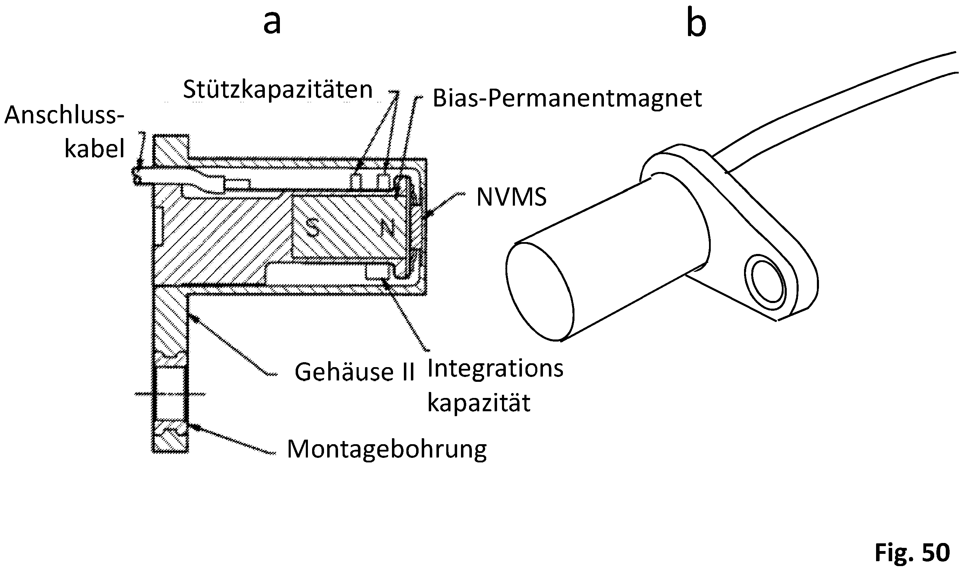

Figur 50 zeigt eine andere Nutzungssituation. Das Sensorsystem (NVMS) ist zusammen mit einem Bias-Permanentmagneten in einem Zylinder, beispielhaft aus Thermoplast oder Duroplast, untergebracht. Ebenfalls sind dort Hilfsbauteile, wie beispielsweise Stützkapazitäten und Filterbauelemente, wie beispielsweise Integrationskapazitäten etc. untergebracht. Bevorzugt wird eine - nicht eingezeichnete - flexible Platine - vorzugsweise beispielsweise eine Kapton-Folie mit Leiterbahnen - für die Montage des Sensorsystems (NVMS) und der Hilfsbauteile verwendet. Vorzugsweise ist das Gehäuse dicht gegenüber Feuchtigkeit etc. Ein ferromagnetischer Körper in der Nähe des so ausgebildeten Sensorsystems verzerrt die magnetischen Feldlinien und führt so zu einer Änderung der magnetischen Flussdichte (B) durch das paramagnetische Zentrum (NV1) bzw. die Vielzahl (NVC) paramagnetischer Zentren (NV1) des Sensorsystems (NVMS), die von diesem Sensorsystem (NVMS) erfasst werden kann und über die Anschlüsse an ein übergeordnetes Rechnersystem übermittelt werden kann.

### Figur 51

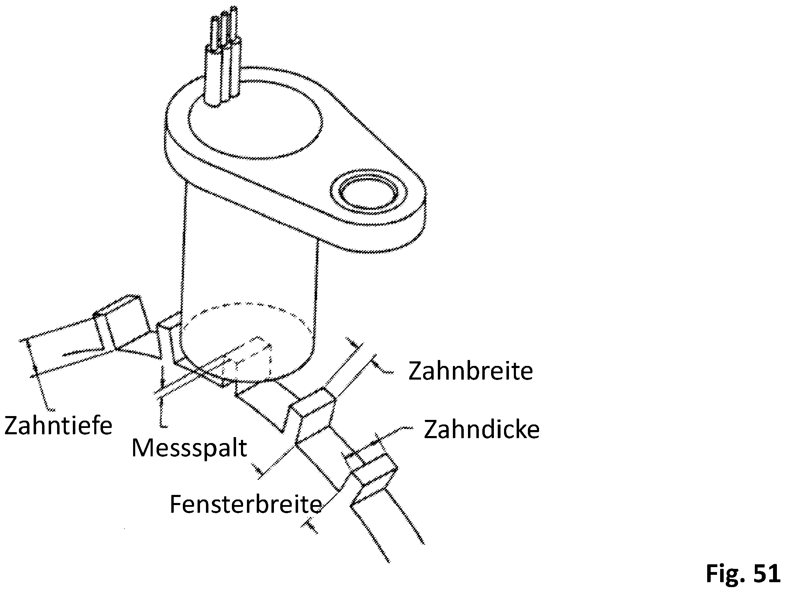

Figur 51 zeigt die Verwendung des Sensorsystems (NVMS) der Figur 50 zur Drehwinkel- und/oder Drehwinkelpositions-Messung unter Zuhilfenahme eines Zahnrads.

### Figur 52

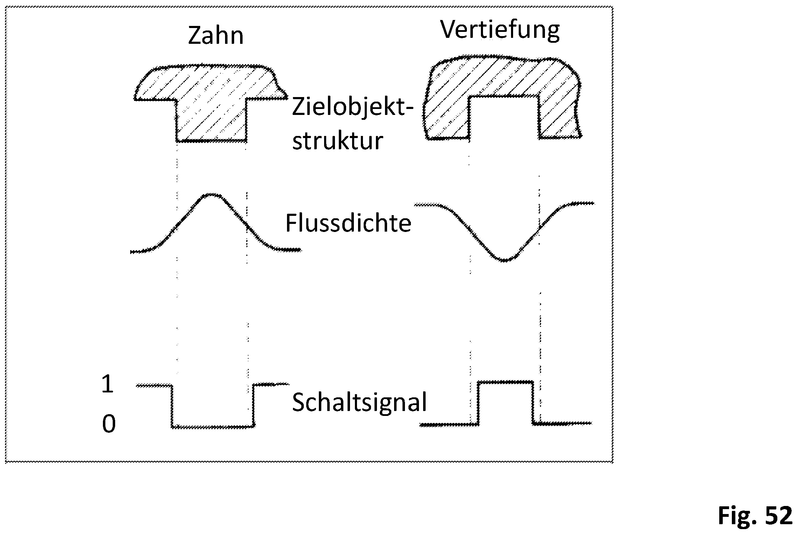

Figur 52 veranschaulicht die Messung der Position- oder Drehwinkelposition durch Zähne und Nuten mit einem Sensor entsprechend Figur 50. In dem Beispiel der Figur 52 wird davon ausgegangen, dass das Sensorsystem (NVMS) des Sensors eine nichtlineare Ausgangssignalformung des ersten Ausgangssignals (out) vornimmt. Überschreitet der Messwert des Sensorsystems (NVMS) einen vorbestimmten und/oder programmierbaren Schwellwert, so schaltet das Sensorsystem (NVMS) sein Ausgangssignal zwischen einem ersten logischen Wert (1) und einem zweiten logischen Wert (0), der vom ersten logischen Wert (1) verschieden ist, um, und signalisiert dieses Umschalten über das erste Ausgangssignal (out) bzw. über einen Datenbus (DB).

### Figur 53

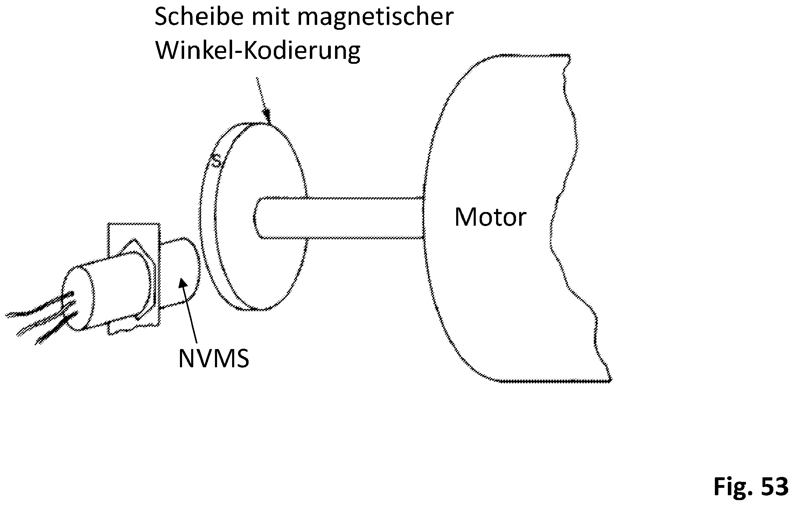

Figur 53 zeigt einen Drehwinkelgeber auf Basis einer Verwendung des Sensorsystems (NVMS) der Figur 50, wobei hier der Permanentmagnet der Figur 50 nicht zwingend erforderlich ist.

Eine magnetisierte Kodierscheibe ist auf die Achse des zu überwachenden Elektromotors aufgebracht. Die Kodierscheibe ist nun nicht mechanisch, sondern magnetisch durch vorzugsweise sektorierte Permanentmagnetisierung kodiert. Die Änderungen der magnetischen Flussdichte (B) infolge einer Änderung des Drehwinkels des Motors werden durch das Sensorsystem (NVMS) erfasst und ggf. bezogen auf einen willkürlichen oder sonst wie bestimmten Nullpunkt gezählt. Im einfachsten Fall gibt das Sensorsystem (NVMS) nur einen Zählpuls bei Änderung der Richtung des magnetischen Flusses (B) aus.

### Figur 54

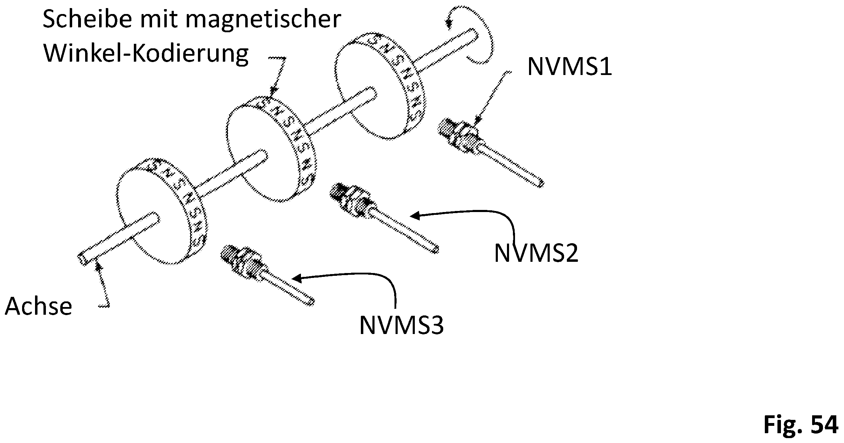

Durch Redundanz und eine unterschiedliche Winkelfrequenz der Permanentmagnetisierung der magnetisierten Kodierscheiben mehrerer Systeme aus Kodierscheibe und Sensorsystem (NVMS1, NVMS2, NVMS3) kann die Winkelauflösung und die Betriebssicherheit verbessert werden. Dies ist in Figur 54 dargestellt.

### Figuren 55 und 56

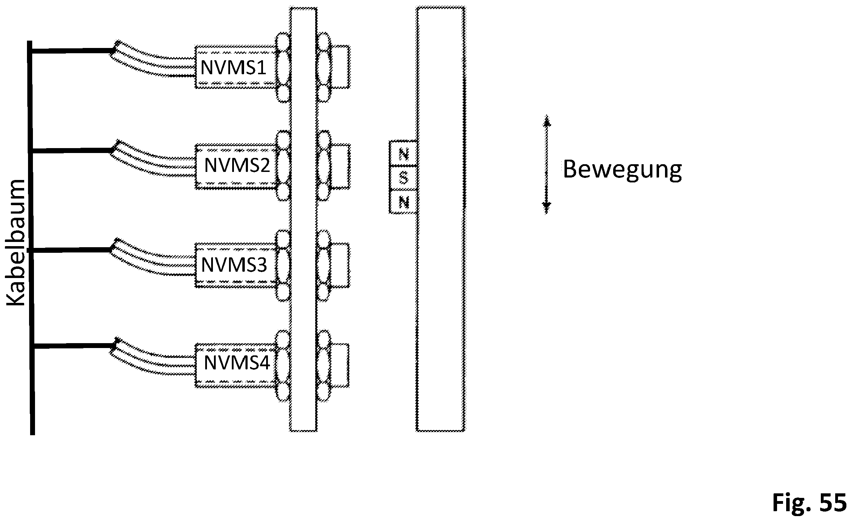

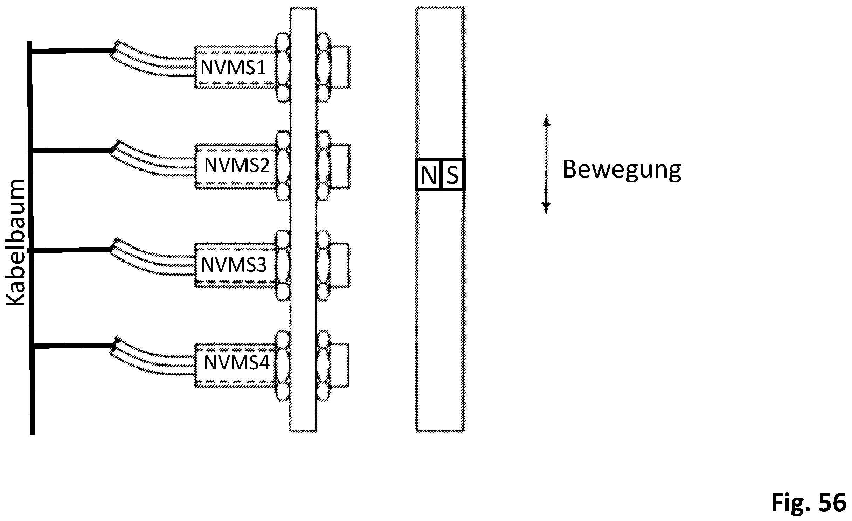

Statt einer Rotationsbewegung kann auch eine Translationsbewegung überwacht werden. Eine Gruppe von Permanentmagneten ist auf einer vorzugsweise nicht ferromagnetischen Unterlage befestigt, deren translatorische Richtung erfasst werden soll. In dem Beispiel der Figur 55 überwachen mehrere Sensorsysteme (NVMS1, NVMS2, NVMS3, NVMS4) die Position dieser Permanentmagneten. Im einfachsten Fall der Figur 56 reicht ein Permanentmagnet und ein Sensorsystem (NVMS) (nicht in den Figuren) bereits für viele Anwendungen aus. Aufgrund der großen Reichweite der quantenpunktbasierenden Messmethode der Sensorsysteme (NVMS1, NVMS2, NVMS3, NVMS4) sind wesentlich weniger Permanentmagneten und wesentlich weniger Sensorsysteme als im Falle der Verwendung von Hall-Sensoren an Stelle der Sensorsysteme (NVMS1, NVMS2, NVMS3, NVMS4) notwendig.

### Figur 57

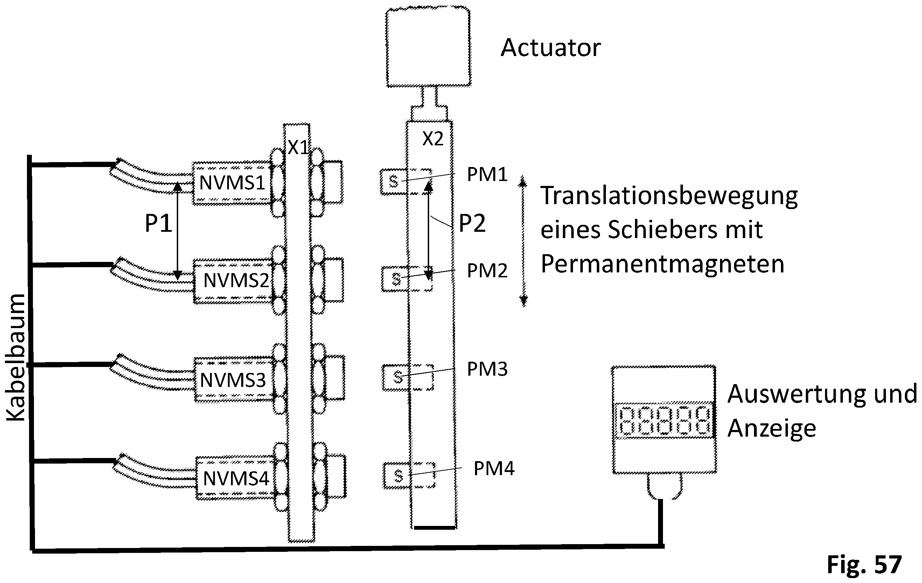

Figur 57 zeigt eine Anwendung des Positionsmessprinzips der Figur 55. Bevorzugt weisen die Sensorsysteme (NVMS1 bis NVMS4) und damit die Periodizität der Orte der paramagnetischen Zentren (NV1) bzw. die Periodizität der Cluster aus jeweils einer Vielzahl (NVC) paramagnetischer Zentren (NV1) eine erste Periodizität (P1) längs einer ersten geraden oder gleichmäßig gekrümmten Linie auf. Bevorzugt weisen die Permanentmagneten auf dem Schieber, dessen Position bestimmt werden soll, eine zweite Periodizität (P2) längs einer zweiten geraden oder gleichmäßig gekrümmten Line auf. Bevorzugt weicht die erste Periodizität (P1) von der zweiten Periodizität (P2) leicht - z.B. um 0,1% bis 5% - ab, sodass eine Moiré-Figur entsteht und die Auflösung des Systems somit erhöht ist.

Es handelt sich somit um eine Vorrichtung zur Messung einer Position längs einer Linie, wobei die Linie bei einer Verschiebung längs der Linie in einem wesentlichen Teil wieder auf sich selbst abgebildet wird. Die Vorrichtung umfasst einen ersten Körper (X1) und einen zweiten Körper (X2). Auf dem ersten Körper (X1) sind paramagnetische Zentren (NV1) bzw. Cluster aus jeweils einer Vielzahl (NVC) paramagnetischer Zentren (NV1) längs und parallel der besagten Linie mit einer ersten Periodizität (P1) angeordnet. Bevorzugt sind diese paramagnetische Zentren (NV1) bzw. Cluster aus jeweils einer Vielzahl (NVC) paramagnetischer Zentren (NV1) jeweils Teilvorrichtungen von zugehörigen Sensorsystemen (NVMS1 bis NVMS4). Auf dem zweiten Körper (X2) sind Permanentmagneten (PM1 bis PM4) längs und parallel der besagten Linie mit einer zweiten Periodizität (P2) angeordnet. Durch die gegenüber der ersten Periodizität (P1) unterschiedliche zweite Periodizität (P2) wird die Fluoreszenzstrahlung (FL) der paramagnetische Zentren (NV1) bzw. Cluster aus jeweils einer Vielzahl (NVC) paramagnetischer Zentren (NV1) der verschiedenen Sensorsysteme (NVMS1 bis NVMS4) an den unterschiedlichen Orten der paramagnetische Zentren (NV1) bzw. der Cluster aus jeweils einer Vielzahl (NVC) paramagnetischer Zentren (NV1) in unterschiedlicher Weise durch eine Verschiebung des zweiten Körpers (X2) relativ zum ersten Körper (X1) längs der besagten Linie in vorhersagbar unterschiedlicher Weise beeinflusst. Diese Redundanz kann dann zur Berechnung der exakten Position verwendet werden. Eine Auswertung ermittelt aufgrund der Messwerte der Sensorsysteme (NVMS1 bis NVMS4) dann die reale Verschiebung. Bevorzugt erfolgt die Translationsbewegung durch einen Aktor längs einer dritten geraden oder gleichmäßig gekrümmten Linie. Die erste gerade oder gleichmäßig gekrümmte Linie und die zweite gerade oder gleichmäßig gekrümmte Linie und die dritte gerade oder gleichmäßig gekrümmte Linie sind bevorzugt im Wesentlichen zueinander parallel. Bevorzugt weicht die erste Periodizität (P1) von der zweiten Periodizität (P2) ab, sodass sich ein Nonius-Effekt ergibt. Eine Auswerteeinheit wertet die Ausgangssignale der Sensorsysteme (NVMS1 bis NVMS4) aus. Ggf. erfolgt wie hier eine Anzeige oder eine Übertragung an eine übergeordnete Datenverarbeitungseinheit beispielsweise über einen Datenbus (DB).

### Figur 58

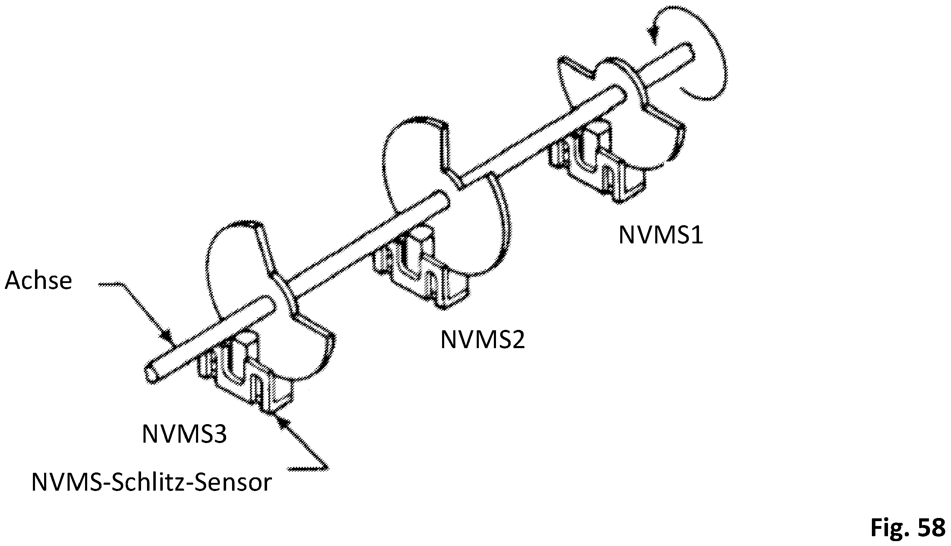

Figur 58 zeigt eine Anwendung eines beispielhaften Schlitzsensors entsprechend einer oder mehrerer der Figuren 37 bis 42 für die Drehwinkelmessung mittels unterschiedlich gestalteter Kodierscheiben mit Fenstern und Zähnen unterschiedlicher Winkelbreite und/oder Winkelmodulation.

### Figur 59

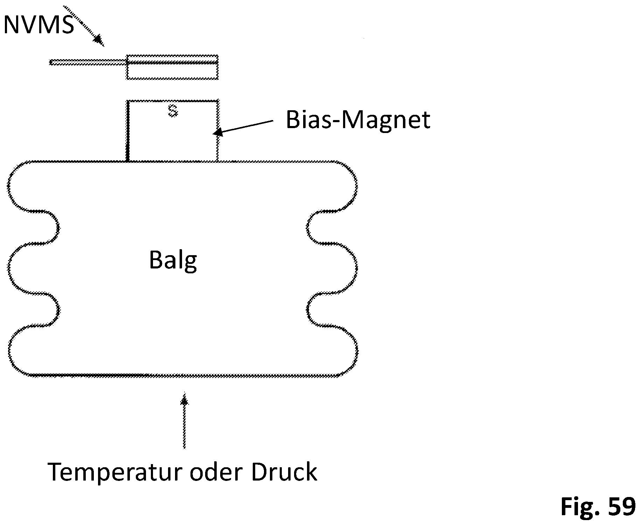

Figur 59 zeigt eine Temperatur- und/oder Druckmessung mittels eines beispielhaften mechanischen Funktionselements, dessen Dimensionen von dem Druck und/oder der Temperatur abhängig sind. In dem Beispiel der Figur 59 kann der Balg beispielsweise mit einem Messgas gefüllt sein, das sich bei Temperaturänderung charakteristisch ausdehnt oder zusammenzieht. Hierdurch ändern sich die Dimensionen des Balgs bei einer Temperaturänderung und damit der magnetische Fluss (B) durch das paramagnetische Zentrum (NV1) bzw. die Vielzahl (NVC) paramagnetischer Zentren (NV1) des Sensorsystems (NVMS). Ebenso führt eine Änderung des Außendrucks und/oder eine Änderung des Balg-Binnendrucks - beispielsweise über eine nicht gezeigte Druckleitung - zu einer Dimensionsänderung des Balgs und damit zu einer Änderung des magnetischen Flusses (B) durch das paramagnetische Zentrum (NV1) bzw. die Vielzahl (NVC) paramagnetischer Zentren (NV1) des Sensorsystems (NVMS). Diese Änderung des magnetischen Flusses (B) durch das paramagnetische Zentrum (NV1) bzw. die Vielzahl (NVC) paramagnetischer Zentren (NV1) des Sensorsystems (NVMS) führt zu einer Änderung der Fluoreszenzstrahlung (FL) des das paramagnetischen Zentrums (NV1) bzw. der Vielzahl (NVC) paramagnetischer Zentren (NV1). Diese Änderung wird von der Auswertevorrichtung (AWV) des Sensorsystems (NVMS) erfasst, und bevorzugt an ein übergeordnetes System, beispielsweise ein Rechnersystem, beispielsweise über einen Datenbus (DB) weitergegeben.

### Figur 60

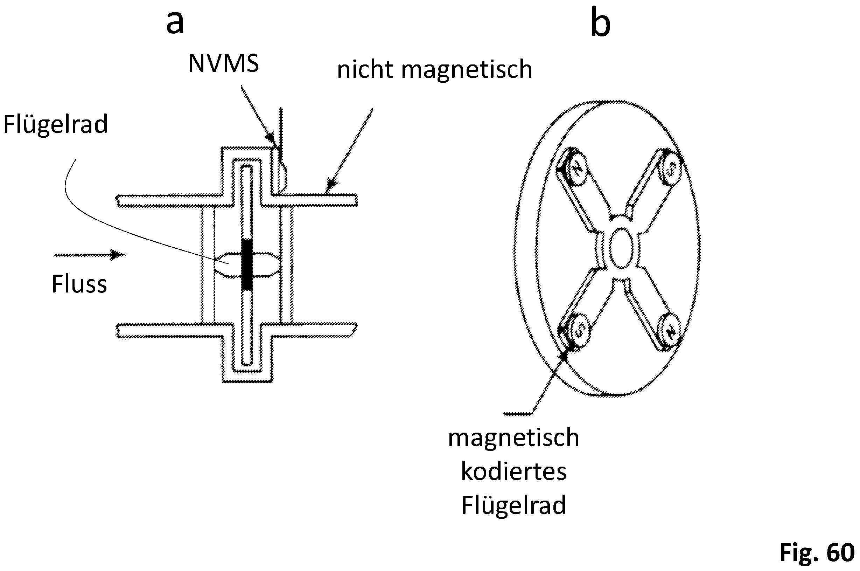

Figur 60 zeigt eine Anwendung eines vorgeschlagenen Sensorsystems (NVMS) für die Durchflussmessung. Ein Flügelrad mit magnetischen Kodierungen wird in eine Transportvorrichtung für ein Fluid gebracht. Das Flügelrad ist bevorzugt so geformt, dass der Fluss des Fluids in der Transportvorrichtung, beispielsweise einer Röhre, das Flügelrad zum Drehen bringt. Durch die Rotation des Flügelrades erzeugen die permanentmagnetbasierenden magnetischen Kodierungen auf dem Flügelrad ein magnetisches Wechselfeld, das von dem Sensorsystem (NVMS) erfasst werden kann, und bevorzugt an ein übergeordnetes System, beispielsweise ein Rechnersystem, weitergegeben werden kann.

### Figur 61

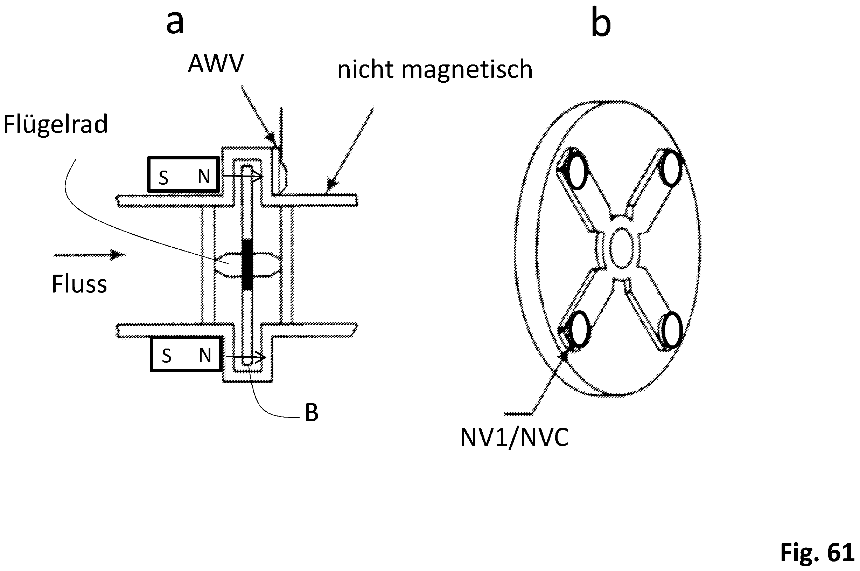

Figur 61 zeigt eine weitere Anwendung eines vorgeschlagenen Sensorsystems (NVMS) für die Durchflussmessung. Nun wird ein beweglicher Körper mit paramagnetischen Zentren (NV1) in einem Magnetfeld mit einer Flussdichte (B) bewegt. Durch die Bewegung des beweglichen Körpers wird die magnetische Flussdichte (B) für die paramagnetischen Zentren (NV1) vermindert. Werden die paramagnetischen Zentren (NV1) mit Pumpstrahlung (LB) durch eine Auswertevorrichtung (AWV) bestrahlt, so ändert sich durch eine Änderung der Bewegungsgeschwindigkeit des beweglichen Körpers im Magnetfeld die Fluoreszenzstrahlung (FL) der paramagnetischen Zentren (NV1). Es ist bevorzugt, dass die paramagnetischen Zentren (NV1) homogen längs der Bewegungsrichtung des Körpers auf dem Körper verteilt sind oder dass die Fluoreszenzstrahlung (FL) während der Bewegung in gleicher Empfindlichkeit durch die Auswertevorrichtung (AWV) erfasst wird und die Pumpstrahlung (LB) während der Bewegung mit gleicher Intensität die paramagnetischen Zentren (NV1) erreicht. In dem Beispiel der Figur 61 wird ein Flügelrad mit paramagnetischen Zentren (NV1) als ein Beispiel für eine beispielhafte Vorrichtung dieser Art dargestellt. Das Flügelrad wird in eine Transportvorrichtung für ein Fluid gebracht. Das Flügelrad ist bevorzugt so geformt, dass der Fluss des Fluids in der Transportvorrichtung, beispielsweise einer Röhre, das Flügelrad, und damit die paramagnetischen Zentren (NV1) auf dem Flügelrad, zum Drehen um die Drehachse des Flügelrades bringt. Durch die Rotation des Flügelrades wird die magnetische Flussdichte (B) des magnetischen Feldes der Permanentmagneten reduziert. Die Flügelräder sorgen für eine gepulste Modulation der Fluoreszenzstrahlung (FL), die ausgesendet wird, wenn ein paramagnetisches Zentrum (NV1) mit der Pumpstrahlung (LB) der Auswertevorrichtung (AWV) des Sensorsystems (NVMS) bestrahlt wird. Dies ist immer dann der Fall, wenn ein Flügelblatt die Position der Auswertevorrichtung (AWV) in dem Beispiel der Figur 61 passiert. Typischerweise moduliert die Rotationsgeschwindigkeit die Amplitude der Modulation der Intensität der Fluoreszenzstrahlung (FL). Diese Amplitude und deren Frequenz kann von der Auswertevorrichtung (AWV) des Sensorsystems (NVMS) erfasst werden, und bevorzugt an ein übergeordnetes System, beispielsweise ein Rechnersystem, weitergegeben werden.

### Figur 62

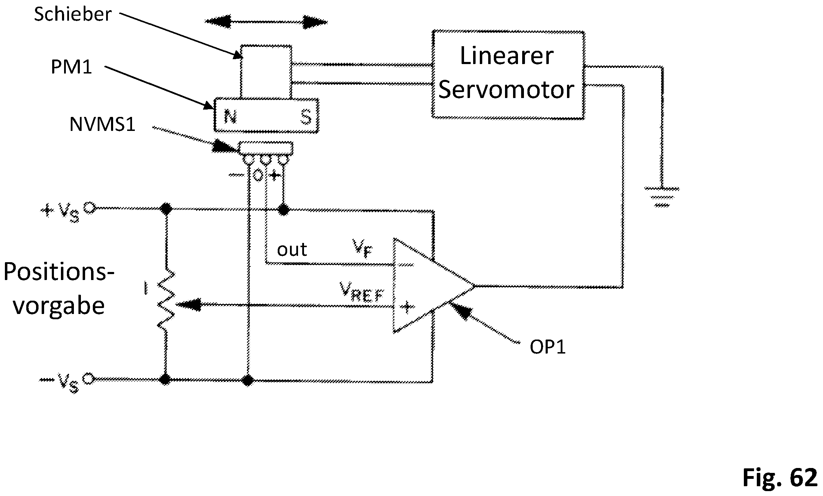

Figur 62 zeigt beispielhaft schematisch die Positionsregelung eines Schiebers relativ zu einem ersten Sensorsystem (NVMS1). Je nach Position des Schiebers erzeugt ein bevorzugt fest mit dem Schieber verbundener erster Permanentmagnet (PM1) eine positionsabhängige magnetische Flussdichte (B) am Ort des paramagnetischen Zentrums (NV1) bzw. der Vielzahl (NVC) paramagnetischer Zentren (NV1) des ersten Sensorsystems (NVMS1). Ein erster Operationsverstärker (OP1) vergleicht das hier bevorzugt beispielhafte, analoge Spannungsausgangssignal des ersten Sensorsystems (NVMS1) mit einem beispielhaft durch ein Potentiometer erzeugten Referenzspannungswert und erzeugt ein Antriebssignal für den linearen Servomotor, der den Schieber dann als Stellglied des Regelkreises so lange nachregelt, bis der Spanungsunterschied an den Eingängen des ersten Operationsverstärkers (OP1) null ist.

### Figur 63

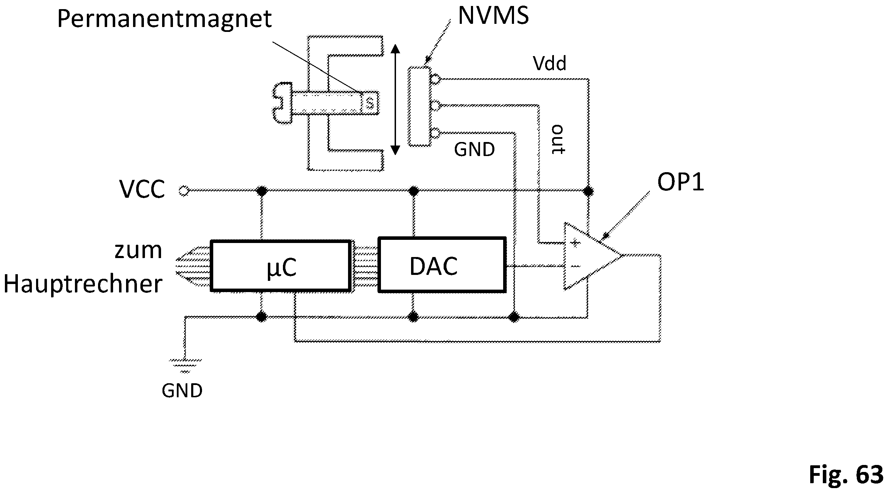

Figur 63 zeigt eine beispielhafte Methode zur Digitalisierung eines beispielhaft analogen ersten Ausgangssignals (out) eines Sensorsystems (NVMS) mit einem paramagnetischen Zentrum (NV1) bzw. einer Vielzahl (NVC) paramagnetischer Zentren (NV1). Der beispielhafte Mikrorechner (µC) erhöht beispielsweise den Eingabewert eines Digital-zu-Analog-Wandlers (DAC) so lange, bis der Wert des Ausgangssignals eines ersten Operationsverstärkers (OP1), der das Ausgangssignal des Digital-zu-Analog-Wandlers mit dem Ausgangssignal des Sensorsystems (NVMS) vergleicht und hier als Komparator dient, einen Schwellwert kreuzt. Der bis zu diesem Punkt erhöhte Eingabewert entspricht genau dann im Moment dieses Kreuzungsvorgangs im Wesentlichen dem Messwert, den der Mikrorechner (µC) weitergegeben kann.

### Figur 64

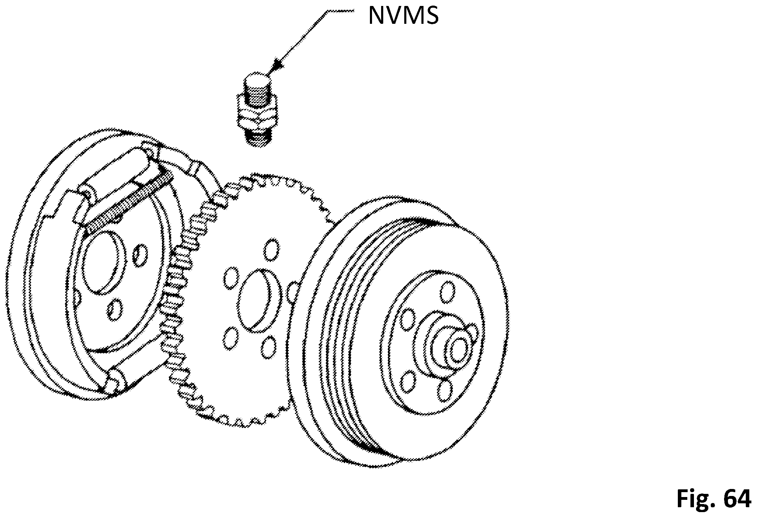

Figur 64 zeigt die Anwendung des Positionsmessprinzips der Figur 51 auf eine beispielhafte Radnabe mit einer Trommelbremse in einem Kfz.

### Figuren 65 und 66 und 67

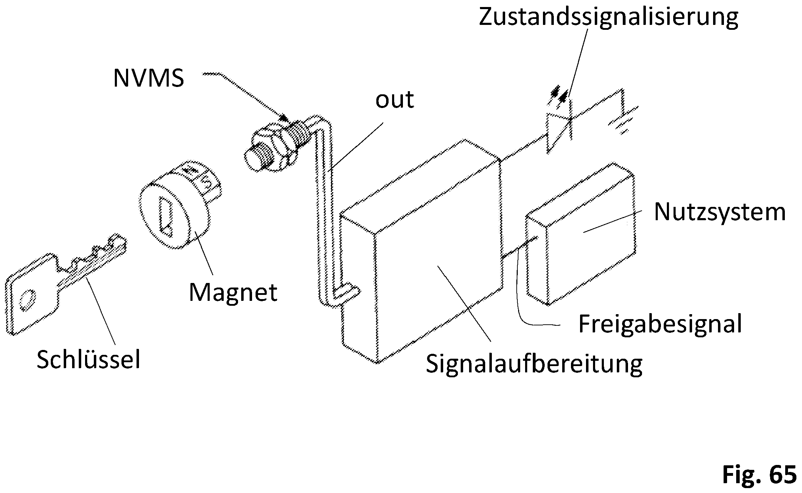

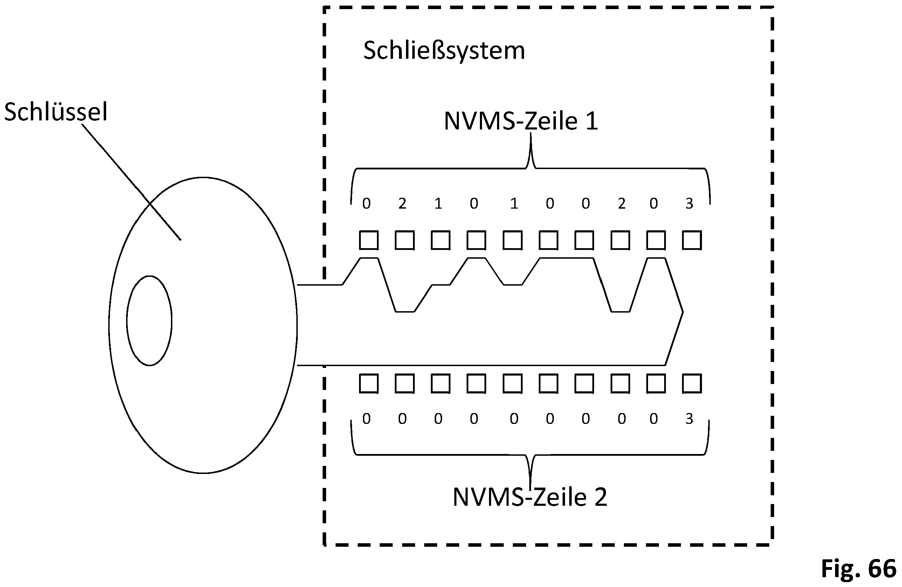

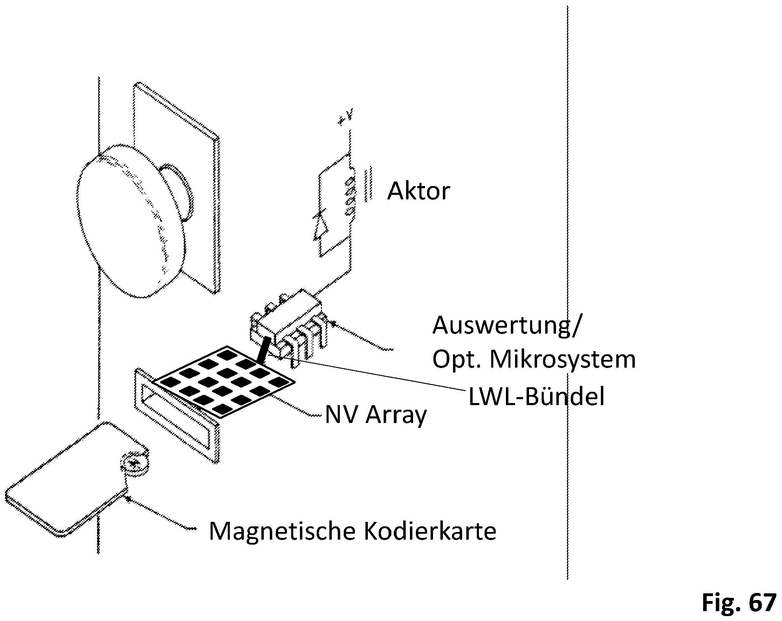

Figur 65 zeigt die Anwendung eines Sensorsystems (NVMS) für ein Schließsystem. Der Schlüssel kann durch Formgebung und/oder Magnetisierung eine räumliche Kodierung aufweisen, die durch ein Sensorsystem (NVMS) mit einem paramagnetischen Zentrum (NV1) bzw. einer Vielzahl (NVC) paramagnetischer Zentren (NV1) erfasst wird. Die räumliche Kodierung kann in eine zeitliche Kodierung verwandelt werden, wenn zu jedem Zeitpunkt die Geschwindigkeit, mit der der Schlüssel in die Vorrichtung gesteckt wird, erfasst wird. Dies kann erreicht werden, wenn der Schlüssel neben einer Grundraumfrequenz eine Trägerraumfrequenz für die eigentliche Schließinformation aufweist. Dies ist deshalb besonders vorteilhaft, weil eine magnetische Kodierung ohne Kenntnis derselben nicht sofort erkennbar ist. In Figur 66 sind daher zwei Zeilen von Sensorsystemen vorgesehen, die die räumliche Modulation eines permanent magnetisch erregten Schlüssels erfassen. Die magnetische Erregung kann aber auch erst im Schlosssystem durch eine Spule eingespeist werden. Auch ist es denkbar, ein komplexeres Sensorsystem mit mehreren paramagnetischen Zentren (NV1) bzw. mehreren Clustern, jeweils in Form einer Vielzahl (NVC) paramagnetischer Zentren (NV1), als Quantenpunkte, vorzusehen. Beispielsweise kann bei der Verwendung von Diamant als Substratmaterial der Schlüssel zwischen zwei Diamantplatten mit NV-Zentren als paramagnetischen Zentren (NV1), bzw. als Cluster in Form einer jeweiligen Vielzahl (NVC) paramagnetischer Zentren (NV1), eingebracht werden. Die magnetische und mechanische Kodierung führt dann zu einem abtastbaren Fluoreszenzbild der paramagnetischen Zentren (NV1), das mit einem vorgegebenen Bild verglichen werden kann. Sind die Abweichungen kleiner als ein vorgegebener Schwellwert, so kann das Schloss entriegelt werden. Diese Situation ist in Figur 67 dargestellt. In dem Beispiel der Figur 67 sind die Quantenpunkte in Form der paramagnetischen Zentren (NV-Array) bzw. Cluster (NVC) in einer Diamant-Platte in einem ein- oder zweidimensionalen Gitter angeordnet und werden beispielsweise durch Lichtwellenfasern stimuliert und ausgelesen. Eine Auswerteinheit (Auswertevorrichtung (AWV)) verarbeitet die unterschiedlichen Fluoreszenzsignale der Fluoreszenzstrahlung (FL) der verschiedenen paramagnetischen Zentren (NV1) bzw. der Verschiedenen Cluster in Form einer jeweiligen Vielzahl (NVC) paramagnetischer Zentren (NV1) und betätigt ggf. den Schließmechanismus.

### Figur 68

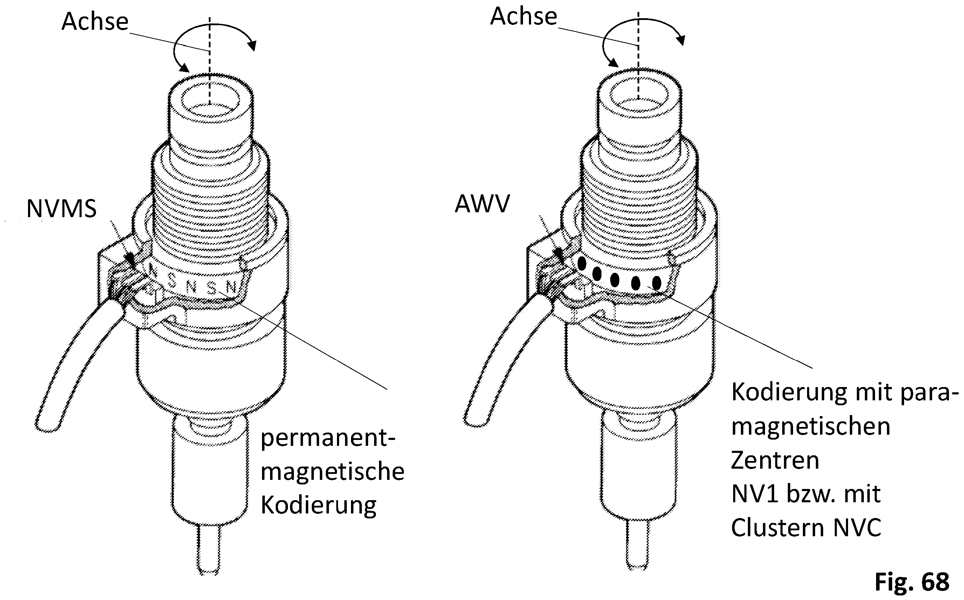

Figur 68a zeigt wieder einen beispielhaften Drehwinkelsensor mit einer permanentmagnetisierten Kodierscheibe und einem Sensorsystem (NVMS). Figur 68b zeigt einen beispielhaften Drehwinkelsensor mit einer mit paramagnetischen Zentren (NV1) bzw. Clustern aus einer Vielzahl (NVC) paramagnetischer Zentren (NV1) kodierten Kodierscheibe und einer Auswertevorrichtung (AWV). Die Auswertevorrichtung (AWV) bestrahlt die paramagnetischen Zentren (NV1) bzw. die Cluster aus einer jeweiligen Vielzahl (NVC) paramagnetischer Zentren. Bevorzugt umfasst die Vorrichtung einen Permanentmagneten, der eine magnetische Flussdichte definierter Größe erzeugt.

Sowohl die Intensität der Pumpstrahlung (LB) als auch die Stärke der magnetischen Flussdichte hängen von dem Drehwinkel ab. Durch die Auswertung der Fluoreszenzstrahlung (FL) kann die Auswertevorrichtung (AWV) auf die Drehwinkelposition schließen.

### Figur 69

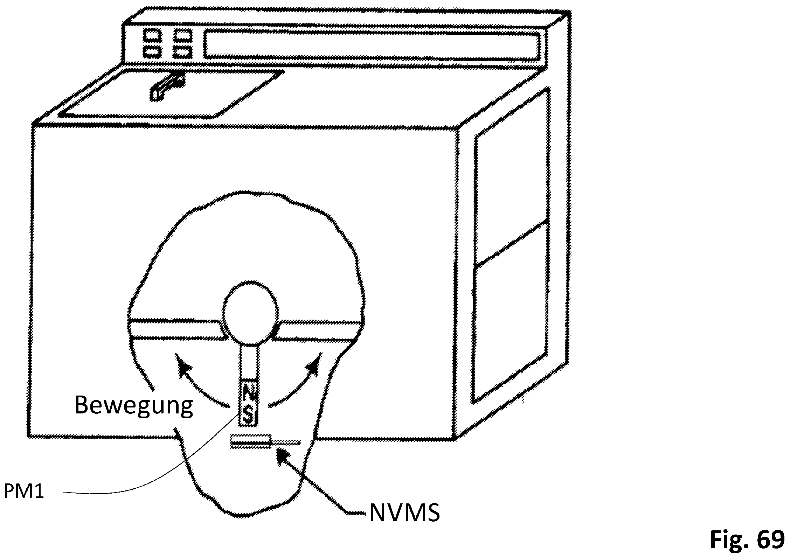

Figur 69 zeigt einen beispielhaften Neigungssensor, bei dem ein erster Permanentmagnet (PM1) an einem vorzugsweise gedämpften Pendel am Ende des Pendels befestigt ist und über einem Sensorsystem (NVMS) mit einem paramagnetischen Zentrum (NV1) bzw. einer Vielzahl (NVC) paramagnetischer Zentren (NV1) hängt. Da sich die magnetische Flussdichte (B) am Ort des Sensorsystems (NVMS) in Abhängigkeit von der Neigung des Systems - hier der beispielhaften Aufhängung einer Waschtrommel einer beispielhaften Waschmaschine - ändert, kann hierdurch ein Neigungswinkelsensor realisiert werden.

### Figur 70

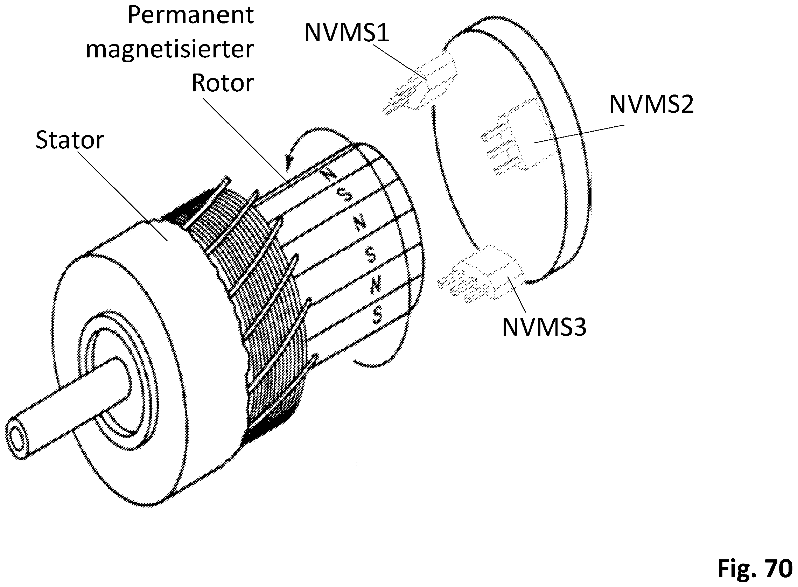

Figur 70 zeigt eine beispielhafte Anwendung von Sensorsystemen (NVMS1, NVMS2, NVMS3) für die Rotorpositionsbestimmung in Elektromotoren. Der beispielhafte Elektromotor ist als Explosionszeichnung grob vereinfacht dargestellt. Es ist beispielhaft ein sogenannter bürstenloser Elektromotor dargestellt. Nicht dargestellt ist die Regelung der Kommutierung der beispielhaften Statorspulen des beispielhaften Elektromotors. In dem Beispiel der Figur 70 sind beispielhaft drei Sensorsysteme (NVMS1, NVMS2, NVM3) jeweils mit paramagnetischen Zentren (NV1) bzw. jeweils mit Clustern aus einer Vielzahl (NVC) paramagnetischer Zentren (NV1) vorgesehen, um die Position des permanent magnetisierten Rotors des beispielhaften BLDC-Motors zu erfassen. Theoretisch reicht ein Sensorsystem (NVMS) hierfür aber bereits aus, wenn die Startposition bekannt ist und Absolutwerte der magnetischen Flussdichte (B) und deren zeitliche Ableitung erfasst werden. Eine nicht gezeichnete Regelungsvorrichtung verarbeitet die so erfassten Messwerte der beispielhaft drei Sensorsysteme (NVMS1, NVMS2, NVM3) und erzeugt aus diesen nach Vergleich mit Soll-Werten die Kommutierungssignale für die Motortreiber, bei denen es sich typischerweise um Halbbrücken handelt. Diese nicht gezeichneten Halbbrücken versorgen die Statorspulen des Stators des Motors dann mit elektrischer Energie in Abhängigkeit von diesen Kommutierungssignalen und damit in Abhängigkeit von dem magnetischen Fluss am Ort des paramagnetischen Zentrums (NV1) bzw. der Vielzahl (NVC) paramagnetischer Zentren (NV1) des jeweiligen Sensorsystems (NVMS1, NVMS2, NVMS3). Wichtig ist, dass die paramagnetischen Zentren (NV1) bzw. Cluster aus einer Vielzahl (NVC) paramagnetischer Zentren (NV1) von den jeweiligen Auswertevorrichtungen (AWV) der jeweiligen Sensorsysteme (NVMS1, NVMS2, NVMS3) durch optische Funktionsmittel, wie beispielsweise Lichtwellenleiter, wieder getrennt werden können, um eine galvanische Trennung zwischen dem jeweiligen Sensorelement (NVMS1, NVMS2, NVMS3) mit dem paramagnetischen Zentrum (NV1) bzw. dem Cluster aus einer Vielzahl (NVC) paramagnetischer Zentren (NV1) zu realisieren.

Ein solches Antriebssystem umfasst dann eine elektrische Maschine mit einem Stator und mit einem relativ zum Stator beweglich längs mindestens eines Freiheitsgrades gelagerten Läufer, insbesondere einem Rotor, und wobei der Stator eine erste magnetfelderzeugende Vorrichtung aufweist und wobei der Rotor eine zweite magnetfelderzeugende Vorrichtung aufweist und wobei zumindest die erste magnetfelderzeugende Vorrichtung oder die zweite magnetfelderzeugende Vorrichtung in Abhängigkeit von einem Steuersignal ein sich fortbewegendes Magnetfeld mit einer Fortbewegungsrichtung längs des Freiheitsgrades des Läufers erzeugen kann und wobei die Maschine ein paramagnetisches Zentrum (NV1) und/oder eine Vielzahl (NVC) paramagnetischer Zentren (NV1) aufweist und wobei eine Auswertevorrichtung (AWV) das paramagnetische Zentrum und/oder die Vielzahl (NVC) paramagnetischer Zentren (NV1) mit Pumpstrahlung (LB) bestrahlt und wobei das paramagnetische Zentrum und/oder die Vielzahl (NVC) paramagnetischer Zentren (NV1) Fluoreszenzstrahlung (FL) in Abhängigkeit von der magnetischen Flussdichte (B) am Ort des paramagnetische Zentrums (NV1) und/oder der Vielzahl (NVC) paramagnetischer Zentren (NV1) ausstrahlt und wobei sich das paramagnetische Zentrum (NV1) und/oder die Vielzahl (NVC) paramagnetischer Zentren (NV1) auf dem Läufer oder dem Stator befinden und wobei die Auswertevorrichtung (AWV) die Fluoreszenzstrahlung (FL) erfasst und wobei die Auswertevorrichtung (AWV) in Abhängigkeit von der erfassten Fluoreszenzstrahlung (FL) das Steuersignal erzeugt. Die Auswertevorrichtung (AWV) kann dabei aus mehreren Auswertevorrichtungen bestehen. Eine Auswertevorrichtung kann durch optische Funktionsmittel, beispielsweise Lichtwellenleiter, mit einem paramagnetischen Zentrum (NV1) und/oder einer Vielzahl (NVC) paramagnetischer Zentren (NV1) dabei gekoppelt sein.

### Figur 71

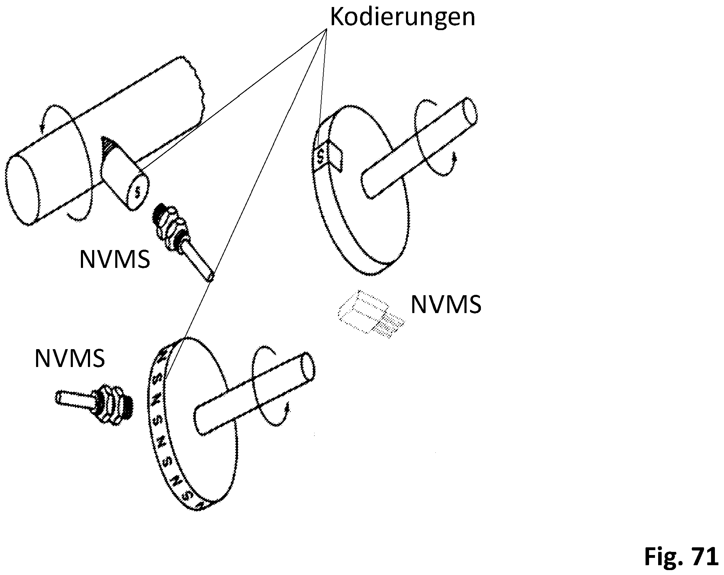

Figur 71 zeigt weitere Kodierungsmöglichkeiten für die Kodierung über permanent magnetisierte Kodierscheiben oder Rotationskörper zur Drehwinkelmessung und/oder Umdrehungszählung.

### Figur 72

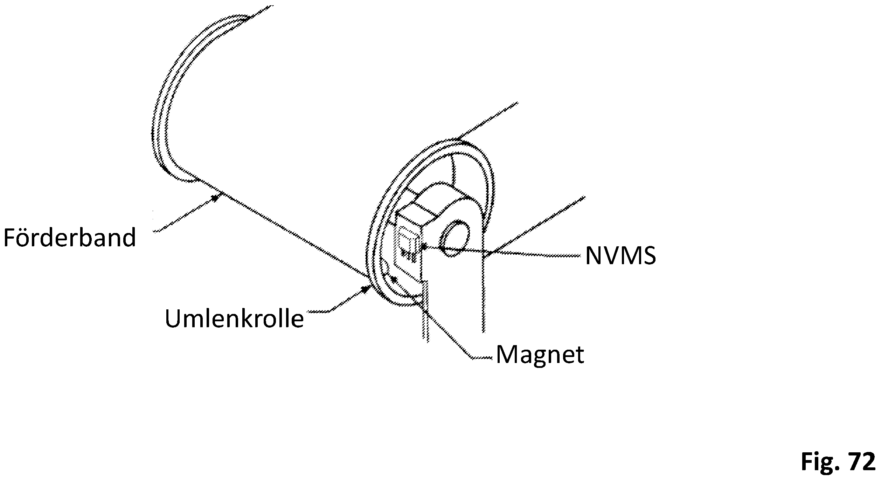

Figur 72 zeigt die Anwendung eines Sensorsystems zur Drehgeschwindigkeitsmessung der Transportrolle eines Förderbandes und damit zur Geschwindigkeitsmessung. Die notwendige Kodierscheibe ist hier nicht explizit eingezeichnet, da sie zuvor mehrfach erwähnt wurde.

### Figur 73

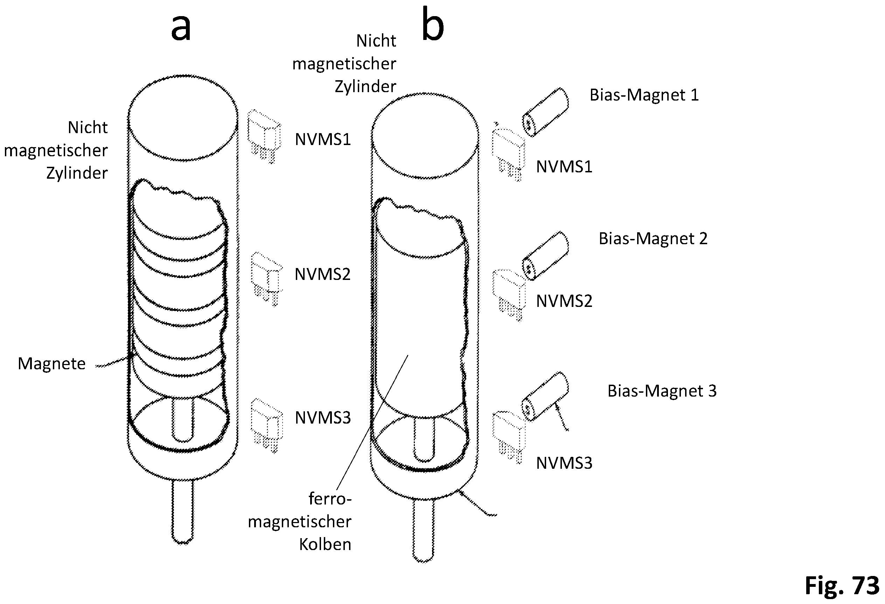

Figur 73 zeigt die Verwendung von vorgeschlagenen Sensorsystemen (NVMS1, NVMS2, NVMS3) für die Positionsbestimmung eines Kolbens in einem Zylinder. Hierfür kann entweder der Kolben permanentmagnetisch kodiert sein oder die magnetische Erregung wird von außen, beispielsweise durch Permanentmagnete zugeführt, und der Kolben ist beispielsweise ferromagnetisch. Je nach Position des Kolbens im Zylinder ändert sich der magnetische Fluss durch die Sensorsysteme (NVMS1, NVMS2, NVMS3). Diese geben die Messwerte an ein Auswertesystem, das die Position bestimmt und ggf. weitergibt oder sonst wie verarbeitet.

### Figur 74

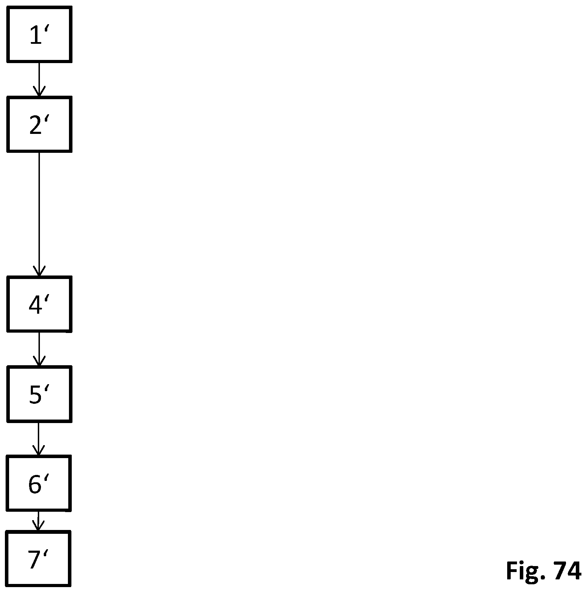

Figur 74 zeigt einen typischen Ablauf eines Verfahrens zum Betrieb eines Messsystems zur Messung elektromagnetischer Wellen (HFW) mit einem Sensorsystem (NVMS) mit mindestens einem Sensorelement mit mindestens einem paramagnetischen Zentrum (NV1) und/oder mindestens einem Cluster einer Vielzahl (NVC) paramagnetischer Zentren (NV1). Das Verfahren kann grundsätzlich auch für andere Wellen verwendet werden, wenn in einem hier nicht verwendeten dritten Schritt eine Wandlung in eine elektromagnetische Welle (HFW) erfolgt.

In einem ersten Schritt (1') erfolgt das Aussenden einer elektromagnetischen Sendewelle durch einen Sender. In einem zweiten Schritt (2') erfolgt das Reflektieren der elektromagnetischen Sendewelle durch ein oder mehrere Objekte (Obj) als elektromagnetischen Welle (HFW) und/oder die Modifikation der elektromagnetischen Sendewelle durch ein oder mehrere Objekte (Obj) oder den Übertragungskanal zu einer elektromagnetischen Welle (HFW). Der dritte Schritt der Wandlung eines Ultraschallsignals in ein elektromagnetisches Signal ist hier nicht notwendig und wird daher hier übersprungen. Hier sei als ein Beispiel auf die Figur 24 und den dortigen dritten Schritt (3) verwiesen. Die elektromagnetische Welle (HFW) verursacht in dem vierten Schritt (4') eine Modulation der magnetischen Flussdichte (B) am Ort des Quantenpunkts (NV1) bzw. des paramagnetischen Zentrums (NV1) bzw. der Vielzahl (NVC) paramagnetischer Zentren (NV1) bzw. des NV-Zentrums des Sensorsystems (NVMS). Die Modulation der der magnetischen Flussdichte (B) am Ort des Quantenpunkts (NV1) bzw. am Ort des paramagnetischen Zentrums (NV1) bzw. der Vielzahl (NVC) paramagnetischer Zentren (NV1) bzw. am Ort des NV-Zentrums (NV1) des Sensorsystems (NVMS) moduliert die Fluoreszenzstrahlung (FL) des Quantenpunkts (NV1) bzw. des paramagnetischen Zentrums (NV1) bzw. der Vielzahl (NVC) paramagnetischer Zentren (NV1) bzw. des NV-Zentrums (NV1) des Sensorsystems (NVMS) in einem fünften Schritt (5'). In einem sechsten Schritt (6') erfasst ein erster Strahlungsempfänger (PD1) des Sensorsystems (NVMS) diese Modulation der Fluoreszenzstrahlung (FL), z.B. als Empfängerausgangssignal (S0). In einem siebten Schritt (7') erzeugt eine Auswerteschaltung und/oder Auswerteinheit aus dem Empfängerausgangssignal (S0) einen oder mehrere Messwerte, bevorzugt eine zeitliche Abfolge von Messwerten, die dann bevorzugt beispielsweise als erstes Ausgangssignal (out) oder über einen Datenbus (DB) ausgegeben werden und bevorzugt ganz oder teilweise verwendet werden.

### Figur 75

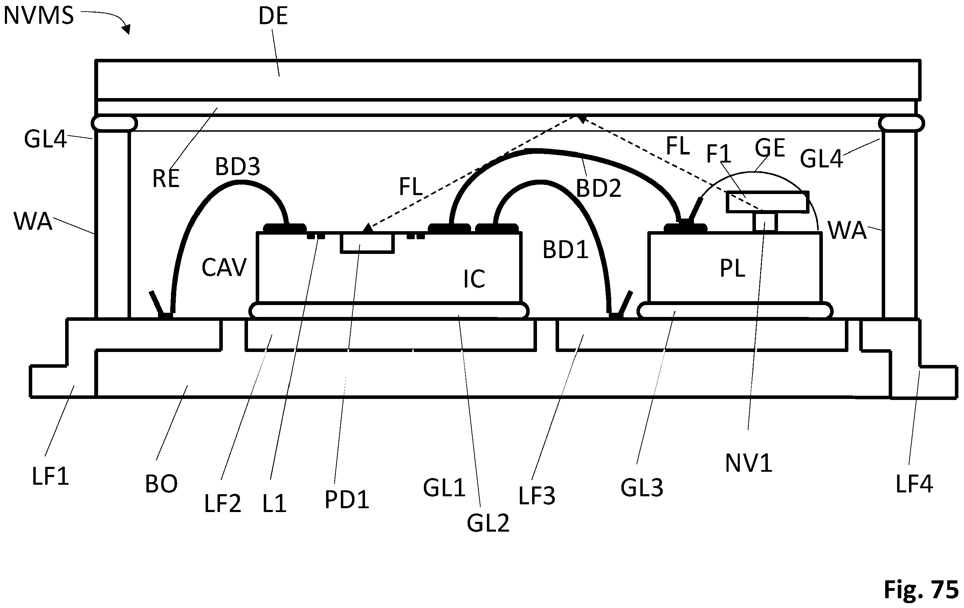

Figur 75 entspricht im Wesentlichen der Figur 1, mit dem Unterschied, dass das Sensorelement mit dem Quantenpunkt (NV1), also beispielsweise einem paramagnetischen Zentrum (NV1) bzw. einer Vielzahl (NVC) paramagnetischer Zentren (NV1) oder bevorzugt einem NV-Zentrum (NV1) in Diamant als Sensorelement, nun unmittelbar auf der ersten Pumpstrahlungsquelle (PL1) befestigt ist. Dies hat den Vorteil, dass nun die Pumpstrahlungsleistung maximiert ist, was den Kontrast maximiert. Die Fluoreszenzstrahlung (FL) wird nun über optische Funktionsmittel, hier den Reflektor (RE), auf den ersten Strahlungsempfänger (PD1) umgeleitet. Experimente haben gezeigt, dass durch eine Pumpleistungsdichtemaximierung im Sensorelement, also beispielsweise im Diamanten, der Kontrast in der Kurve der Figur 15 maximiert werden kann.

### Figur 76

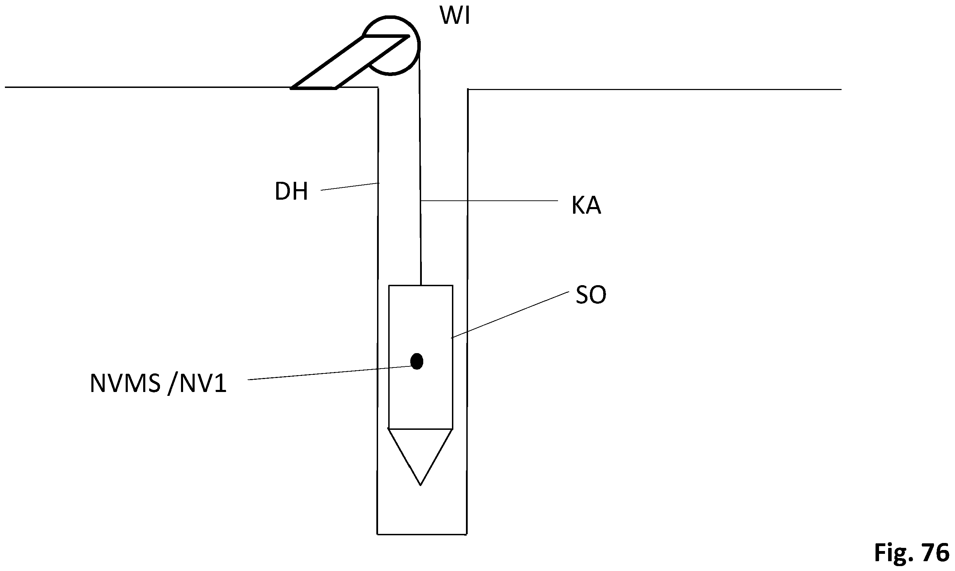

Figur 76 zeigt eine Sonde (SO) für die Vermessung eines Bohrlochs (DH) bzw. zur Vermessung der Eigenschaften des ggf. in dem Bohrloch (DH) befindlichen Fluids. Die Sonde (SO) kann beispielsweise einen oder mehrere Permanentmagneten aufweisen, die ein Magnetfeld erzeugen, das durch Stoffe in der Wand des Bohrlochs (DH) oder in dem Fluid in dem Bohrloch in der Nähe der Sonde (SO) deformiert wird. Hierzu kann ggf. auch das Erdmagnetfeld genutzt werden. Eine Winde (WI) lässt die Sonde (SO) an einem Kabel (KA) in das Bohrloch (DH) herunter. Das Kabel (KA) hält die Sonde (SO) mechanisch. Das Kabel (KA) kann einen oder mehrere Lichtwellenleiter umfassen, die ein

Sensorelement, z.B. einen Diamanten, mit einem Quantenpunkt (NV1), bevorzugt umfassend ein paramagnetisches Zentrum (NV1) bzw. eine Vielzahl (NVC) paramagnetischer Zentren (NV1), mit einem restlichen Sensorsystem bevorzugt in Form einer Auswertevorrichtung (AWV) auf der Oberfläche verbinden. An dieser Stelle sei auf die Figuren 27 bis 30 verwiesen. Auch kann gleich ein ganzes Sensorsystem (NVMS) in der Sonde (SO) untergebracht werden. Ein solches Sensorsystem (NVMS) kommuniziert dann bevorzugt über Leitungen in dem Kabel (KA) oder drahtlos akustisch oder per Funk mit einem übergeordneten Rechnersystem auf der Oberfläche. Auf diese Weise ist eine Vermessung der besagten physikalischen Parameter, insbesondere der magnetischen Flussdichte (B) in dem Bohrloch (DH) auch bei sehr hohen Temperaturen und/oder in aggressiven Umgebungen möglich.

### Bezugszeichenliste

- 1: erster Schritt: Aussenden einer akustischen Sendewelle (ASW) durch einen Schallsender, insbesondere einen Ultraschallsender (USS);
- 1': erster Schritt: Aussenden einer elektromagnetischen Sendewelle durch einen Sender;
- 2: zweiter Schritt: Reflektieren der akustischen Sendewelle (ASW) durch ein oder mehrere Objekte (Obj) als akustische Welle (AW) und/oder Modifizieren der akustischen Sendewelle (ASW) durch ein oder mehrere Objekte (Obj) oder den Übertragungskanal zu einer akustischen Welle (AW);
- 2': zweiter Schritt: Reflektieren der elektromagnetischen Sendewelle durch ein oder mehrere Objekte (Obj) als elektromagnetischen Welle (HFW) und/oder Modifizieren der elektromagnetischen Sendewelle durch ein oder mehrere Objekte (Obj) oder den Übertragungskanal zu einer elektromagnetischen Welle (HFW);
- 3: dritter Schritt: Die reflektierte akustische Welle (AW), versetzt eine Membrane (ME) mit einer ferromagnetischen Teilvorrichtung in dem dritten Schritt (3) in Schwingungen;
- 4: vierter Schritt: Die schwingende Membrane (ME) mit der ferromagnetischen Teilvorrichtung verursacht in dem vierten Schritt (4) eine Modulation der magnetischen Flussdichte (B) am Ort des Quantenpunkts (NV1) bzw. des paramagnetischen Zentrums (NV1) bzw. des NV-Zentrums des Sensorsystems (NVMS);
- 4': vierter Schritt: Die elektromagnetische Welle (HFW) verursacht in dem vierten Schritt (4') eine Modulation der magnetischen Flussdichte (B) am Ort des Quantenpunkts (NV1) bzw. des paramagnetischen Zentrums (NV1) bzw. des NV-Zentrums des Sensorsystems (NVMS);
- 5: fünfter Schritt: Die Modulation der magnetischen Flussdichte (B) am Ort des Quantenpunkts (NV1) bzw. am Ort des paramagnetischen Zentrums (NV1) bzw. am Ort des NV-Zentrums (NV1) des Sensorsystems (NVMS) moduliert die Fluoreszenzstrahlung (FL) des Quantenpunkts (NV1) bzw. des paramagnetischen Zentrums (NV1) bzw. des NV-Zentrums (NV1) des Sensorsystems (NVMS);
- 5': fünfter Schritt: Die Modulation der magnetischen Flussdichte (B) am Ort des Quantenpunkts (NV1) bzw. am Ort des paramagnetischen Zentrums (NV1) bzw. am Ort des NV-Zentrums (NV1) des Sensorsystems (NVMS) moduliert die Fluoreszenzstrahlung (FL) des Quantenpunkts (NV1) bzw. des paramagnetischen Zentrums (NV1) bzw. des NV-Zentrums (NV1) des Sensorsystems (NVMS);
- 6: sechster Schritt: In einem sechsten Schritt (6) erfasst ein erster Strahlungsempfänger (PD1) des Sensorsystems (NVMS) diese Modulation der Fluoreszenzstrahlung (FL) z.B. als Empfängerausgangssignal (S0);
- 6': sechster Schritt: In einem sechsten Schritt (6') erfasst ein erster Strahlungsempfänger (PD1) des Sensorsystems (NVMS) diese Modulation der Fluoreszenzstrahlung (FL) z.B. als Empfängerausgangssignal (S0);
- 7: siebter Schritt: In einem siebten Schritt (7) erzeugt eine Auswerteschaltung und/oder Auswerteinheit aus dem Empfängerausgangssignal (S0) einen oder mehrere Messwerte, bevorzugt eine zeitliche Abfolge von Messwerten, die dann bevorzugt ganz oder teilweise verwendet werden.
- 7': siebter Schritt: In einem siebten Schritt (7') erzeugt eine Auswerteschaltung und/oder Auswerteinheit aus dem Empfängerausgangssignal (S0) einen oder mehrere Messwerte, bevorzugt eine zeitliche Abfolge von Messwerten, die dann bevorzugt ganz oder teilweise verwendet werden.
- 2D oder 3D-B-Felderzeugung: Die 2D oder 3D-B-Felderzeugung umfasst alle Mittel zur Erzeugung eines zweidimensionalen oder dreidimensionalen magnetischen Feldes. Typischerweise handelt es sich um Helmholzspulen (L2 bis L7). Es ist aber denkbar, statt der Helmholzspulen (L2 bis L7) andere Spulenkonfigurationen, insbesondere segmentierte Flachspulen einzusetzen, um den magnetischen Fluss (B) oder zumindest vorbestimmte Komponenten des magnetischen Flusses (B) am Ort des Quantenpunkts (NV1) bzw. des paramagnetischen Zentrums (NV1) bzw. des NV-Zentrums (NV1) zu kompensieren und/oder zu beeinflussen.
- a: Punkt zu dem die Zahnschiene gerade den magnetischen Fluss (B) in dem Luftspalt des Schlitzsensors so absenkt, dass der zweite Schwellwert (SW2) bei einer Bewegung der Zahnschiene von links nach rechts in Figur 41 unterschritten wird;
- A1: Subtrahierer;
- ab: Abstand (ab) der Symmetrieachse (ms) des Zahns einer Zahnschiene vom Symmetriepunkt (m) eines beispielhaft ansonsten symmetrisch konstruierten Schlitzsensors in Figur 41;
- ADC: Analog-zu-Digital-Wandler;
- AKT: Aktor(en);
- AKTL: Leitung /Datenbus zur Steuerung des Aktors / der Aktoren;
- AMP: Verstärker;
- b: Punkt zu dem die Zahnschiene gerade den magnetischen Fluss (B) in dem Luftspalt des Schlitzsensors so absenkt, dass der erste Schwellwert (SW1) bei einer Bewegung der Zahnschiene von links nach rechts in Figur 41 unterschritten wird;
- AS1: erste Achse (AS1) der ersten Helmholz-Spule, der siebten Spule (L7);
- AS2: zweite Achse (AS2) der zweiten Helmholz-Spule, der zweiten Spule (L2);
- AS3: dritte Achse (AS3) der dritten Helmholz-Spule, der dritten Spule (L3);
- AS4: vierte Achse (AS4) der vierten Helmholz-Spule, der vierten Spule (L4);
- AS5: fünfte Achse (AS5) der fünften Helmholz-Spule, der fünften Spule (L5);
- AS6: sechste Achse (AS6) der sechsten Helmholz-Spule, der sechsten Spule (L6);
- ASW: akustische Sendewelle. Der Ultraschallsender (USS) emittiert eine beispielhafte akustische Sendewelle (ASW), die beispielsweise an einem Objekt (Obj) oder im Übertragungskanal zu einer akustischen Welle (AW) modifiziert wird und dann durch das vorgeschlagene Mikrofon (Figur 21) empfangen wird.
- AW: akustische Welle. Die akustische Welle (AW) setzt in dem Beispiel der Figur 21 eine Membrane (ME) mit einer ferromagnetischen Teilvorrichtung in Schwingung, sodass die so erzeugte Schwingung der magnetischen Flussdichte (B) am Ort des Quantenpunkts (NV1) bzw. des paramagnetischen Zentrums (NV1) bzw. des NV-Zentrums (NV1) durch die sich ergebende Fluoreszenzstrahlungsschwankung der Fluoreszenzstrahlung (FL) erfasst werden kann.
- AWV: Auswertevorrichtung;
- B: magnetische Flussdichte;
- BA: Barriere oder Blende. In Figur 31 verhindert die beispielhafte Barriere (BA) ein Übersprechen der ersten Fluoreszenzstrahlung (FL1) des ersten Quantenpunkts (NV1) bzw. ersten paramagnetischen Zentrums (NV1) bzw. ersten NV-Zentrums (NV1) auf den zweiten Strahlungsempfänger (PD2) und ein Übersprechen der zweiten Fluoreszenzstrahlung (FL22) des zweiten Quantenpunkts (NV2) bzw. des zweiten paramagnetischen Zentrums (NV2) bzw. des zweiten NV-Zentrums (NV2) auf den ersten Strahlungsempfänger (PD1);
- BA1: erste Blende oder Barriere. Die erste Blende (BA1) verhindert in dem Beispiel der Figur 12 die direkte Einstrahlung der Kompensationsstrahlungsquelle (PLK) in den Quantenpunkt (NV1) bzw. in das paramagnetische Zentrum (NV1) bzw. in das NV-Zentrum;
- BA2: zweite Blende oder Barriere. Die zweite Blende (BA2) verhindert in den Beispielen der Figuren 11 und 12 die direkte Einstrahlung der ersten Pumpstrahlungsquelle (PL1) in den ersten Strahlungsempfänger (PD1);
- BD: Boden / Fahrbahnoberfläche;
- BD1: erster Bond-Draht;
- BD2: zweiter Bond-Draht;
- BD3: dritter Bond-Draht;
- BO: Gehäuseboden;
- c: Punkt zu dem die Zahnschiene gerade den magnetischen Fluss (B) in dem Luftspalt des Schlitzsensors so absenkt, dass der erste Schwellwert (SW1) bei einer Bewegung der Zahnschiene von links nach rechts in Figur 41 überschritten wird;
- CAV: Kavität;
- CON: elektrischer Leiter;
- CORR: Korrelator. Der Korrelator (CORR) vergleicht ein erstes Signal mit einem zweiten Signal und gibt ein Ergebnissignal aus, dessen Wert ein Maß dafür ist, inwieweit das erste Signal mit dem zweiten Signal übereinstimmt. Im einfachsten Falle führt der Korrelator (CORR) eine mathematische Funktion aus, die einer Linearform entspricht. Die beiden Signale werden dabei als unendlich dimensionale Vektoren betrachtet, deren Index die kontinuierliche Zeit ist. Die Linearform verknüpft diese beiden Signale miteinander und erzeugt ein Signal, das selbst wieder bevorzugt Element des Vektorraumes ist, dem die Signale entstammen. Bevorzugt ist die Linearform ein Skalar-Produkt. Im Falle von Signalen kann das Skalarprodukt so gebildet werden, dass über einen vordefinierten Zeitraum, beispielsweise die Periodendauer des Sendesignals (S5), der jeweilige Momentanwert des ersten Signals mit dem entsprechenden Momentanwert des zweiten Signals zum gleichen Zeitpunkt für alle Zeitpunkte innerhalb der Periode multipliziert wird und das Multiplikationsergebnis für die Periode aufintegriert wird. In dem Beispiel der Figur 8 geschieht dies durch einen ersten Multiplizierer (M1), der das reduzierte Empfängerausgangssignal (S1) mit dem Sendesignal (S5) multipliziert. Ein Filter (TP), der bevorzugt ein Tiefpass ist, führt die Integration durch. Eigentlich wäre am Ausgang des Filters (TP) noch eine Abtast- und Halteschaltung (Englisch: Sample & Hold-Schaltung) notwendig, die am Ende bevorzugt jeder Periode des Sendesignals (S5) das Ausgangssignal des Filters (TP) bevorzugt bis zum Ende der nächsten Periode des Sendesignals (S5) zwischenspeichert und so die Integration eindeutig periodenbezogen macht. Es hat sich aber gezeigt, dass in der Praxis diese Abtast-und Halteschaltung nicht immer notwendig ist und der dadurch verursachte Fehler oft vernachlässigt werden kann. Das Filterausgangssignal (S4) der Figur 8 ist somit das Signal, dessen Signal den Korrelationswert repräsentiert. Bevorzugt ist der Filter (TP) der Figur 8 mit einer großen Verstärkung versehen, um das System zu linearisieren. Mittels eines zweiten Multiplizierers (M2) wird in dem Beispiel der Figur 8 das reduzierte Empfängerausgangssignal (S1), soweit es Anteile des Sendesignals (S5) enthielt, rekonstruiert und von dem Empfängerausgangssignal (S0) abgezogen. Im stabilen Zustand enthält dann das reduzierte Empfängerausgangssignal (S1) fast keine Anteile des Sendesignals (S5) mehr, während das Filterausgangssignal (S4) den Korrelationswert zwischen dem Empfängerausgangssignal (S0) und dem Sendesignal (S5) repräsentiert. Der Korrelator (CORR) kann auch anders realisiert werden. Wichtig ist, dass er den Anteil des Sendesignals (S5) in dem Empfängerausgangssignal (S0) als Korrelationswert bestimmt. Hierfür sind beispielsweise auch Optimalfilter und/oder Matched-Filter geeignet.
- CTR: Steuerrechner;
- d: Punkt zu dem die Zahnschiene gerade den magnetischen Fluss (B) in dem Luftspalt des Schlitzsensors so absenkt, dass der zweite Schwellwert (SW2) bei einer Bewegung der Zahnschiene von links nach rechts in Figur 41 überschritten wird;
- d2: Abstand;
- DE: Gehäusedeckel;
- DB: Datenbus;
- DB2: ggf. vorhandener zweiter Datenbus (DB2) zu einem ggf. übergeordneten System und/oder einem Rechnerverbund und/oder zur Verbindung mit dem Internet.
- d_{FOB}: Abstand vom Sensorsystem (NVMS) zu einem magnetisierten Objekt, hier vorzugsweise zu einem ferromagnetischen Objekt (FOB);
- DH: Bohrloch. Das Bohrloch (DH) ist im weitesten Sinne ein fluidisches Funktionselement. Es kann mit Fluiden, kolloidalen Lösungen, Mischungen von Flüssigkeiten, festen Materialien, wie z.B. Sande und/oder Stäube, sowie Gase umfassen.
- DSP: Bildschirm;
- DSPL: Leitung/ Datenleitung (DSPL) zur Steuerung des Bildschirms (DSP) bzw. zur Steuerung der Darstellung auf dem Bildschirm (DSP) bzw. von Objekten auf dem Bildschirm (DSP);
- ΔTFL: Fluoreszenzphasenverschiebungszeit der zeitlichen Phasenverschiebung zwischen dem Signal der Modulation der Pumpstrahlung (LB, LB1) und dem Signal der Modulation der Fluoreszenzstrahlung (FL, FL1). Die Fluoreszenzphasenverschiebungszeit beschreibt somit näherungsweise das Nachleuchten der Fluoreszenzstrahlung (FL) der Quantenpunkte (NV1) bzw. der paramagnetischen Zentren (NV1) bzw. der NV-Zentren (NV1) nach dem Abklingen der Pumpstrahlung (LB, LB1);
- ΔTm: Messphasenverschiebungseinheit. Die optionale Messphasenverschiebungseinheit verzögert das Sendesignal (S5) um eine Messphasenverschiebungszeit (ΔTM) zum Messsignal (MES), das für die Analyse des Empfängerausgangssignals (S0) bevorzugt verwendet wird.
- ΔTM: Messphasenverschiebungszeit (ΔTM) der zeitlichen Phasenverschiebung zwischen dem Signal der Modulation der Pumpstrahlung (LB, LB1) und den zeitlichen Zeiträumen oder Zeitpunkten der Auswertung des Empfängerausgangssignals (S0) des ersten Strahlungsempfängers (PD1), das von der durch den ersten Strahlungsempfänger (PD1) empfangenen Fluoreszenzstrahlung (FL, FL1) abhängt, durch die Auswerteschaltung, beispielsweise durch die integrierte Schaltung (IC). In den Figuren 3 bis 7 entspricht dies der zeitlichen Verschiebung zwischen den Flanken des Signals der Pumpstrahlung (LB, LB1) einerseits und des beispielhaften, zur Verdeutlichung dienenden Messsignals (MES) andererseits;
- EL1: erste Elektrode;
- EL2: zweite Elektrode;
- F1: erster optischer Filter. Der erste optische Filter (F1) ist nur notwendig, wenn die Fluoreszenzstrahlung (FL) zu ersten Zeiten (T1) ausgewertet werden soll, zu denen auch die Pumpstrahlungsquelle (PL1) Pumpstrahlung (LB, LB1) emittiert. Wird die Fluoreszenzstrahlung (FL) zu dritten Zeiten (T3) oder zweiten Zeiten (T2) ausgewertet, zu denen die Pumpstrahlungsquelle (PL1) keine Pumpstrahlung (LB, LB1) emittiert, indem das Nachleuchten der Fluoreszenzstrahlung (FL) ausgenutzt wird, so ist dieses erste optische Filter (F1) nicht unbedingt notwendig. Der erste optische Filter (F1) wird bevorzugt so gestaltet, dass er Strahlung mit der Pumpstrahlungswellenlänge (λₚₘₚ) der Pumpstrahlung (LB, LB1) und/oder der reflektierten Pumpstrahlung (LB2) nicht passieren lässt und Strahlung mit der Fluoreszenzstrahlungswellenlänge (λ_{fl}) der Fluoreszenzstrahlung (FL) passieren lässt. Wird eine Kompensationsstrahlungsquelle (PLK) vorgesehen, die Kompensationsstrahlung (KS) ebenfalls summierend überlagernd in den ersten Strahlungsempfänger (PD1) einstrahlt und dessen Kompensationsstrahlung (KS) das erste optische Filter (F1) vor dem Auftreffen auf den ersten Strahlungsempfänger (PD1) passieren soll, so ist der erste optische Filter (F1) vorzugsweise so ausgelegt, dass er das das Licht der Kompensationsstrahlungsquelle (PLK) für den vorgesehenen Zweck nicht oder nicht Wesentlich dämpft, also Strahlung mit der Kompensationsstrahlungswellenlänge (λₖₛ) der Kompensationsstrahlung (KS) im Wesentlichen passieren lässt. Bevorzugt sperrt im Falle der Verwendung von NV-Zentren als Quantenpunkten das erste optische Filter (F1) Strahlung mit Wellenlängen kürzer 600 nm und lässt Strahlung mit Wellenlängen oberhalb von 600 nm, also kürzer als 600nm, passieren. Bei der Verwendung anderer Typen paramagnetischer Störstellen (NV1) werden diese Wellenlängen funktionsäquivalent ggf. angepasst. Die Wellenlängengrenze wird bevorzugt in Abhängigkeit von der Pumpstrahlungswellenlänge (λₚₘₚ) der Pumpstrahlung (LB) der ersten Pumpstrahlungsquelle (PL1), der Fluoreszenzwellenlänge (λ_{fl}) der Fluoreszenzstrahlung (FL) des Quantenpunkts bzw. der Quantenpunkte und der Kompensationsstrahlungswellenlänge (λₖₛ) der Kompensationsstrahlung (KS) der Kompensationsstrahlungsquelle (PLK) gewählt. Die Wellenlängengrenze wird bevorzugt so gewählt, dass die Pumpstrahlungswellenlänge (λₚₘₚ) der Pumpstrahlung (LB) der ersten Pumpstrahlungsquelle (PL1) nicht durch den ersten optischen Filter (F1) transmittiert wird und die Fluoreszenzwellenlänge (λ_{fl}) der Fluoreszenzstrahlung (FL) des Quantenpunkts bzw. der Quantenpunkte durch den ersten optischen Filter (F1) transmittiert wird und die Kompensationsstrahlungswellenlänge (λₖₛ) der Kompensationsstrahlung (KS) der Kompensationsstrahlungsquelle (PLK) durch den ersten optischen Filter (F1) transmittiert wird.
- FL: Fluoreszenzstrahlung (FL) die der Quantenpunkt, also insbesondere das paramagnetische Zentrum (NV1) bzw. die Vielzahl (NVC) paramagnetischer Zentren (NV1) bzw. das NV-Zentrum bzw. die Vielzahl von NV-Zentren, ausstrahlt, wenn es durch Pumpstrahlung (LB, LB1) der ersten Pumpstrahlungsquelle (PL1) und/oder von reflektierter Pumpstrahlung (LB2) mit einer Pumpstrahlungswellenlänge (λₚₘₚ) bestrahlt wird. Im Falle eines NV-Zentrums in einem Diamanten als paramagnetisches Zentrum (NV1) ist die Pumpstrahlung (LB1) und damit bevorzugt die reflektierte Pumpstrahlung (LB2) grün. Die Fluoreszenzstrahlung (FL) ist im Falle eines NV-Zentrums in einem Diamanten als paramagnetisches Zentrum (NV1) dann typischerweise rot. Die Intensität der Fluoreszenzstrahlung (FL) des Quantenpunkts hängt typischerweise von dem Betrag der magnetischen Flussdichte (B) ab. Sofern es sich bei dem Quantenpunkt um ein paramagnetisches Zentrum (NV1) beispielsweise in Form eines einzelnen Störstellenzentrums in einem Einkristall oder um eine Vielzahl (NVC) paramagnetischer Zentren (NV1) handelt, hängt die Intensität der Fluoreszenzstrahlung (FL) bei gewissen magnetischen Flussdichten (B) am Ort des paramagnetischen Zentrums (NV1) bzw. der Vielzahl (NVC) paramagnetischer Zentren (NV1) auch von der Richtung der magnetischen Flussdichte (B) relativ zur Kristallachse des betreffenden Kristalls und damit relativ von der Orientierung des Störstellenzentrums (NV1) ab. Bevorzugt handelt es sich bei der Fluoreszenzstrahlung im Falle eines NV-Zentrums in Diamant als paramagnetisches Zentrum (NV1) um rotes Licht mit einer Wellenlänge von 600nm bis 700nm, die länger als die Wellenlänge der Pumpstrahlung (LB, LB11) und kürzer als die Wellenlänge der Kompensationsstrahlung (KS, KS1) ist.
- FL1: erste Fluoreszenzstrahlung die der Quantenpunkt, also insbesondere das paramagnetische Zentrum (NV1) bzw. die Vielzahl (NVC) paramagnetischer Zentren (NV1) bzw. das NV-Zentrum bzw. die Vielzahl von NV-Zentren, ausstrahlt, wenn er durch Pumpstrahlung (LB, LB1) der Pumpstrahlungsquelle (PL1) und/oder von reflektierter Pumpstrahlung (LB1) mit einer Pumpstrahlungswellenlänge (λₚₘₚ) bestrahlt wird. Im Falle eines NV-Zentrums in einem Diamanten als paramagnetisches Zentrum (NV1) bzw. im Falle einer Vielzahl von NV-Zentren in einem Diamanten als Vielzahl (NVC) paramagnetischer Zentren (NV1) ist die Pumpstrahlung (LB1) und damit bevorzugt die reflektierte Pumpstrahlung (LB2) grün. Die Fluoreszenzstrahlung (FL) ist dann typischerweise rot. Die Intensität (I_{fl}) der Fluoreszenzstrahlung (FL) hängt typischerweise von dem Betrag der magnetischen Flussdichte (B) ab. Sofern es sich bei dem Quantenpunkt um ein paramagnetisches Zentrum (NV1) in Form eines einzelnen Störstellenzentrums in einem Einkristall handelt und/oder um eine Vielzahl (NVC) paramagnetischer Zentren (NV1) in Form mehrerer Störstellenzentren in einem Einkristall handelt, hängt die Intensität (I_{fl}) der Fluoreszenzstrahlung (FL) bei gewissen magnetischen Flussdichten (B) auch von der Richtung der magnetischen Flussdichte (B) relativ zur Kristallachse ab. Wird eine Vielzahl von Kristallen unterschiedlicher, bevorzugt stochastisch verteilter Orientierung verwendet, so kann diese Abhängigkeit unterdrückt werden. Bevorzugt handelt es sich bei der ersten Fluoreszenzstrahlung (FL1) im Falle eines NV-Zentrums in Diamant als paramagnetisches Zentrum (NV1) im Falle einer Vielzahl von NV-Zentren in Diamant um rotes Licht mit einer Wellenlänge von 600nm bis 700nm, die typischerweise länger als die Pumpstrahlungswellenlänge (λₚₘₚ) der Pumpstrahlung (LB, LB1) (z.B. 520nm bei NV-Zentren) und oft kürzer als die Kompensationsstrahlungswellenlänge (λₖₛ) der Kompensationsstrahlung (KS) ist.
- FL2: reflektierte Fluoreszenzstrahlung. Beispielsweise der Reflektor (RE) reflektiert ggf. die Fluoreszenzstrahlung (FL, FL1) des Quantenpunkts, also beispielsweise des paramagnetischen Zentrums (NV1) bzw. der Vielzahl (NVC) paramagnetischer Zentren (NV1) bzw. des NV-Zentrums bzw. der Vielzahl von NV-Zentren, als reflektierte Fluoreszenzstrahlung (FL2) bevorzugt in Richtung des ersten Strahlungsempfängers (PD1), der die Fluoreszenzstrahlung (FL, FL1) dann als reflektierte Fluoreszenzstrahlung (FL2) bevorzugt empfängt. Statt des Reflektors (RE) können auch andere optischen Funktionselemente zur optischen Kopplung des ersten Strahlungsempfängers (PD1) mit dem Quantenpunkt, z.B. in Form des paramagnetischen Zentrums (NV1) oder der Vielzahl paramagnetischer Zentren (NV1) oder des NV-Zentrums oder der Vielzahl der NV-Zentren, beispielsweise durch Fokussierung und/oder Umlenkung der Fluoreszenzstrahlung (FL, FL1) oder beispielsweise durch Filterung der Fluoreszenzstrahlung (FL, FL1) mittels eines ersten optischen Filters (F1) verwendet werden, um die reflektierte Fluoreszenzstrahlung (FL2) aus der Fluoreszenzstrahlung (FL, FL1) zu erzeugen und durch den ersten Strahlungsempfänger (PD1) zu empfangen. Bevorzugt handelt es sich im Falle von NV-Zentren als paramagnetischen Zentren (NV1) bei der reflektierten Fluoreszenzstrahlung (FL2) um rotes Licht mit einer Wellenlänge von 600 nm bis 700 nm, die typischerweise länger als die Pumpstrahlungswellenlänge (λₚₘₚ) der Pumpstrahlung (LB, LB1) und oft kürzer als die Kompensationsstrahlungswellenlänge (λₖₛ) der Kompensationsstrahlung (KS) ist;
- FL22: zweite Fluoreszenzstrahlung (FL22), die den zweiten Quantenpunkt, insbesondere in Form des zweiten paramagnetischen Zentrums (NV2) bzw. in Form der zweiten Vielzahl (NVC2) zweiter paramagnetischer Zentren (NV2) bzw. in Form des zweiten NV-Zentrums bzw. in Form einer zweiten Vielzahl von NV-Zentren, ausstrahlt, wenn es durch Pumpstrahlung (LB, LB1) der Pumpstrahlungsquelle (PL, PL1) und/oder von reflektierter Pumpstrahlung (LB2) mit Pumpstrahlungswellenlänge (λₚₘₚ) bestrahlt wird. Im Falle eines zweiten NV-Zentrums in einem Diamanten als zweites paramagnetisches Zentrum (NV2) in einem Diamanten als zweites paramagnetisches Zentrum (NV2) oder im Falle einer zweiten Vielzahl von NV-Zentren in einem oder mehreren Diamanten als zweite Vielzahl (NVC2) zweiter paramagnetischer Zentren (NV2) ist die Pumpstrahlung (LB1) und damit bevorzugt die reflektierte Pumpstrahlung (LB2) grün. Die zweite Fluoreszenzstrahlung (FL22) ist dann typischerweise rot. Die Intensität der zweiten Fluoreszenzstrahlung (FL22) hängt typischerweise von dem Betrag der magnetischen Flussdichte (B) ab. Sofern es sich bei dem zweiten paramagnetischen Zentrum (NV2) um ein einzelnes zweites Störstellenzentrum in einem Einkristall handelt, hängt die Intensität der zweiten Fluoreszenzstrahlung (FL22) bei gewissen magnetischen Flussdichten (B) typischerweise auch von der Richtung der magnetischen Flussdichte(B) relativ zur Kristallachse und damit zur Orientierung des zweiten paramagnetischen Zentrums (NV2) relativ zur Richtung der magnetischen Flussdichte (B) ab. Sofern es sich bei der zweiten Vielzahl (NVC2) zweiter paramagnetischer Zentren (NV2) um eine Vielzahl zweiter Störstellenzentrum in mehreren, vorzugsweise unterschiedlich und vorzugsweise zufällig orientierten Einkristallen handelt, kann diese Richtungsabhängigkeit unterdrückt werden. Bevorzugt handelt es sich bei der zweiten Fluoreszenzstrahlung (FL22) im Falle eines NV-Zentrums in Diamant als zweites paramagnetisches Zentrum (NV2) bzw. im Falle einer Vielzahl von NV-Zentren in Diamant als zweite Vielzahl (NVC2) zweiter paramagnetischer Zentren (NV2) um rotes Licht mit einer Wellenlänge von 600 nm bis 700 nm, die typischerweise länger als die Pumpstrahlungswellenlänge (λₚₘₚ) der Pumpstrahlung (LB, LB1) und kürzer als die Kompensationsstrahlungswellenlänge (λₖₛ) der Kompensationsstrahlung (KS) ist;
- FLU: Fluid. Bei dem Fluid (FLU) kann es sich um ein Gas oder eine Flüssigkeit oder eine flüssige Mischung (z.B. ein Gas-/Öl-/Sand-/Wasser-Gemisch wie in Bohrlöchern (DH)) oder eine quasi gasförmige Mischung (z.B. ein mit Stäuben durchsetztes Gas) handeln. Insbesondere kann es sich um den Elektrolyten einer elektrochemischen Vorrichtung, beispielsweise einer Elektrolysezelle, einer Brennstoffzelle, einer Batterie oder eines Akkumulators, etc. handeln.
- FOB: ferromagnetisches Objekt;
- G: Signalgenerator. Der Signalgenerator (G) erzeugt bevorzugt das Sendesignal (S5);
- GE: Befestigungsmittel (GE) mit dem das Sensorelement mit dem Quantenpunkt (NV1), bzw. dem paramagnetischen Zentrum (NV1) bzw. dem NV-Zentrum (NV1) befestigt wird;
- GL1: erster Kleber. In dem Beispiel der Figur 1 ist der erste optische Filter (F1) mittels des strahlungstransparenten ersten Klebers (GL1) mit der integrierten Schaltung (IC) mechanisch verbunden. Der erste Kleber (GL1) ist dabei für die Fluoreszenzstrahlung (FL) im Wesentlichen transparent. Dies bedeutet, dass der erste Kleber (GL1) die Fluoreszenzstrahlung (FL), wenn überhaupt, nur soweit dämpft, dass es für den bestimmungsgemäßen Zweck der Vorrichtung unerheblich ist. Der erste Kleber (GL1) koppelt in dem Beispiel der Figur 1 das paramagnetische Zentrum (NV1) optisch mit dem ersten Strahlungsempfänger (PD1). Diese Kopplung bezieht sich in dem Beispiel der Figur 1 auf die Fluoreszenzstrahlung (FL). Sofern eine Kompensationsstrahlung (KS) verwendet wird, koppelt der erste Kleber (Gl1) die Kompensationsstrahlungsquelle (PLK) mit dem ersten Strahlungsempfänger (PD1) als ein optisches Element in dem optischen Kopplungspfad zwischen Kompensationsstrahlungsquelle (PLK) und erstem Strahlungsempfänger (PD1). Der erste Kleber (GL1) ist daher bevorzugt im Falle der Verwendung einer Kompensationsstrahlung (KS) für die Wellenlänge der Kompensationsstrahlung (KS) ausreichend transparent.
- GL2: zweiter Kleber (GL2) für die Befestigung der integrierten Schaltung (IC) auf der zweiten Lead-Frame-Insel (LF2). Bevorzugt ist dieser zweiter Kleber (GL2) elektrisch leitfähig. Es sind aber auch Systeme mit elektrisch isolierendem zweiten Kleber (GL2) denkbar;
- GL3: dritter Kleber (GL3) für die Befestigung der ersten Pumpstrahlungsquelle (PL1) auf der dritten Lead-Frame-Insel (LF3). Bevorzugt ist dieser dritte Kleber (GL3) elektrisch leitfähig. Es sind aber auch Systeme mit elektrisch isolierendem dritten Kleber (GL3) denkbar;
- GL4: vierter Kleber (GL4) für die Befestigung des Gehäusedeckels (DE) an der Gehäusewand (WA);
- GND: Bezugspotenzialleitung (GND) auf Bezugspotenzial;
- H: magnetische Feldstärke oder Erregung. Die magnetische Feldstärke (H) ist über die bekannte Materialgleichung der Maxwellschen-Gleichungen mit der magnetischen Flussdichte (B) verknüpft;
- HF-Fenster: spezieller Deckel (DE) des Gehäuses, der den Eintritt elektromagnetischer Strahlung, beispielsweise in Form einer elektromagnetischen Welle (HFW) in das Gehäuse zulässt. Die elektromagnetische Welle (HFW) moduliert die Fluoreszenzstrahlung (FL) des Quantenpunkts, beispielsweise in Form des paramagnetischen Zentrums (NV1) bzw. der Vielzahl (NVC) paramagnetischer Zentren (NV1) bzw. des NV-Zentrums (NV1) bzw. der Vielzahl von NV-Zentren, was durch das Sensorsystem (NVMS) erfasst und ausgewertet wird;
- HFW: elektromagnetische Welle;
- IC: integrierte Schaltung;
- IF: Ansteuerungs- und Aufbereitungseinheit;
- IFL: Leitung/ Datenbus (IFL) zur Steuerung der Ansteuerungs- und Aufbereitungseinheit (IF);
- I_{fl}: Intensität (I_{fl}) der Fluoreszenzstrahlung (FL) des Quantenpunkts;
- Iₖₛ: Intensität (Iₖₛ) der Kompensationsstrahlung (KS);
- INV: Invertierungseinheit. Die optionale Invertierungseinheit (INV) invertiert im einfachsten Fall das Sendesignal (S5) zum Messsignal (MES), das für die Analyse des Empfängerausgangssignals (S0) bevorzugt wird. Die Bildung eines zum Sendesignal (S5) komplementären Messsignals (MES) entsprechend MES=c-S5 mit c als konstantem Wert ist auch denkbar.
- Iₘ: elektrischer Strom (Iₘ), der den Leiter (CON) zumindest anteilig so durchströmt, dass die magnetische Flussdichte (B) am Ort des Quantenpunkts, also des paramagnetischen Zentrums (NV1) bzw. der Vielzahl (NVC) paramagnetischer Zentren (NV1) bzw. des NV-Zentrums bzw. der Vielzahl von NV-Zentren in Abhängigkeit von diesem elektrischen Strom modifiziert wird;
- I_{L8}: achter Spulenstrom. Der achte Spulenstrom fließt durch die Steuersignalleitung (SS1) in eine achte Spule (L8).
- Iₚₘₚ: Intensität (Iₚₘₚ) der Pumpstrahlung (LB);
- IS1: erste elektrische Isolation;
- IS2: zweite elektrische Isolation;
- J1: torusförmiges oder ringförmiges Joch;
- JK1: erstes Jochsegment;
- JK2: zweites Jochsegment;
- JK3: drittes Jochsegment;
- JV: Verbindungsjoch;
- KA: Kabel. Das Kabel (KA) kann elektrische Leitungen zur Versorgung von elektrischen und elektronischen und elektrooptischen Einrichtungen der Sonde (SO) und zur Signalisierung zwischen Sonde (SO) und einem übergeordneten System an der Oberfläche umfassen. Das Kabel (KA) kann auch optische Systeme wie beispielsweise Lichtwellenleiter umfassen. Auch kann das Kabel (KA) mechanische Adern umfassen, deren einziger Zweck das mechanische Halten der Sonde ist.
- Kfz: Fahrzeug und/oder mobile Vorrichtung. Hierunter können alle nicht lokal fixierten Vorrichtungen, wie beispielsweise, aber nicht nur, Autors, Lastwagen, Baumaschinen, bewegliche Maschinen, Roboter, Lokomotiven, Zugmaschinen, Flugzeuge, Satelliten, Raketen, Geschosse, Flugkörper, Schiffe, Unterseeboote, Raumstationen, etc. sowie nicht zwingend lokal fixierte Vorrichtungen wie tragbares oder transportables medizinische Equipment, Mobiltelefone und Smartphones, Laptops, Desk-Top-PCs, Schreib/Leseköpfe für Datenspeicher, Magnetometer, Messequipment, Messequipment für die Materialuntersuchung und die Detektion von Materialdefekten und Störungen, Messequipment für die Vermessung von Bohrlöchern, geomagnetisches Messequipment für die Prospektion, Kreiselkompasse, Kompasse und Navigationsequipment, portables Equipment für die Vermessung chemischer Parameter wie ph-Wert oder elektrochemische Potenziale, Gassensoren etc. verstanden werden.
- Kopf: Kopf. Beispielhaftes Körperteil für die Anwendung der magnetoenzephalografischen Vorrichtung.
- KP: Kappe. Die Kappe (KP) ist eine beispielhafte Vorrichtung zur vorhersagbaren Anordnung mehrerer Sensorsysteme (NVMS) in einer vordefinierten Geometrie. Diese Anordnung ermöglicht eine magnetoenzephalografische Auswertung der Sensordaten der Sensorsysteme (NVMS). Statt einer Kappe (KP) können ähnliche Vorrichtungen zur Untersuchung anderer Körperteile oder ganzer menschlicher und tierischer Körper verwendet werden. Eine Implantation der Sensorsysteme (NVMS) in ein Körperteil an vordefinierten Orten ist ebenfalls denkbar. In dem Fall wird die Rolle der Kappe (KP) durch ein Körperteil, beispielsweise einen Knochen, übernommen;
- KS: Kompensationsstrahlung. Die Kompensationsstrahlung (KS) wird von der Kompensationsstrahlungsquelle (PLK) emittiert. Bevorzugt geschieht dies zu zweiten Zeiten (T2), die von den ersten Zeiten (T1), zu denen die Pumpstrahlungsquelle (PL, PL1) bevorzugt Pumpstrahlung (LB, LB1) emittiert, verschieden sind. Sofern die Auswertung der Fluoreszenzstrahlung (FL) zu dritten Zeiten (T3) erfolgt, so sind dann bevorzugt diese zweiten Zeiten (T2) von diesen dritten Zeiten (T3) bevorzugt ebenfalls verschieden. Bevorzugt handelt es sich um infrarotes Licht mit einer Wellenlänge größer als die Wellenlänge der Fluoreszenzstrahlung (FL) und größer als die Wellenlänge der Pumpstrahlung (LB, LB1).
- KS2: reflektierte Kompensationsstrahlung. Der Reflektor (RE) reflektiert die Kompensationsstrahlung (KS) der Kompensationsstrahlungsquelle (PLK) als reflektierte Kompensationsstrahlung bevorzugt in Richtung des ersten Strahlungsempfängers (PD1), der die Kompensationsstrahlung (KS) dann als reflektierte Kompensationsstrahlung (KS2) bevorzugt empfängt. Statt des Reflektors (RE) können auch andere optische Funktionselemente zur optischen Kopplung des ersten Strahlungsempfängers (PD1) mit der Kompensationsstrahlungsquelle (PLK) beispielsweise durch Umlenkung und/oder Fokussierung/Defokussierung und/oder Streuung der Kompensationsstrahlung (KS) verwendet werden, um die reflektierte Kompensationsstrahlung (KS2) aus der Kompensationsstrahlung (KS) zu erzeugen und durch den ersten Strahlungsempfänger (PD1) zu empfangen. Bevorzugt handelt es sich bei der reflektierten Kompensationsstrahlung (KS2) um infrarotes Licht mit einer Wellenlänge größer als die Wellenlänge der Fluoreszenzstrahlung (FL) und größer als die Wellenlänge der Pumpstrahlung (LB, LB1).
- Kunststoffstoßstange: Kunststoffstoßstange. Die Kunststoffstoßstange ist ein Beispiel für ein Bauteil eines Fahrzeugs (Kfz), in das ein Sensorsystem (NVMS) eingebaut werden kann. Bevorzugt ist das Bauteil aus einem nicht magnetischen, also bevorzugt diamagnetischen Werkstoff. Der Einbau in andere Fahrzeugbauteile wie Lenkrad, Spiegelgehäuse, Sitze, Armaturenbrett, Batterie, Kabelbaum, Fensterheber, Airbag-System, Klimaanlage, Klimaklappen, Bedienelemente, Navigationssystem, Kofferraum, Türen und Klappen, Befüllstutzen, Füllstandsmessvorrichtungen, Schließsysteme etc. ist denkbar.
- λ_{fl}: Fluoreszenzstrahlungswellenlänge (λ_{fl}) der Fluoreszenzstrahlung (FL) des Quantenpunks bei Bestrahlung mit Pumpstrahlung (LB) der Pumpstrahlungswellenlänge (λₚₘₚ);
- λₖₛ: Kompensationsstrahlungswellenlänge (λₖₛ) der Kompensationsstrahlung (KS) der Kompensationsstrahlungsquelle (PLK);
- λₚₘₚ: Pumpstrahlungswellenlänge (λₚₘₚ) der Pumpstrahlung (LB, LB1) der Pumpstrahlungsquelle (PL1);
- L0: Spule. Eine Stromquelle (SQ) erzeugt in dem Beispiel der Figur 30 mittels der Spule (L0) eine magnetische Flussdichte (B);
- L1: erste Spule. In der Figur 1 ist die erste Spule (L1) als beispielhafte Flachspule in die integrierte mikroelektronische Schaltung (IC) integriert.
- L2: zweite Spule. Die zweite Spule (L2) ist die erste Spule des zweiten Helmholzspulenpaars (L2, L4);
- L3: dritte Spule. Die dritte Spule (L3) ist die zweite Spule des ersten Helmholzspulenpaars (L7, L3);
- L4: vierte Spule. Die vierte Spule (L4) ist die zweite Spule des zweiten Helmholzspulenpaars (L2, L4);
- L5: fünfte Spule. Die fünfte Spule (L5) ist die erste Spule des dritten Helmholzspulenpaars (L5, L6);
- L6: sechste Spule. Die sechste Spule (L6) ist die zweite Spule des dritten Helmholzspulenpaars (L5, L6);
- L7: siebte Spule. Die siebte Spule (L7) ist die erste Spule des ersten Helmholzspulenpaars (L7, L3);
- L8: achte Spule;
- LB: Pumpstrahlung, die von der ersten Pumpstrahlungsquelle (PL1) emittiert wird. Die Wellenlänge der Pumpstrahlung (LB) wird bevorzugt so gewählt, dass die Pumpstrahlung (LB) das verwendete paramagnetische Zentrum (NV1) zur Emission von Fluoreszenzstrahlung (FL) anregen kann. Beispielsweise wird die Wellenlänge im Falle eines NV-Zentrums in Diamant als paramagnetisches Zentrum (NV1) bevorzugt so gewählt, dass es sich bei der Pumpstrahlung (LB) um grünes Licht handelt. In diesem Zusammenhang wird auf die einschlägige Literatur und die zitierten deutschen unveröffentlichten Patentanmeldungen ergänzend verwiesen. Bevorzugt handelt es sich bei der Pumpstrahlung (LB) im Falle eines NV-Zentrums in Diamant als paramagnetisches Zentrum (NV1) um grünes Licht mit einer Wellenlänge von 500 nm bis 600 nm, besser 520 nm bis 540 nm, besser 530 nm +/- 5 nm, die kürzer als die Wellenlänge der Fluoreszenzstrahlung (FL, FL1) und kürzer als die Wellenlänge der Kompensationsstrahlung (KS) ist;
- LB1: Pumpstrahlung, die von der ersten Pumpstrahlungsquelle (PL1) emittiert wird. Die Pumpstrahlungswellenlänge (λₚₘₚ) der Pumpstrahlung (LB1) wird bevorzugt so gewählt, dass die Pumpstrahlung (LB1) das verwendete paramagnetische Zentrum (NV1) bzw. die verwendete Vielzahl (NVC) paramagnetischer Zentren (NV1) bzw. das verwendete NV-Zentrum bzw. die verwendete Vielzahl von NV-Zentren zur Emission von Fluoreszenzstrahlung (FL) anregen kann. Beispielsweise wird die Pumpstrahlungswellenlänge (λₚₘₚ) im Falle eines NV-Zentrums in Diamant als paramagnetisches Zentrum (NV1) bzw. im Falle einer Vielzahl von NV-Zentren in Diamant als Vielzahl (NVC) paramagnetischer Zentren (NV1) bevorzugt so gewählt, dass es sich bei der Pumpstrahlung (LB1) um grünes Licht handelt. In diesem Zusammenhang wird auf die einschlägige Literatur und die zitierten deutschen unveröffentlichten Patentanmeldungen ergänzend verwiesen. Bevorzugt handelt es sich bei der Pumpstrahlung (LB1) im Falle eines NV-Zentrums in Diamant als paramagnetisches Zentrum (NV1) bzw. im Falle einer Vielzahl von NV-Zentren in Diamant als Vielzahl (NVC) paramagnetischer Zentren (NV1) um grünes Licht mit einer Wellenlänge von 500nm bis 600nm, besser 520nm bis 540nm, besser 530nm +/- 5nm, die typischerweise kürzer als die Fluoreszenzwellenlänge (λ_{fl}) der Fluoreszenzstrahlung (FL, FL1) und oft kürzer als die Kompensationsstrahlungswellenlänge (λₖₛ) der Kompensationsstrahlung (KS) ist;
- LB1a: Pumpstrahlung, die von der ersten Pumpstrahlungsquelle (PL1) emittiert wird. Die Pumpstrahlungswellenlänge (λₚₘₚ) der Pumpstrahlung (LB1a) wird bevorzugt so gewählt, dass die Pumpstrahlung (LB1a) den verwendeten Quantenpunkt, also z.B. das verwendete paramagnetische Zentrum (NV1) bzw. die Vielzahl (NVC) paramagnetischer Zentren (NV1) bzw. das NV-Zentrum bzw. die Vielzahl von NV-Zentren, zur Emission von Fluoreszenzstrahlung (FL) mit einer Fluoreszenzwellenlänge (λ_{fl}) anregen kann. Beispielsweise wird die Pumpstrahlungswellenlänge (λₚₘₚ) im Falle eines NV-Zentrums in Diamant als paramagnetisches Zentrum (NV1) bzw. im Falle einer Vielzahl von NV-Zentren in Diamant als Vielzahl (NVC) paramagnetischer Zentren (NV1) bevorzugt so gewählt, dass es sich bei der Pumpstrahlung (LB1a) um grünes Licht handelt. In diesem Zusammenhang wird auf die einschlägige Literatur und die zitierten deutschen unveröffentlichten Patentanmeldungen ergänzend verwiesen. Bevorzugt handelt es sich bei der Pumpstrahlung (LB1a) im Falle eines NV-Zentrums in Diamant als paramagnetisches Zentrum (NV1) bzw. im Falle einer Vielzahl von NV-Zentren in Diamant als Vielzahl (NVC) paramagnetischer Zentren (NV1) um grünes Licht mit einer Pumpstrahlungswellenlänge (λpmp) von 500 nm bis 600 nm, besser 520 nm bis 540 nm, besser 530 nm +/- 5 nm, die bevorzugt kürzer als die Fluoreszenzwellenlänge (λ_{fl}) der Fluoreszenzstrahlung (FL, FL1) und oft kürzer als die Kompensatinsstrahlungswellenlänge (λₖₛ) der Kompensationsstrahlung (KS) ist;
- LB1b: reflektierte Pumpstrahlung. Der Reflektor (RE) reflektiert die Pumpstrahlung (LB, LB1a) der ersten Pumpstrahlungsquelle (PL1) als reflektierte Pumpstrahlung (LB1b) bevorzugt in Richtung des paramagnetischen Zentrums (NV1). Statt des Reflektors (RE) können auch andere optischen Funktionselemente zur optischen Kopplung des paramagnetischen Zentrums (NV1) mit der ersten Pumpstrahlungsquelle (PL1) beispielsweise durch Umlenkung und/oder Fokussierung und/oder Streuung der Pumpstrahlung (LB, LB1a) verwendet werden, um die reflektierte Pumpstrahlung (LB1b) aus der Pumpstrahlung (LB, LB1a) zu erzeugen und durch den Quantenpunkt, z.B. in Form des paramagnetischen Zentrums (NV1) bzw. in Form der Vielzahl (NVC) paramagnetischer Zentren (NV1) bzw. in Form des NV-Zentrums bzw. in Form der Vielzahl von NV-Zentren, zu empfangen und den Quantenpunkt ggf. zur Fluoreszenz durch Abgabe von Fluoreszenzstrahlung (FL) mit einer Fluoreszenzwellenlänge (λ_{fl}) anzuregen. Bevorzugt handelt es sich bei der reflektierten Pumpstrahlung (LB1b) im Falle eines NV-Zentrums in Diamant als paramagnetisches Zentrum (NV1) bzw. im Falle einer Vielzahl von NV-Zentren in Diamant als Vielzahl (NVC) paramagnetischer Zentren (NV1) um grünes Licht mit einer Wellenlänge von 500 nm bis 600 nm, besser 520 nm bis 540 nm, besser 530 nm +/- 5 nm, die typischerweise kürzer als die Fluoreszenzstrahlungswellenlänge (λ_{fl}) der Fluoreszenzstrahlung (FL, FL1) und oft kürzer als die Kompensationsstrahlungswellenlänge (λₖₛ) der Kompensationsstrahlung (KS) ist;
- LB2: reflektierte Pumpstrahlung. Der Reflektor (RE) reflektiert die Pumpstrahlung (LB, LB1) der ersten Pumpstrahlungsquelle (PL1) als reflektierte Pumpstrahlung (LB2) bevorzugt in Richtung des Quantenpunkts, als beispielsweise in Richtung desparamagnetischen Zentrums (NV1) bzw. in Richtung der Vielzahl (NVC) paramagnetischer Zentren (NV1) bzw. in Richtung des NV-Zentrums bzw. in Richtung der Vielzahl von NV-Zentren. Statt des Reflektors (RE) können auch andere optischen Funktionselemente zur optischen Kopplung des Quantenpunkts mit der ersten Pumpstrahlungsquelle (PL1) beispielsweise durch Umlenkung der Pumpstrahlung (LB, LB1a) verwendet werden, um die reflektierte Pumpstrahlung (LB2) aus der Pumpstrahlung (LB, LB1a) zu erzeugen und durch den Quantenpunkt, also z.B. durch das paramagnetische Zentrum (NV1) bzw. die Vielzahl (NVC) paramagnetischer Zentren (NV1) bzw. das NV-Zentrum bzw. die Vielzahl von NV-Zentren, zu empfangen und den Quantenpunkt ggf. zur Fluoreszenz durch Abgabe von Fluoreszenzstrahlung (FL) anzuregen. Bevorzugt handelt es sich bei der reflektierten Pumpstrahlung (LB2) im Falle eines NV-Zentrums in Diamant als paramagnetisches Zentrum (NV1) bzw. im Falle einer Vielzahl von NV-Zentren als Vielzahl (NVC) paramagnetischer Zentren (NV1) um grünes Licht mit einer Wellenlänge von 500 nm bis 600 nm, besser 520 nm bis 540 nm, besser 530 nm +/- 5 nm, die bevorzugt kürzer als die Fluoreszenzwellenlänge (λ_{fl}) der Fluoreszenzstrahlung (FL, FL1) und oft kürzer als die Kompensationswellenlänge (λₖₛ) der Kompensationsstrahlung (KS, KS1) ist;
- LC: Kompensationsspule;
- LF1: erste Lead-Frame-Insel. Diese dient in dem Beispiel der Figur 1 als Anschluss-Pin;
- LF2: zweite Lead-Frame-Insel Diese dient in dem Beispiel der Figur 1 als Die-Paddle für die integrierte Schaltung (IC);
- LF3: dritte Lead-Frame-Insel. Diese dient in dem Beispiel der Figur 1 als Die-Paddle für die Pumpstrahlungsquelle (PL1);
- LF4: vierte Lead-Frame-Insel. Diese dient in dem Beispiel der Figur 1 als Anschluss-Pin;
- LS: Lautsprecher / akustische Ausgabeeinheit;
- LSL: Leitung / Datenbus zur Steuerung der akustischen Ausgabeeinheit (LS);
- LSP1: erster Luftspalt;
- LSP2: zweiter Luftspalt;
- LSP3: dritter Luftspalt;
- LWL1: erster Lichtwellenleiter;
- LWL2: zweiter Lichtwellenleiter;
- µC: Mikrorechner;
- m: Symmetriepunkt. Der Symmetriepunkt (m) ist der Punkt, zu dem die Zahnschiene in Figur 41 gerade den magnetischen Fluss (B) in dem Luftspalt des Schlitzsensors so absenkt hat, dass bei einer weiteren Bewegung der Zahnschiene von links nach rechts, die Flussdichte (B) von diesem Punkt an wieder ansteigt. In dem Fall befindet sich die Symmetrieachse (ms) des Zahns der Zahnschiene in Figur 41 im Symmetriepunkt des Schlitzsensors;
- M1: erster Multiplizierer;
- M2: zweiter Multiplizierer;
- MDS: Ausgangsdatenstrom (MDS) der durch den Mustererkenner (NN) erkannten Prototypen (Prototyp = prototypischer Merkmalsvektor der Datenbank);
- ME: Membrane;
- MES: beispielhaftes Messsignal (MES) zur Verdeutlichung, wann das Empfängerausgangssignal (S0) des ersten Strahlungsempfängers (PD1) bevorzugt ausgewertet wird. In den Figuren 3 und 4 soll ein beispielhafter logischer Wert des Messsignals von 1 beispielhaft bedeuten, dass das Empfängerausgangssignal (S0) ausgewertet wird und ein beispielhafter logischer Wert des Messsignals von 0 bedeuten, dass des Empfängerausgangssignals (S0) des ersten Strahlungsempfängers (PD1) zu diesen Zeiten nicht ausgewertet wird.
- Messwert: Messwert den der Rechner (µC) erzeugt und/oder bereitstellt und/oder überträgt;
- ms: Symmetrieachse (ms) des Zahns der Zahnschiene in Figur 41;
- MS1: erstes Messwertsignal;
- N: magnetischer Nordpol;
- NN: Mustererkenner. Der Mustererkenner (NN) ist bevorzugt ein Rechnersystem, das einen Algorithmus zur Erkennung von Mustern im vektoriellen Ausgangsdatenstrom (VDS) der Ansteuerungs- und Aufbereitungseinheit (IF) ausführt. Hierbei kann es sich beispielsweise um ein neuronales Netz, einen HMM-Erkenner oder dergleichen aus der Mustererkennung handeln;
- NNL: Leitung und/oder Datenbus (NNL) zur Steuerung des Mustererkenners (NN);
- NV1: zumindest ein paramagnetisches Zentrum (NV1) oder zumindest ein Quantenpunkt in einem Sensorelement. Bei dem Quantenpunkt handelt es sich bevorzugt um ein paramagnetisches Zentrum (NV1) bzw. um eine Vielzahl (NVC) paramagnetischer Zentren (NBV1) bzw. um ein NV-Zentrum bzw. um eine Vielzahl von NV-Zentren. Bevorzugt handelt es sich bei dem paramagnetischen Zentrum (NV1) um ein oder mehrere Störstellenzentren in einem Kristall, wobei der Kristall das Sensorelement im Sinne dieser Schrift darstellt. Bevorzugt ist der Kristall, also das Sensorelement, ein Diamantkristall. Das Störstellenzentrum ist bevorzugt ein NV-Zentrum in einem Diamantkristall. Im Sinne dieser Schrift kann es sich auch um mehrere Störstellenzentren in einem Kristall und/oder um eine Zusammenfügung mehrerer Kristalle mit mehreren Störstellenzentren handeln. Beispielsweise kann es sich um mehrere miteinander gekoppelte NV-Zentren in einem Diamantkristall und/oder um mehrere Diamanten mit mehreren NV-Zentren handeln, die z.B. durch stimulierte Emission und Absorption bevorzugt zusammenwirken und bevorzugt gekoppelt sind. Vorzugweise handelt es sich im Falle der Verwendung von NV-Zentren in Diamant als paramagnetische Zentren (NV1) bei dem Sensorelement um einen Diamanten mit hoher NV-Dichte und zwar vorzugsweise um einen mittels High-Pressure-High-Temperature künstlich erzeugten Diamanten mit vorzugsweise einem Gehalt von NV-Zentren als paramagnetische Zentren (NV1) in einem Konzentrationsbereich von 0,1ppm bis 500 ppm bezogen auf die Atome des Diamanten. Es kann sich neben der bevorzugten Kombination aus NV-Zentrum als Störstellenzentrum und Diamant als Sensorelement aber auch um ein oder mehrere andere Störstellenzentren in Diamant handeln. Beispielsweise um ein SiV-Zentrum oder ein ST1 Zentrum oder ein L2-Zentrum in Diamant. Der Quantenpunkt (NV1) kann diese Störstellenzentren ggf. auch gemischt in Diamant aufweisen. Auch können andere Kristalle mit anderen Störstellenzentren verwendet werden, wenn sie die magnetfeldabhängige Fluoreszenz aufweisen.
- NV2: zweiter Quantenpunkt (NV2) und/oder zweites paramagnetisches Zentrum (NV2) und/oder NV-Zentrum. Es handelt sich um zumindest ein zweites paramagnetisches Zentrum (NV2) oder zumindest einen zweiten Quantenpunkt (NV2) in einem Sensorelement. Bevorzugt handelt es sich bei dem paramagnetischen Zentrum um ein oder mehrere Störstellenzentren in einem Kristall, wobei der Kristall das Sensorelement im Sinne dieser Schrift darstellt. Bevorzugt ist der Kristall, also das Sensorelement, ein Diamantkristall. Das Störstellenzentrum ist bevorzugt ein NV-Zentrum in einem Diamantkristall. Im Sinne dieser Schrift kann es sich auch um mehrere Störstellenzentren in einem Kristall und/oder um eine Zusammenfügung mehrerer Kristalle mit mehreren Störstellenzentren handeln. Beispielsweise kann es sich um mehrere miteinander gekoppelte NV-Zentren in einem Diamantkristall und/oder um mehrere Diamanten mit mehreren NV-Zentren handeln, die z.B. durch stimulierte Emission und Absorption bevorzugt zusammenwirken und bevorzugt gekoppelt sind. Vorzugweise handelt es sich im Falle der Verwendung von NV-Zentren in Diamant als paramagnetische Zentren (NV2) bei dem Sensorelement um einen Diamanten mit hoher NV-Dichte und zwar vorzugsweise um einen mittels High-Pressure-High-Temperature künstlich erzeugten Diamanten mit vorzugsweise einem Gehalt von NV-Zentren als zweite paramagnetische Zentren (NV2) in einem Konzentrationsbereich von 0,1ppm bis 500 ppm bezogen auf die Atome des Diamanten. Es kann sich neben der bevorzugten Kombination aus NV-Zentrum als Störstellenzentrum und Diamant als Sensorelement aber auch um ein oder mehrere andere Störstellenzentren in Diamant handeln. Beispielsweise um ein SiV-Zentrum oder ein ST1 Zentrum oder ein L2-Zentrum in Diamant. Der zweite Quantenpunkt (NV2) kann diese Störstellenzentren ggf. auch gemischt in Diamant aufweisen. Auch können andere Kristalle mit anderen Störstellenzentren verwendet werden, wenn sie die magnetfeldabhängige Fluoreszenz aufweisen.
- NVC: Vielzahl (NVC) paramagnetischer Zentren (NV1). Bevorzugt handelt es sich um einen Cluster paramagnetischer Zentren (NV1), der auch einen gesamten Kristall eines Materials des Sensorelements umfassen kann;
- NVC2: zweite Vielzahl (NVC2) zweiter paramagnetischer Zentren (NV2). Bevorzugt handelt es sich um einen Cluster zweiter paramagnetischer Zentren (NV2), der auch einen gesamten Kristall eines Materials des Sensorelements umfassen kann;
- NVMS: Sensorsystem. Das vorgeschlagene Sensorsystem umfasst zumindest ein Sensorelement mit zumindest einem paramagnetischen Zentrum (NV1), wobei das Sensorsystem Mittel aufweist, eine Fluoreszenzstrahlung (FL) dieses paramagnetischen Zentrums (NV1) typischerweise in Abhängigkeit von der jeweiligen magnetischen Flussdichte (B) am Ort des Quantenpunkts des betreffenden Sensorelements, also beispielsweise am Ort des jeweiligen paramagnetischen Zentrums (NV1) des betreffenden Sensorelements, hervorzurufen, und Mittel, um die jeweilige Fluoreszenzstrahlung (FL) zu erfassen und Mittel, um den Wert der erfassten Fluoreszenzstrahlung (FL), insbesondere der Intensität (I_{fl}) der Fluoreszenzstrahlung (FL) zu verarbeiten und/oder an ein übergeordnetes System zu übermitteln;
- NVMS1: erstes Sensorsystem. Das vorgeschlagene erste Sensorsystem (NVMS1) umfasst zumindest ein Sensorelement mit zumindest einem Quantenpunkt, also beispielsweise mit zumindest einem paramagnetischen Zentrum (NV1), wobei das erste Sensorsystem Mittel aufweist, eine Fluoreszenzstrahlung (FL) dieses paramagnetischen Zentrums (NV1) typischerweise in Abhängigkeit von der jeweiligen magnetischen Flussdichte (B) am Ort des jeweiligen Quantenpunkts des betreffenden Sensorelements, also z.B. am Ort des jeweiligen paramagnetischen Zentrums (NV1) des betreffenden Sensorelements, hervorzurufen, und Mittel, um die jeweilige Fluoreszenzstrahlung (FL), beispielsweise die Intensität (I_{fl}) der Fluoreszenzstrahlung (FL), zu erfassen und Mittel, um den Wert der erfassten Fluoreszenzstrahlung (FL) zu verarbeiten und/oder an ein übergeordnetes System zu übermitteln;
- NVMS2: zweites Sensorsystem. Das vorgeschlagene zweite Sensorsystem (NVMS2) umfasst zumindest ein Sensorelement mit zumindest einem Quantenpunkt, also beispielsweise mit zumindest einem paramagnetischen Zentrum (NV1), wobei das zweite Sensorsystem (NVMS2) Mittel aufweist, eine Fluoreszenzstrahlung (FL) dieses paramagnetischen Zentrums (NV1) typischerweise in Abhängigkeit von der jeweiligen magnetischen Flussdichte (B) am Ort des jeweiligen Quantenpunkts des betreffenden Sensorelements, also z.B. am Ort des jeweiligen paramagnetischen Zentrums (NV1) des betreffenden Sensorelements, hervorzurufen, und Mittel, um die jeweilige Fluoreszenzstrahlung (FL), beispielsweise die Intensität (I_{fl}) der Fluoreszenzstrahlung (FL), zu erfassen und Mittel, um den Wert der erfassten Fluoreszenzstrahlung (FL) zu verarbeiten und/oder an ein übergeordnetes System zu übermitteln;
- NVMS3: drittes Sensorsystem. Das vorgeschlagene dritte Sensorsystem (NVMS3) umfasst zumindest ein Sensorelement mit zumindest einem Quantenpunkt, also beispielsweise mit zumindest einem paramagnetischen Zentrum (NV1), wobei das dritte Sensorsystem (NVMS3) Mittel aufweist, eine Fluoreszenzstrahlung (FL) dieses paramagnetischen Zentrums (NV1) typischerweise in Abhängigkeit von der jeweiligen magnetischen Flussdichte (B) am Ort des jeweiligen Quantenpunkts des betreffenden Sensorelements, also z.B. am Ort des jeweiligen paramagnetischen Zentrums (NV1) des betreffenden Sensorelements, hervorzurufen, und Mittel, um die jeweilige Fluoreszenzstrahlung (FL), beispielsweise die Intensität (I_{fl}) der Fluoreszenzstrahlung (FL), zu erfassen und Mittel, um den Wert der erfassten Fluoreszenzstrahlung (FL) zu verarbeiten und/oder an ein übergeordnetes System zu übermitteln;
- NVMS4: viertes Sensorsystem. Das vorgeschlagene vierte Sensorsystem (NVMS4) umfasst zumindest ein Sensorelement mit zumindest einem Quantenpunkt, also beispielsweise mit zumindest einem paramagnetischen Zentrum (NV1), wobei das vierte Sensorsystem (NVMS4) Mittel aufweist, eine Fluoreszenzstrahlung (FL) dieses paramagnetischen Zentrums (NV1) typischerweise in Abhängigkeit von der jeweiligen magnetischen Flussdichte (B) am Ort des jeweiligen Quantenpunkts des betreffenden Sensorelements, also z.B. am Ort des jeweiligen paramagnetischen Zentrums (NV1) des betreffenden Sensorelements, hervorzurufen, und Mittel, um die jeweilige Fluoreszenzstrahlung (FL), beispielsweise die Intensität (I_{fl}) der Fluoreszenzstrahlung (FL), zu erfassen und Mittel, um den Wert der erfassten Fluoreszenzstrahlung (FL) zu verarbeiten und/oder an ein übergeordnetes System zu übermitteln;
- OE: Öffnung im Joch (J1) der Strommessvorrichtung der Figur 26 (Flux-Gate);
- Obj: Objekt;
- OF: Offset-Vorrichtung. Die Offset-Vorrichtung addiert zu dem Rückkoppelsignal (S6) einen typischerweise positiven Gleichanteil und erzeugt so das offsetbehaftete Rückkoppelsignal (S7);
- OP1: erster Operationsverstärker;
- out: erstes Ausgangssignal;
- out": zweites Ausgangssignal;
- P1: erste Periodizität;
- P2: zweite Periodizität;
- PCB: gedruckte Schaltung;
- PD1: erster Strahlungsempfänger. Bevorzugt handelt es sich um ein lichtempfindliches Bauelement, beispielsweise eine Fotodiode und/oder eine PIN-Diode und/oder eine Avalanche-Fotodiode und/oder eine SPAD-Fotodiode oder dergleichen. Der erste Strahlungsempfänger (PD1) kann noch weitere Verstärker und/oder Filter und/oder andere Signalaufbereitungen umfassen, die zur Vereinfachung hier nicht weiter diskutiert werden. Es kann sich also auch um ein Strahlungsempfängersystem handeln;
- PD2: zweiter Strahlungsempfänger. Bevorzugt handelt es sich um ein lichtempfindliches Bauelement, beispielsweise eine Fotodiode und/oder eine PIN-Diode und/oder eine Avalanche-Fotodiode und/oder eine SPAD-Fotodiode oder dergleichen. Der zweite Strahlungsempfänger (PD2) kann noch weitere Verstärker und/oder Filter und/oder andere Signalaufbereitungen umfassen, die zur Vereinfachung hier nicht weiter diskutiert werden. Es kann sich also auch um ein Strahlungsempfängersystem handeln;
- permanentes Magnetfeld: permanentes Magnetfeld. Das permanente Magnetfeld wird bevorzugt durch einen oder mehrere Permanentmagnete (PM1, PM2) erzeugt. Der beispielsweise von dem einen oder mehreren Permanentmagneten (PM1, PM2) erzeugte permanente magnetische Fluss B wirkt summierend überlagernd auf den Quantenpunkt (NV1) bzw. das paramagnetische Zentrum (NV1) bzw. das NV-Zentrum (NV1) zusammen z.B. mit einem externen Magnetfeld ein;
- PL: Pumpstrahlungsquelle. Die Pumpstrahlungsquelle (PL) regt den Quantenpunkt (NV1), bzw. das paramagnetische Zentrum bzw. das NV-Zentrum (NV1) zur Abgabe von Fluoreszenzstrahlung (FL) in Abhängigkeit von der magnetischen Flussdichte (B) am Ort des Quantenpunkts (NV1), bzw. des paramagnetischen Zentrums bzw. des NV-Zentrums (NV1) an. Im Falle der Verwendung von NV-Zentren in Diamant als Quantenpunkte bzw. als paramagnetische Zentren (NV1) handelt es sich bevorzugt um eine LED und/oder einen Laser mit 535 nm Wellenlänge. Ein Wellenlängenbereich von typischerweise 500 nm bis 600 nm ist im Falle der Verwendung von NV-Zentren in Diamant als Quantenpunkte bzw. als paramagnetische Zentren (NV1) denkbar und von den Ansprüchen umfasst;
- PL1: erste Pumpstrahlungsquelle (PL1). Die erste Pumpstrahlungsquelle (PL1) regt den Quantenpunkt (NV1), bzw. das paramagnetische Zentrum bzw. das NV-Zentrum (NV1) zur Abgabe von Fluoreszenzstrahlung (FL) in Abhängigkeit von der magnetischen Flussdichte (B) am Ort des Quantenpunkts (NV1), bzw. des paramagnetischen Zentrums bzw. des NV-Zentrums (NV1) an. Im Falle der Verwendung von NV-Zentren in Diamant als Quantenpunkte bzw. als paramagnetische Zentren (NV1) handelt es sich bevorzugt um eine LED und/oder einen Laser mit 535 nm Wellenlänge. Ein Wellenlängenbereich von typischerweise 500 nm bis 600 nm ist im Falle der Verwendung von NV-Zentren in Diamant als Quantenpunkte bzw. als paramagnetische Zentren (NV1) denkbar und von den Ansprüchen umfasst;
- PLK: Kompensationsstrahlungsquelle. Bevorzugt handelt es sich um eine Infrarot-LED, insbesondere bevorzugt mit einer Wellenlänge größer 800nm;
- PM1: erster Permanentmagnet;
- PM2: zweiter Permanentmagnet;
- PM3: dritter Permanentmagnet;
- PM4: vierter Permanentmagnet;
- RE: Reflektor oder anderes geeignetes optische Funktionselement oder anderes optisches System zur Lenkung zumindest eines Teils der Pumpstrahlung (LB1) als reflektierte Pumpstrahlung (LB2) in Richtung des paramagnetischen Zentrums (NV1).
- RG: Regler;

- RO: fluidische Leitung, beispielsweise ein Rohr oder ein Behälter oder ein Reaktor oder eine elektrochemische Vorrichtung oder ein Kessel oder ein Batteriebehälter oder ein Akkumulatorbehälter oder eine Brennstoffzelle oder eine Elektrolysezelle oder ein mikrofluidisches oder fluidisches Funktionselement, wie beispielsweise ein Verweiler oder ein Wärmetauscher oder ein Zerstäuber oder eine Düse oder ein Mischer etc. Bei der fluidischen Leitung (RO) kann es sich auch um ein Bohrloch (DH) handeln. In dem Fall kann das vorgeschlagene Sensorsystem (NVMS) zur Lagerstättenerkundung eingesetzt werden.;
- S: magnetischer Südpol (S);
- 50: Empfängerausgangssignal;
- S1: reduziertes Empfängerausgangssignal;
- S3: Filtereingangssignal;
- S3': zusätzliches Filtereingangssignal;
- S4: Filterausgangssignal;
- S4': zusätzliches Filterausgangssignal;
- S5: Sendesignal;
- S5': orthogonales Referenzsignal;
- S6: Rückkoppelsignal;
- S6': zusätzliches Rückkoppelsignal;
- S7: offsetbehaftetes Rückkoppelsignal;
- S8: komplexes Rückkoppelsignal;
- S9: Arbeitspunktregelsignal;
- SMBG: Symbolgenerator;

- SO: Sonde. Die Sonde (SO) wird an einem Kabel (KA) in Figur 74 in das Bohrloch (DH) hinabgelassen. Das Kabel (KA) kann ein oder mehrere Glasfasern umfassen. Das Messsystem kann so gestaltet sein, dass entsprechend den Figuren 28 bis 30 das Sensorelement, also beispielsweise der Diamantkristall, mit dem Quantenpunkt (NV1), also das paramagnetische Zentrum oder das NV-Zentrum (NV1), von den übrigen Sensorsystemkomponenten getrennt wird. Dies hat den Vorteil, dass so die Auswerteelektronik (z.B. die integrierte Schaltung (IC)) nicht den extremen Bedingungen im Bohrloch (DH) ausgesetzt wird. Sofern diese Komponenten aber ausreichend geschützt werden, können sie als Teil der Sonde aber auch mit in das Bohrloch (DH) hinabgelassen werden. In dem Fall weist die Sonde (SO) dann nicht nur ein Sensorelement mit einem Quantenpunkt (NV1) auf, sondern gleich ein ganzes Sensorsystem (NVMS). In dem Fall wird die Energie bevorzugt über das Kabel (KA) zugeführt. Die Messergebnisse werden vom Sensorsystem (NVMS) dann z.B. über das Kabel (KA) oder drahtlos wieder an eine Auswerteeinheit auf der Oberfläche signalisiert. Die Sonde (SO) kann Aktoren wie Spulen, Motoren, Strahlungsquellen, Heizer, Kühlvorrichtungen, Magneten und dergleichen umfassen. Die Sonde (SO) kann weitere Detektoren umfassen. Die Sonde (SO) kann eine Recheneinheit zur Steuerung dieser Aktoren und zur Erfassung der Messwerte der Detektoren und zur Signalisierung von Zustands- und Messdaten an ein übergeordnetes Rechnersystem auf der Oberfläche und zum Empfang von Steuerdaten von diesem umfassen.
- Spulentreiber: Spulentreiber. Die Spulentreiber umfassen typischerweise die Ansteuerlogik und die Endstufen zur Ansteuerung der Helmholzspulen (L2 bis L7);
- SQ: Stromquelle;
- SS1: Steuersignalleitung;
- STG: Steuergerät;
- SW1: erster Schwellwert;
- SW2: zweiter Schwellwert;
- T1: erste Zeiten. Zu den ersten Zeiten (T1) ist die erste Pumpstrahlungsquelle (PL1) bevorzugt aktiv. Das bedeutet, dass die erste Pumpstrahlungsquelle (PL1) Pumpstrahlung (LB, LB1) emittiert. Sofern eine Kompensationsstrahlungsquelle (PLK) verwendet wird, ist diese in den ersten Zeiten (T1) bevorzugt nicht aktiv. Das bedeutet, dass die Kompensationsstrahlungsquelle (PLK) bevorzugt keine Kompensationsstrahlung (KS) in diesen ersten Zeiten (T1) aussendet. Eine Auswertung des Empfängerausgangssignals (S0) durch den Korrelator (CORR) ist in einigen Konfigurationen zu den ersten Zeiten (T1) möglich. In diesem Fall ist ein erster optischer Filter (F1) notwendig, wenn der erste Strahlungsempfänger (PD1) für Pumpstrahlung (LB, LB1a, LB1b) empfindlich ist, um den ersten Strahlungsempfänger (PD1) von der Pumpstrahlung (LB, LB1a, LB1b) abzuschirmen. Die ersten Zeiten (T1) sind bevorzugt von den dritten Zeiten (T3) und den zweiten Zeiten (T2) verschieden.
- T1': verschobene erste Zeiten. Die durch den ersten Strahlungsempfänger (PD1) empfangene Intensität der Fluoreszenzstrahlung (FL) in Form des Empfängerausgangssignals (S0) erscheint zu verschobenen ersten Zeiten (T1'), die um eine Fluoreszenzphasenverschiebungszeit (ΔTFL) gegenüber den ersten Zeiten (T1) verschoben sind, im Empfängerausgangssignal (S0). Zu den ersten Zeiten (T1) ist die Pumpstrahlungsquelle (PL1) bevorzugt aktiv. Das bedeutet, dass die erste Pumpstrahlungsquelle (PL1) Pumpstrahlung (LB, LB1) emittiert. Der Quantenpunkt (NV1) bzw. das paramagnetische Zentrum (NV1) bzw. das NV-zentrum (NV1) wird von zumindest einem Teil der Pumpstrahlung (LB, LB1) getroffen und emittiert die Fluoreszenzstrahlung (FL) verzögert um die Fluoreszenzphasenverschiebungszeit (ΔTFL). Eine Auswertung des Empfängerausgangssignals (S0) durch den Korrelator (CORR) ist in einigen Konfigurationen zu den verschobenen ersten Zeiten (T1') möglich. In diesem Fall ist typischerweise ein erster optischer Filter (F1) notwendig, wenn der erste Strahlungsempfänger (PD1) für Pumpstrahlung (LB, LB1a, LB1b) empfindlich ist, um den ersten Strahlungsempfänger (PD1) von der Pumpstrahlung (LB, LB1a, LB1b) abzuschirmen. Die verschobenen ersten Zeiten (T1') überlappen bevorzugt mit den ersten Zeiten (T1) und den zweiten Zeiten (T2). Sofern die ersten Zeiten (T1) kürzer als die Fluoreszenzphasenverschiebungszeit (ΔTFL) sind, kann dies auch nicht der Fall sein.
- T2: zweite Zeiten. Zu den zweiten Zeiten (T2) ist die erste Pumpstrahlungsquelle (PL1) bevorzugt nicht aktiv. Das bedeutet, dass die erste Pumpstrahlungsquelle (PL1) keine Pumpstrahlung (LB, LB1) emittiert. Sofern eine Kompensationsstrahlungsquelle (PLK) verwendet wird, ist diese in den zweiten Zeiten (T2) bevorzugt nicht aktiv. Das bedeutet, dass die Kompensationsstrahlungsquelle (PLK) bevorzugt keine Kompensationsstrahlung (KS) in diesen zweiten Zeiten (T2) aussendet. Eine Auswertung des Empfängerausgangssignals (S0) durch den Korrelator (CORR) ist in einigen Konfigurationen zu den zweiten Zeiten (T2) möglich. In diesem Fall ist kein erster optischer Filter (F1) notwendig, um den ersten Strahlungsempfänger (PD1) von der Pumpstrahlung (LB, LB1a, LB1b) abzuschirmen, da dann keine Pumpstrahlung (LB, LB1a, LB1b) in dem Sensorsystem (NVMS) mehr vorhanden sein sollte. Insofern sind solche Sensorsysteme (NVMS) preisgünstiger, aber weniger empfindlich. Sie arbeiten mit dem Nachleuchten der Quantenpunkte (NV1) bzw. der paramagnetischen Zentren(NV1), bzw. der NV-Zentren (NV1). Die zweiten Zeiten (T2) sind bevorzugt von den ersten Zeiten (T1) und den dritten Zeiten (T3) verschieden.
- T3: dritte Zeiten. Zu den dritten Zeiten (T3) ist die erste Pumpstrahlungsquelle (PL1) bevorzugt nicht aktiv. Das bedeutet, dass die erste Pumpstrahlungsquelle (PL1) keine Pumpstrahlung (LB, LB1) emittiert. Sofern eine Kompensationsstrahlungsquelle (PLK) verwendet wird, ist diese in den dritten Zeiten (T3) bevorzugt aktiv. Das bedeutet, dass die Kompensationsstrahlungsquelle (PLK) bevorzugt Kompensationsstrahlung (KS) in diesen zweiten Zeiten (T2) aussendet. Eine Auswertung des Empfängerausgangssignals (S0) durch den Korrelator (CORR) ist zu den dritten Zeiten(T3) nicht möglich, da das Nachleuchten der Quantenpunkte (NV1) bzw. der paramagnetischen Zentren (NV1) bzw. der NV-Zentren (NV1) dann bereits abgeklungen ist. In diesem Fall ist die Verwendung von Kompensationsstrahlung (KS) mit einer Kompensationsstrahlungswellenlänge (λₖₛ) möglich, die von der Fluoreszenzstrahlungswellenlänge (λ_{fl}) der Fluoreszenzstrahlung (FL) oder der Pumpstrahlungswellenlänge (λₚₘₚ) der Pumpstrahlung (LB, LB1) nicht verschieden ist. Dies wird aber nicht empfohlen. Die dritten Zeiten (T3) sind bevorzugt von den ersten Zeiten (T1) und den zweiten Zeiten (T2) verschieden.
- TP: Filter. Der Filter kann als Tiefpass bevorzugt so konstruiert sein, dass er ein linearer Filter mit bevorzugt großer Verstärkung ist. Bevorzugt lässt er die Frequenz des Sendesignals (S0) bereits nicht mehr durch. Alle höheren Frequenzen werden bevorzugt ebenfalls weggefiltert.
- TR1: erster Transistor der beispielhaften Push-Pull-Stufe;
- TR2: zweiter Transistor der beispielhaften Push-Pull-Stufe;
- USS: Ultraschallsender oder Ultraschallsendesystem. Der Ultraschallsender (USS) emittiert eine beispielhafte akustische Sendewelle (ASW), die beispielsweise an einem Objekt (Obj) oder im Übertragungskanal zu einer akustischen Welle (AW) modifiziert wird und dann durch das vorgeschlagene Mikrofon (Figur 21) empfangen wird. Statt eines Ultraschallsenders (USS) können auch normale Lautsprecher oder Infraschallsender verwendet werden.
- VDD: Betriebsspannungsleitung (VDD) auf Betriebsspannungspotenzial;
- VDS: vektorieller Ausgangsdatenstrom (VDS) der Ansteuerungs- und Aufbereitungseinheit (IF);
- WA: Gehäusewand;
- WI: Winde. Ggf. ist die Winde (WI) motorisiert;
- X1: erster Körper;
- X2: zweiter Körper;
- Zahnschiene: Zahnschiene. Vorrichtung mit einer modulierten Oberfläche oder Kante, so dass je nach Positionierung der Zahnschiene der magnetische Fluss (B) am Ort des Quantenpunkts (NV1) bzw. des paramagnetischen Zentrums (NV1) bzw. des NV-Zentrums (NV1) geändert wird. Die Zahnschiene weist Erhebungen- beispielsweise Zähne - und Vertiefungen - beispielsweise Fenster - auf.

### Liste der zitierten Schriften

Alexander M. Zaitsev, "Optical Properties of Diamond", erschienen im Springer Verlag,
Bernd Burchard et. AI., "NM Scale Resolution Single Ion Implantation Into Diamond for Quantum Dot Production", Diamond 2004 Conference Riva del Garda,
B. Burchard, J. Meijer, M. Domhan, C. Wittmann, T. Gaebel, I. Popa, F. Jelezko, and J. Wrachtrup, "Generation of single color centers by focused nitrogen implantation" Appl. Phys. Lett. 87, 261909 (2005); https://doi.org/10.1063/1.2103389,
Küpfmüller, Kohn, "Theoretische Elektrotechnik und Elektronik" Springer 1993 Kapitel 3,
Francisco Herrera, Francisco Charte, Antonio J. Rivera, Maria J. del Jesus, "Multilabel Classification: Problem Analysis, Metrics and Techniques", Springer, 22. April 2018, ISBN-13 : 978-3319822693 verwiesen,
Charu C. Aggarwal, "Neural Networks and Deep Learning: A Textbook" Springer; 1. Auflage, 13. September 2018,
C. Wang, C. Kurtsiefer, H. Weinfurter, B. Burchard, "Single photon emission from SiV centres in diamond produced by ion implantation" J. Phys. B: At. Mol. Opt. Phys., 39(37), 2006,
Björn Tegetmeyer, "Luminescence properties of SiV-centers in diamond diodes" Promotionsschrift, Universität Freiburg, 30.01.2018,
Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992,
Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph], 25 May 2020,
Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph],
Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
DE 10 2018 127 394 A1, DE 10 2019 120 076.8, DE 10 2019 121 028.3, DE 10 2019 121 137.9,
DE 10 2019 130 114.9, DE 10 2020 119 414.5, PCT/DE 2020/100 648, PCT/DE 2020/100 827

## Patentansprüche

1. Sensorsystem (NVMS) mit
- einem Quantenpunkt mit einer Vielzahl von NV-Zentren (NV1),
- wobei zwei oder mehr paramagnetische Zentren (NV1) der Vielzahl (NVC) paramagnetischer Zentren (NV1) miteinander koppeln,
- einer Ansteuer- und Auswertevorrichtung (AWV),
- wobei die Ansteuer- und Auswertevorrichtung (AWV) eine erste Pumpstrahlungsquelle (PL1) umfasst,
- wobei die Ansteuer- und Auswertevorrichtung (AWV) einen ersten Strahlungsempfänger (PD1) umfasst,
- wobei die Ansteuer- und Auswertevorrichtung (AWV) dazu eingerichtet ist, mittels der ersten Pumpstrahlungsquelle (PL1) den Quantenpunkt mit Pumpstrahlung (LB) zumindest zeitweise zu bestrahlen,
- wobei die Pumpstrahlung (LB) der ersten Pumpstrahlungsquelle (PL1) von einem Sendesignal (S5) der Ansteuer- und Auswertevorrichtung (AWV) abhängt,
- wobei der Quantenpunkt Fluoreszenzstrahlung (FL) bei Bestrahlung mit der Pumpstrahlung (LB) emittiert,
- wobei die Fluoreszenzstrahlung (FL) von der magnetischen Flussdichte (B) am Ort des Quantenpunkts und/oder einem anderen physikalischen Parameter abhängt,
- wobei die Ansteuer- und Auswertevorrichtung (AWV) dazu eingerichtet ist, in Abhängigkeit von der Fluoreszenzstrahlung (FL) ein erstes Ausgangssignal (out) mit einem Signalanteil zu erzeugen, der einen Messwert repräsentiert,
- wobei der Messwert von dem Wert der magnetischen Flussdichte (B) und/oder des anderen physikalischen Parameters abhängt, **dadurch gekennzeichnet,**
- **dass** die Ansteuer- und Auswertevorrichtung (AWV) dazu eingerichtet ist, mittels einer Teilvorrichtung in Form einer oder mehrerer Kompensationsspulen (LC) die Empfindlichkeit des Quantenpunkts für die magnetische Flussdichte (B) und/oder den anderen physikalischen Parameter nachzuregeln,
- **dass** die Ansteuer- und Auswertevorrichtung (AWV) dazu eingerichtet ist, diese Empfindlichkeit des Quantenpunkts mittels der Teilvorrichtung in Abhängigkeit von dem ersten Ausgangssignal (out) der Ansteuer- und Auswertevorrichtung (AWV) nachzuregeln,
**dass** die Ansteuer- und Auswertevorrichutng (AWV) einen ersten Multiplizierer (M1), einen zweiten Multiplizierer (M2), einen Subtrahierer (A1), einen Filter (TP) und einen Regler (RG) umfasst,
- **dass** der zweite Multiplizierer (M2) das erste Ausgangssignal (out) mit dem Sendesignal (S5) multipliziert und so den verstärkten Anteil des Sendesignals (S5) im Empfängerausgangssignal (S0) als Rückkoppelsignal (S6) rekonstruiert,
- **dass** der Subtrahierer (A1) von dem Empfängerausgangssignal (S0) das Rückkoppelsignal (S6) subtrahiert und so ein reduziertes Empfängerausgangssignal (S1) bildet,
- **dass** der erste Multiplizierer (M1) das reduzierte Empfängerausgangssignal (S1) mit dem Sendesignal (S5) multipliziert und ein Filtereingangssignal (S3) erzeugt,
- **dass** der Filter (TP) das Filtereingangssignal (S3) zum ersten Ausgangssignal (out) filtert,
- **dass** der Regler (RG) ein Arbeitspunktregelsignal (S9) aus dem ersten Ausgangssignal (out) ableitet,
- **dass** die Regelung durch den Regler (RG) mit einer ersten Zeitkonstante t1 erfolgt,
- **dass** die Kompensationsregelung mittels des Filters (TP) mit einer zweiten Zeitkonstante t2 erfolgt,
- **dass** die erste Zeitkonstante t1 des Reglers (RG) größer als die zweite Zeitkonstante t2 des Filters (TP) ist,
- **dass** der Regler (RG) bei einer Änderung des Werts der magnetischen Flussdichte (B) oder einer Änderung des Werts eines anderen der physikalischen Parameter am Ort der Vielzahl (NVC) paramagnetischer Zentren (NV1) durch Subtraktion oder Addition eines durch den Regler (RG) gespeisten Spulenstroms der Kompensationsspule (LC) die magnetische Gesamtflussdichte (B) am Ort der Vielzahl (NVC) paramagnetischer Zentren (NV1) in Richtung eines Arbeitspunktes verlagert und
- **dass** die Ansteuer- und Auswertevorrichtung (AWV) dazu eingerichtet ist, die Nachregelung über das Rückkoppelsignal (S6) somit kompensierend so durchzuführen, dass das reduzierte Empfängerausgangssignal (S1) keinen Anteil des Sendesignals (S5) im reduzierten Empfängerausgangssignal (S1) bis auf Signalrauschen und Regelfehler mehr aufweist.

2. Sensorsystem nach Anspruch 1, **dadurch gekennzeichnet,**
- **dass** die magnetische Flussdichte (B), die durch die Teilvorrichtung erzeugt wird, auf den Quantenpunkt einwirkt und
- **dass** das Empfängerausgangssignal (S0) des ersten Strahlungsempfängers (PD1) einen Anteil des Sendesignals (S5) im Empfängerausgangssignal (S0) mit einer Amplitude dieses Anteils des Sendesignals (S5) im Empfängerausgangssignal (S0) aufweist, deren Betrag kleiner als ein vorgegebener Amplitudenbandbreitenbetrag ist.

3. Verfahren zur Kommutierung von Statorspulen und/oder Rotorspulen bzw. Läuferspulen eines Elektromotors oder einer elektrischen Maschine unter Verwendung eines Sensor nach Anspruch 1 oder 2,
- wobei die Kommutierung des Elektromotors bzw. der elektrischen Maschine von der Fluoreszenzstrahlung (FL) eines Quantenpunkts, insbesondere eines paramagnetischen Zentrums (NV1) und/oder insbesondere einer Vielzahl (NVC) von paramagnetischen Zentren (NV1) und/oder insbesondere eines NV-Zentrums und/oder insbesondere einer Vielzahl von NV-Zentren, abhängt.

## Claims

1. A sensor system (NVMS) comprising
- a quantum dot having a plurality of NV centers (NV1),
- wherein two or mor paramagnetic centers (NV1) of the plurality (NVC) of paramagnetic centers (NV1) couple with each other,
- a control and evaluation device (AWV),
- wherein the control and evaluation device (AWV) comprises a first pump radiation source (PL1),
- wherein the control and evaluation device (AWV) comprises a first radiation receiver (PD1),
- wherein the control and evaluation device (AWV) is configured to at least partially irradiate the quantum dot with pump radiation (LB) by means of the first pump radiation source (PL1),
- wherein the pump radiation (LB) of the first pump radiation source (PL1) depends on a transmitting signal (S5) of the control and evaluation device (AWV),
- wherein the quantum dot emits fluorescence radiation (FL) upon irradiation with the pump radiation (LB),
- wherein the fluorescence radiation (FL) depends on the magnetic flux density (B) at the location of the quantum dot and/or on another physical parameter,
- wherein the control and evaluation device (AWV) is configured to generate, depending on the fluorescence radiation (FL), a first output signal (out) with a signal portion representing a measured value,
- wherein the measured value depends on the value of the magnetic flux density (B) and/or the other physical parameter,
**characterized in that**
- the control and evaluation device (AWV) is configured to readjust the sensitivity of the quantum dot for the magnetic flux density (B) und/or the other physical parameter by means of a diving device in the form of one or more compensation coils (LC),
- the control and evaluation device (AWV) is configured to readjust the sensitivity of the quantum dot by means of the dividing device depending on the first output signal (out) of the control and evaluation device (AWV),
- the control and evaluation device (AWV) comprises a first multiplier (M1), a second multiplier (M2), a first subtracter (A1), a filter (TP), and a controller (RG),
- the second multiplier (M2) multiplies the first output signal (out) by the transmitting signal (S5) and thus reconstructs the amplified portion of the transmitting signal (S5) in the receiver output signal (S0) as a feedback signal (S6),
- the subtracter (A1) subtracts the feedback signal (S6) from the receiver output signal (S0) and thus forms a reduced receiver output signal (S1),
- the first multiplier (M1) multiplies the reduced receiver output signal (S1) by the transmitting signal (S5) and generates a filter input signal (S3),
- the filter (TP) filters the filter input signal (S3) to the first output signal (out),
- the controller (RG) derives an operating point control signal (S9) from the first output signal (out),
- the control is performed by the controller (RG) with a first time constant t1,
- the compensation control is performed by means of the filter (TP) with a second time constant t2,
- the first time constant t1 of the controller (RG) is larger than the second time constant t2 of the filter (TP),
- the controller (RG), upon a change in the value of the magnetic flux density (B) or a change in the value of any other of the physical parameters at the location of the plurality (NVC) of paramagnetic centers (NV1), shifts the total magnetic flux density (B) at the location of the plurality (NVC) of paramagnetic centers (NV1) toward an operating point by subtracting or adding a coil current of the compensation coil (LC) fed by the controller (RG),
- the control and evaluation device (AWV) is configured to perform the readjustment via the feedback signal (S6) in a compensating manner such that the reduced receiver output signal (S1) no longer comprises any portion of the transmitting signal (S5) in the reduced receiver output signal (S1) except for signal noise and control errors.

2. The sensor system according to claim 1, **characterized in that**
- the magnetic flux density (B) generated by the dividing device acts on the quantum dot, and
- the receiver output signal (S0) of the first radiation receiver (PD1) comprises a portion of the transmitting signal (S5) in the receiver output signal (S0) with am amplitude of said portion of the transmitting signal (S5) in the receiver output signal (S0), the amount of which is smaller than a preset amplitude bandwidth amount.

3. A method for commutating stator coils and/or rotor coils of an electric motor or an electric machine by using a sensor according to claim 1 or 2,
- wherein the commutation of the electric motor and the electric machine, respectively, depends on the fluorescence radiation (FL) of a quantum dot, in particular a paramagnetic center (NV1), and/or in particular a plurality (NVC) of paramagnetic centers (NV1), and/or in particular an NV center, and/or in particular a plurality of NV centers.

## Revendications

1. Système de capteur (NVMS) avec
- une boîte quantique dotée d'une pluralité de centres NV (NV1),
- dans lequel deux, ou plus de deux, centres paramagnétiques (NV1) de la pluralité (NVC) de centres paramagnétiques (NV1) sont mutuellement couplés,
- un dispositif de commande et d'analyse (AWV),
- dans lequel le dispositif de commande et d'analyse (AWV) comprend une première source de rayonnement de pompage (PL1),
- dans lequel le dispositif de commande et d'analyse (AWV) comprend un premier récepteur de rayonnement (PD1),
- dans lequel le dispositif de commande et d'analyse (AWV) est configuré de façon à exposer au moins temporairement la boîte quantique au rayonnement de pompage (LB) au moyen de la première source de rayonnement de pompage (PL1),
- dans lequel le rayonnement de pompage (LB) de la première source de rayonnement de pompage (PL1) dépend d'un signal d'émission (S5) du dispositif de commande et d'analyse (AWV),
- dans lequel la boîte quantique émet un rayonnement fluorescent (FL) lorsqu'elle est exposée au rayonnement de pompage (LB),
- dans lequel le rayonnement fluorescent (FL) dépend de la perméabilité magnétique (B) à l'emplacement de la boîte quantique et/ou d'un autre paramètre physique,
- dans lequel le dispositif de commande et d'analyse (AWV) est configuré de façon à générer en fonction du rayonnement fluorescent (FL) un premier signal de sortie (out) avec une composante de signal représentant une valeur de mesure,
- dans lequel la valeur de mesure dépend de la valeur de la perméabilité magnétique (B) et/ou de l'autre paramètre physique,
**caractérisé**
- **en ce que** le dispositif de commande et d'analyse (AWV) est configuré de façon à ajuster la sensibilité de la boîte quantique à la perméabilité magnétique (B) et/ou à l'autre paramètre physique au moyen d'un dispositif partiel sous la forme d'une ou plusieurs bobines de compensation (LC),
- **en ce que** le dispositif de commande et d'analyse (AWV) est configuré de façon à ajuster cette sensibilité de la boîte quantique au moyen du dispositif partiel en fonction du premier signal de sortie (out) du dispositif de commande et d'analyse (AWV),
- **en ce que** le dispositif de commande et d'analyse (AWV) comprend un premier multiplicateur (M1), un deuxième multiplicateur (M2), un soustracteur (A1), un filtre (TP) et un régulateur (RG),
- **en ce que** le deuxième multiplicateur (M2) multiplie le premier signal de sortie (out) par le signal d'émission (S5) et reconstitue ainsi la composante amplifiée du signal d'émission (S5) dans le signal de sortie du récepteur (S0) comme signal de rétroaction (S6),
- **en ce que** le soustracteur (A1) soustrait le signal de rétroaction (S6) du signal de sortie du récepteur (S0) et forme ainsi un signal réduit de sortie du récepteur (S1),
- **en ce que** le premier multiplicateur (M1) multiplie le signal réduit de sortie du récepteur (S1) par le signal d'émission (S5) et génère un signal d'entrée du filtre (S3),
- **en ce que** le filtre (TP) filtre le signal d'entrée du filtre (S3) pour donner le premier signal de sortie (out),
- **en ce que** le régulateur (RG) dérive du premier signal de sortie (out) un signal de régulation de point de fonctionnement (S9),
- **en ce que** la régulation par le régulateur (RG) s'effectue avec une première constante de temps t1,
- **en ce que** la régulation de compensation au moyen du filtre (TP) s'effectue avec une deuxième constante de temps t2,
- **en ce que** la première constante de temps t1 du régulateur (RG) est supérieure à la deuxième constante de temps t2 du filtre (TP),
- **en ce que** le régulateur (RG), lors d'une variation de la valeur de la perméabilité magnétique (B) ou d'une variation de la valeur d'un autre des paramètres physiques à l'emplacement de la pluralité (NVC) de centres paramagnétiques (NV1), déplace la perméabilité magnétique (B) à l'emplacement de la pluralité (NVC) de centres paramagnétiques (NV1) en direction d'un point de fonctionnement par soustraction ou addition d'un courant de bobine alimentant la bobine de compensation (LC) par le régulateur (RG) et
- **en ce que** le dispositif de commande et d'analyse (AWV) est configuré de façon à effecteur l'ajustage par le biais du signal de rétroaction (S6) en compensant de sorte que le signal réduit de sortie du récepteur (S1) ne comporte plus aucune composante du signal d'émission (S5) dans le signal réduit de sortie du récepteur (S1) à l'exception du bruit de signal et des erreurs de régulation.

2. Système de capteur selon la revendication 1, **caractérisé**
- **en ce que** la perméabilité magnétique (B) générée par le dispositif partiel agit sur la boîte quantique et
- **en ce que** le signal de sortie du récepteur (S0) du premier récepteur de rayonnement (PD1) comporte une composante du signal d'émission (S5) dans le signal de sortie du récepteur (S0) avec une amplitude de cette composante du signal d'émission (S5) dans le signal de sortie du récepteur (S0) dont la valeur est inférieure à une valeur prédéfinie de bande passante d'amplitude.

3. Procédé de commutation de bobines de stator et/ou de bobines de rotor d'un moteur électrique ou d'une machine électrique en utilisant un capteur selon la revendication 1 ou 2,
- dans lequel la commutation du moteur électrique ou respectivement de la machine électrique dépend du rayonnement fluorescent (FL) d'une boîte quantique, en particulier d'un centre paramagnétique (NV1) et/ou en particulier d'une pluralité (NVC) de centres paramagnétiques (NV1) e/ou en particulier d'un centre NV et/ou en particulier d'une pluralité de centres NV.
